(19) Europäisches Patentamt
European Patent Office
Office européen des brevets

(11) EP 3 395 823 B1

(12) **EUROPEAN PATENT SPECIFICATION**

(45) Date of publication and mention of the grant of the patent:
**26.02.2020 Bulletin 2020/09**

(51) Int Cl.:
***C07F 15/00*** (2006.01) ***C09K 11/06*** (2006.01)
***H01L 51/50*** (2006.01) ***H01L 51/00*** (2006.01)

(21) Application number: **18168937.3**

(22) Date of filing: **24.04.2018**

# (54) ORGANOMETALLIC COMPOUND, ORGANIC LIGHT-EMITTING DEVICE INCLUDING THE SAME, AND DIAGNOSTIC COMPOSITION INCLUDING THE ORGANOMETALLIC COMPOUND

ORGANOMETALLISCHE VERBINDUNG, ORGANISCHE LICHTEMITTIERENDE VORRICHTUNG DAMIT UND DIAGNOSEZUSAMMENSETZUNG MIT DER ORGANOMETALLISCHEN VERBINDUNG

COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.04.2017 KR 20170053242**

(43) Date of publication of application:
**31.10.2018 Bulletin 2018/44**

(73) Proprietor: **Samsung Electronics Co., Ltd.**
**Gyeonggi-do 16677 (KR)**

(72) Inventors:
- **Lee, Jungin**
**16678 Gyeonggi-do (KR)**
- **Kim, Jiwhan**
**16678 Gyeonggi-do (KR)**
- **Park, Bumwoo**
**16678 Gyeonggi-do (KR)**
- **Lee, Sunyoung**
**16678 Gyeonggi-do (KR)**
- **Choi, Hyeonho**
**16678 Gyeonggi-do (KR)**
- **Hwang, Kyuyoung**
**16678 Gyeonggi-do (KR)**
- **Kwak, Yoonhyun**
**16678 Gyeonggi-do (KR)**
- **Kwon, Ohyun**
**16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**WO-A2-2014/109814**
**JP-A- 2010 135 689**
**US-A1- 2013 168 656**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 395 823 B1

## Description

FIELD OF THE INVENTION

One or more embodiments relate to an organometallic compound, an organic light-emitting device including the organometallic compound, and a diagnostic composition including the organometallic compound.

BACKGROUND OF THE INVENTION

Organic light-emitting devices (OLEDs) are self-emission devices, which have better characteristics in terms of a viewing angle, a response time, a brightness, a driving voltage, and a response speed, and which produce full-color images.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Meanwhile, luminescent compounds may be used to monitor, sense, or detect a variety of biological materials including cells and proteins. An example of the luminescent compounds includes a phosphorescent luminescent compound.

Various types of organic light emitting devices are known. However, there still remains a need in OLEDs having low driving voltage, high efficiency, high brightness, and long lifespan.

JP 2010 135689 discloses a white organic electroluminescent element including a pair of electrodes and at least one organic layer including a light-emitting layer between the electrodes on a substrate.

US 2013/168656 discloses phosphorescent platinum complexes containing tetradentate ligands. The disclosed compounds have three 6-membered metallocycle units in each tertadentate ligand. The disclosed compounds have desirable electronic properties that make them useful when incorporated into a variety of OLED devices.

WO 2014/109814 discloses metal complexes that exhibit multiple radiative decay mechanisms, together with methods for the preparation and use thereof.

SUMMARY OF THE INVENTION

Aspects of the present disclosure provide an organometallic compound, an organic light-emitting device including the same, and a diagnostic composition including the organometallic compound.

Additional aspects will be set forth in part in the description which follows and, in part, will be apparent from the description, or may be learned by practice of the presented embodiments.

An aspect provides an organometallic compound represented by Formula 1:

Formula 1

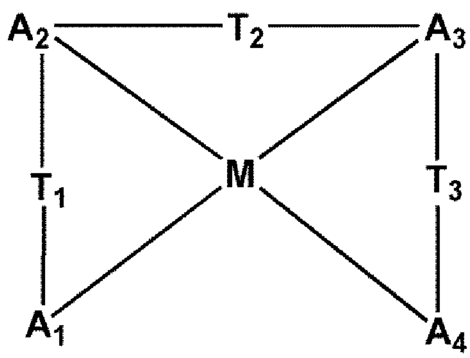

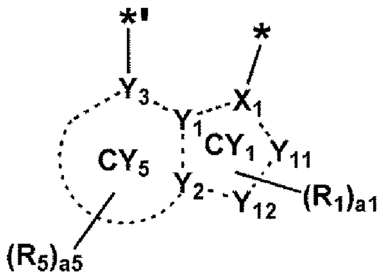

Formula A1-1

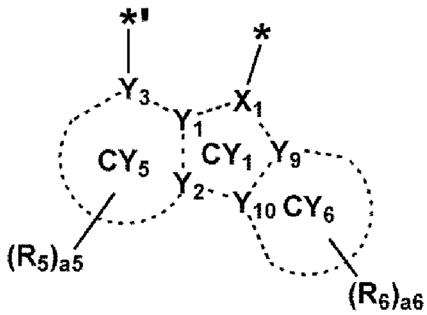

Formula A1-2

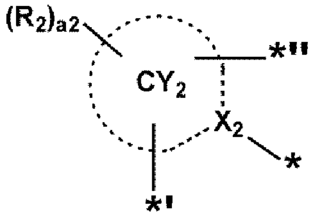

Formula A2-1

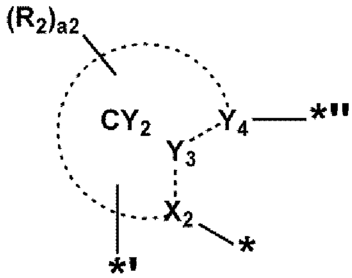

Formula A2-2

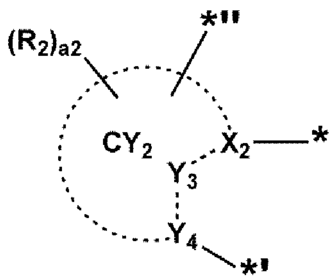

Formula A2-3

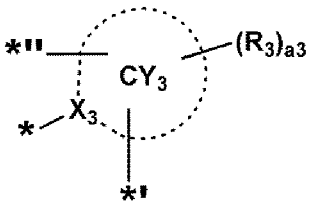

Formula A3-1

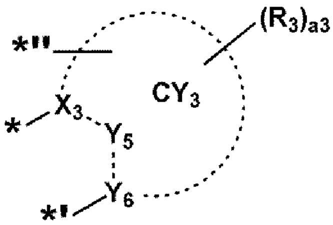

Formula A3-2

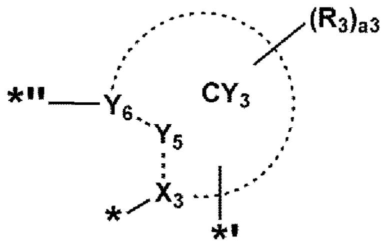

Formula A3-3

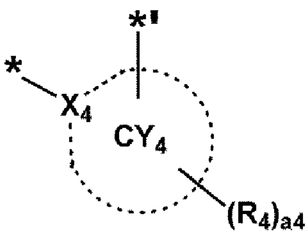

Formula A4-1

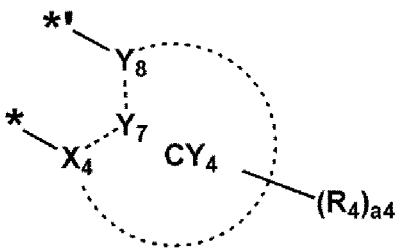

Formula A4-2

wherein

M in Formula 1 is platinum (Pt),
in Formula 1, two bonds selected from a bond between $A_1$ and M, a bond between $A_2$ and M, a bond between $A_3$ and M, and a bond between $A_4$ and M are each a covalent bond, and the others thereof are each a coordinate bond,
$A_1$ in Formula 1 is represented by Formula A1-1 or A1-2, and in Formulae A1-1 and A1-2, * indicates a binding site to M in Formula 1, and *' indicates a binding site to $T_1$ in Formula 1,
$A_2$ in Formula 1 is represented by one of Formula A2-1 to A2-3, and in Formulae A2-1 to A2-3, * indicates a binding site to M in Formula 1, *' indicates a binding site to $T_1$ in Formula 1, and *" indicates a binding site to $T_2$ in Formula 1, and in Formula A2-1, the two atoms to which *' and *" are linked are adjacent to $X_2$,

$A_3$ in Formula 1 is represented by one of Formulae A3-1 to A3-3, and in Formulae A3-1 to A3-3, * indicates a binding site to M in Formula 1, *" indicates a binding site to $T_2$ in Formula 1, and *' indicates a binding site to $T_3$ in Formula 1, and in Formula A3-1, the two atoms to which *' and *" are linked are adjacent to $X_3$,

$A_4$ in Formula 1 is a non-cyclic moiety including a first atom linked to M, or is represented by Formula A4-1 or A4-2, and in Formulae A4-1 and A4-2, * indicates a binding site to M in Formula 1, and *' indicates a binding site to $T_3$ in Formula 1, and in Formula A4-1, the atom to which *' is linked is adjacent to $X_4$,

the first atom is B, N, P, C, Si, O, or S,

in Formulae A1-1, A1-2, A2-1 to A2-3, A3-1 to A3-3, A4-1, and A4-2, $X_1$ to $X_4$ and $Y_1$ to $Y_{10}$ are each independently C or N, and $Y_{11}$ is O, S, N, C, or Si,

$Y_{12}$ is C,

ring $CY_1$ in Formulae A1-1 and A1-2 is a 5-membered ring,

rings $CY_2$ to $CY_6$ in Formulae A1-1, A1-2, A2-1 to A2-3, A3-1 to A3-3, A4-1, and A4-2 are each independently a $C_5$-$C_{30}$ carbocyclic group or a C1-C30 heterocyclic group,

$T_1$ to $T_3$ in Formula 1 are each a single bond,

$R_7$ and Rs are optionally linked via a single bond, a double bond, or a first linking group to form a substituted or unsubstituted $C_5$-$C_{30}$ carbocyclic group or a substituted or unsubstituted $C_1$-$C_{30}$ heterocyclic group,

$R_1$ to $R_8$ are each independently selected from hydrogen, deuterium, - F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -B($Q_6$)($Q_7$), and -P(=O)($Q_8$)($Q_9$),

a1 in Formula A1-1 is an integer from 0 to 4,

a2 to a6 in Formulae A1-1, A1-2, A2-1 to A2-3, A3-1 to A3-3, A4-1, and A4-2 are each independently be an integer from 0 to 20,

two of a plurality of neighboring groups $R_2$ are optionally linked to form a substituted or unsubstituted $C_5$-$C_{30}$ carbocyclic group or a substituted or unsubstituted $C_1$-$C_{30}$ heterocyclic group,

two of a plurality of neighboring groups $R_3$ are optionally linked to form a substituted or unsubstituted $C_5$-$C_{30}$ carbocyclic group or a substituted or unsubstituted $C_1$-$C_{30}$ heterocyclic group,

two of a plurality of neighboring groups $R_4$ are optionally linked to form a substituted or unsubstituted $C_5$-$C_{30}$ carbocyclic group or a substituted or unsubstituted $C_1$-$C_{30}$ heterocyclic group,

two of a plurality of neighboring groups $R_5$ are optionally linked to form a substituted or unsubstituted $C_5$-$C_{30}$ carbocyclic group or a substituted or unsubstituted $C_1$-$C_{30}$ heterocyclic group,

two of a plurality of neighboring groups $R_6$ are optionally linked to form a substituted or unsubstituted $C_5$-$C_{30}$ carbocyclic group or a substituted or unsubstituted $C_1$-$C_{30}$ heterocyclic group,

two or more neighboring groups selected from $R_2$ to $R_5$ are optionally linked to form a substituted or unsubstituted $C_5$-$C_{30}$ carbocyclic group, or a substituted or unsubstituted $C_1$-$C_{30}$ heterocyclic group,

$A_1$ and $A_4$ in Formula 1 are not linked to each other,

i) when $A_1$ in Formula 1 is represented by Formula A1-1, the organometallic compound represented by Formula 1 satisfies "Condition 1", and ii) when $A_1$ in Formula 1 is represented by Formula A1-2, the organometallic compound represented by Formula 1 satisfies at least one of "Condition 1" to "Condition 3":

"Condition 1"
$A_2$ in Formula 1 is represented by Formula A2-2 or A2-3,
"Condition 2"
$A_3$ in Formula 1 is represented by Formula A3-2 or A3-3, and
"Condition 3"
$A_4$ in Formula 1 is represented by Formula A4-2,

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the

substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group is selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

Another aspect of the present disclosure provides an organic light-emitting device including:

a first electrode,
a second electrode, and
an organic layer disposed between the first electrode and the second electrode,
wherein the organic layer includes an emission layer and at least one of the organometallic compound.

The organometallic compounds may act as a dopant in the emission layer.

Another aspect of the present disclosure provides a diagnostic composition including at least one organometallic compound represented by Formula 1.

BRIEF DESCRIPTION OF THE DRAWING

These and/or other aspects will become apparent and more readily appreciated from the following description of the embodiments, taken in conjunction with the FIGURE which is a schematic view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An organometallic compound according to an embodiment is represented by Formula 1 below:

Formula 1

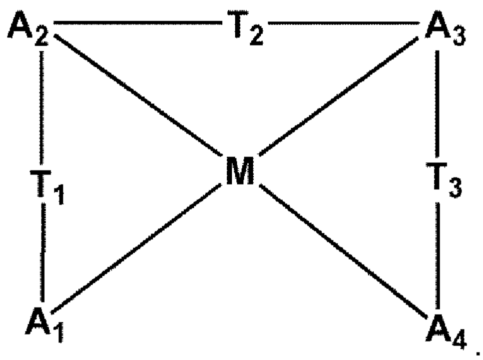

M in Formula 1 is platinum (Pt).

In Formula 1, two bonds selected from a bond between $A_1$ and M, a bond between $A_2$ and M, a bond between $A_3$ and M, and a bond between $A_4$ and M are each a covalent bond, and the others thereof are each a coordinate bond. Accordingly, the organometallic compound represented by Formula 1 is electrically neutral. Therefore, the organometallic compound represented by Formula 1 clearly distinguishes from a virtual organometallic compound being represented by i) Formula 1, in which one bond selected from a bond between $A_1$ and M, a bond between $A_2$ and M, a bond between $A_3$ and M, and a bond between $A_4$ and M may be a covalent bond, and the others thereof may each be a coordinate bond, or ii) Formula 1, in which three bonds selected from a bond between $A_1$ and M, a bond between $A_2$ and M, a bond between $A_3$ and M, and a bond between $A_4$ and M may each be a covalent bond, and the other thereof may be a coordinate bond, and thus not being electrically neutral.

In an embodiment,

a bond between $A_1$ and M and a bond between $A_3$ and M may each be a covalent bond, and a bond between $A_2$ and M and a bond between $A_4$ and M may each be a coordinate bond, or

a bond between $A_1$ and M and a bond between $A_4$ and M may each be a covalent bond, and a bond between $A_2$ and M and a bond between $A_3$ and M may each be a coordinate bond, but embodiments of the present disclosure are not limited thereto.

$A_1$ in Formula 1 is represented by Formula A1-1 or A1-2, and in Formulae A1-1 and A1-2, * indicates a binding site to M in Formula 1, and *' indicates a binding site to $T_1$ in Formula 1,

$A_2$ in Formula 1 is represented by one of Formula A2-1 to A2-3, and in Formulae A2-1 to A2-3, * indicates a binding site to M in Formula 1, *' indicates a binding site to $T_1$ in Formula 1, and *" indicates a binding site to $T_2$ in Formula 1, and in Formula A2-1, the two atoms to which *' and *" are linked are adjacent to $X_2$,

$A_3$ in Formula 1 is represented by one of Formulae A3-1 to A3-3, and in Formulae A3-1 to A3-3, * indicates a binding site to M in Formula 1, *" indicates a binding site to $T_2$ in Formula 1, and *' indicates a binding site to $T_3$ in Formula 1, and in Formula A3-1, the two atoms to which *' and *" are linked are adjacent to $X_3$, and

$A_4$ in Formula 1 is a non-cyclic moiety including a first atom linked to M, or is represented by Formula A4-1 or A4-2, and in Formulae A4-1 and A4-2, * indicates a binding site to M in Formula 1, and *' indicates a binding site to $T_3$ in Formula 1, and in Formula A4-1, the atom to which *' is linked is adjacent to $X_4$:

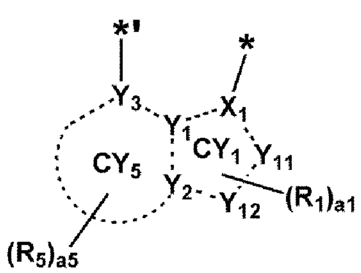

Formula A1-1

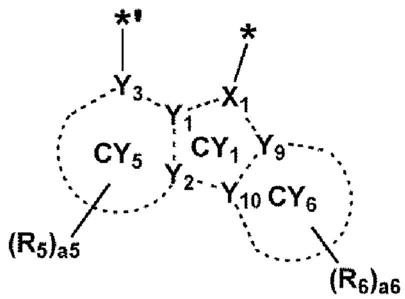

Formula A1-2

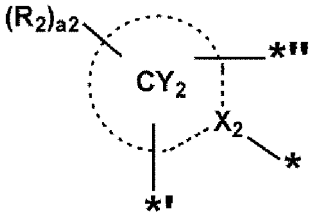

Formula A2-1

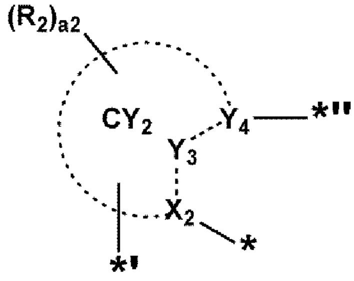

Formula A2-2

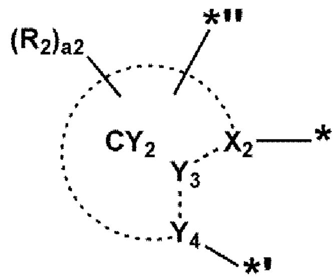

Formula A2-3

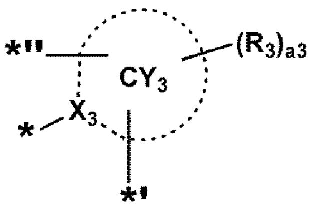

Formula A3-1

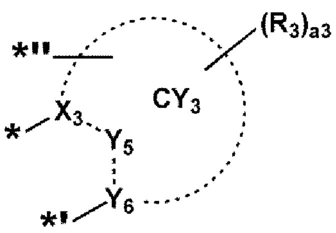

Formula A3-2

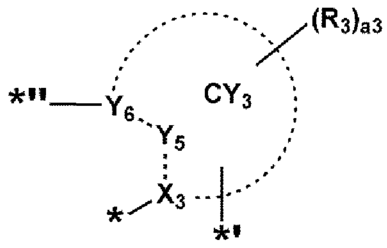

Formula A3-3

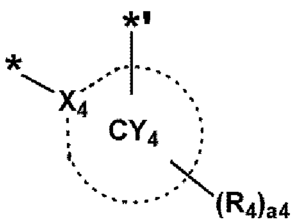

Formula A4-1

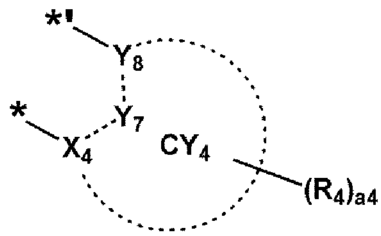

Formula A4-2

.

The first atom is B, N, P, C, Si, O, or S.

For example, the first atom may be N, P, C, Si, or O, but embodiments of the present disclosure are not limited thereto.

In an embodiment, the first atom may be O.

The non-cyclic moiety including the first atom linked to M may be *-C($R_{41}$)-*', *-Si($R_{41}$)-*', *-B($R_{41}$)-*', *-N($R_{41}$)-*', *-P($R_{41}$)-*', *-C($R_{41}$)($R_{42}$)-*', *-Si($R_{41}$)($R_{42}$)-*', *-C($R_{41}$)-C(=O)-*', *-Si($R_{41}$)- C(=O)-*', *-B($R_{41}$)-C(=O)-*', *-N($R_{41}$)-C(=O)-*', *-P($R_{41}$)-C(=O)-*', *-C($R_{41}$)($R_{42}$)-C(=O)-*', or *-Si($R_{41}$)($R_{42}$)-C(=O)-*' (wherein $R_{41}$ and $R_{42}$ are the same as described in connection with $R_4$, * indicates a binding site to M in Formula 1, and *' indicates a binding site to $T_3$ in Formula 1).

In Formulae A1-1, A1-2, A2-1 to A2-3, A3-1 to A3-3, A4-1, and A4-2, $X_1$ to $X_4$ and $Y_1$ to $Y_{10}$ are each independently C or N, and $Y_{11}$ is O, S, N, C, or Si.

$Y_{12}$ is C.

Ring $CY_1$ in Formulae A1-1 and A1-2 is a 5-membered ring.

Rings $CY_2$ to $CY_6$ in Formulae A1-1, A1-2, A2-1 to A2-3, A3-1 to A3-3, A4-1, and A4-2 are each independently a $C_5$-$C_{30}$carbocyclic group or a $C_1$-$C_{30}$ heterocyclic group.

In an embodiment, ring $CY_1$ may be selected from a pyrrole group, a furan group, a thiophene group, a silole group, a pyrazole group, an imidazole group, a triazole group, a tetrazole group, an oxazole group, an isoxazole group, a thiazole group, an isothiazole group, an oxadiazole group, a thiadiazole group, an oxatriazole group, and a thiatriazole group.

In one or more embodiments, rings $CY_2$ to $CY_6$ may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group,

an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a 5,6,7,8-tetrahydroisoquinoline group, and a 5,6,7,8-tetrahydroquinoline group.

In one or more embodiments, at least one of rings $CY_2$ to $CY_4$ may be a condensed ring with at least one 5-membered ring and at least one 6-membered ring,

the 5-membered ring may be selected from a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and

the 6-membered ring may be selected from a cyclohexane group, a cyclohexene group, a benzene group, a pyridine group, a pyrimidine group, a pyrazine group, and a pyridazine group, but embodiments of the present disclosure are not limited thereto.

In one or more embodiments, when $A_2$ is the condensed ring (for example, a moiety represented by Formula A2-2), the 5-membered ring of the condensed ring may be linked to $T_1$ in Formula 1.

In one or more embodiments, when $A_2$ is the condensed ring (for example, a moiety represented by Formula A2-2), the 5-membered ring of the condensed ring may be linked to $T_2$ in Formula 1.

In one or more embodiments, when $A_3$ is the condensed ring (for example, a moiety represented by Formula A3-2 or A3-3), the 5-membered ring of the condensed ring may be linked to $T_2$ in Formula 1.

In one or more embodiments, when $A_3$ is the condensed ring (for example, a moiety represented by Formula A3-2 or A3-3), the 5-membered ring of the condensed ring may be linked to $T_3$ in Formula 1.

In one or more embodiments, when $A_4$ is the condensed ring (for example, a moiety represented by Formula A4-2), the 5-membered ring of the condensed ring may be linked to $T_3$ in Formula 1.

In one or more embodiments, at least one of rings $CY_2$ to $CY_4$ may be a condensed ring with at least two 6-membered rings, and

the 6-membered ring may be selected from a cyclohexane group, a cyclohexene group, a benzene group, a pyridine group, a pyrimidine group, a pyrazine group, and a pyridazine group, but embodiments of the present disclosure are not limited thereto.

$T_1$ to $T_3$ in Formula 1 are each a single bond.

$R_7$ and $R_8$ are the same as described herein, and $R_7$ and $R_8$ are optionally linked via a single bond, a double bond, or a first linking group to form a substituted or unsubstituted $C_5$-$C_{30}$ carbocyclic group or a substituted or unsubstituted $C_1$-$C_{30}$ heterocyclic group.

The first linking group may be selected from *-N($R_9$)-*', *-B($R_9$)-*', *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O-*', *-C(=O)-*', *-S(=O)-*', *-S(=O)$_2$-*', *-C($R_9$)=*', *=C($R_9$)-*', *-C($R_9$)=C($R_{10}$)-*', *-C(=S)-*', and *-C=C-*', $R_9$ and $R_{10}$ are the same as described in connection with $R_7$, and * and *' each indicate a binding site to a neighboring atom.

$R_1$ to $R_8$ are each independently selected from hydrogen, deuterium, -F, -Cl, - Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, - N($Q_1$)($Q_2$), -Si($Q_3$)($Q_4$)($Q_5$), -B($Q_6$)($Q_7$), and -P(=O)($Q_8$)($Q_9$).

For example, $R_1$ to $R_8$ may each independently be selected from:

hydrogen, deuterium, -F, -Cl, -Br, -I, a hydroxyl group, a cyano group, a nitro group, an amino group, an amidino

group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, - $CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, - $CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and $-Si(Q_{33})(Q_{34})(Q_{35})$; and

$-N(Q_1)(Q_2)$, $-Si(Q_3)(Q_4)(Q_5)$, $-B(Q_6)(Q_7)$, and $-P(=O)(Q_8)(Q_9)$, and

$Q_1$ to $Q_9$ and $Q_{33}$ to $Q_{35}$ may each independently be selected from:

$-CH_3$, $-CD_3$, $-CD_2H$, $-CDH_2$, $-CH_2CH_3$, $-CH_2CD_3$, $-CH_2CD_2H$, - $CH_2CDH_2$, $-CHDCH_3$, $-CHDCD_2H$, $-CHDCDH_2$, $-CHDCD_3$, $-CD_2CH_3$, - $CD_2CD_3$, $-CD_2CD_2H$, and $-CD_2CDH_2$;

an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a

naphthyl group, each substituted with at least one selected from deuterium, a $C_1$-$C_{10}$ alkyl group, and a phenyl group.

In an embodiment, $R_1$ to $R_8$ may each independently be selected from hydrogen, deuterium, -F, a cyano group, a nitro group, $-SF_5$, $-CH_3$, $-CD_3$, $-CD_2H$, - $CDH_2$, $-CF_3$, $-CF_2H$, $-CFH_2$, groups represented by Formulae 9-1 to 9-19, groups represented by Formulae 10-1 to 10-161, $-N(Q_1)(Q_2)$, $-Si(Q_3)(Q_4)(Q_5)$, $-B(Q_6)(Q_7)$, and $-P(=O)(Q_8)(Q_9)$ (wherein $Q_1$ to $Q_9$ are the same as described herein):

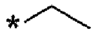
Formula 9-1
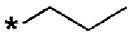
Formula 9-2
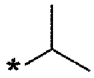
Formula 9-3
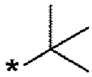
Formula 9-4
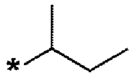
Formula 9-5
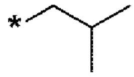
Formula 9-6
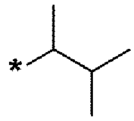
Formula 9-7

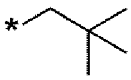
Formula 9-8
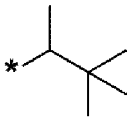
Formula 9-9
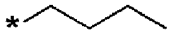
Formula 9-10
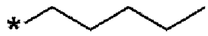
Formula 9-11
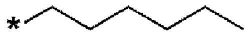
Formula 9-12

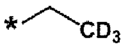
Formula 9-13
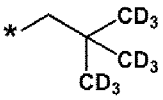
Formula 9-14
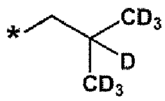
Formula 9-15
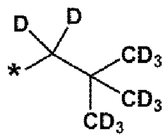
Formula 9-16
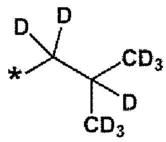
Formula 9-17
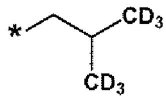
Formula 9-18

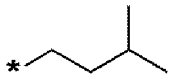
Formula 9-19

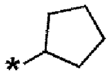
Formula 10-1
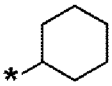
Formula 10-2
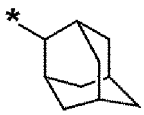
Formula 10-3
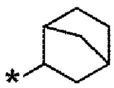
Formula 10-4
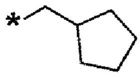
Formula 10-5
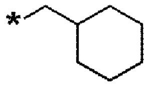
Formula 10-6
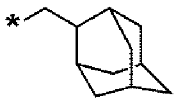
Formula 10-7

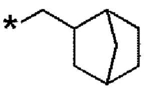
Formula 10-8
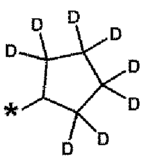
Formula 10-9
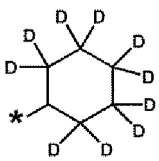
Formula 10-10
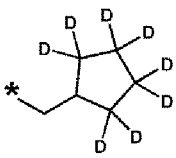
Formula 10-11
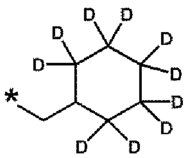
Formula 10-12
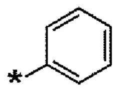
Formula 10-13

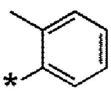
Formula 10-14
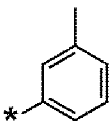
Formula 10-15
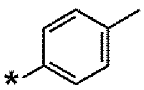
Formula 10-16
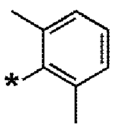
Formula 10-17
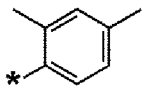
Formula 10-18
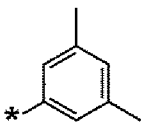
Formula 10-19
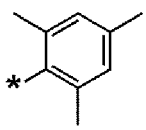
Formula 10-20

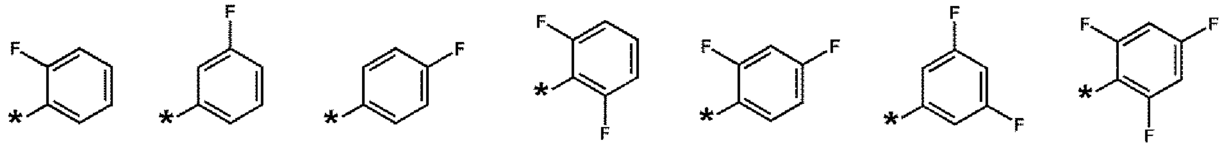

Formula 10-21 Formula 10-22 Formula 10-23 Formula 10-24 Formula 10-25 Formula 10-26 Formula 10-27

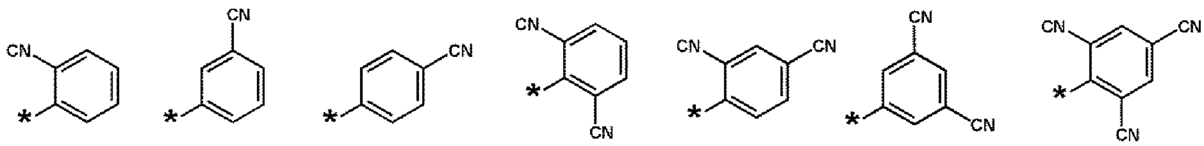

Formula 10-28 Formula 10-29 Formula 10-30 Formula 10-31 Formula 10-32 Formula 10-33 Formula 10-34

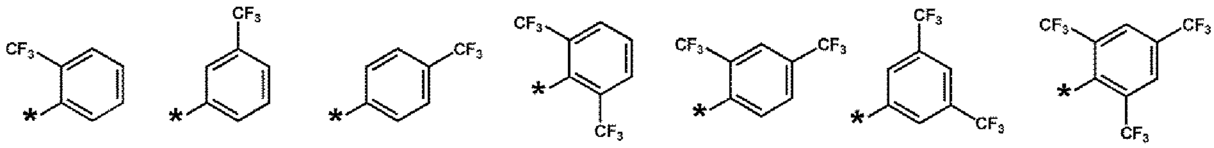

Formula 10-35 Formula 10-36 Formula 10-37 Formula 10-38 Formula 10-39 Formula 10-40 Formula 10-41

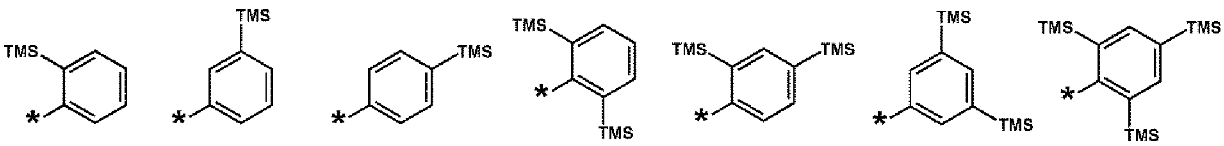

Formula 10-42 Formula 10-43 Formula 10-44 Formula 10-45 Formula 10-46 Formula 10-47 Formula 10-48

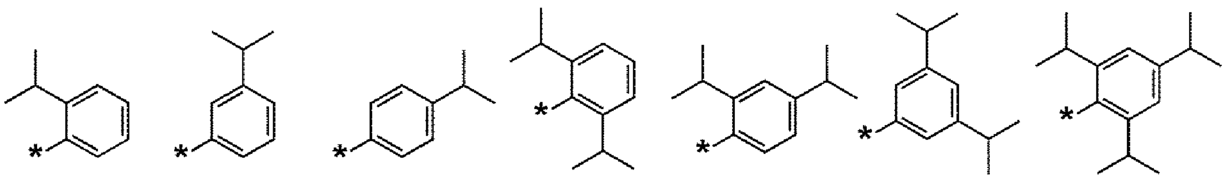

Formula 10-49 Formula 10-50 Formula 10-51 Formula 10-52 Formula 10-53 Formula 10-54 Formula 10-55

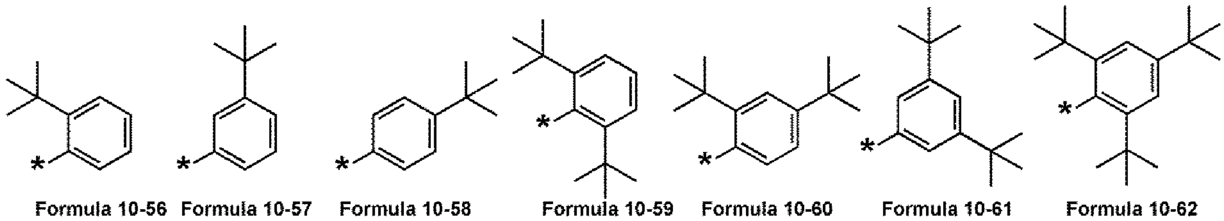

Formula 10-56 Formula 10-57 Formula 10-58 Formula 10-59 Formula 10-60 Formula 10-61 Formula 10-62

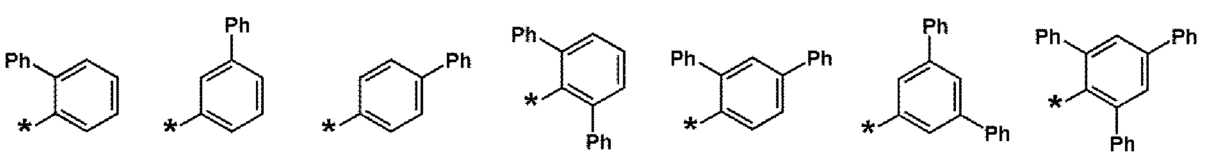

Formula 10-63 Formula 10-64 Formula 10-65 Formula 10-66 Formula 10-67 Formula 10-68 Formula 10-69

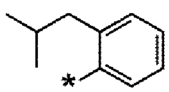
Formula 10-70

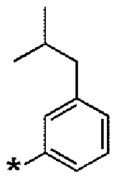
Formula 10-71

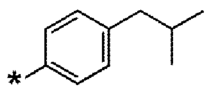
Formula 10-72

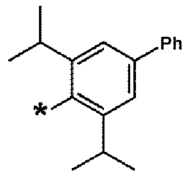
Formula 10-73

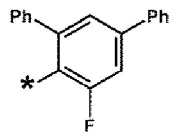
Formula 10-74

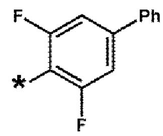
Formula 10-75

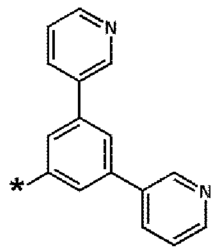
Formula 10-76

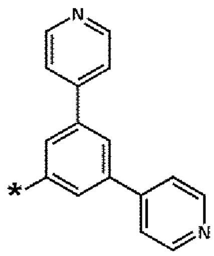
Formula 10-77

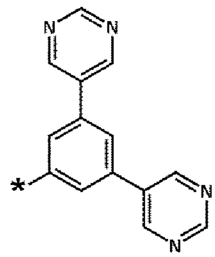
Formula 10-78

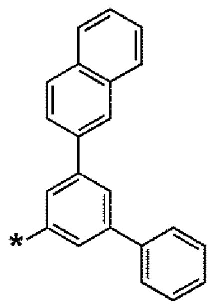
Formula 10-79

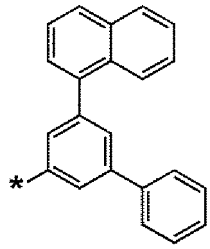
Formula 10-80

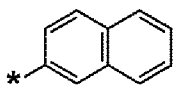
Formula 10-81

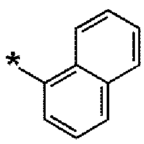
Formula 10-82

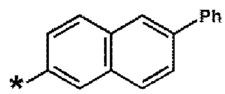
Formula 10-83

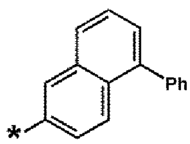
Formula 10-84

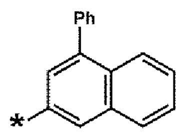
Formula 10-85

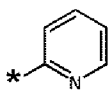
Formula 10-86

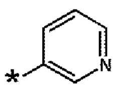
Formula 10-87

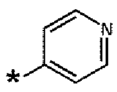
Formula 10-88

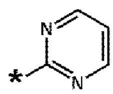
Formula 10-89

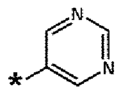
Formula 10-90

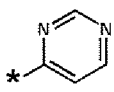
Formula 10-91

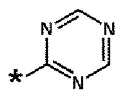
Formula 10-92

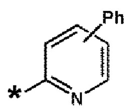
Formula 10-93

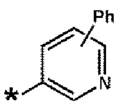
Formula 10-94

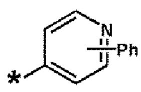
Formula 10-95

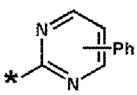
Formula 10-96

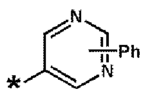
Formula 10-97

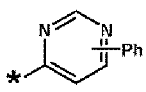
Formula 10-98

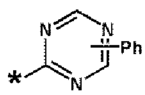
Formula 10-99

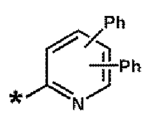
Formula 10-100

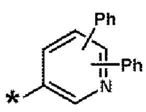
Formula 10-101

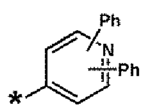
Formula 10-102

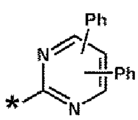
Formula 10-103

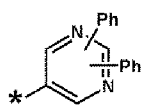
Formula 10-104

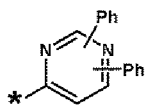
Formula 10-105

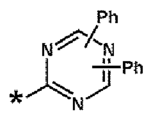
Formula 10-106

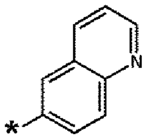
Formula 10-107

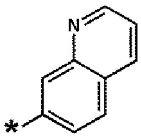
Formula 10-108

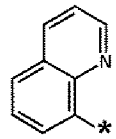
Formula 10-109

Formula 10-110

Formula 10-111

Formula 10-112

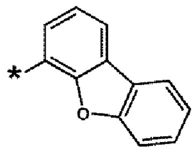
Formula 10-113
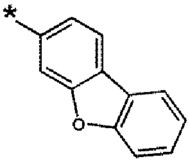
Formula 10-114
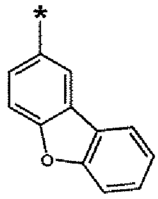
Formula 10-115
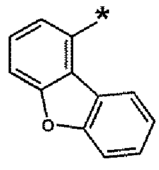
Formula 10-116
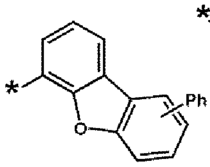
Formula 10-117
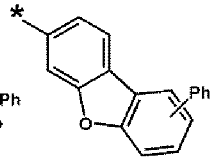
Formula 10-118

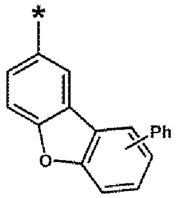
Formula 10-119
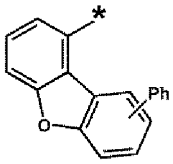
Formula 10-120
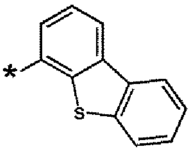
Formula 10-121
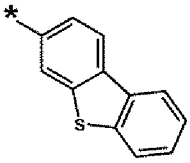
Formula 10-122
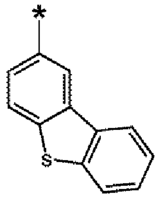
Formula 10-123
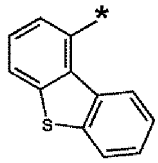
Formula 10-124

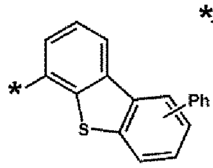
Formula 10-125
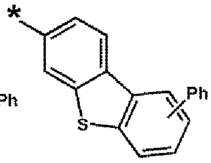
Formula 10-126
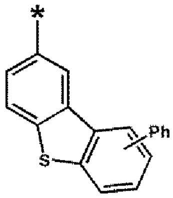
Formula 10-127
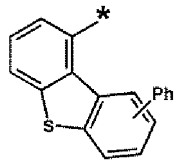
Formula 10-128
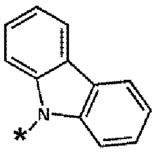
Formula 10-129
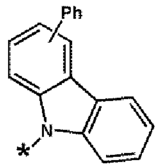
Formula 10-130

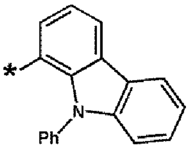
Formula 10-131
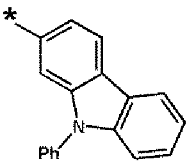
Formula 10-132
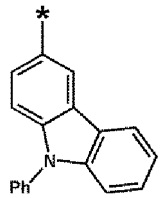
Formula 10-133
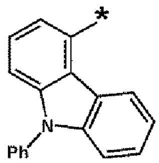
Formula 10-134
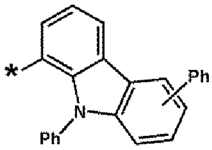
Formula 10-135
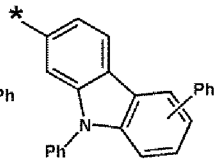
Formula 10-136

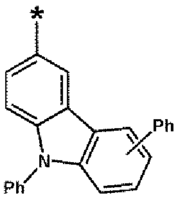
Formula 10-137
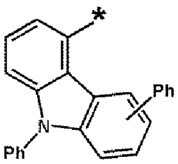
Formula 10-138
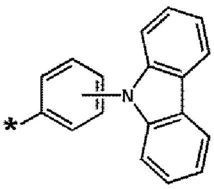
Formula 10-139
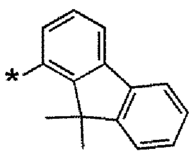
Formula 10-140
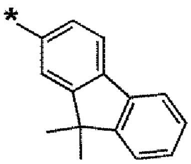
Formula 10-141
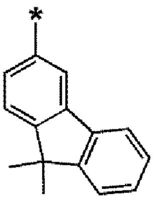
Formula 10-142

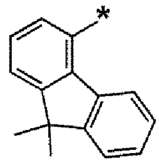
Formula 10-143
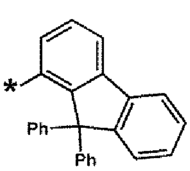
Formula 10-144
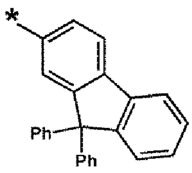
Formula 10-145
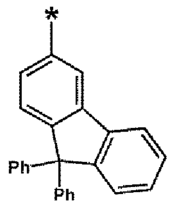
Formula 10-146
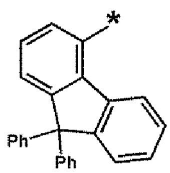
Formula 10-147

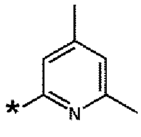 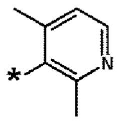 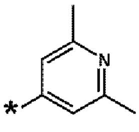 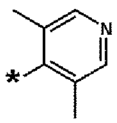 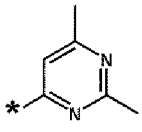 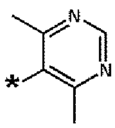 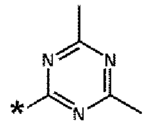

Formula 10-148 Formula 10-149 Formula 10-150 Formula 10-151 Formula 10-152 Formula 10-153 Formula 10-154

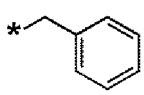 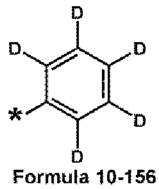 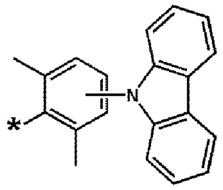 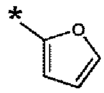 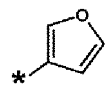 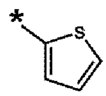 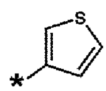

Formula 10-155 Formula 10-156 Formula 10-157 Formula 10-158 Formula 10-159 Formula 10-160 Formula 10-161

.

In Formulae 9-1 to 9-19 and 10-1 to 10-161, "Ph" indicates a phenyl group, "TMS" indicates a trimethylsilyl group, and "*" indicates a binding site to a neighboring atom.

a1 in Formula A1-1 indicates the number of groups $R_1$ and is an integer from 0 to 4. a2, a3, a4, a5, and a6 in Formulae A1-1, A1-2, A2-1 to A2-3, A3-1 to A3-3, A4-1, and A4-2 respectively indicate the number of groups $R_2$, the number of groups $R_3$, the number of groups $R_4$, the number of groups $R_5$, and the number of groups $R_6$ and are each independently an integer from 0 to 20 (for example, an integer from 0 to 4). When a1 is two or more, a plurality of groups $R_1$ may be identical to or different from each other, when a2 is two or more, a plurality of groups $R_2$ may be identical to or different from each other, when a3 is two or more, a plurality of groups $R_3$ may be identical to or different from each other, when a4 is two or more, a plurality of groups $R_4$ may be identical to or different from each other, when a5 is two or more, a plurality of groups $R_5$ may be identical to or different from each other, and when a6 is two or more, a plurality of groups $R_6$ may be identical to or different from each other.

In an embodiment, $A_1$ in Formula 1 may be represented by one of Formulae A1-1 (1) to A1-1(24) and A1 -2(1) to A1-2(8):

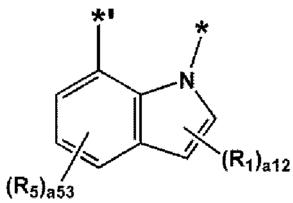 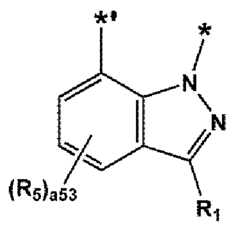 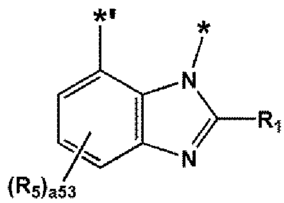 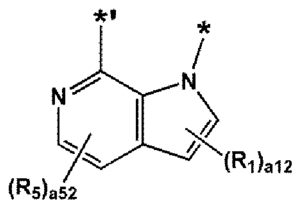

Formula A1-1(1) Formula A1-1(2) Formula A1-1(3) Formula A1-1(4)

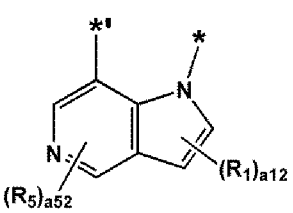 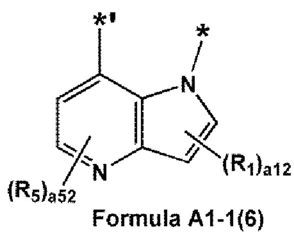 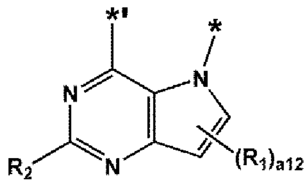 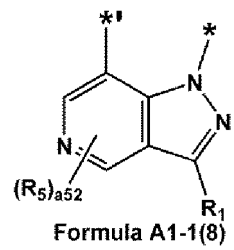

Formula A1-1(5) Formula A1-1(6) Formula A1-1(7) Formula A1-1(8)

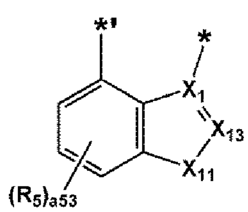 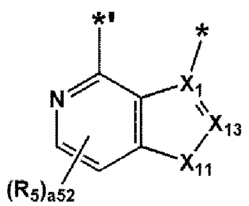 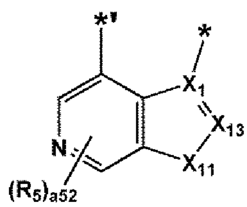 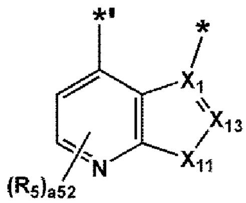

Formula A1-1(9) Formula A1-1(10) Formula A1-1(11) Formula A1-1(12)

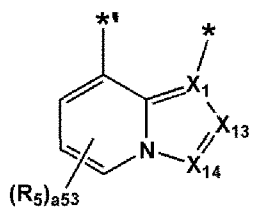
Formula A1-1(13)

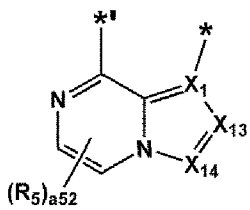
Formula A1-1(14)

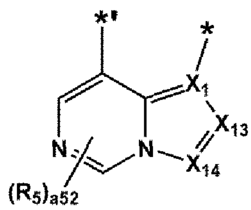
Formula A1-1(15)

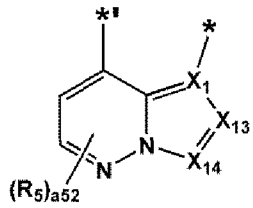
Formula A1-1(16)

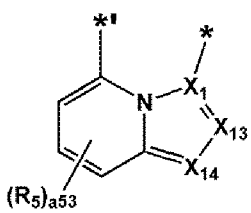
Formula A1-1(17)

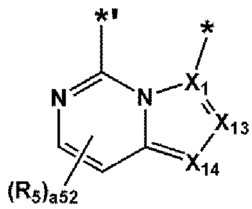
Formula A1-1(18)

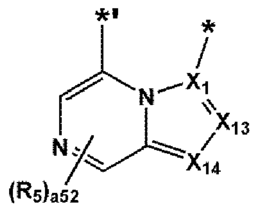
Formula A1-1(19)

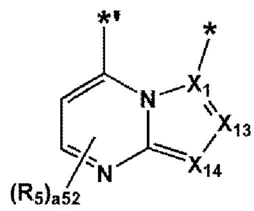
Formula A1-1(20)

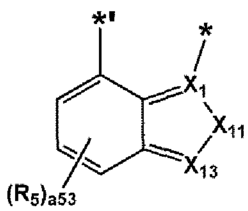
Formula A1-1(21)

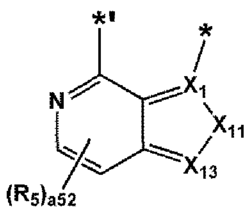
Formula A1-1(22)

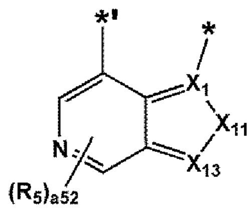
Formula A1-1(23)

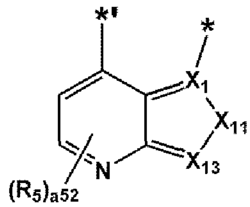
Formula A1-1(24)

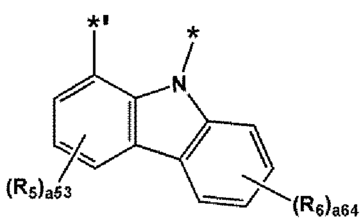
Formula A1-2(1)

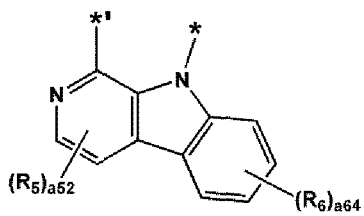
Formula A1-2(2)

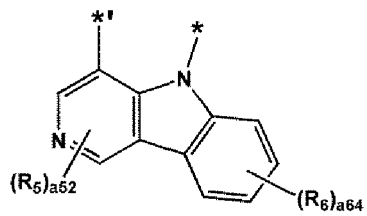
Formula A1-2(3)

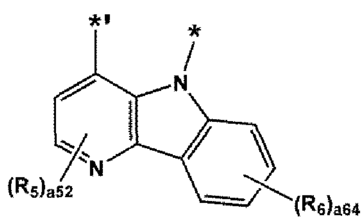
Formula A1-2(4)

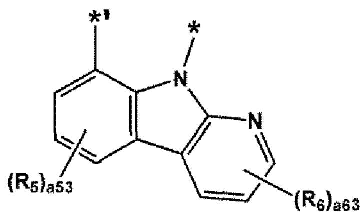
Formula A1-2(5)

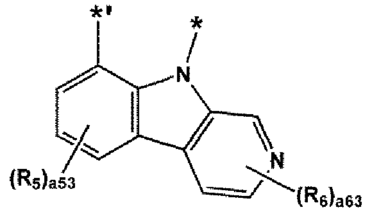
Formula A1-2(6)

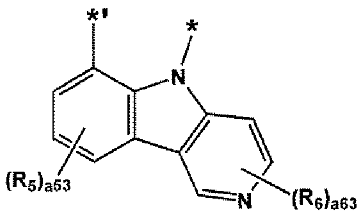

Formula A1-2(7)

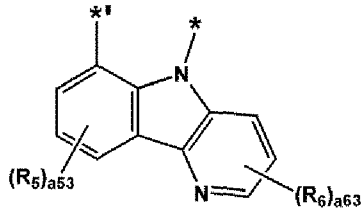

Formula A1-2(8)

.

In Formulae A1-1(1) to A1-1(24) and A1-2(1) to A1-2(8),

$X_1$, $R_1$, $R_5$, $R_6$, *, and *' are the same as described herein,
$X_{11}$ may be O, S, $N(R_{11})$, $C(R_{11})(R_{12})$, or $Si(R_{11})(R_{12})$,
$X_{13}$ may be N or $C(R_{13})$,
$X_{14}$ may be N or $C(R_{14})$,
$R_{11}$ to $R_{14}$ are the same as described in connection with $R_1$,
a64 may be an integer from 0 to 4,
a53 and a63 may each independently be an integer from 0 to 3, and
a12 and a52 may each independently be an integer from 0 to 2.

In one or more embodiments, $A_2$ in Formula 1 may be represented by one of Formulae A2-1(1) to A2-1(17), A2-2(1) to A2-2(58), and A2-3(1) to A2-3(58):

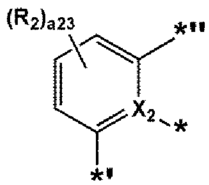

Formula A2-1(1)

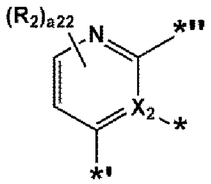

Formula A2-1(2)

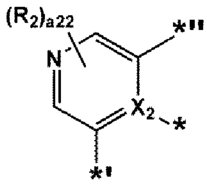

Formula A2-1(3)

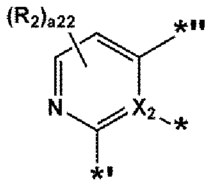

Formula A2-1(4)

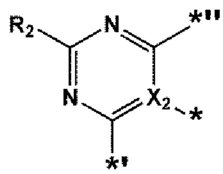

Formula A2-1(5)

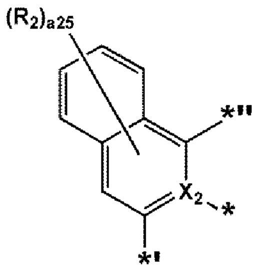

Formula A2-1(6)

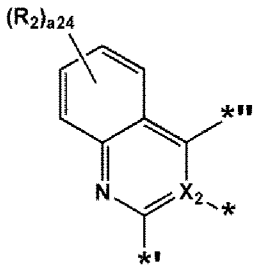

Formula A2-1(7)

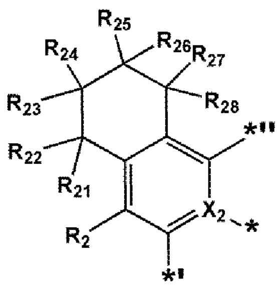

Formula A2-1(8)

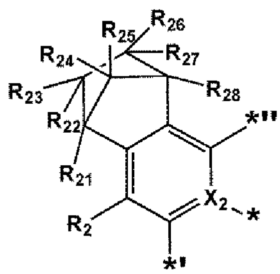

Formula A2-1(9)

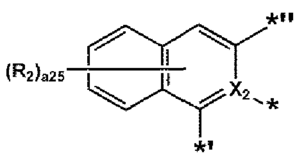

Formula A2-1(10)

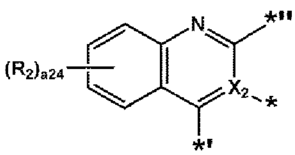

Formula A2-1(11)

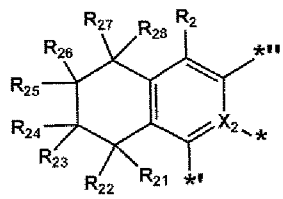

Formula A2-1(12)

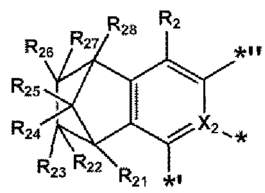

Formula A2-1(13)

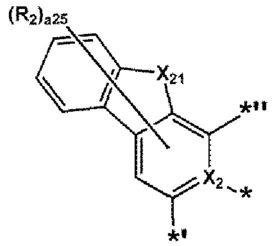

Formula A2-1(14)

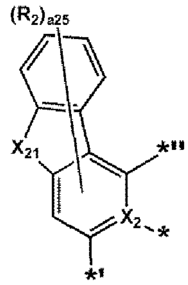

Formula A2-1(15)

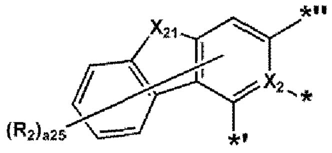

Formula A2-1(16)

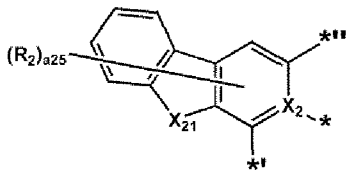

Formula A2-1(17)

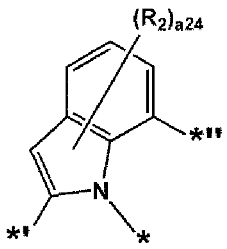

Formula A2-2(1)

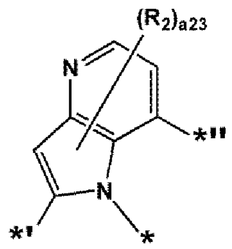

Formula A2-2(2)

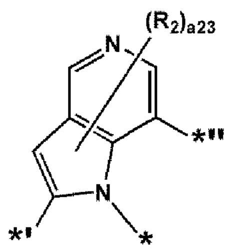

Formula A2-2(3)

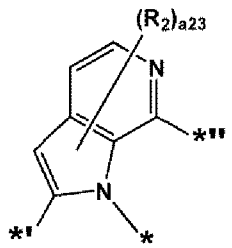

Formula A2-2(4)

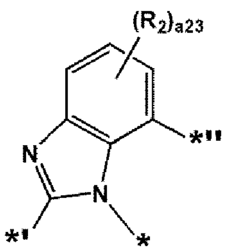

Formula A2-2(5)

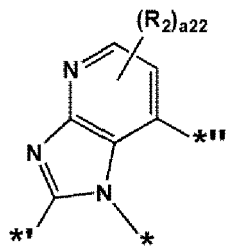

Formula A2-2(6)

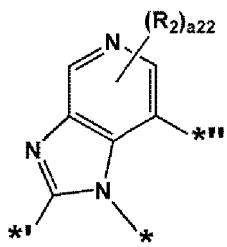

Formula A2-2(7)

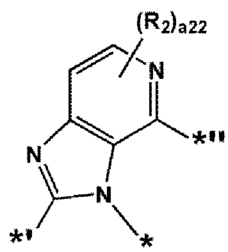

Formula A2-2(8)

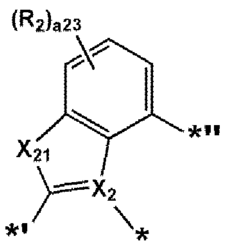

Formula A2-2(9)

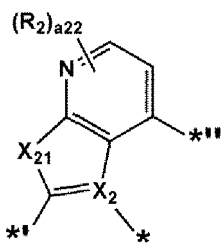

Formula A2-2(10)

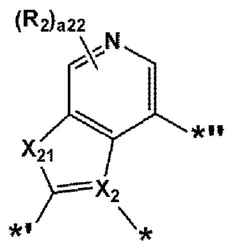

Formula A2-2(11)

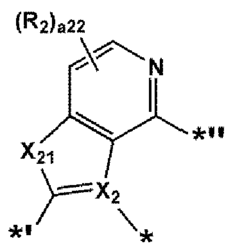

Formula A2-2(12)

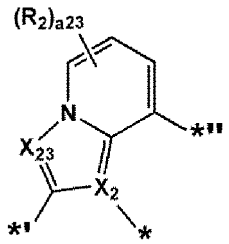

Formula A2-2(13)

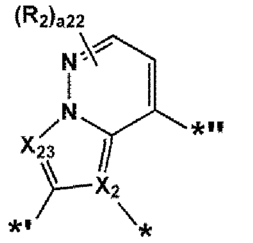

Formula A2-2(14)

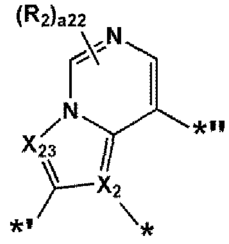

Formula A2-2(15)

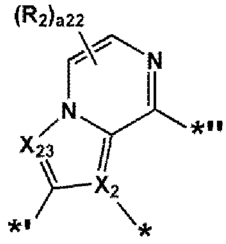

Formula A2-2(16)

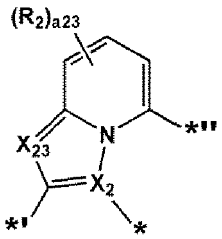
Formula A2-2(17)

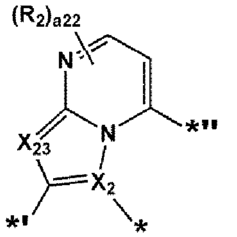
Formula A2-2(18)

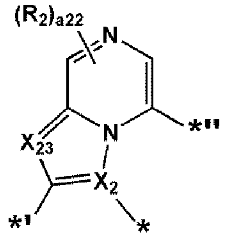
Formula A2-2(19)

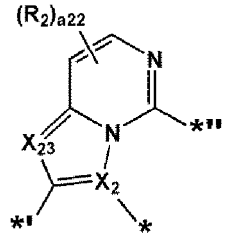
Formula A2-2(20)

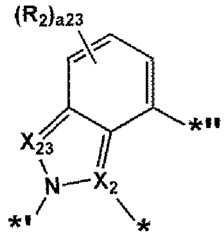
Formula A2-2(21)

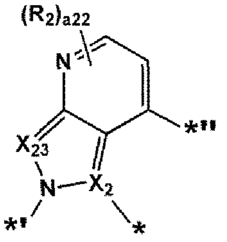
Formula A2-2(22)

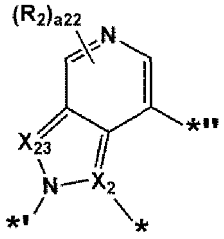
Formula A2-2(23)

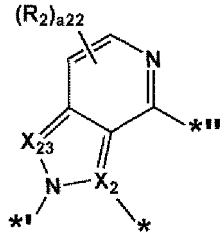
Formula A2-2(24)

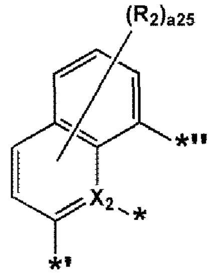
Formula A2-2(25)

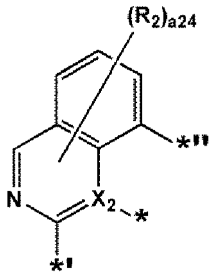
Formula A2-2(26)

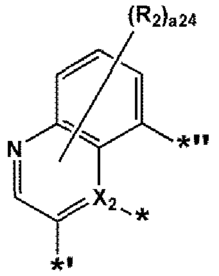
Formula A2-2(27)

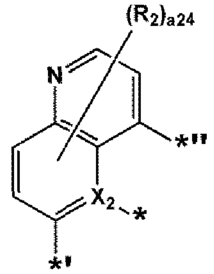
Formula A2-2(28)

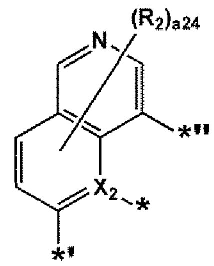
Formula A2-2(29)

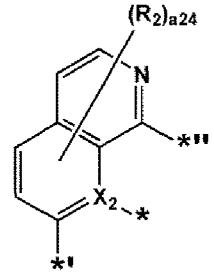
Formula A2-2(30)

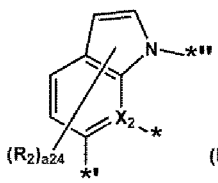
Formula A2-2(31)

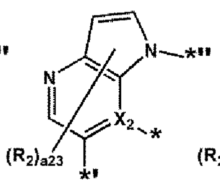
Formula A2-2(32)

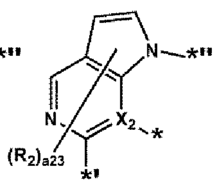
Formula A2-2(33)

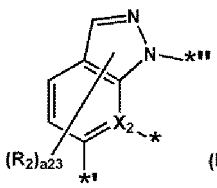
Formula A2-2(34)

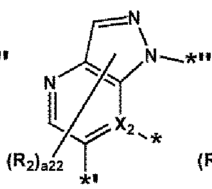
Formula A2-2(35)

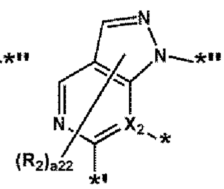
Formula A2-2(36)

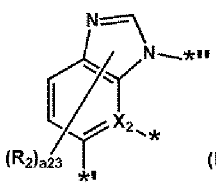
Formula A2-2(37)

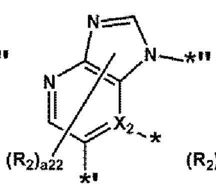
Formula A2-2(38)

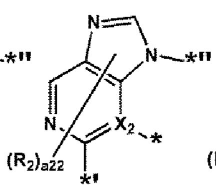
Formula A2-2(39)

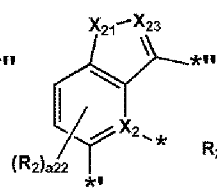
Formula A2-2(40)

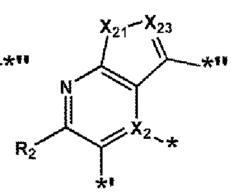
Formula A2-2(41)

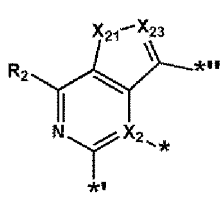
Formula A2-2(42)

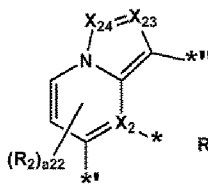
Formula A2-2(43)

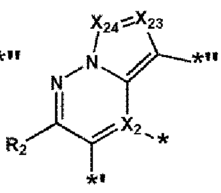
Formula A2-2(44)

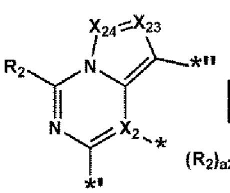
Formula A2-2(45)

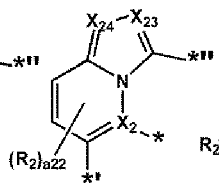
Formula A2-2(46)

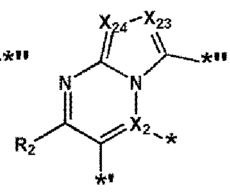
Formula A2-2(47)

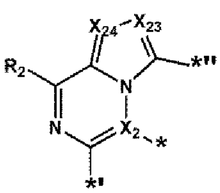
Formula A2-2(48)

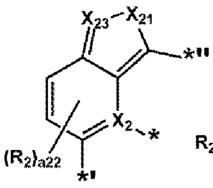
Formula A2-2(49)

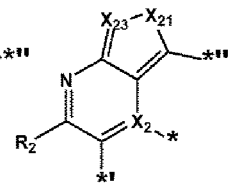
Formula A2-2(50)

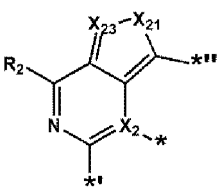
Formula A2-2(51)

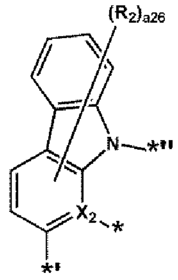
Formula A2-2(52)

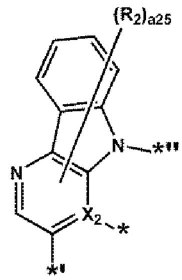
Formula A2-2(53)

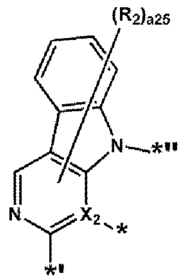
Formula A2-2(54)

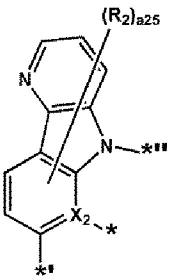
Formula A2-2(55)

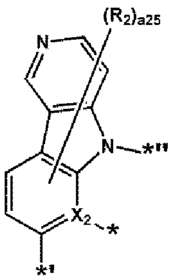
Formula A2-2(56)

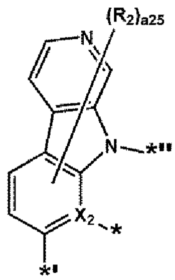
Formula A2-2(57)

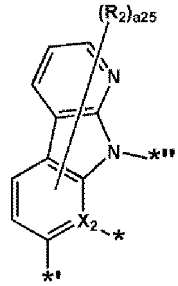
Formula A2-2(58)

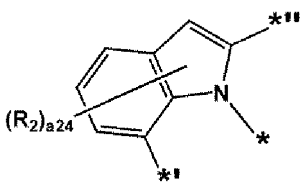
Formula A2-3(1)

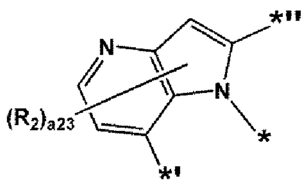
Formula A2-3(2)

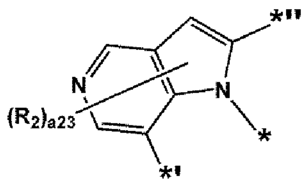
Formula A2-3(3)

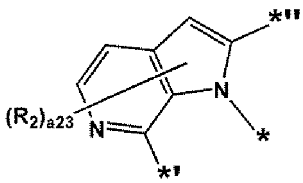
Formula A2-3(4)

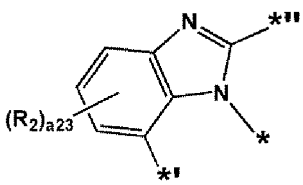
Formula A2-3(5)

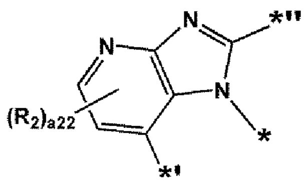
Formula A2-3(6)

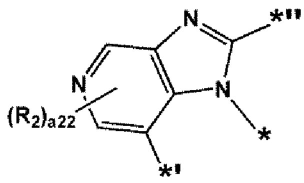
Formula A2-3(7)

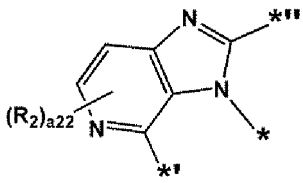
Formula A2-3(8)

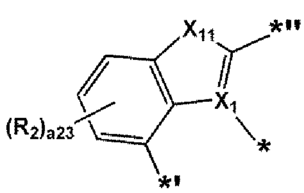
Formula A2-3(9)

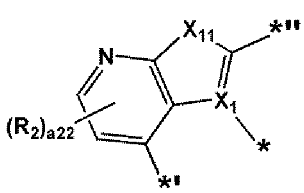
Formula A2-3(10)

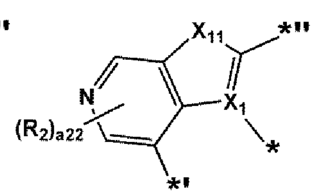
Formula A2-3(11)

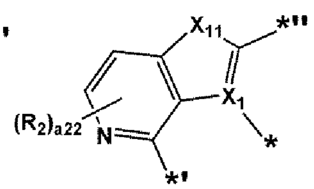
Formula A2-3(12)

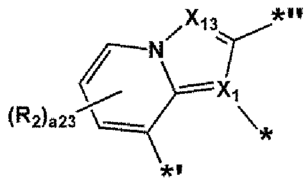
Formula A2-3(13)

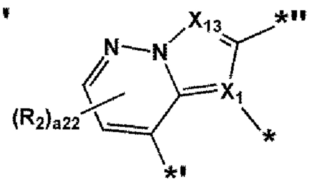
Formula A2-3(14)

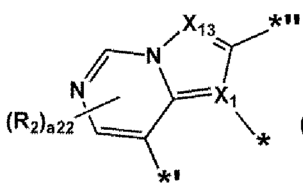
Formula A2-3(15)

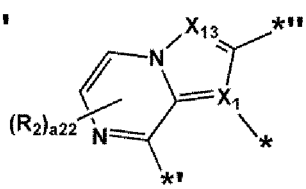
Formula A2-3(16)

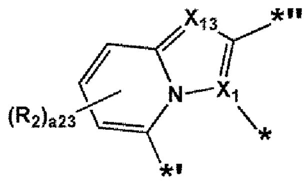
Formula A2-3(17)

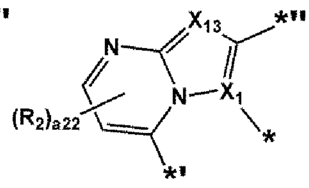
Formula A2-3(18)

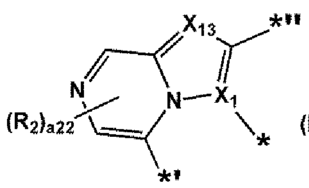
Formula A2-3(19)

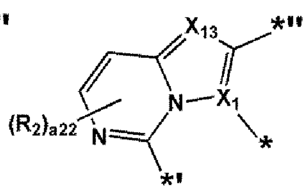
Formula A2-3(20)

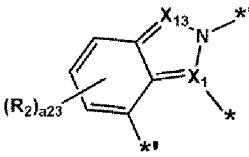
Formula A2-3(21)

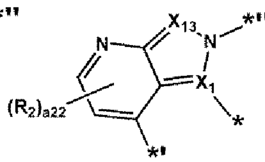
Formula A2-3(22)

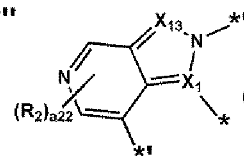
Formula A2-3(23)

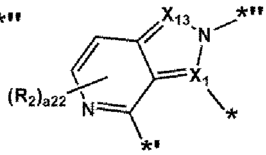
Formula A2-3(24)

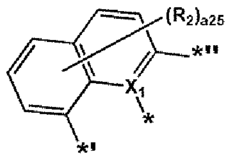
Formula A2-3(25)

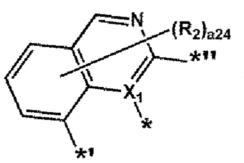
Formula A2-3(26)

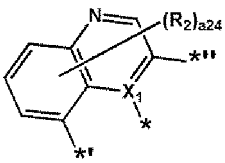
Formula A2-3(27)

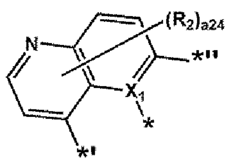
Formula A2-3(28)

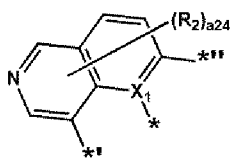
Formula A2-3(29)

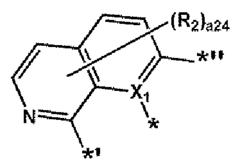
Formula A2-3(30)

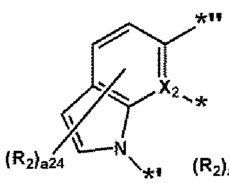
Formula A2-3(31)

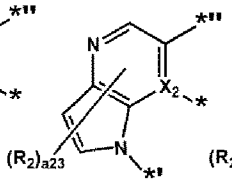
Formula A2-3(32)

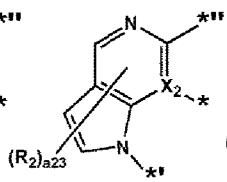
Formula A2-3(33)

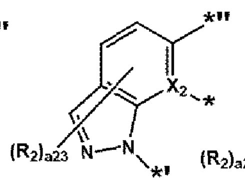
Formula A2-3(34)

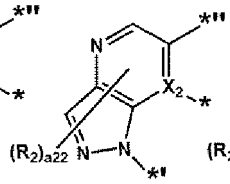
Formula A2-3(35)

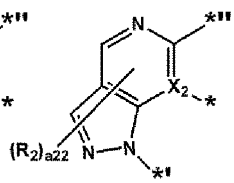
Formula A2-3(36)

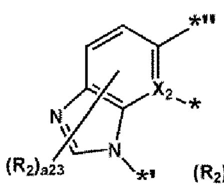
Formula A2-3(37)

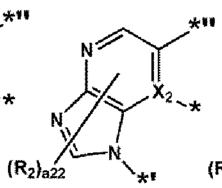
Formula A2-3(38)

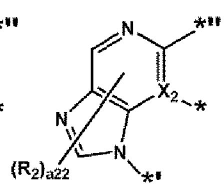
Formula A2-3(39)

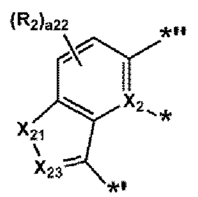
Formula A2-3(40)

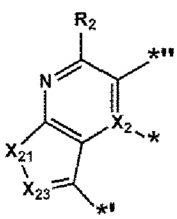
Formula A2-3(41)

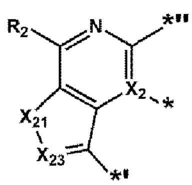
Formula A2-3(42)

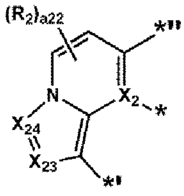
Formula A2-3(43)

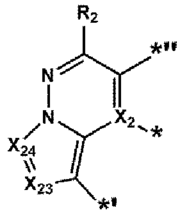
Formula A2-3(44)

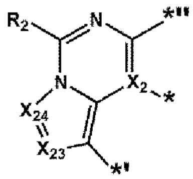
Formula A2-3(45)

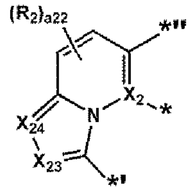
Formula A2-3(46)

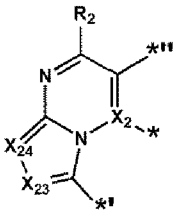
Formula A2-3(47)

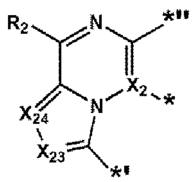
Formula A2-3(48)

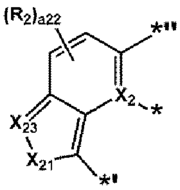
Formula A2-3(49)

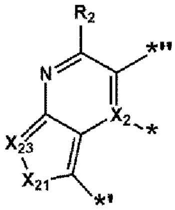
Formula A2-3(50)

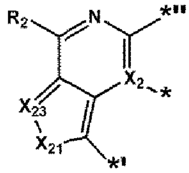
Formula A2-3(51)

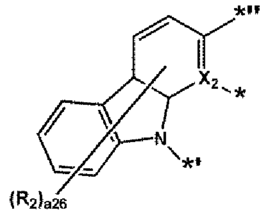
Formula A2-3(52)

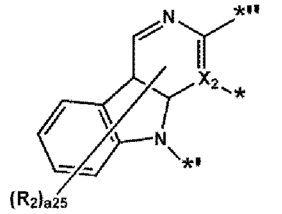
Formula A2-3(53)

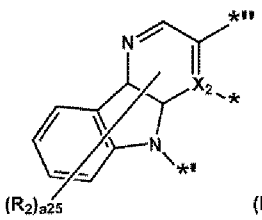
Formula A2-3(54)

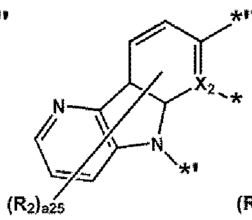
Formula A2-3(55)

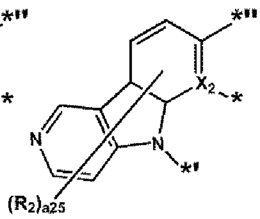
Formula A2-3(56)

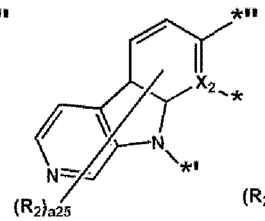
Formula A2-3(57)

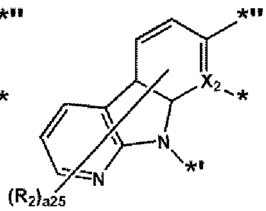
Formula A2-3(58)

.

In Formulae A2-1(1) to A2-1(17), A2-2(1) to A2-2(58), and A2-3(1) to A2-3(58),

$X_2$ and $R_2$ are the same as described herein,
$X_{21}$ may be O, S, $N(R_{21})$, $C(R_{21})(R_{22})$, or $Si(R_{21})(R_{22})$,
$X_{23}$ may be N or $C(R_{23})$,
$X_{24}$ may be N or $C(R_{24})$,
$R_{21}$ to $R_{28}$ are the same as described in connection with $R_2$,
a26 may be an integer from 0 to 6,
a25 may be an integer from 0 to 5,
a24 may be an integer from 0 to 4,
a23 may be an integer from 0 to 3,
a22 may be an integer from 0 to 2, and
*, *', and *" are the same as described in connection with *, *', and *" in Formula A2-1.

In one or more embodiments, $A_3$ in Formula 1 may be represented by one of Formulae A3-1 (1) to A3-1 (21), A3-2(1) to A3-2(58), and A3-3(1) to A3-3(58):

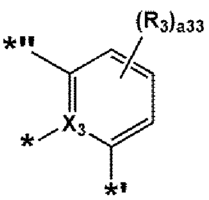
Formula A3-1(1)

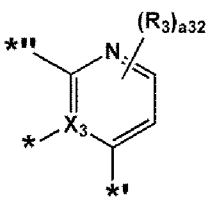
Formula A3-1(2)

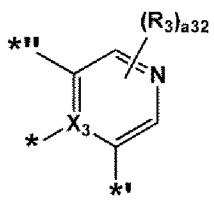
Formula A3-1(3)

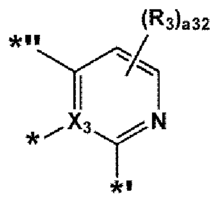
Formula A3-1(4)

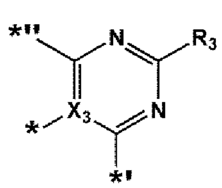
Formula A3-1(5)

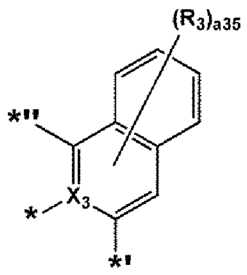
Formula A3-1(6)

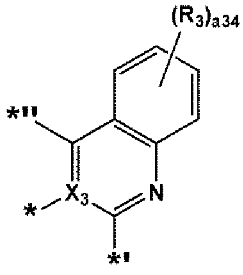
Formula A3-1(7)

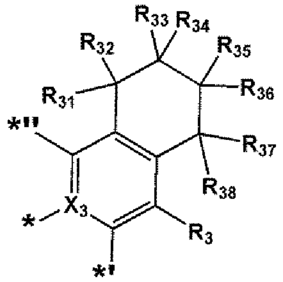
Formula A3-1(8)

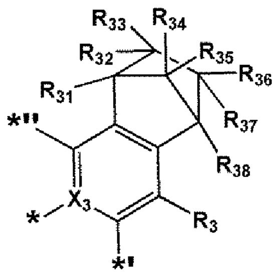
Formula A3-1(9)

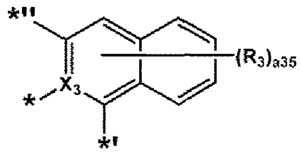
Formula A3-1(10)

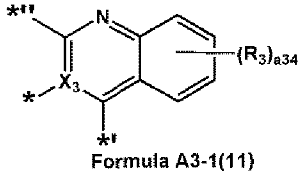
Formula A3-1(11)

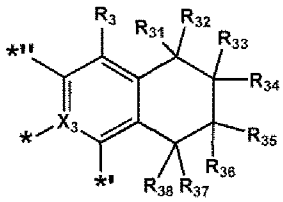
Formula A3-1(12)

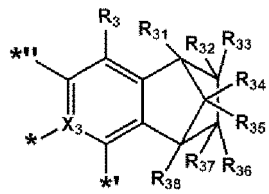
Formula A3-1(13)

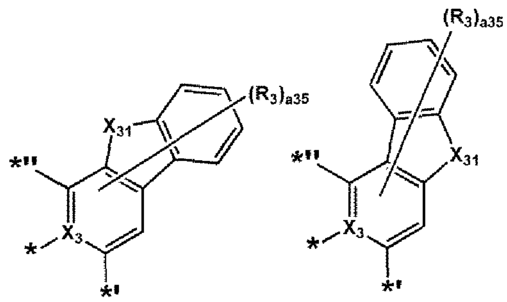
Formula A3-1(14) Formula A3-1(15)

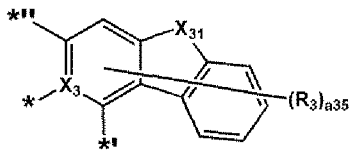
Formula A3-1(16)

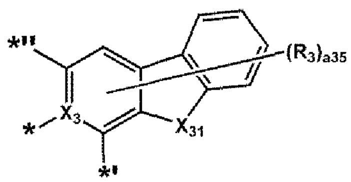
Formula A3-1(17)

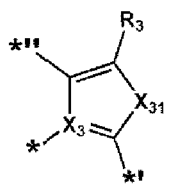
Formula A3-1(18)

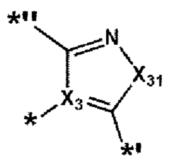
Formula A3-1(19)

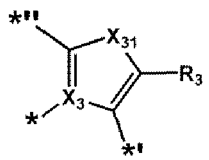
Formula A3-1(20)

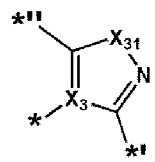
Formula A3-1(21)

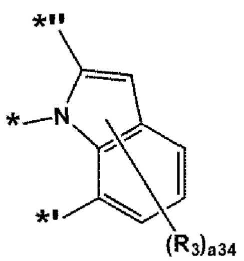
Formula A3-2(1)

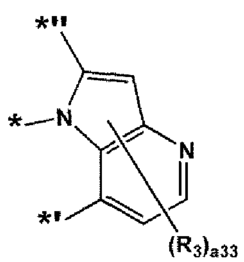
Formula A3-2(2)

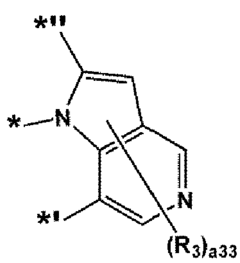
Formula A3-2(3)

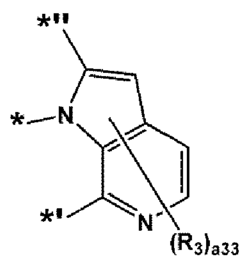
Formula A3-2(4)

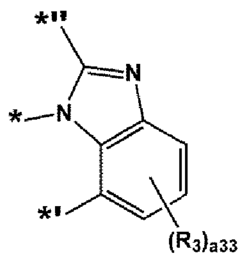
Formula A3-2(5)

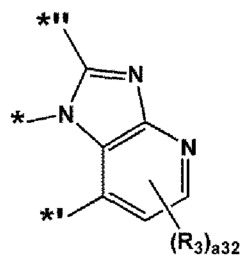
Formula A3-2(6)

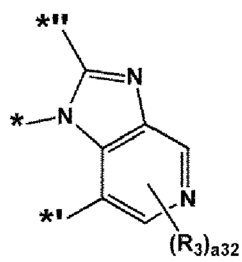
Formula A3-2(7)

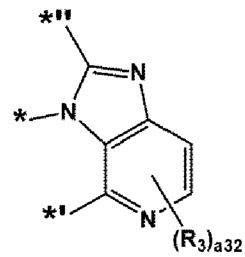
Formula A3-2(8)

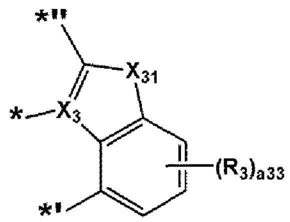
Formula A3-2(9)

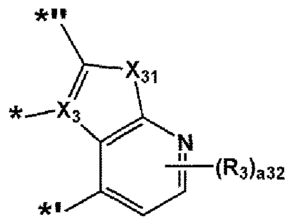
Formula A3-2(10)

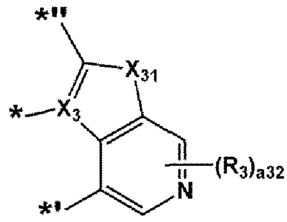
Formula A3-2(11)

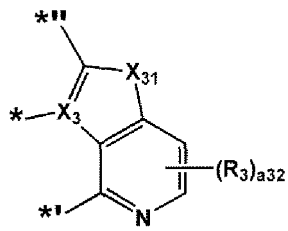
Formula A3-2(12)

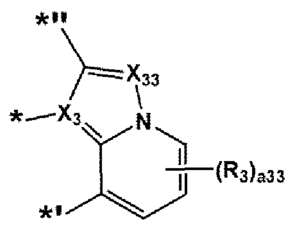
Formula A3-2(13)

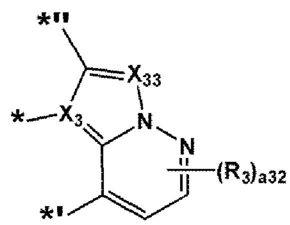
Formula A3-2(14)

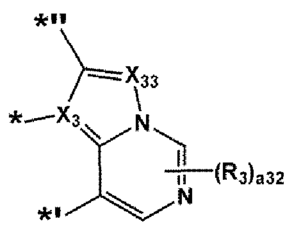
Formula A3-2(15)

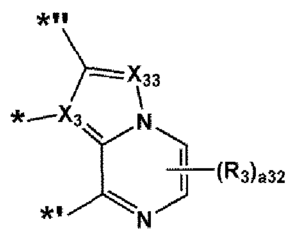
Formula A3-2(16)

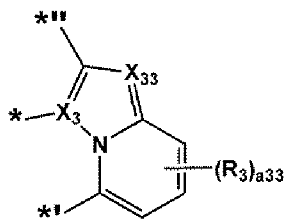
Formula A3-2(17)

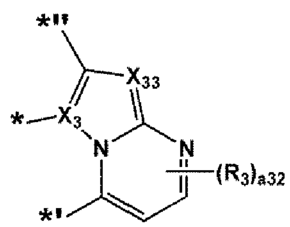
Formula A3-2(18)

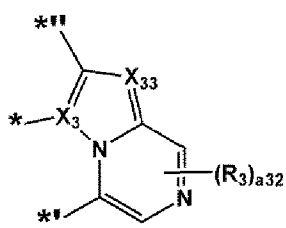
Formula A3-2(19)

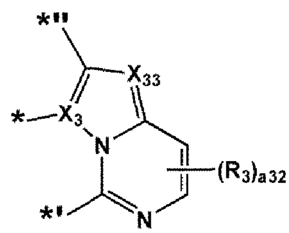
Formula A3-2(20)

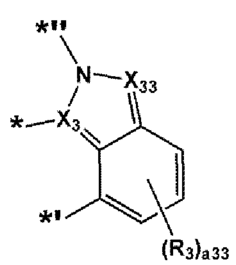
Formula A3-2(21)

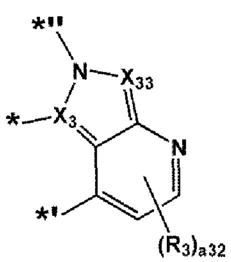
Formula A3-2(22)

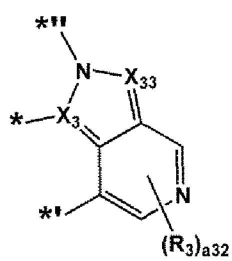
Formula A3-2(23)

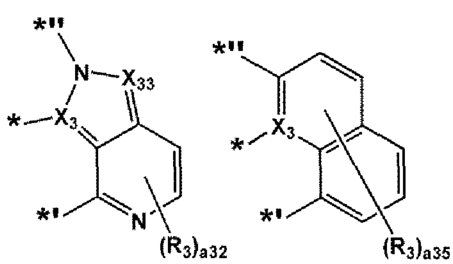
Formula A3-2(24) Formula A3-2(25)

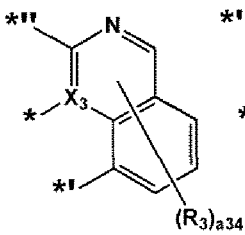
Formula A3-2(26)

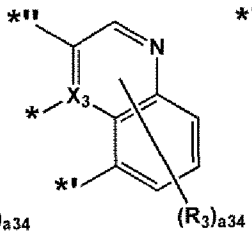
Formula A3-2(27)

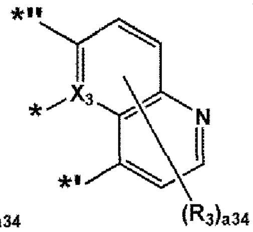
Formula A3-2(28)

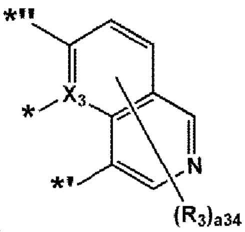
Formula A3-2(29)

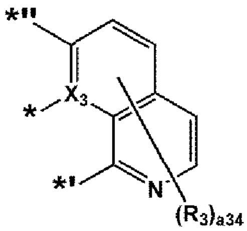
Formula A3-2(30)

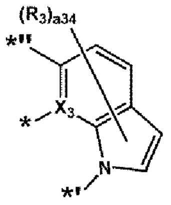
Formula A3-2(31)

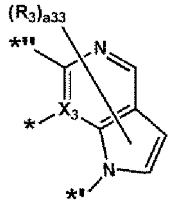
Formula A3-2(32)

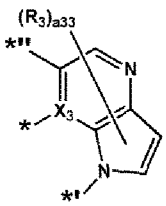
Formula A3-2(33)

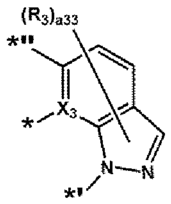
Formula A3-2(34)

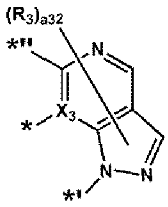
Formula A3-2(35)

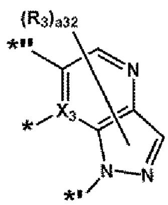
Formula A3-2(36)

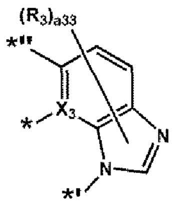
Formula A3-2(37)

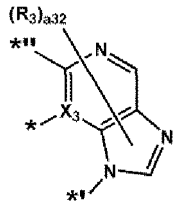
Formula A3-2(38)

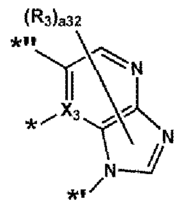
Formula A3-2(39)

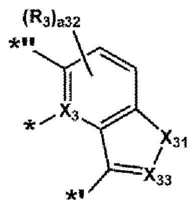
Formula A3-2(40)

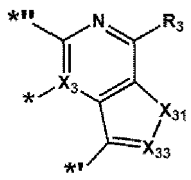
Formula A3-2(41)

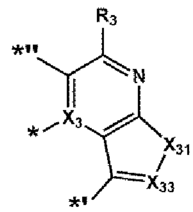
Formula A3-2(42)

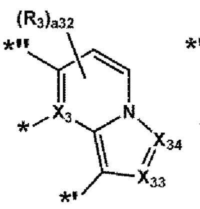
Formula A3-2(43)

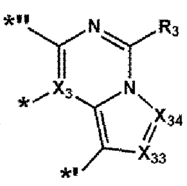
Formula A3-2(44)

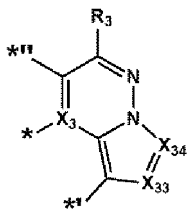
Formula A3-2(45)

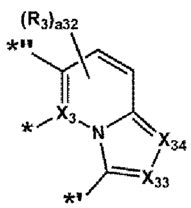
Formula A3-2(46)

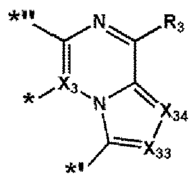
Formula A3-2(47)

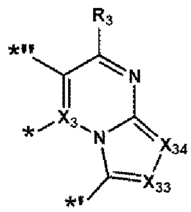
Formula A3-2(48)

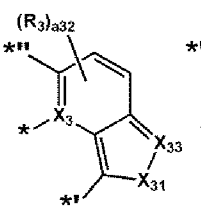
Formula A3-2(49)

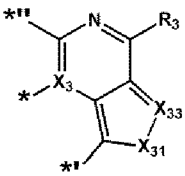
Formula A3-2(50)

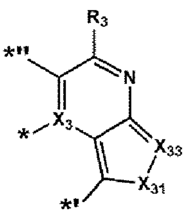
Formula A3-2(51)

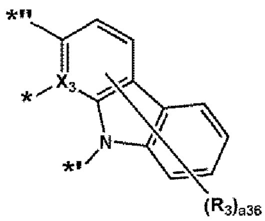
Formula A3-2(52)

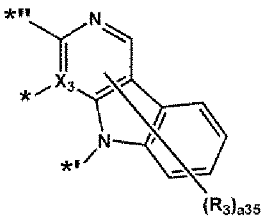
Formula A3-2(53)

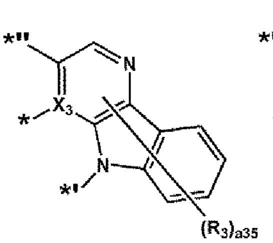
Formula A3-2(54)

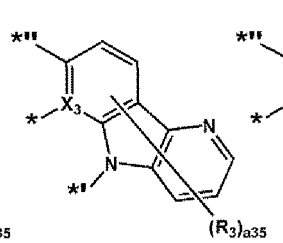
Formula A3-2(55)

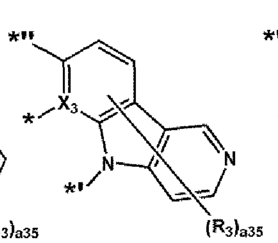
Formula A3-2(56)

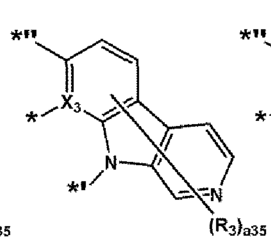
Formula A3-2(57)

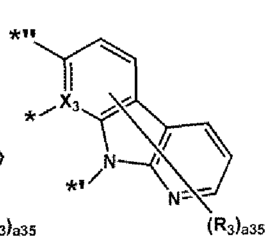
Formula A3-2(58)

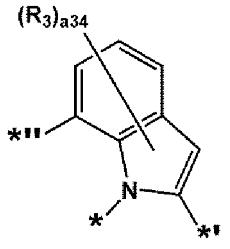

Formula A3-3(1)

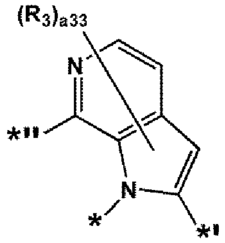

Formula A3-3(2)

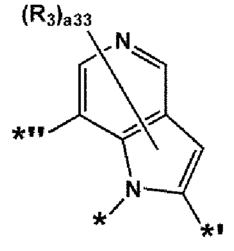

Formula A3-3(3)

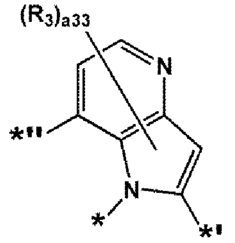

Formula A3-3(4)

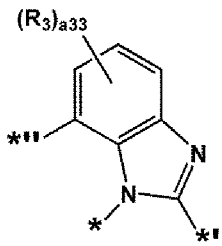

Formula A3-3(5)

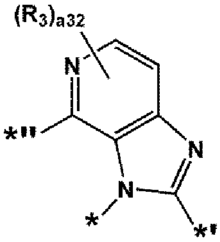

Formula A3-3(6)

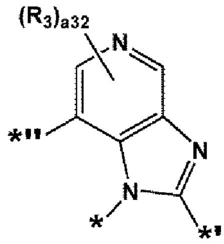

Formula A3-3(7)

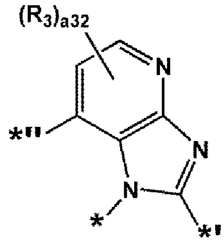

Formula A3-3(8)

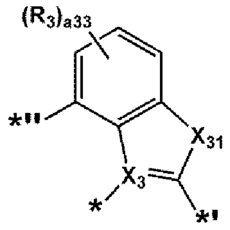

Formula A3-3(9)

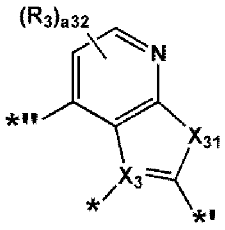

Formula A3-3(10)

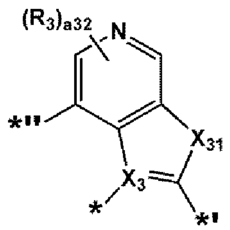

Formula A3-3(11)

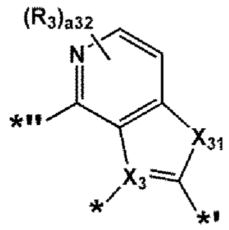

Formula A3-3(12)

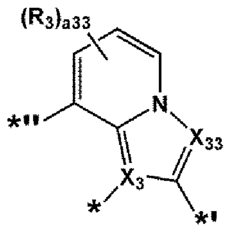

Formula A3-3(13)

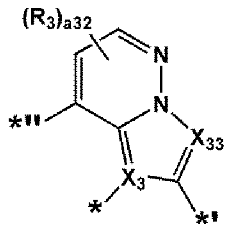

Formula A3-3(14)

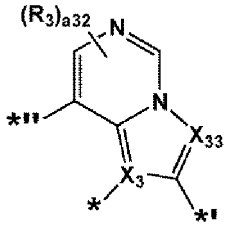

Formula A3-3(15)

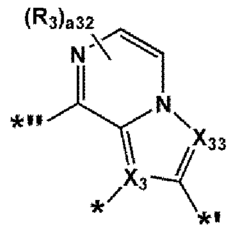

Formula A3-3(16)

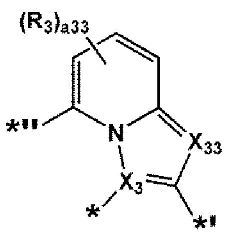

Formula A3-3(17)

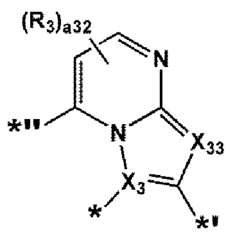

Formula A3-3(18)

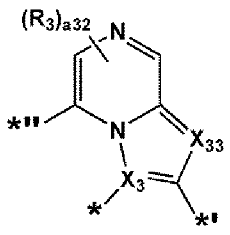

Formula A3-3(19)

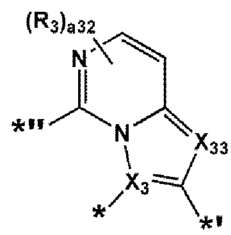

Formula A3-3(20)

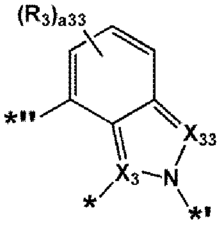
Formula A3-3(21)

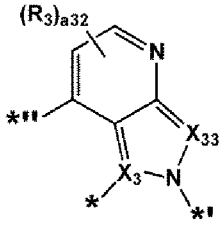
Formula A3-3(22)

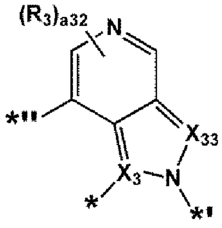
Formula A3-3(23)

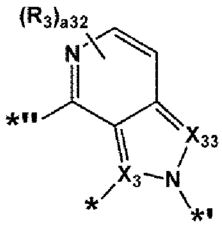
Formula A3-3(24)

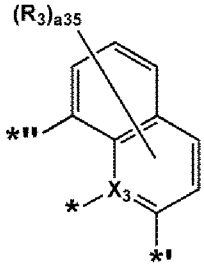
Formula A3-3(25)

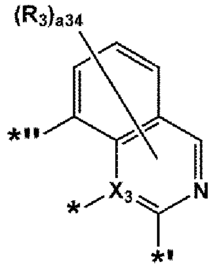
Formula A3-3(26)

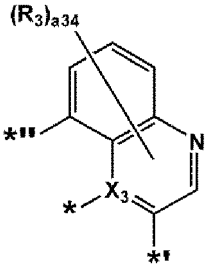
Formula A3-3(27)

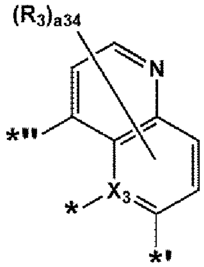
Formula A3-3(28)

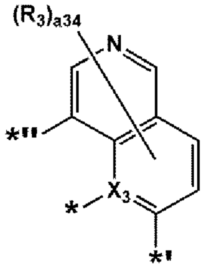
Formula A3-3(29)

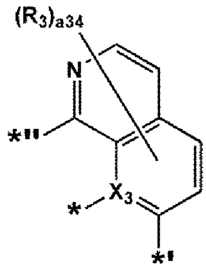
Formula A3-3(30)

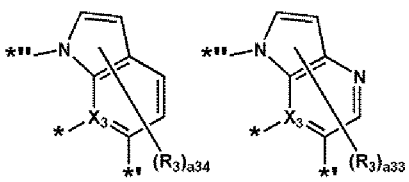
Formula A3-3(31) Formula A3-3(32)

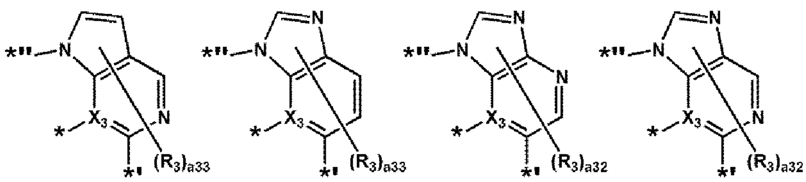
Formula A3-3(33) Formula A3-3(34) Formula A3-3(35) Formula A3-3(36)

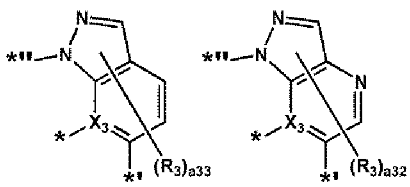
Formula A3-3(37) Formula A3-3(38)

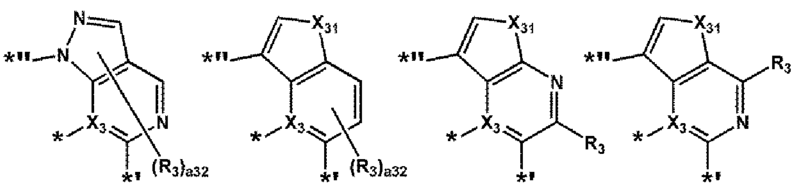
Formula A3-3(39) Formula A3-3(40) Formula A3-3(41) Formula A3-3(42)

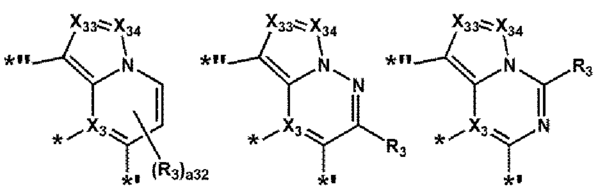
Formula A3-3(43) Formula A3-3(44) Formula A3-3(45)

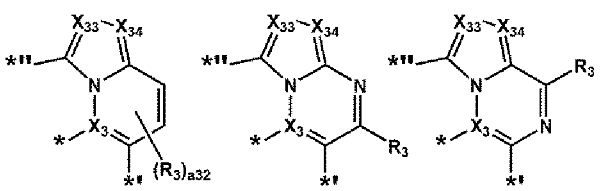
Formula A3-3(46) Formula A3-3(47) Formula A3-3(48)

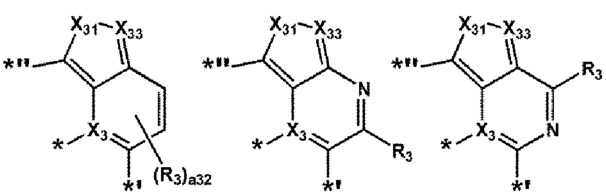
Formula A3-3(49) Formula A3-3(50) Formula A3-3(51)

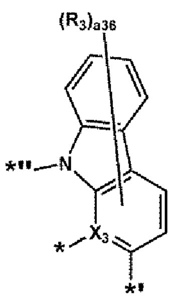
Formula A3-3(52)

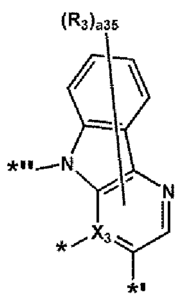
Formula A3-3(53)

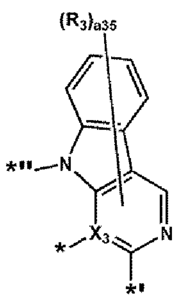
Formula A3-3(54)

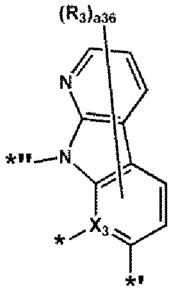 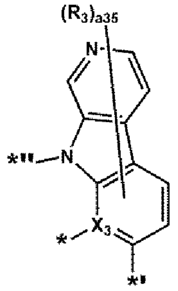 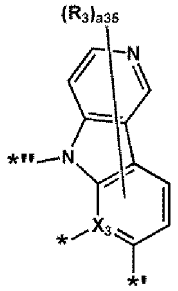 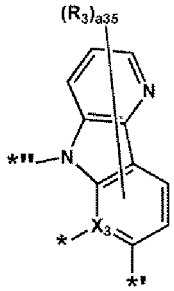

Formula A3-3(55) Formula A3-3(56) Formula A3-3(57) Formula A3-3(58)

.

In Formulae A3-1(1) to A3-1(21), A3-2(1) to A3-2(58), and A3-3(1) to A3-3(58),

$X_3$ and $R_3$ are the same as described herein,
$X_{31}$ may be O, S, $N(R_{31})$, $C(R_{31})(R_{32})$, or $Si(R_{31})(R_{32})$,
$X_{33}$ may be N or $C(R_{33})$,
$X_{34}$ may be N or $C(R_{34})$,
$R_{31}$ to $R_{38}$ may be the same as described in connection with $R_3$,
a36 may be an integer from 0 to 6,
a35 may be an integer from 0 to 5,
a34 may be an integer from 0 to 4,
a33 may be an integer from 0 to 3,
a32 may be an integer from 0 to 2, and
*, *', and *" are the same as described in connection with *, *', and *" in Formula A3-1.

In one or more embodiments, $A_4$ in Formula 1 may be represented by one of Formulae A4-1 (1) to A3-1(44) and A4-2(1) to A4-2(71):

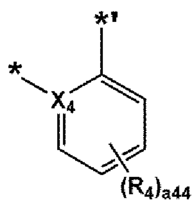 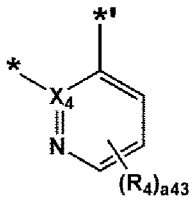 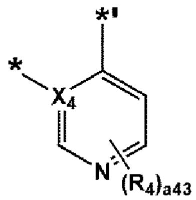 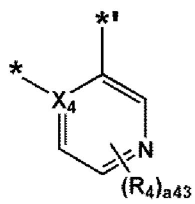

Formula A4-1(1) Formula A4-1(2) Formula A4-1(3) Formula A4-1(4)

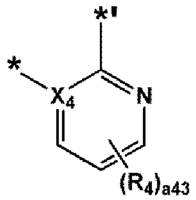 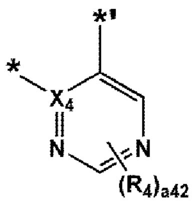 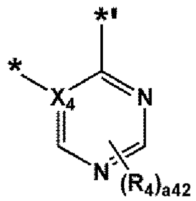 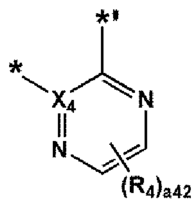

Formula A4-1(5) Formula A4-1(6) Formula A4-1(7) Formula A4-1(8)

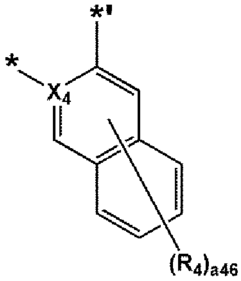
Formula A4-1(9)

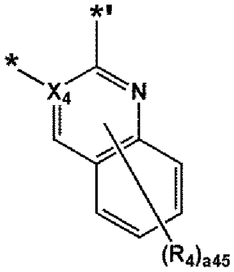
Formula A4-1(10)

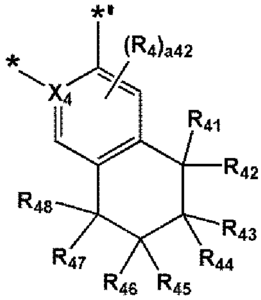
Formula A4-1(11)

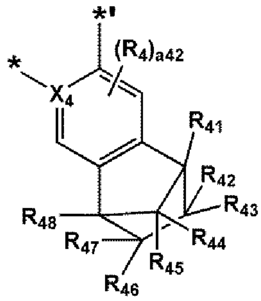
Formula A4-1(12)

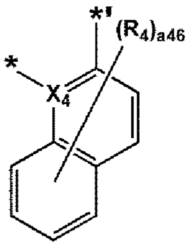
Formula A4-1(13)

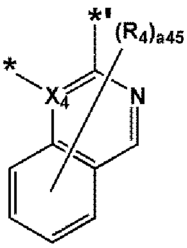
Formula A4-1(14)

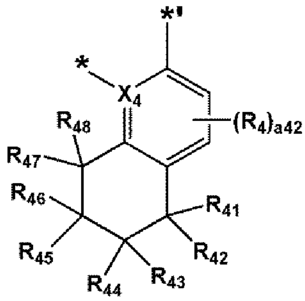
Formula A4-1(15)

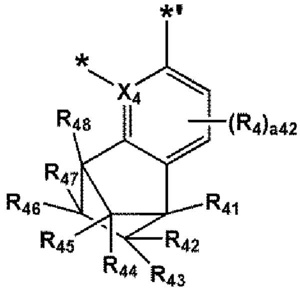
Formula A4-1(16)

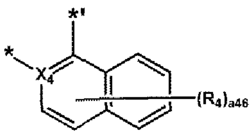
Formula A4-1(17)

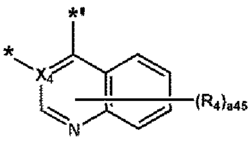
Formula A4-1(18)

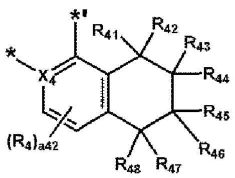
Formula A4-1(19)

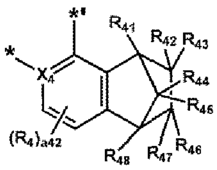
Formula A4-1(20)

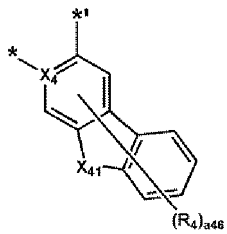
Formula A4-1(21)

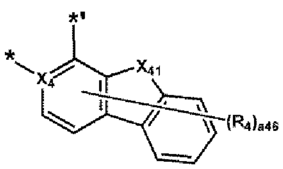
Formula A4-1(22)

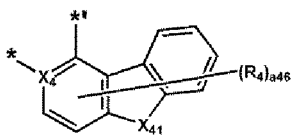
Formula A4-1(23)

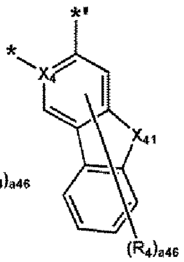
Formula A4-1(24)

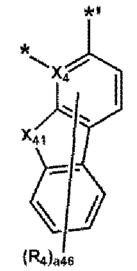
Formula A4-1(25)

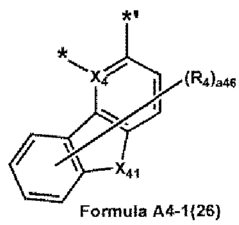
Formula A4-1(26)

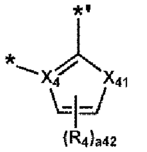
Formula A4-1(27)

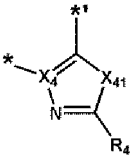
Formula A4-1(28)

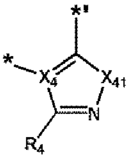
Formula A4-1(29)

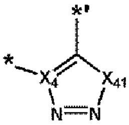
Formula A4-1(30)

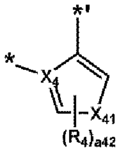
Formula A4-1(31)

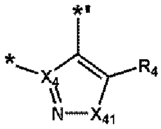
Formula A4-1(32)

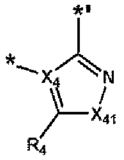
Formula A4-1(33)

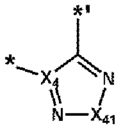
Formula A4-1(34)

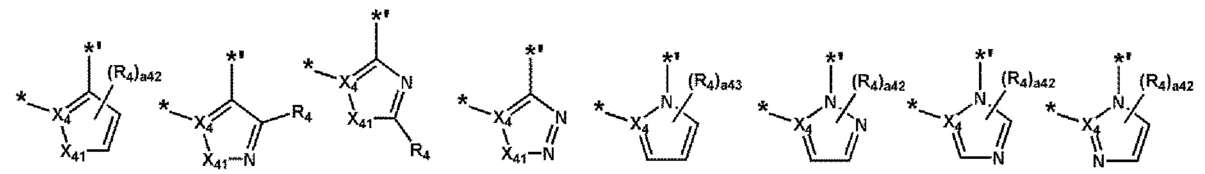

Formula A4-1(35) Formula A4-1(36) Formula A4-1(37) Formula A4-1(38) Formula A4-1(39) Formula A4-1(40) Formula A4-1(41) Formula A4-1(42)

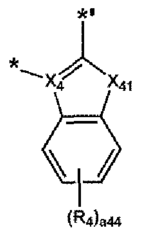

Formula A4-1(43)

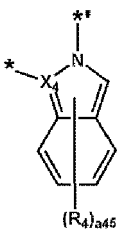

Formula A4-1(44)

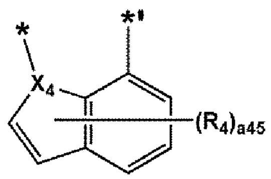

Formula A4-2(1)

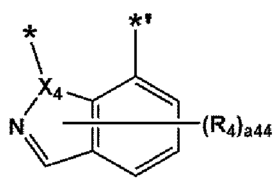

Formula A4-2(2)

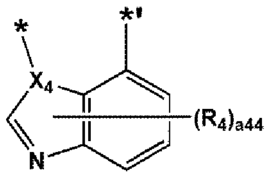

Formula A4-2(3)

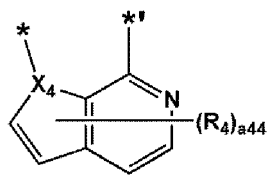

Formula A4-2(4)

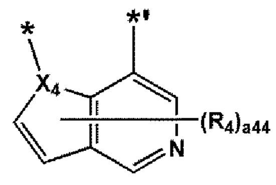

Formula A4-2(5)

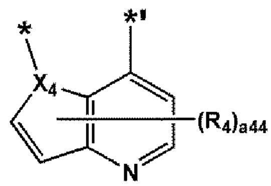

Formula A4-2(6)

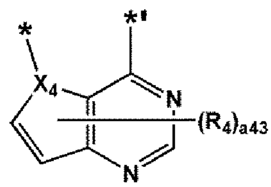

Formula A4-2(7)

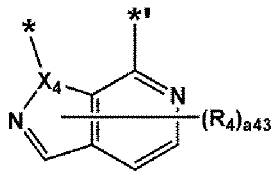

Formula A4-2(8)

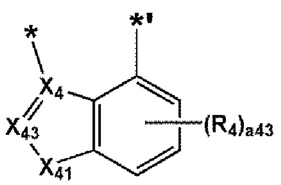

Formula A4-2(9)

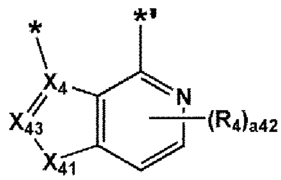

Formula A4-2(10)

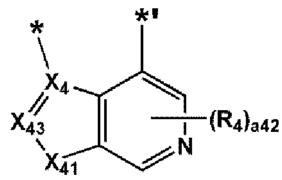

Formula A4-2(11)

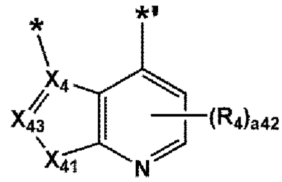

Formula A4-2(12)

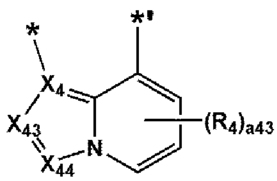

Formula A4-2(13)

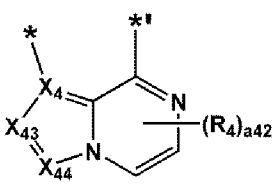

Formula A4-2(14)

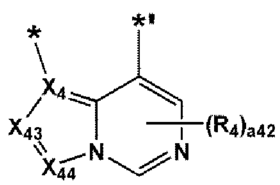

Formula A4-2(15)

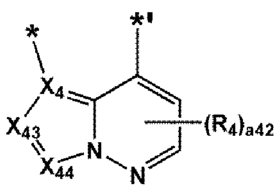

Formula A4-2(16)

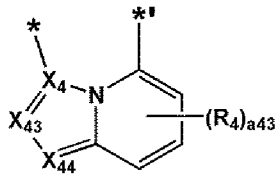

Formula A4-2(17)

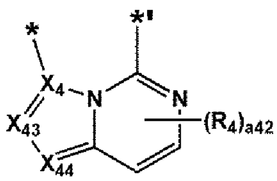

Formula A4-2(18)

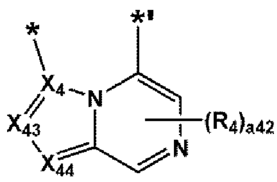

Formula A4-2(19)

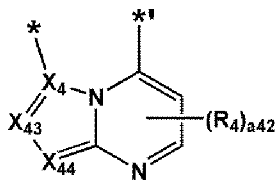

Formula A4-2(20)

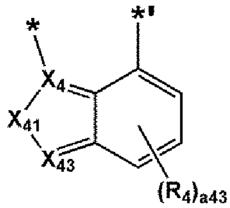

Formula A4-2(21)

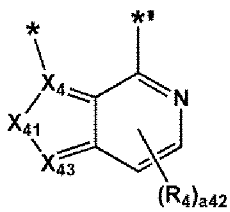

Formula A4-2(22)

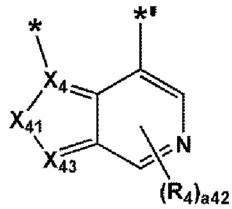

Formula A4-2(23)

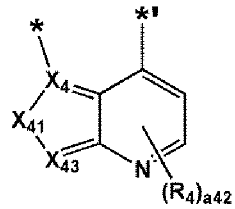

Formula A4-2(24)

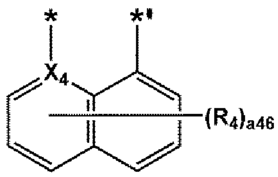

Formula A4-2(25)

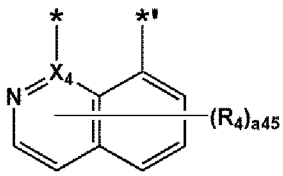

Formula A4-2(26)

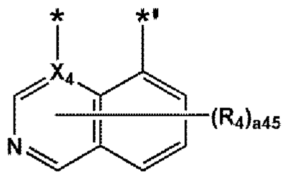

Formula A4-2(27)

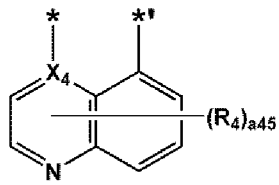

Formula A4-2(28)

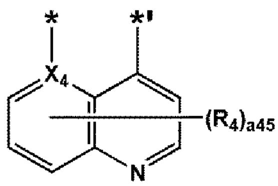

Formula A4-2(29)

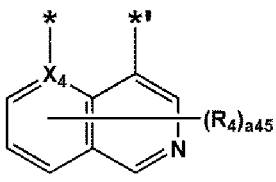

Formula A4-2(30)

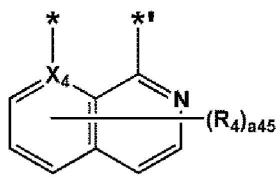

Formula A4-2(31)

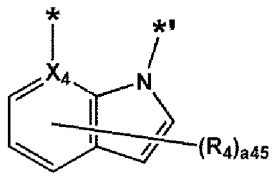

Formula A4-2(32)

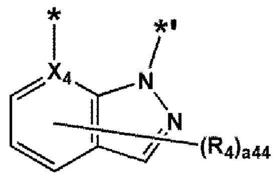

Formula A4-2(33)

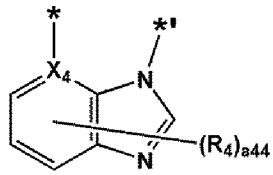

Formula A4-2(34)

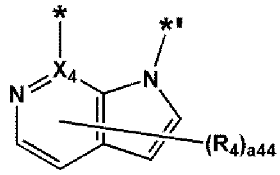

Formula A4-2(35)

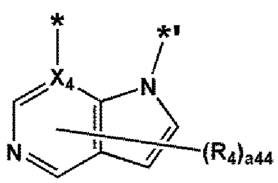

Formula A4-2(36)

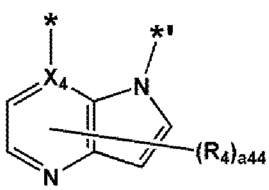

Formula A4-2(37)

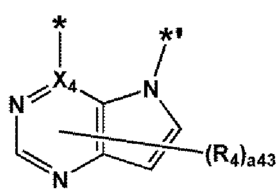

Formula A4-2(38)

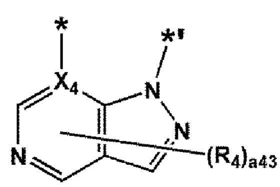

Formula A4-2(39)

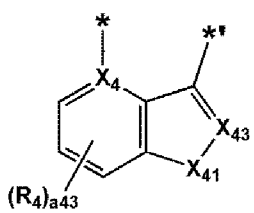
Formula A4-2(40)

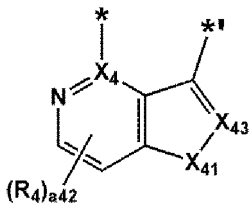
Formula A4-2(41)

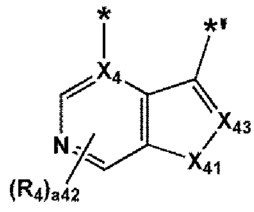
Formula A4-2(42)

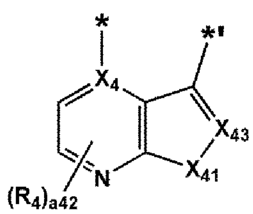
Formula A4-2(43)

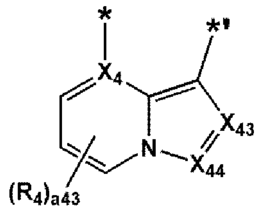
Formula A4-2(44)

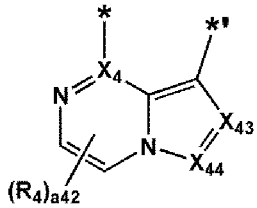
Formula A4-2(45)

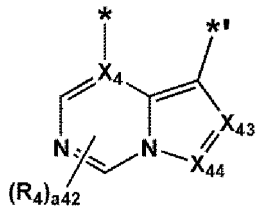
Formula A4-2(46)

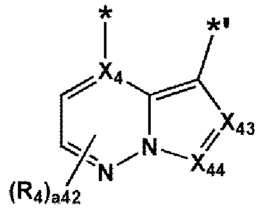
Formula A4-2(47)

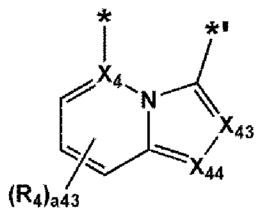
Formula A4-2(48)

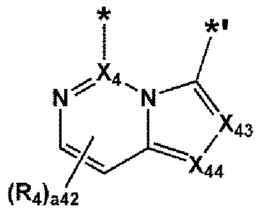
Formula A4-2(49)

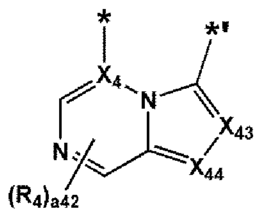
Formula A4-2(50)

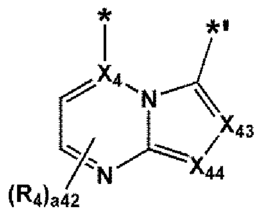
Formula A4-2(51)

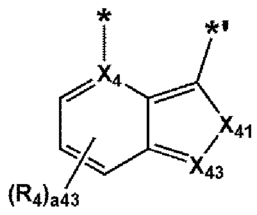
Formula A4-2(52)

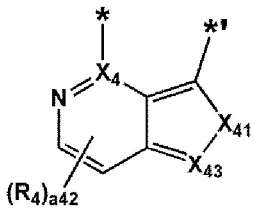
Formula A4-2(53)

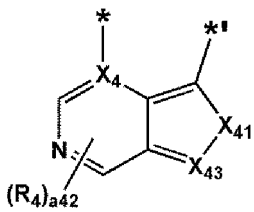
Formula A4-2(54)

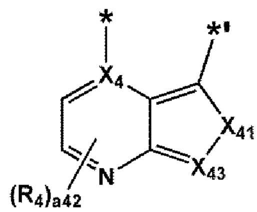
Formula A4-2(55)

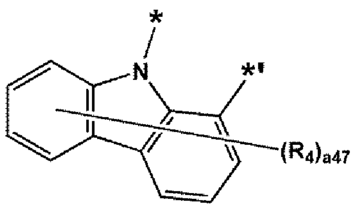
Formula A4-2(56)

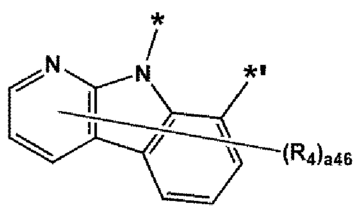
Formula A4-2(57)

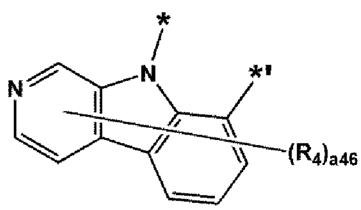
Formula A4-2(58)

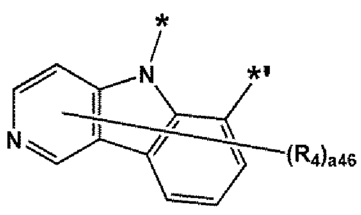
Formula A4-2(59)

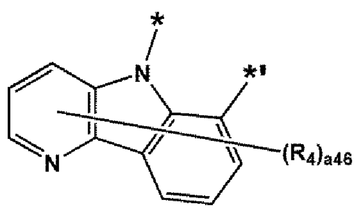
Formula A4-2(60)

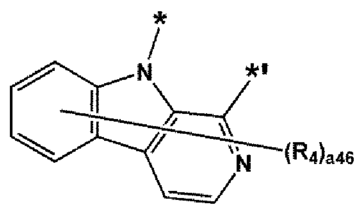
Formula A4-2(61)

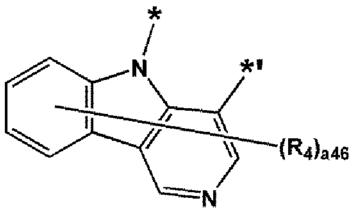

Formula A4-2(62)

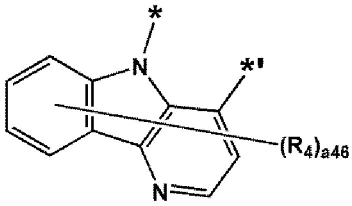

Formula A4-2(63)

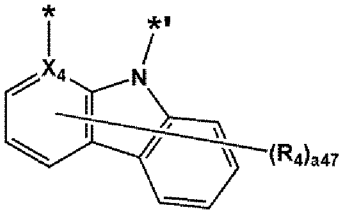

Formula A4-2(64)

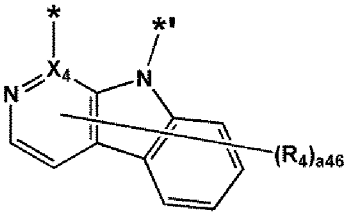

Formula A4-2(65)

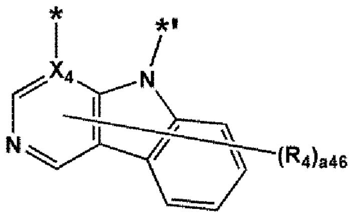

Formula A4-2(66)

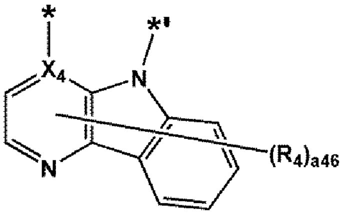

Formula A4-2(67)

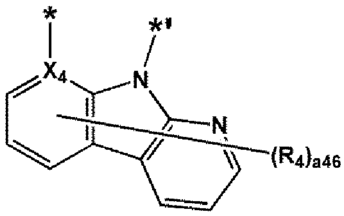

Formula A4-2(68)

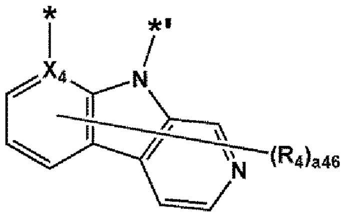

Formula A4-2(69)

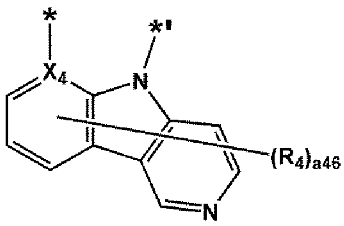

Formula A4-2(70)

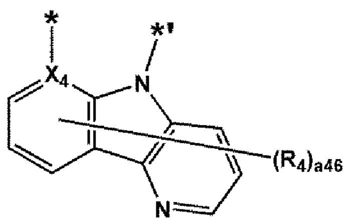

Formula A4-2(71)

.

In Formulae A4-1 (1) to A4-1(44) and A4-2(1) to A4-2(71),

$X_4$, $R_4$, *, and *' are the same as described herein,
$X_{41}$ may be O, S, $N(R_{41})$, $C(R_{41})(R_{42})$, or $Si(R_{41})(R_{42})$,
$X_{43}$ may be N or $C(R_{43})$,
$X_{44}$ may be N or $C(R_{44})$,
$R_{41}$ to $R_{48}$ are the same as described in connection with $R_4$,
a47 may be an integer from 0 to 7,
a46 may be an integer from 0 to 6,
a45 may be an integer from 0 to 5,
a44 may be an integer from 0 to 4,
a43 may be an integer from 0 to 3, and
a42 may be an integer from 0 to 2.

In one or more embodiments, $A_2$ in Formula 1 may be represented by Formula A2-2 (for example, one of Formulae A2-2(1) to A2-2(58)).

$A_1$ may be represented by one of Formulae A1-1-1 to A1-1-10 and A1-2-1 to A1-2-4,

$A_2$ may be represented by one of Formulae A2-2-1 to A2-2-4,
$A_3$ may be represented by one of Formulae A3-1-1 to A3-1-10, and/or
$A_4$ may be represented by one of Formulae A4-1-1 to A4-1-14, but embodiments of the present disclosure are not limited thereto:

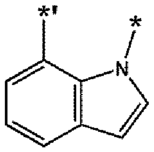
Formula A1-1-1

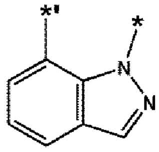
Formula A1-1-2

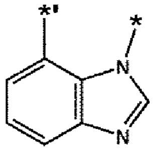
Formula A1-1-3

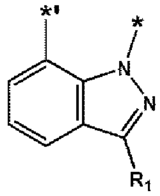
Formula A1-1-4

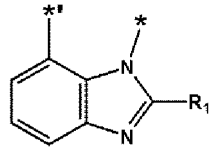
Formula A1-1-5

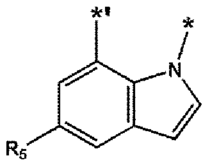
Formula A1-1-6

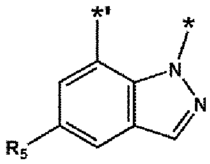
Formula A1-1-7

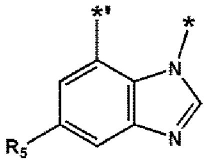
Formula A1-1-8

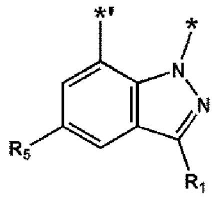
Formula A1-1-9

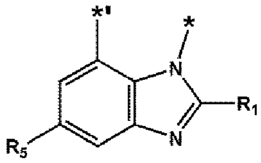
Formula A1-1-10

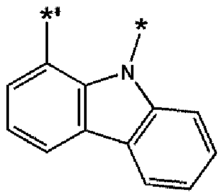
Formula A1-2-1

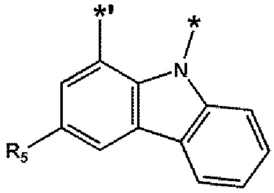
Formula A1-2-2

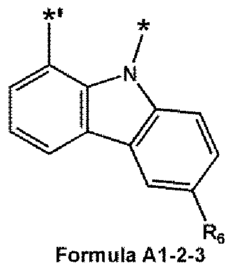
Formula A1-2-3

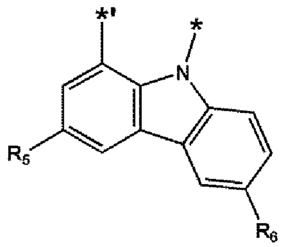
Formula A1-2-4

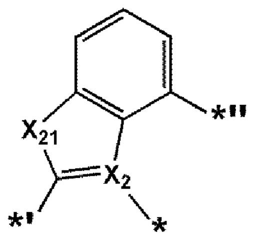
Formula A2-2-1

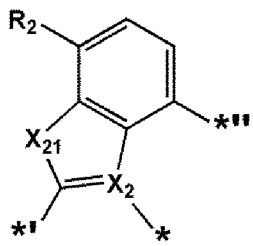
Formula A2-2-2

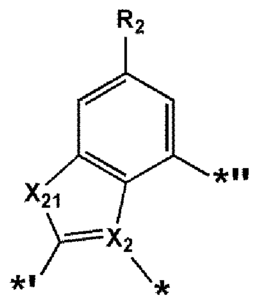
Formula A2-2-3

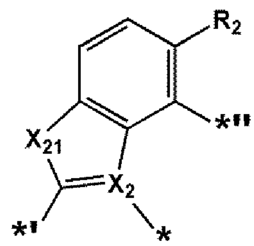
Formula A2-2-4

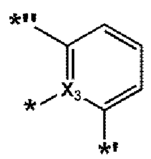
Formula A3-1-1

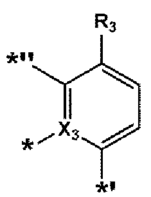
Formula A3-1-2

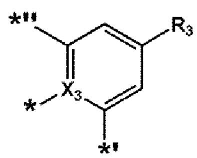
Formula A3-1-3

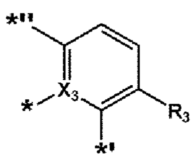
Formula A3-1-4

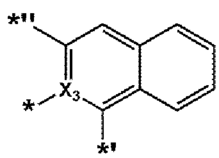
Formula A3-1-5

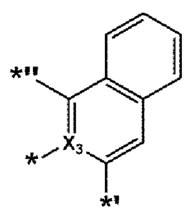
Formula A3-1-6

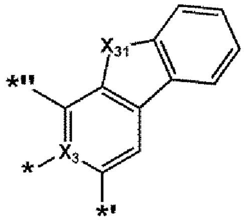
Formula A3-1-7
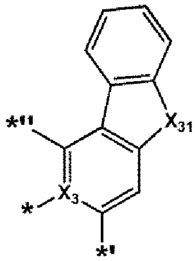
Formula A3-1-8
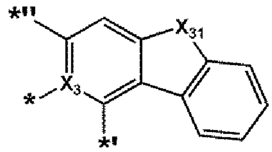
Formula A3-1-9
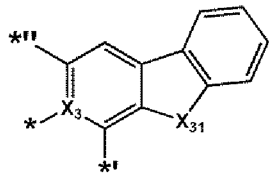
Formula A3-1-10

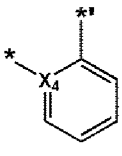
Formula A4-1-1
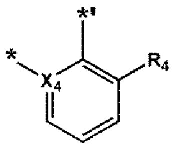
Formula A4-1-2
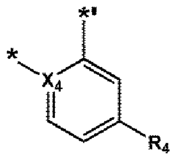
Formula A4-1-3
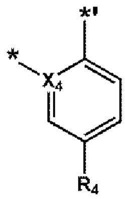
Formula A4-1-4
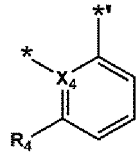
Formula A4-1-5
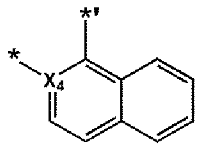
Formula A4-1-6

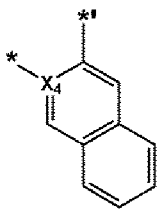
Formula A4-1-7
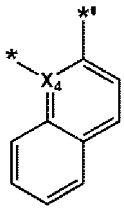
Formula A4-1-8
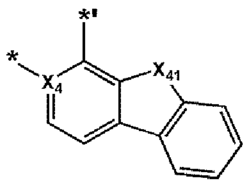
Formula A4-1-9
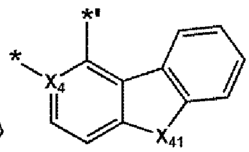
Formula A4-1-10
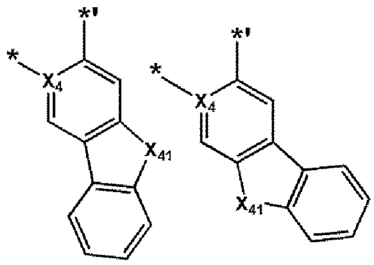
Formula A4-1-11 Formula A4-1-12

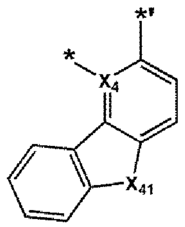
Formula A4-1-13
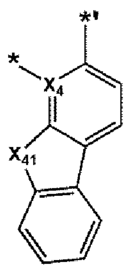
Formula A4-1-14

In Formulae A1-1-1 to A1-1-10, A1-2-1 to A1-2-4, A2-2-1 to A2-2-4, A3-1-1 to A3-1-10, and A4-1-1 to A4-1-14,

$X_1$ to $X_4$ and $R_1$ to $R_6$ are the same as described herein, provided that $R_1$ to $R_6$ are not hydrogen,

$X_{21}$ may be O, S, $N(R_{21})$, $C(R_{21})(R_{22})$, or $Si(R_{21})(R_{22})$, and $R_{21}$ and $R_{22}$ are the same as described in connection with $R_2$,

$X_{31}$ may be O, S, $N(R_{31})$, $C(R_{31})(R_{32})$, or $Si(R_{31})(R_{32})$, and $R_{31}$ and $R_{32}$ are the same as described in connection with $R_3$,

$X_{41}$ may be O, S, $N(R_{41})$, $C(R_{41})(R_{42})$, or $Si(R_{41})(R_{42})$, and $R_{41}$ and $R_{42}$ are the same as described in connection with $R_4$,

in Formulae A1-1-1 to A1-1-10 and A1-2-1 to A1-2-4, * indicates a binding site to M in Formula 1, and *' indicates a binding site to $T_1$ in Formula 1,

in Formulae A2-2-1 to A2-2-4, * indicates a binding site to M in Formula 1, *' indicates a binding site to $T_1$ in Formula 1, and *" indicates a binding site to $T_2$ in Formula 1,

in Formulae A3-1-1 to A3-1-10, * indicates a binding site to M in Formula 1, *" indicates a binding site to $T_2$ in Formula 1, and *' indicates a binding site to $T_3$ in Formula 1, and

in Formulae A4-1-1 to A4-1-14, * indicates a binding site to M in Formula 1, and *' indicates a binding site to $T_3$ in Formula 1.

In Formula 1, i) two of a plurality of neighboring groups $R_2$ are optionally linked to form a substituted or unsubstituted $C_5$-$C_{30}$ carbocyclic group or a substituted or unsubstituted $C_1$-$C_{30}$ heterocyclic group, ii) two of a plurality of neighboring groups $R_3$ are optionally linked to form a substituted or unsubstituted $C_5$-$C_{30}$ carbocyclic group or a substituted or unsubstituted $C_1$-$C_{30}$ heterocyclic group, iii) two of a plurality of neighboring groups $R_4$ are optionally linked to form a substituted or unsubstituted $C_5$-$C_{30}$ carbocyclic group or a substituted or unsubstituted $C_1$-$C_{30}$ heterocyclic group, iv) two of a plurality of neighboring groups $R_5$ are optionally linked to form a substituted or unsubstituted $C_5$-$C_{30}$ carbocyclic group or a substituted or unsubstituted $C_1$-$C_{30}$ heterocyclic group, v) two of a plurality of neighboring groups $R_6$ are optionally linked to form a substituted or unsubstituted $C_5$-$C_{30}$ carbocyclic group or a substituted or unsubstituted $C_1$-$C_{30}$ heterocyclic group, and vi) two or more neighboring groups selected from $R_2$ to $R_5$ are optionally linked to form a substituted or unsubstituted $C_5$-$C_{30}$ carbocyclic group or a substituted or unsubstituted $C_1$-$C_{30}$ heterocyclic group.

For example, i) a substituted or unsubstituted $C_5$-$C_{30}$ carbocyclic group or a substituted or unsubstituted $C_1$-$C_{30}$ heterocyclic group, formed by optionally linking two of a plurality of neighboring groups $R_2$, ii) a substituted or unsubstituted $C_5$-$C_{30}$ carbocyclic group or a substituted or unsubstituted $C_1$-$C_{30}$ heterocyclic group, formed by optionally linking two of a plurality of neighboring groups $R_3$, iii) a substituted or unsubstituted $C_5$-$C_{30}$ carbocyclic group or a substituted or unsubstituted $C_1$-$C_{30}$ heterocyclic group, formed by optionally linking two of a plurality of neighboring groups $R_4$, iv) a substituted or unsubstituted $C_5$-$C_{30}$ carbocyclic group or a substituted or unsubstituted $C_1$-$C_{30}$ heterocyclic group, formed by optionally linking two of a plurality of neighboring groups $R_5$, v) a substituted or unsubstituted $C_5$-$C_{30}$ carbocyclic group or a substituted or unsubstituted $C_1$-$C_{30}$ heterocyclic group, formed by optionally linking two of a plurality of neighboring groups $R_6$, and vi) a substituted or unsubstituted $C_5$-$C_{30}$ carbocyclic group or a substituted or unsubstituted $C_1$-$C_{30}$ heterocyclic group, formed by optionally linking two neighboring groups selected from $R_2$ to $R_5$ in Formula 1 may each independently be selected from:

a cyclopentadiene group, a cyclohexane group, a cycloheptane group, an adamantane group, a bicycloheptane group, a bicyclo-octane group, a benzene group, a pyridine group, a pyrimidine group, a pyrazine group, a pyridazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group; and

a cyclopentadiene group, a cyclohexane group, a cycloheptane group, an adamantane group, a bicycloheptane group, a bicyclo-octane group, a benzene group, a pyridine group, a pyrimidine group, a pyrazine group, a pyridazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group, each substituted with at least one $R_{10a}$, and

$R_{10a}$ is the same as described in connection with $R_1$.

"An azabenzothiophene group, an azabenzofuran group, an azaindene group, an azaindole group, an azabenzosilole group, an azadibenzothiophene group, an azadibenzofuran group, an azafluorene group, an azacarbazole group, and an azadibenzosilole group" as used herein mean hetero-rings that respectively have the same backbones as "a benzothiophene group, a benzofuran group, an indene group, an indole group, a benzosilole group, a dibenzothiophene group, a dibenzofuran group, a fluorene group, a carbazole group, and a dibenzosilole group", provided that at least one of carbons forming rings thereof is substituted with nitrogen.

$A_1$ and $A_4$ in Formula 1 are not linked to each other. That is, the organometallic compound represented by Formula 1 may have three cyclometallated rings sharing M with one another.

i) When $A_1$ in Formula 1 is a moiety represented by Formula A1-1, the organometallic compound represented by Formula 1 satisfies "Condition 1" below, and ii) when $A_1$ in Formula 1 is a moiety represented by Formula A1-2, the organometallic compound represented by Formula 1 satisfies at least one of "Condition 1" to "Condition 3" below:

"Condition 1"
$A_2$ in Formula 1 is represented by Formula A2-2 or A2-3,
"Condition 2"
$A_3$ in Formula 1 is represented by Formula A3-2 or A3-3, and
"Condition 3"
$A_4$ in Formula 1 is represented by Formula A4-2.

In an embodiment, the organometallic compound satisfies "Condition 1".

The organometallic compound represented by Formula 1 may be selected from Compounds 1 to 273, but embodiments of the present disclosure are not limited thereto:

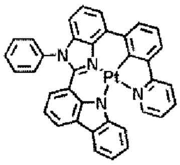
1
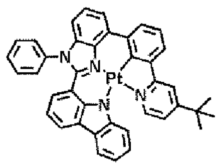
2
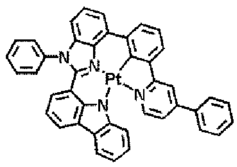
3
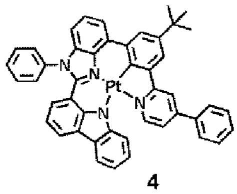
4
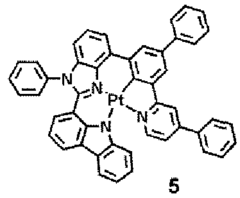
5
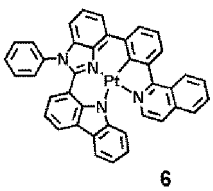
6
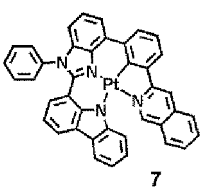
7
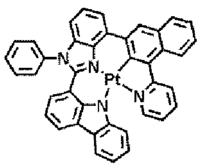
8
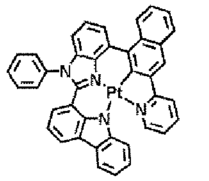
9
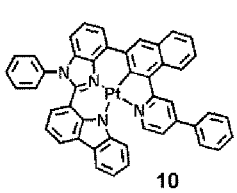
10
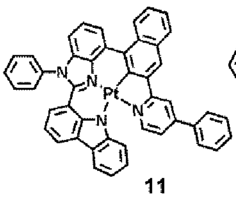
11
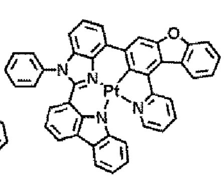
12
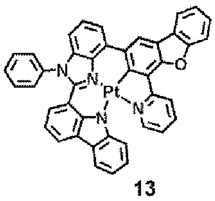
13
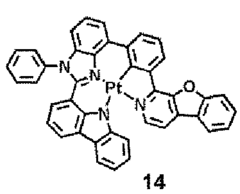
14
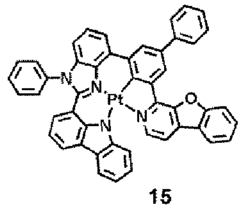
15
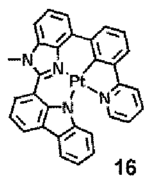
16
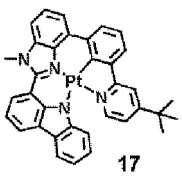
17
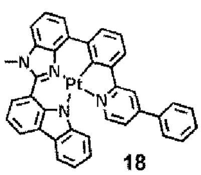
18
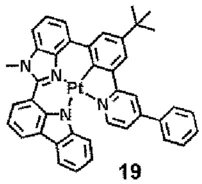
19
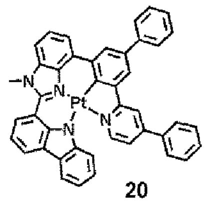
20
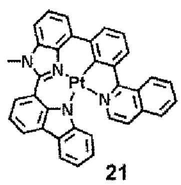
21
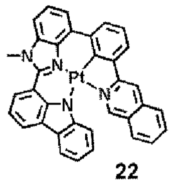
22
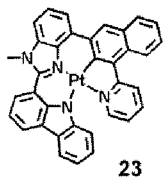
23
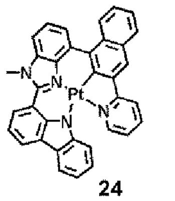
24
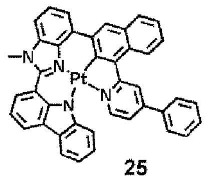
25
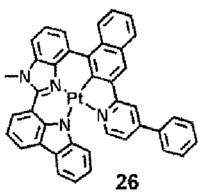
26
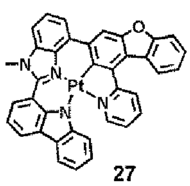
27
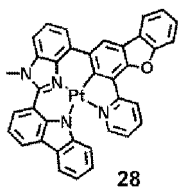
28
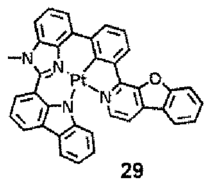
29
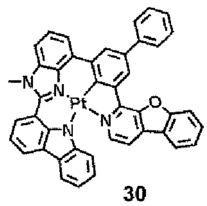
30

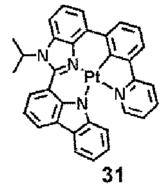
31

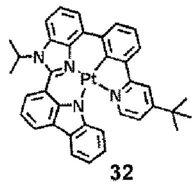
32

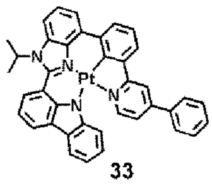
33

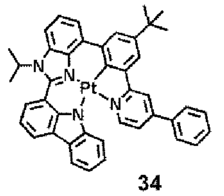
34

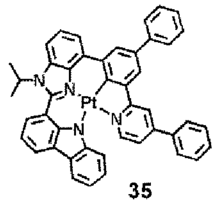
35

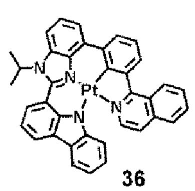
36

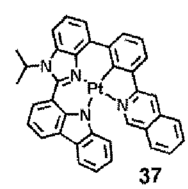
37

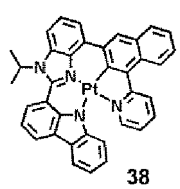
38

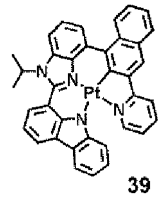
39

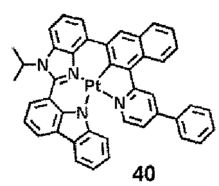
40

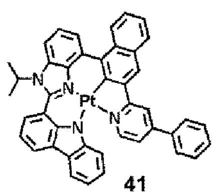
41

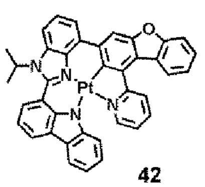
42

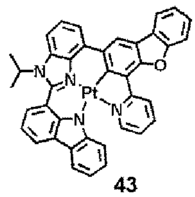
43

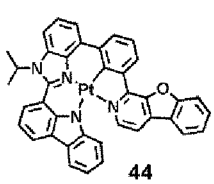
44

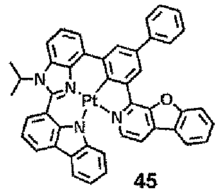
45

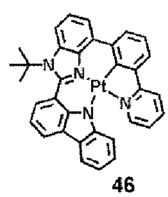
46

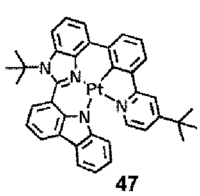
47

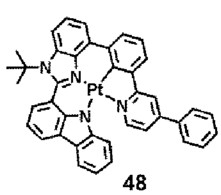
48

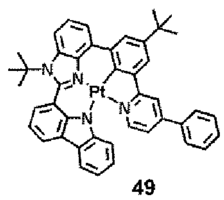
49

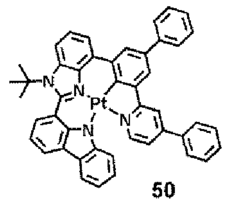
50

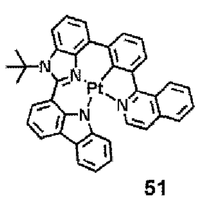
51

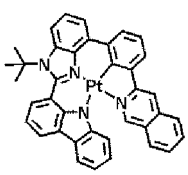
52

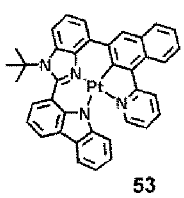
53

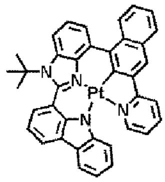
54

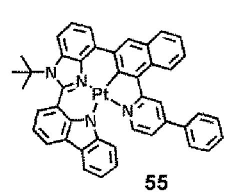
55

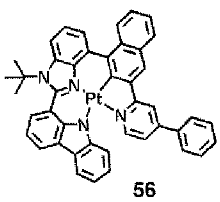
56

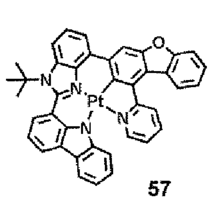
57

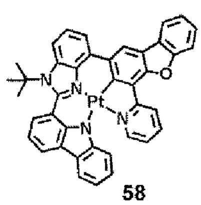
58

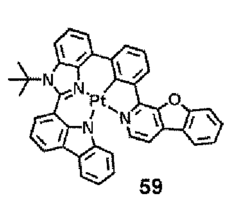
59

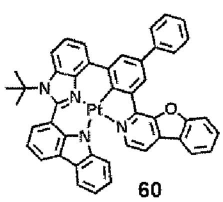
60

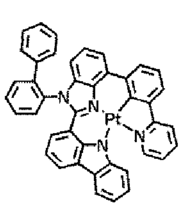
61

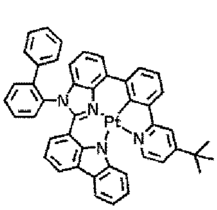
62

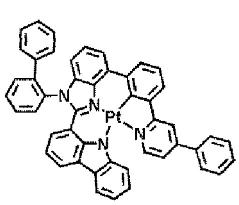
63

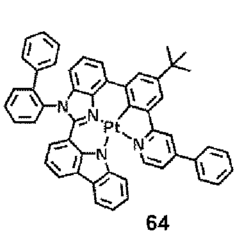
64

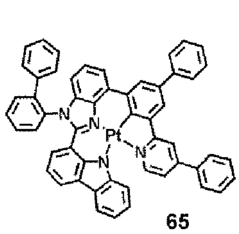
65

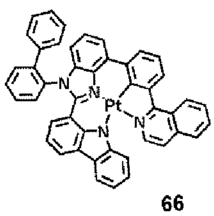
66

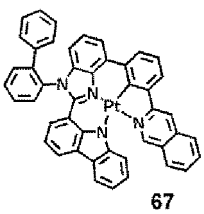
67

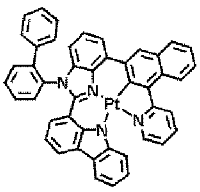
68

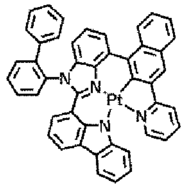
69

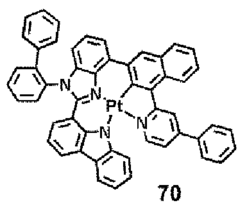
70

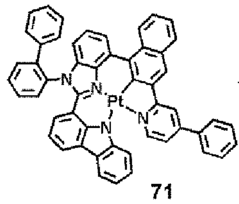
71

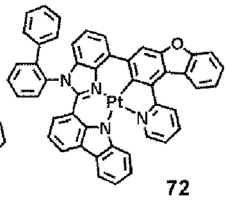
72

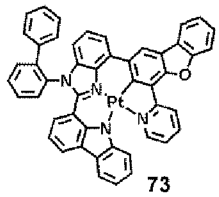
73

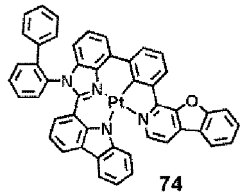
74

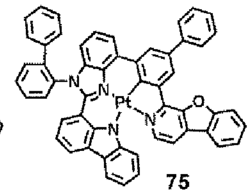
75

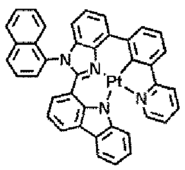
76

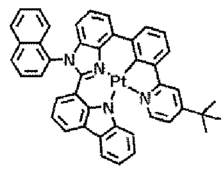
77

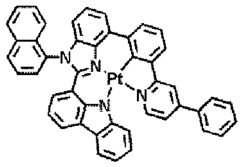
78

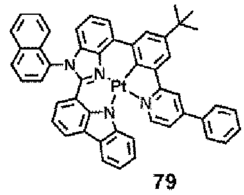
79

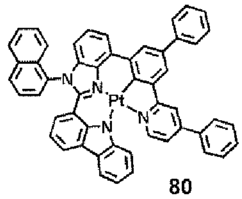
80

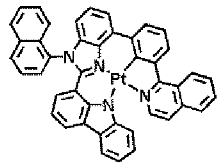
81

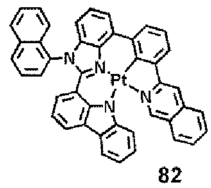
82

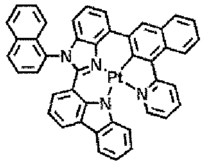
83

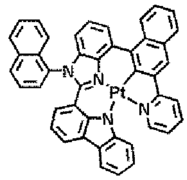
84

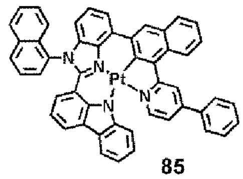
85

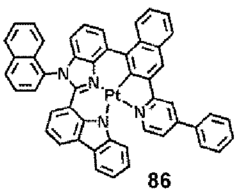
86

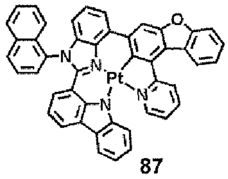
87

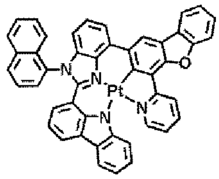
88

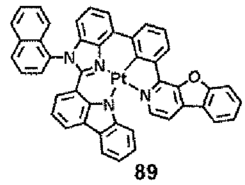
89

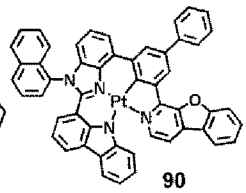
90

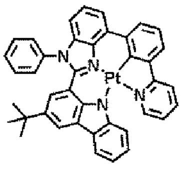
91

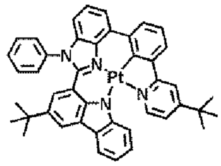
92

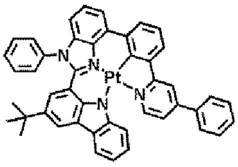
93

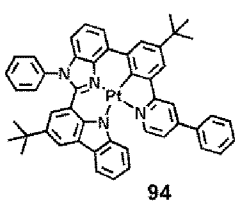
94

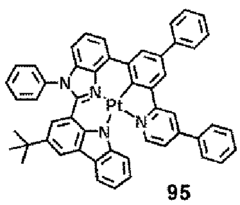
95

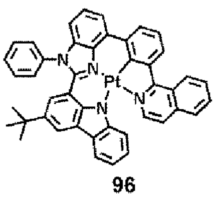
96

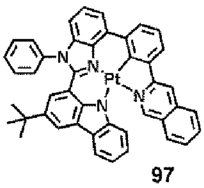
97

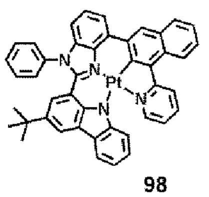
98

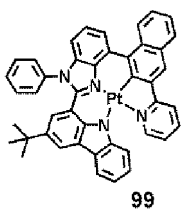
99

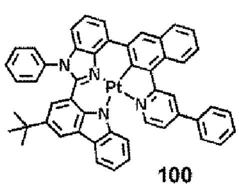
100

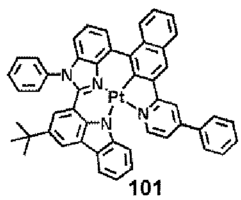
101

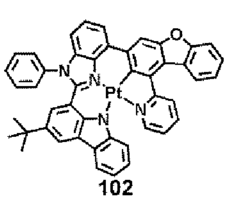
102

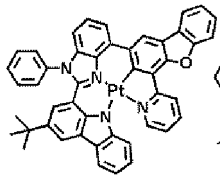
103

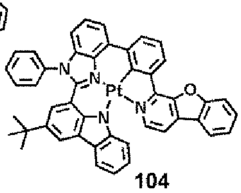
104

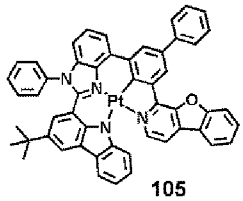
105

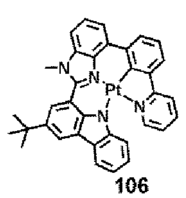
106

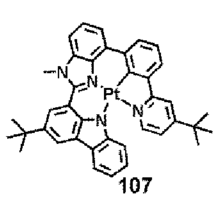
107

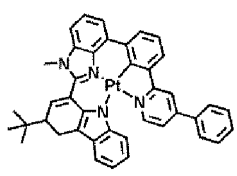
108

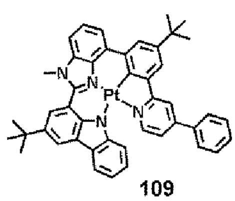
109

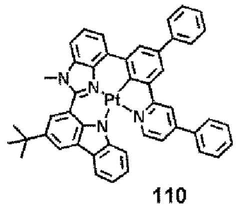
110

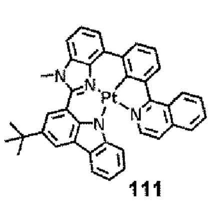
111

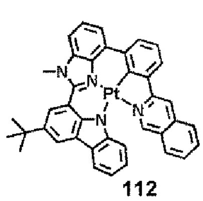
112

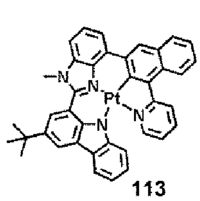
113

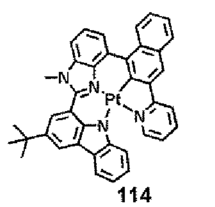
114

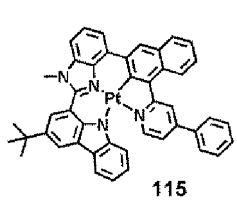
115

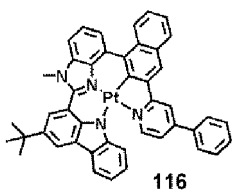
116

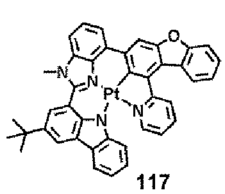
117

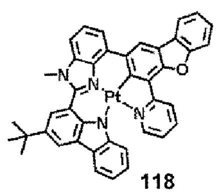
118

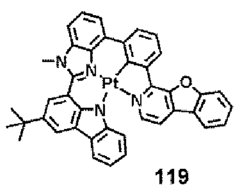
119

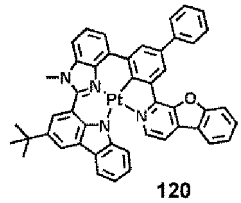
120

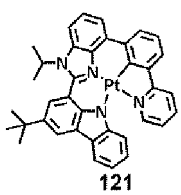
121

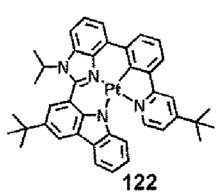
122

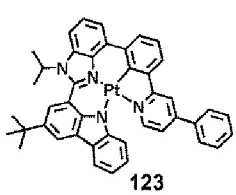
123

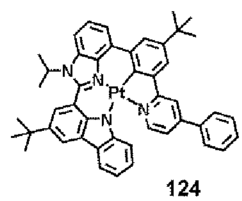
124

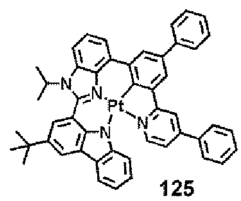
125

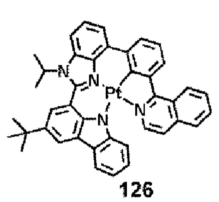
126

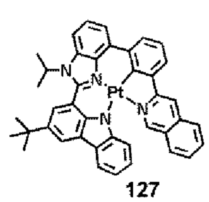
127

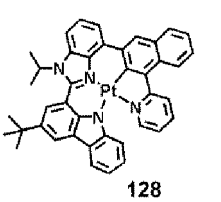
128

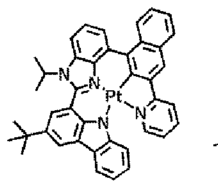
129

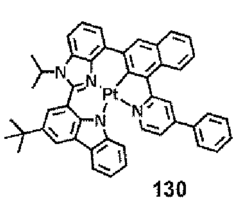
130

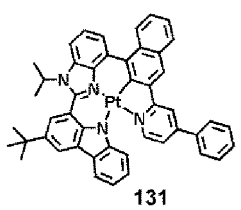
131

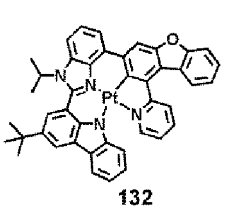
132

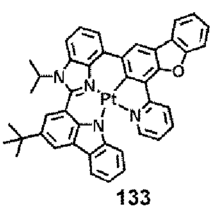
133

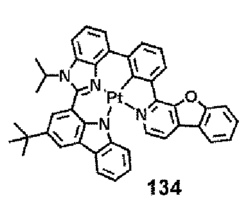
134

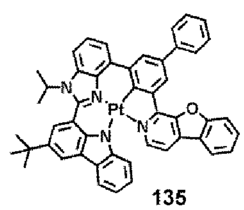
135

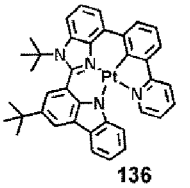
136
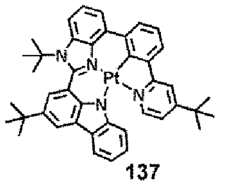
137
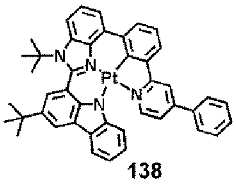
138
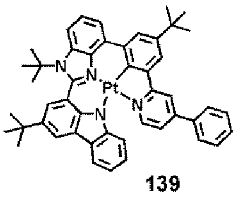
139
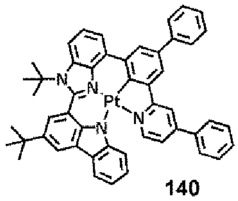
140

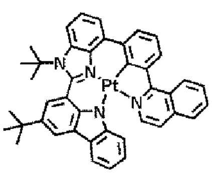
141
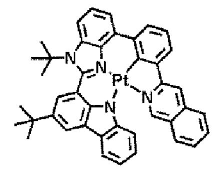
142
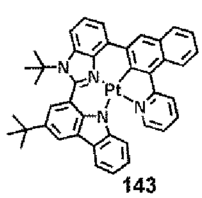
143
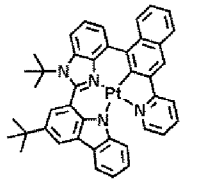
144
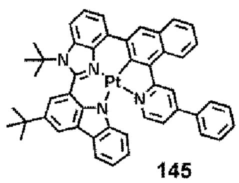
145

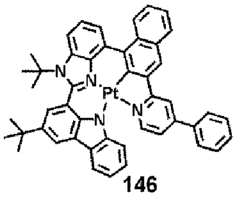
146
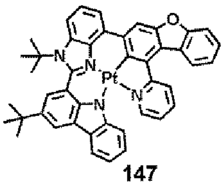
147
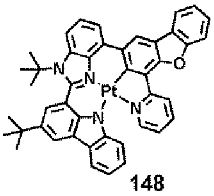
148
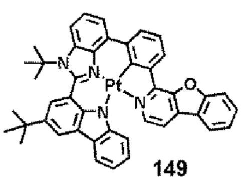
149
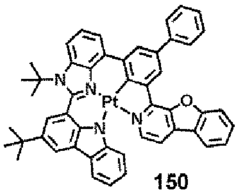
150

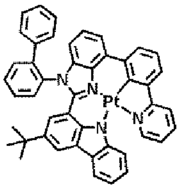
151
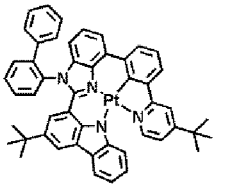
152
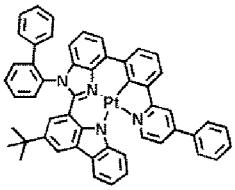
153
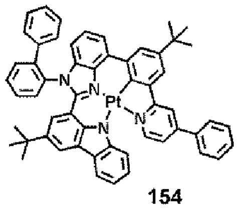
154
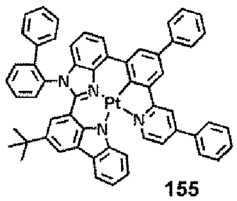
155

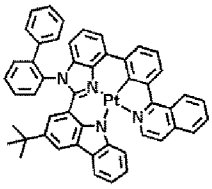
156
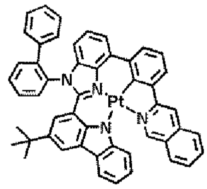
157
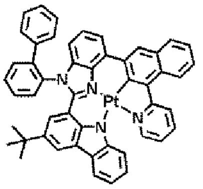
158
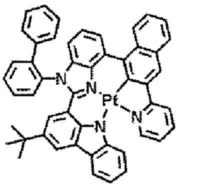
159
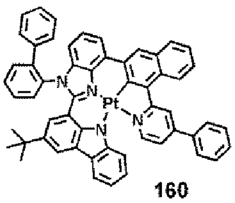
160

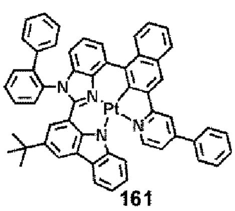
161
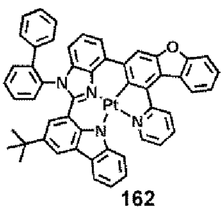
162
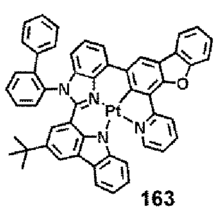
163
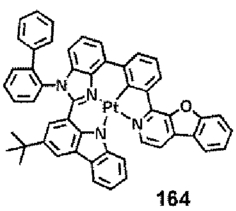
164
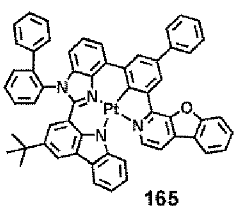
165

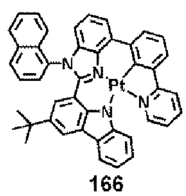
166
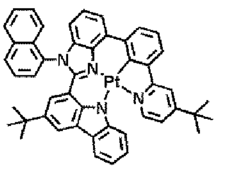
167
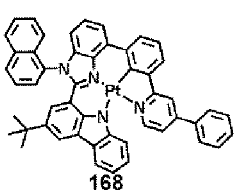
168
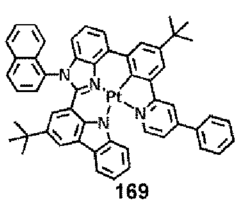
169
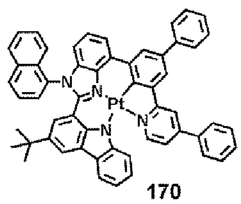
170

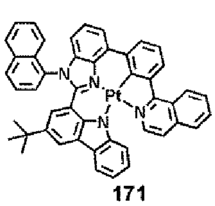
171
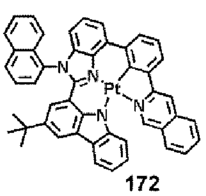
172
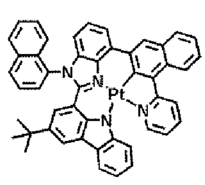
173
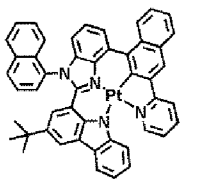
174
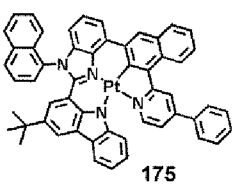
175

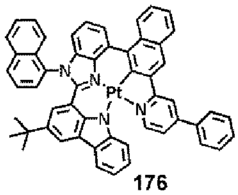
176
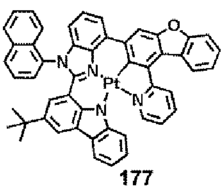
177
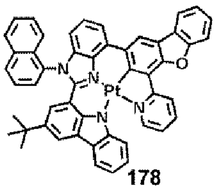
178
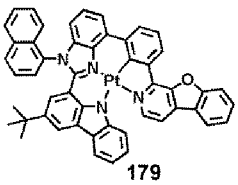
179
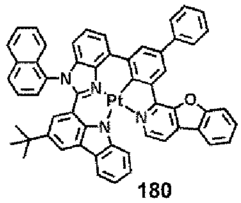
180

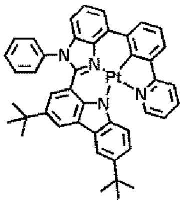
181
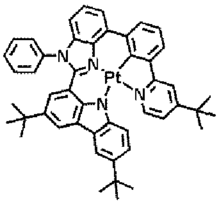
182
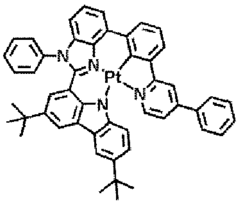
183
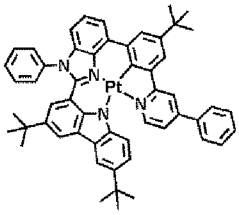
184
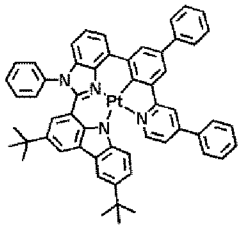
185

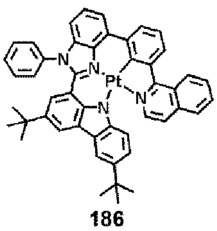
186
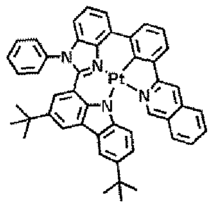
187
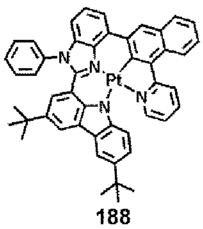
188
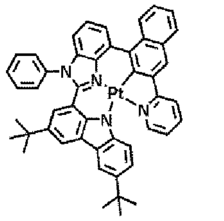
189
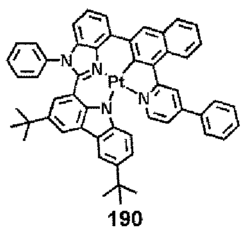
190

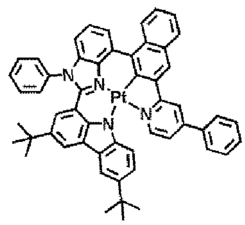
191
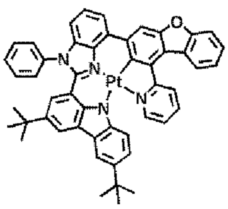
192
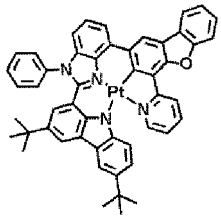
193
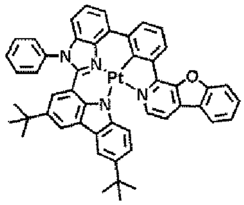
194
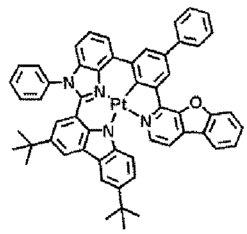
195

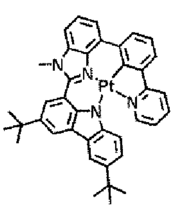
196
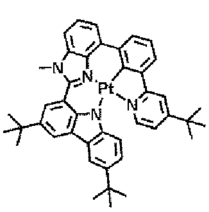
197
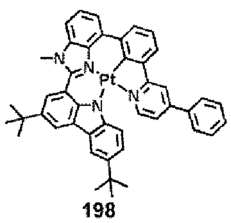
198
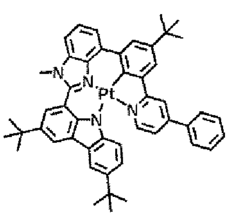
199
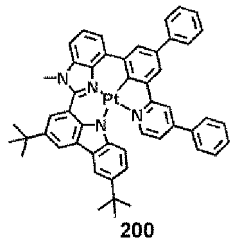
200

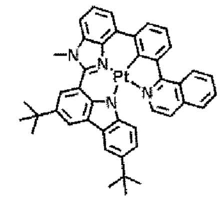
201
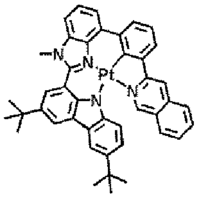
202
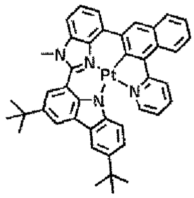
203
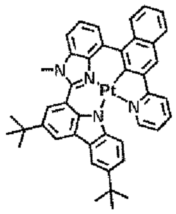
204
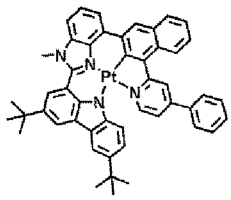
205

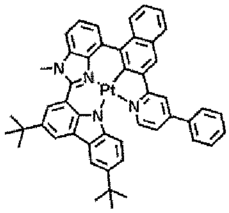
206
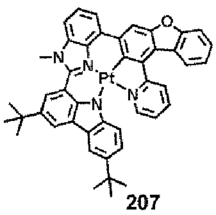
207
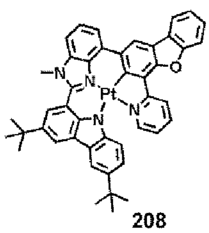
208
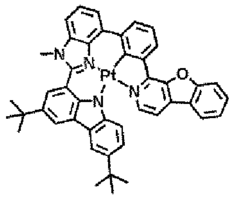
209
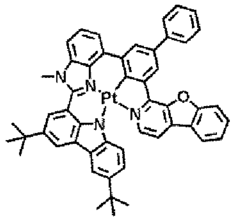
210

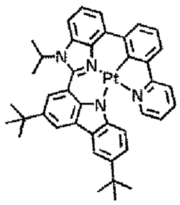
211
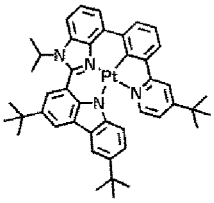
212
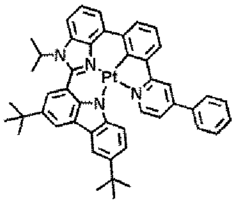
213
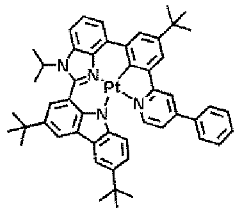
214
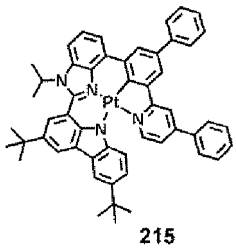
215

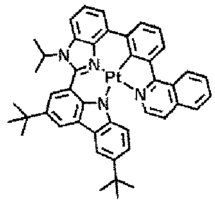
216
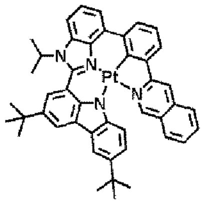
217
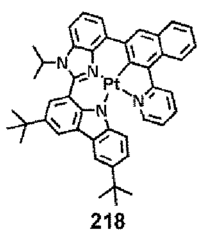
218
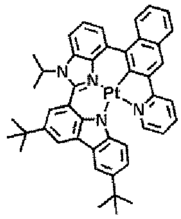
219
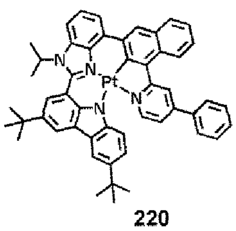
220

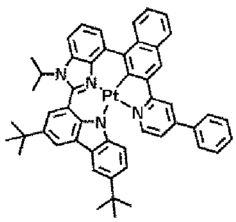
221
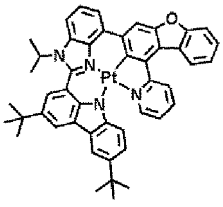
222
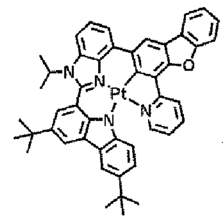
223
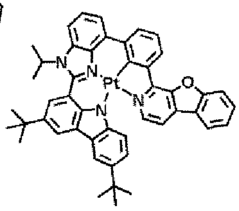
224
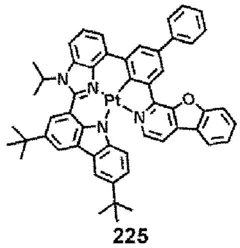
225

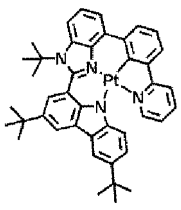
226
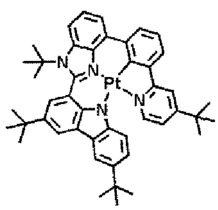
227
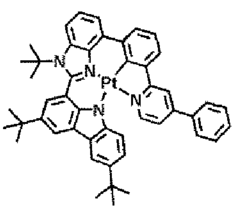
228
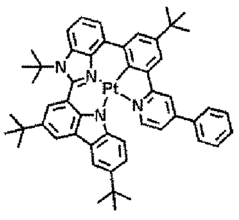
229
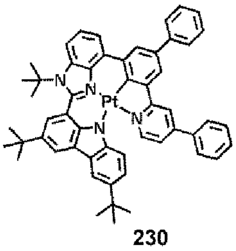
230

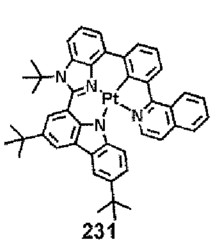
231
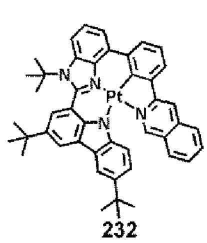
232
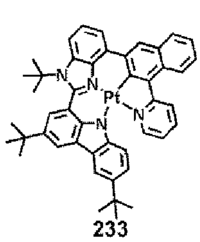
233
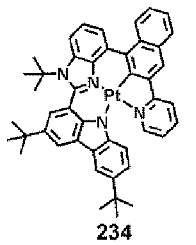
234
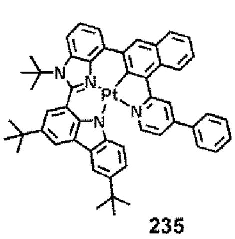
235

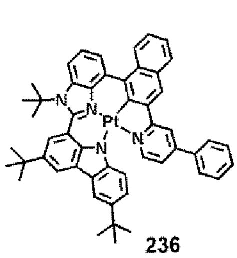
236
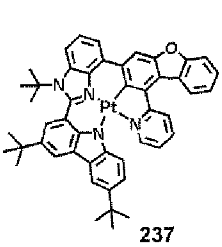
237
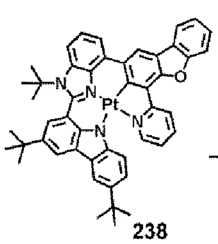
238
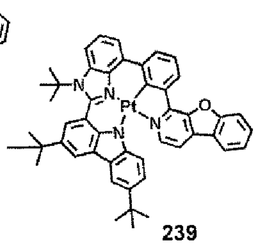
239
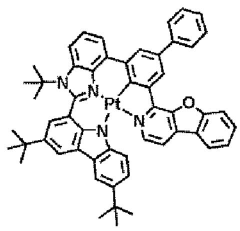
240

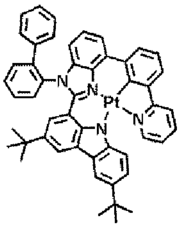
241
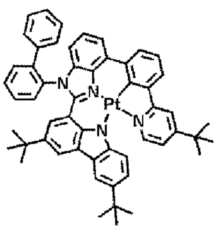
242
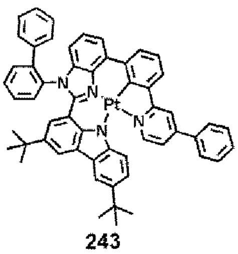
243
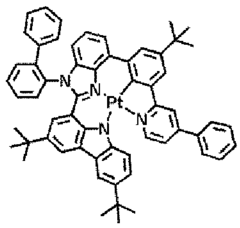
244
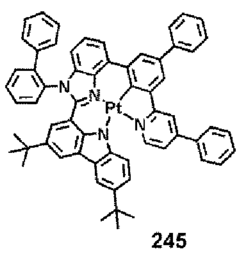
245

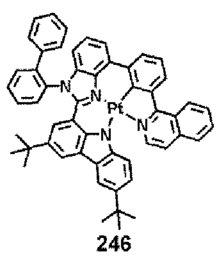
246
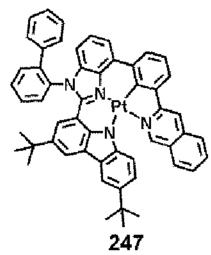
247
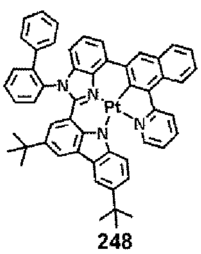
248
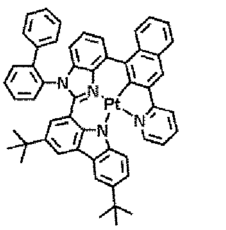
249
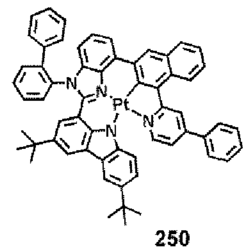
250

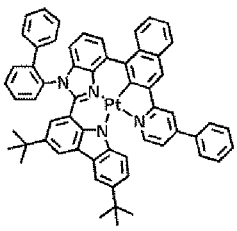
251
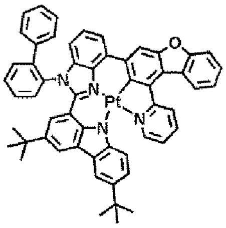
252
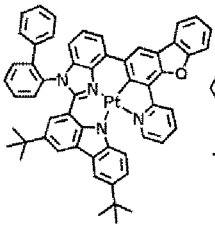
253
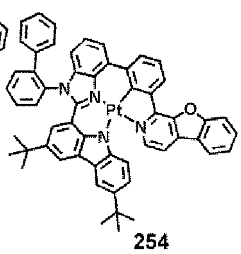
254
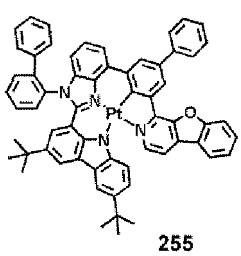
255

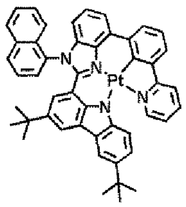
256
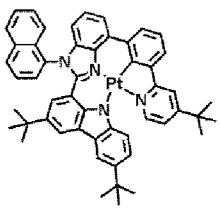
257
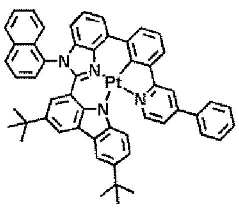
258
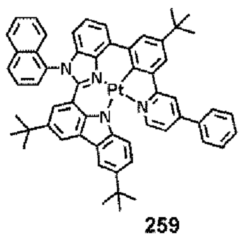
259
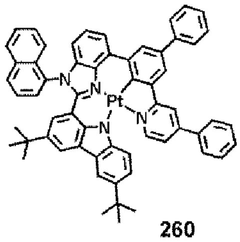
260

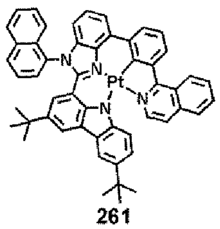
261
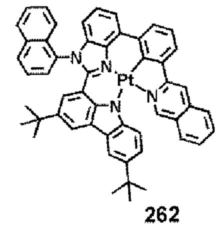
262
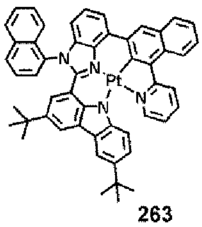
263
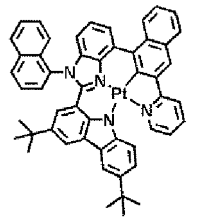
264
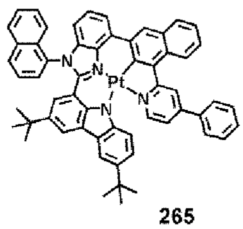
265

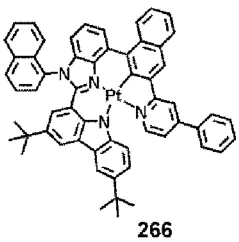
266
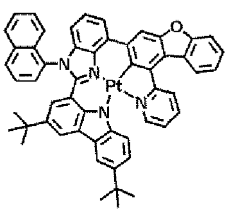
267
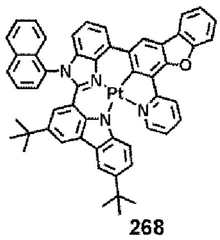
268
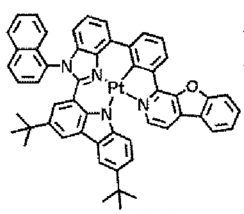
269
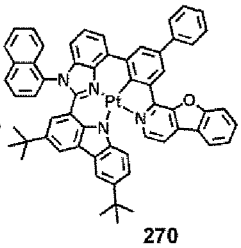
270

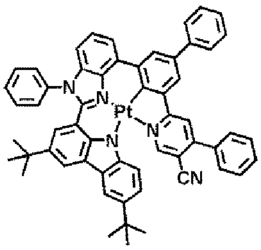
271
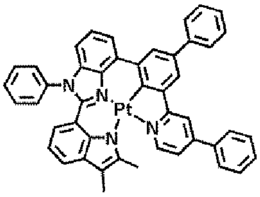
272
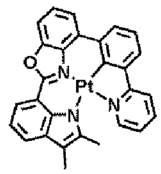
273.

In Formula 1, two bonds selected from a bond between $A_1$ and M, a bond between $A_2$ and M, a bond between $A_3$ and M, and a bond between $A_4$ and M are each a covalent bond, and the others thereof are each a coordinate bond. Accordingly, since the organometallic compound is electrically neutral, molecular structural stability and thermal stability thereof may be increased.

In addition, $A_1$ in Formula 1 is represented by Formula A1-1 or A1-2, and ring $CY_1$ in Formulae A1-1 and A1-2 is a 5-membered ring. Accordingly, planarity of the organometallic compound increases, and the lifespan and/or efficiency of an electronic device, for example, an organic light-emitting device, which includes an organometallic compound, may be improved.

Furthermore, i) when $A_1$ in Formula 1 is represented by Formula A1-1, the organometallic compound represented by Formula 1 satisfies "Condition 1", and ii) when $A_1$ in Formula 1 is represented by Formula A1-2, the organometallic compound represented by Formula 1 satisfies at least one of "Condition 1" to "Condition 3". Accordingly, appropriate angles may be maintained between different structural moieties included in the organometallic compound, and the organometallic compound may have a stable covalent number and/or coordination number, thereby more improving molecular stability of the organometallic compound.

For example, the highest occupied molecular orbital (HOMO) energy level, the lowest unoccupied molecular orbital (LUMO) energy level, an energy band gap ($E_g$), a singlet ($S_1$) energy level, and a triplet ($T_1$) energy level of some Compounds were evaluated by using a density functional theory (DFT) method of a Gaussian program (B3LYP, structurally optimized at a level of 6-31 G(d,p)). Evaluation results thereof are shown in Table 1.

Table 1

| Compound No. | HOMO (eV) | LUMO (eV) | Eg energy level (eV) | $S_1$ energy level (eV) | $T_1$ energy level (eV) |
|---|---|---|---|---|---|
| 185 | -4.505 | -1.791 | 2.714 | 2.230 | 2.091 |
| 5 | -4.598 | -1.802 | 2.796 | 2.301 | 2.158 |
| 271 | -4.594 | -2.287 | 2.307 | 1.848 | 1.736 |
| 272 | -4.477 | -1.805 | 2.672 | 2.213 | 2.028 |
| 273 | -4.694 | -1.813 | 2.881 | 2.406 | 1.984 |

From Table 1, it is confirmed that the organometallic compound represented by Formula 1 has such electrical characteristics that are suitable for use in an electronic device, for example, for use as a dopant for an organic light-emitting device.

Synthesis methods of the organometallic compound represented by Formula 1 may be apparent to those of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes:

a first electrode;

a second electrode; and

an organic layer that is disposed between the first electrode and the second electrode,

wherein the organic layer includes an emission layer and at least one of the organometallic compound represented by Formula 1.

The organic light-emitting device may have, due to the inclusion of an organic layer including the organometallic compound represented by Formula 1, a low driving voltage, high emission efficiency, high quantum emission efficiency, a long lifespan, a low roll-off ratio, and excellent color purity.

The organometallic compound of Formula 1 may be used between a pair of electrodes of an organic light-emitting device. For example, the organometallic compound represented by Formula 1 may be included in the emission layer. In this embodiment, the organometallic compound may act as a dopant, and the emission layer may further include a host (that is, an amount of the organometallic compound represented by Formula 1 is smaller than an amount of the host).

The expression "(an organic layer) includes at least one organometallic compound" as used herein may include an embodiment in which "(an organic layer) includes identical organometallic compounds represented by Formula 1" and an embodiment in which "(an organic layer) includes two or more different organometallic compounds represented by Formula 1."

For example, the organic layer may include, as the organometallic compound, only Compound 1. In this embodiment, Compound 1 may be included in an emission layer of the organic light-emitting device. In one or more embodiments, the organic layer may include, as the organometallic compound, Compound 1 and Compound 2. In this regard, Compound 1 and Compound 2 may be included in an identical layer (for example, Compound 1 and Compound 2 all may be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode is an anode, and the second electrode is a cathode, and the organic layer further includes a hole transport region disposed between the first electrode and the emission layer and an electron transport region disposed between the emission layer and the second electrode, wherein the hole transport region includes a hole injection layer, a hole transport layer, an electron blocking layer, or any combination thereof, and wherein the electron transport region includes a hole blocking layer, an electron transport layer, an electron injection layer, or any combination thereof.

The term "organic layer" as used herein refers to a single layer and/or a plurality of layers disposed between the first electrode and the second electrode of the organic light-emitting device. The "organic layer" may include, in

addition to an organic compound, an organometallic complex including metal.

The FIGURE is a schematic view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. As the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100°C to about 500°C, a vacuum pressure of about $10^{-8}$ torr to about $10^{-3}$ torr, and a deposition rate of about 0.01 Å/sec (Angstroms per second) to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

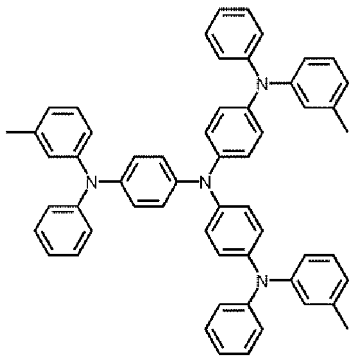

m-MTDATA

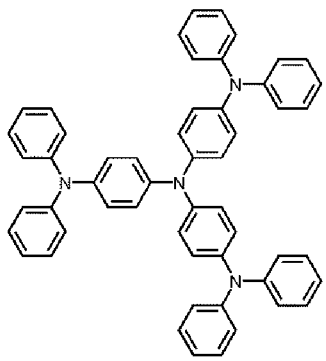

TDATA

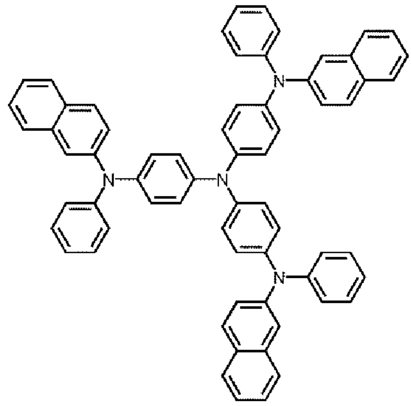

2-TNATA

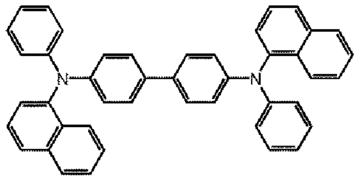

NPB

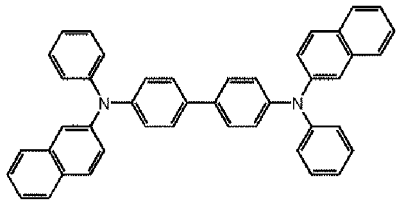

β-NPB

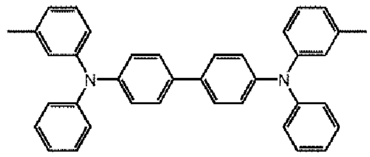

TPD

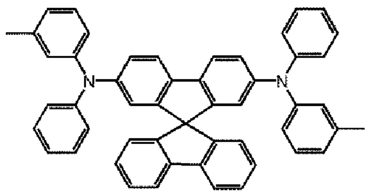

Spiro-TPD

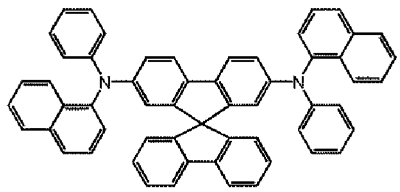

Spiro-NPB

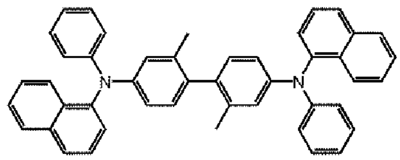

methylated NPB

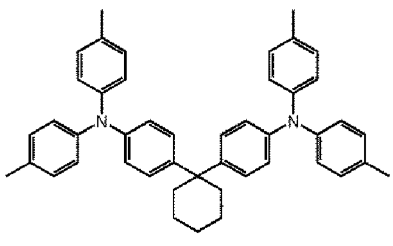

TAPC

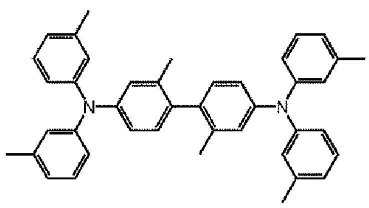

HMTPD

Formula 201

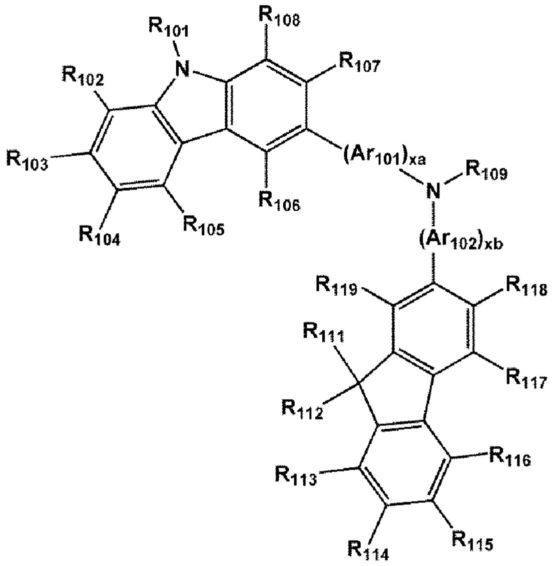

Formula 202

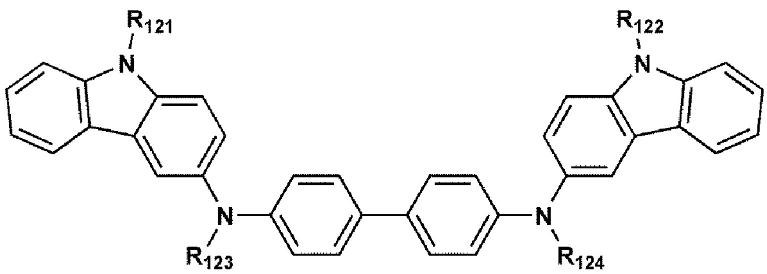

.

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

xa and xb in Formula 201 may each independently be an integer from 0 to 5, or may each independently be 0, 1, or 2. For example, xa may be 1, and xb may be 0, but embodiments of the present disclosure are not limited thereto. $R_{101}$ to $R_{108}$, $R_{111}$ to $R_{119}$, and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, pentyl group, a hexyl group, and so on), and a $C_1$-$C_{10}$ alkoxy group (for example, a methoxy group, an ethoxy group, a propoxy group, a butoxy group, a pentoxy group, and so on);

a $C_1$-$C_{10}$ alkyl group and a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a fluorenyl group, and a pyrenyl group; and

a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group,

but embodiments of the present disclosure are not limited thereto. $R_{109}$ in Formula 201 may be selected from:

a phenyl group, a naphthyl group, an anthracenyl group, and a pyridinyl group; and

a phenyl group, a naphthyl group, an anthracenyl group, and a pyridinyl group, each substituted with at least one selected from deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

In an embodiment, the compound represented by Formula 201 may be represented by Formula 201A, but embodiments of the present disclosure are not limited thereto:

Formula 201A

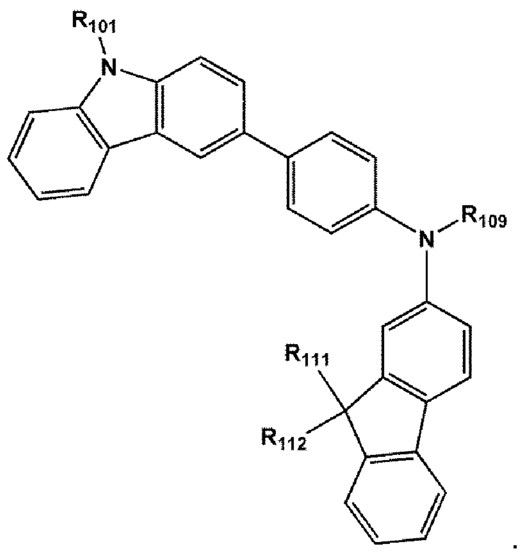

$R_{101}$, $R_{111}$, $R_{112}$, and $R_{109}$ in Formula 201A are the same as described herein.

For example, the compound represented by Formula 201, and the compound represented by Formula 202 may include compounds HT1 to HT20 illustrated below, but are not limited thereto:

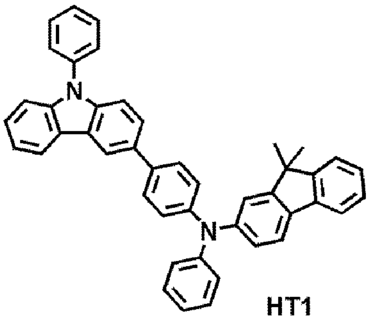

HT1

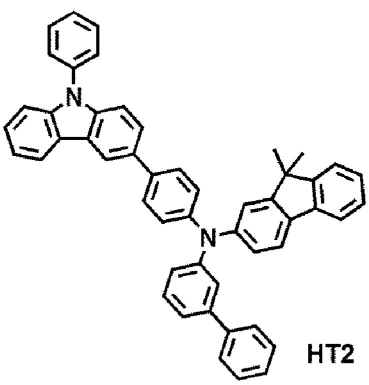

HT2

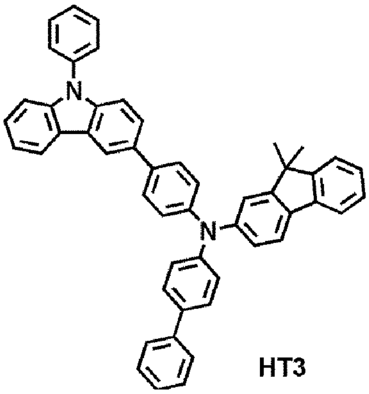

HT3

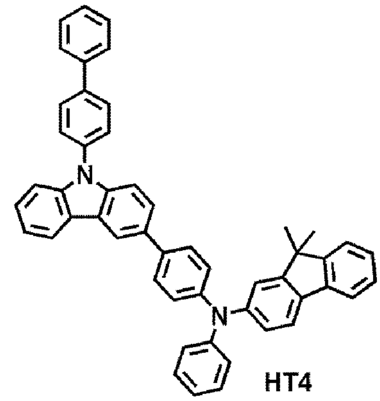

HT4

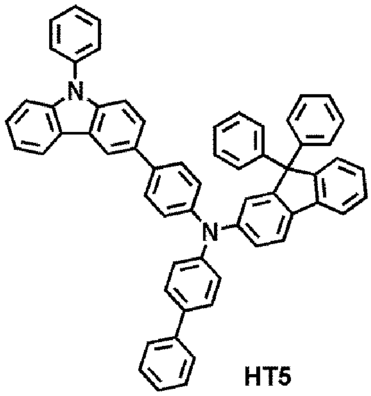

HT5

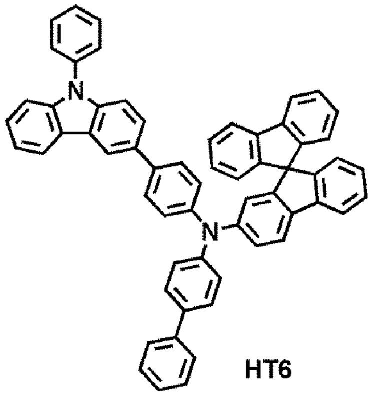

HT6

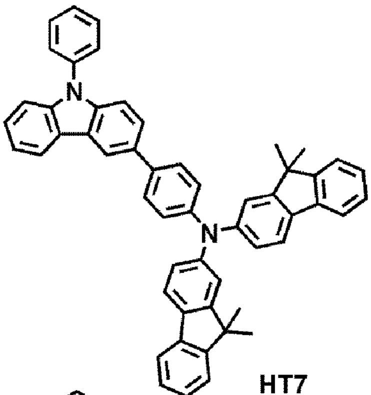

HT7

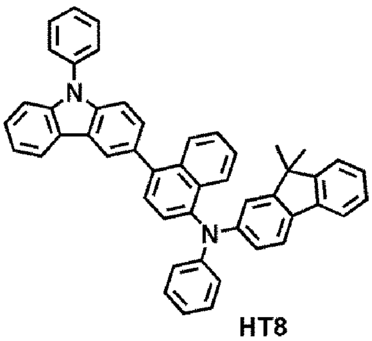

HT8

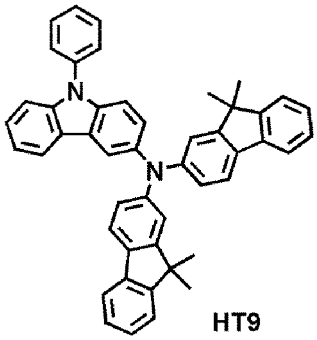

HT9

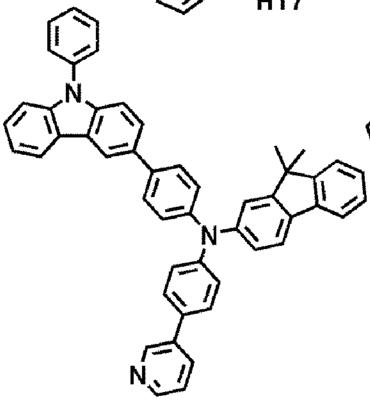

HT10

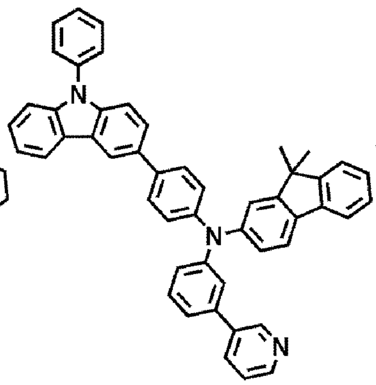

HT11

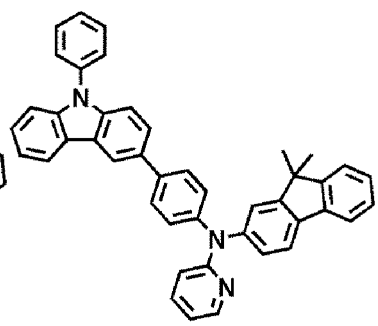

HT12

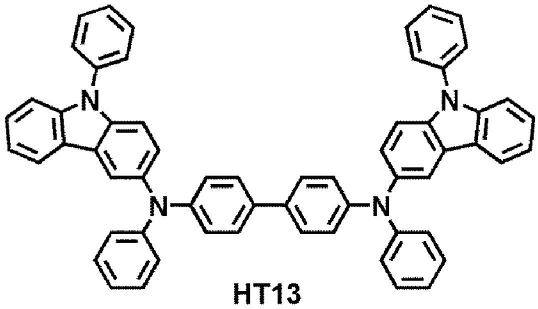

HT13

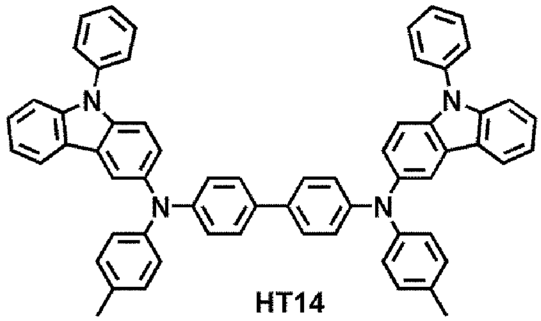

HT14

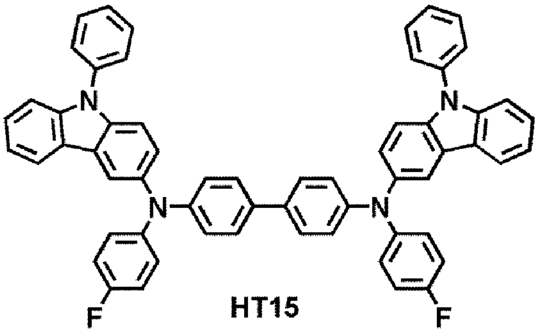

HT15

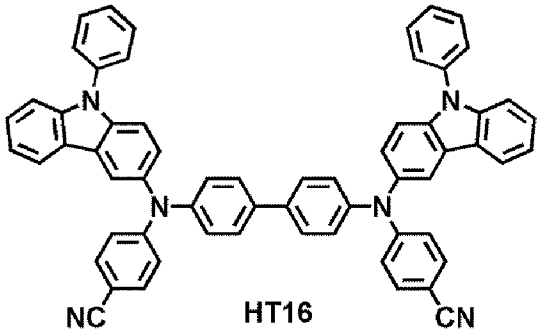

HT16

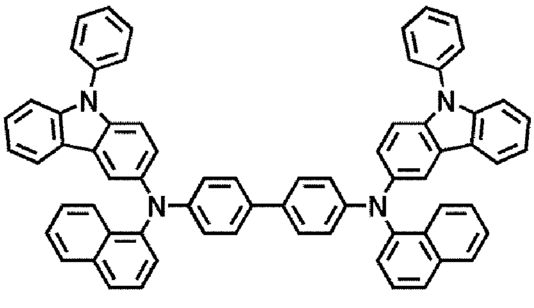

HT17

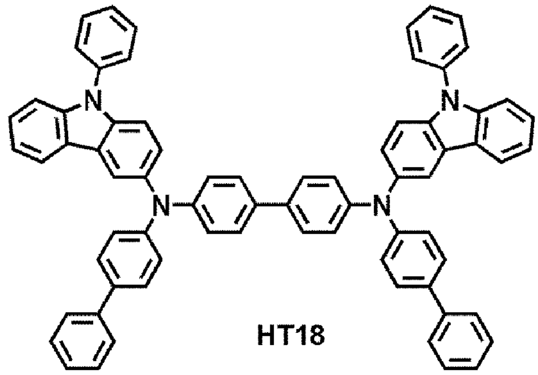

HT18

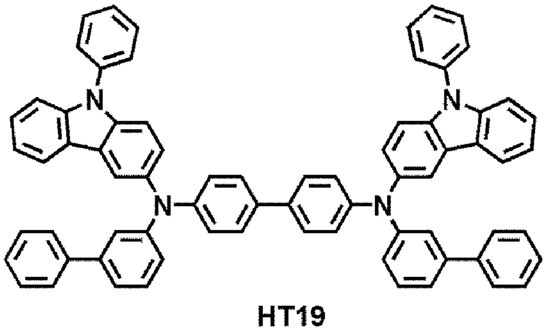

HT19

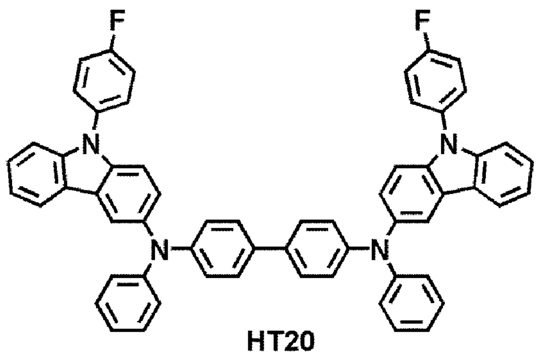

HT20

.

A thickness of the hole transport region may be in a range of about 100 Å (Angstroms) to about 10,000 Å, for example, about 100 Å to about 1,000 Å. When the hole transport region includes at least one of a hole injection layer and a hole transport layer, the thickness of the hole injection layer may be in a range of about 100 Å to about 10,000 Å, and for example, about 100 Å to about 1,000 Å, and the thickness of the hole transport layer may be in a range of about 50 Å to about 2,000 Å, and for example, about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in

driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto:

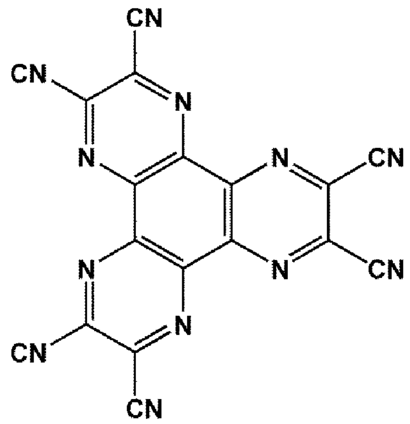

HT-D1

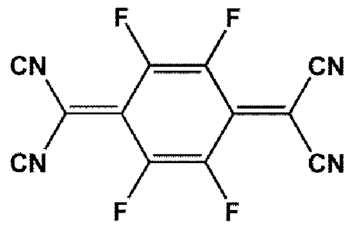

F4-TCNQ .

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, and Compound H51:

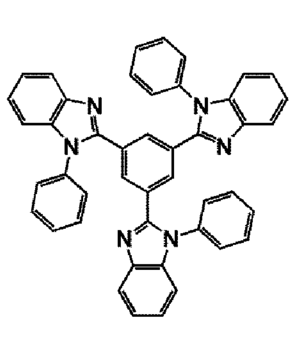

TPBi

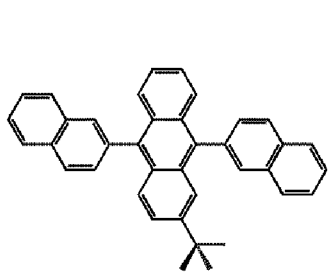

TBADN

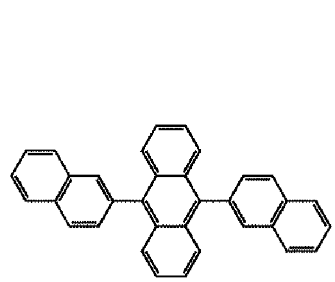

ADN

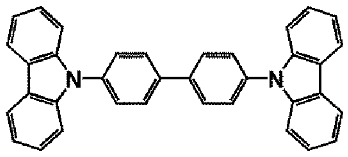

CBP

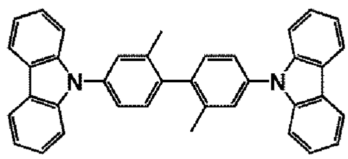

CDBP

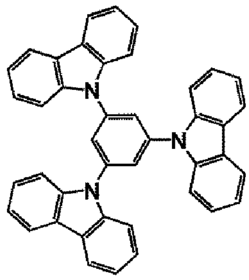

TCP

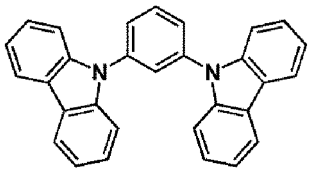

mCP

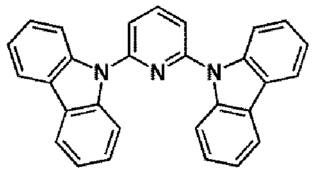

H50

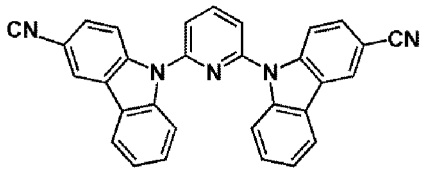

H51 .

In one or more embodiments, the host may further include a compound represented by Formula 301 below.

Formula 301

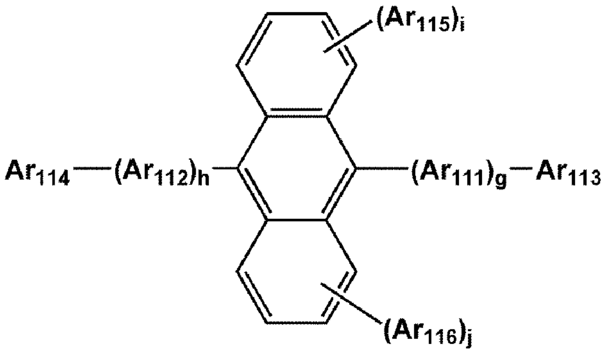

.

$Ar_{111}$ and $Ar_{112}$ in Formula 301 may each independently be selected from:

a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

$Ar_{113}$ to $Ar_{116}$ in Formula 301 may each independently be selected from:

a $C_1$-$C_{10}$ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

g, h, i, and j in Formula 301 may each independently be an integer from 0 to 4, for example, 0, 1, or 2.
$Ar_{113}$ to $Ar_{116}$ in Formula 301 may each independently be selected from:

a $C_1$-$C_{10}$ alkyl group substituted with at least one selected from a phenyl group, a naphthyl group, and an anthracenyl group;
a phenyl group, a naphthyl group, an anthracenyl group, a pyrenyl group, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano

group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthracenyl group, a pyrenyl group, a phenanthrenyl group, and a fluorenyl group; and

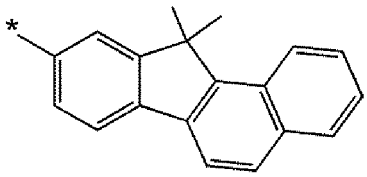

,

but embodiments of the present disclosure are not limited thereto.

In one or more embodiments, the host may include a compound represented by Formula 302:

Formula 302

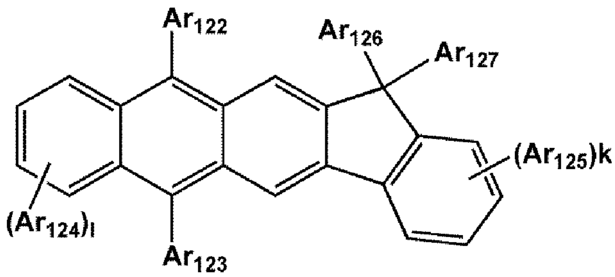

.

$Ar_{122}$ to $Ar_{125}$ in Formula 302 are the same as described in connection with $Ar_{113}$ in Formula 301.

$Ar_{126}$ and $Ar_{127}$ in Formula 302 may each independently be a $C_1$-$C_{10}$ alkyl group (for example, a methyl group, an ethyl group, or a propyl group).

k and l in Formula 302 may each independently be an integer from 0 to 4. For example, k and l may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto.

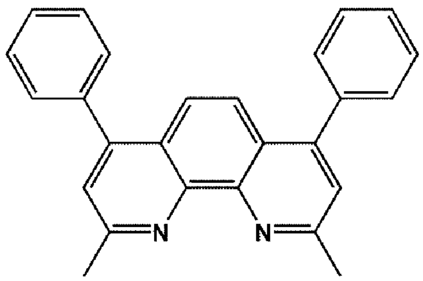

BCP

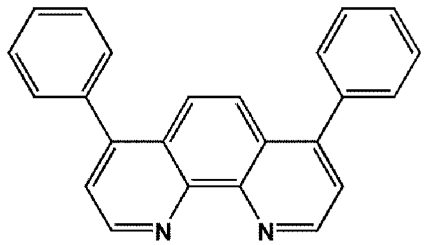

Bphen

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have improved hole blocking ability without a substantial increase in driving voltage.

The electron transport layer may further include at least one selected from BCP, Bphen, $Alq_3$, BAlq, TAZ, and NTAZ:

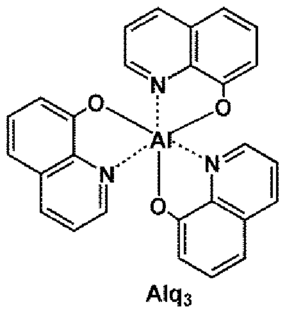

$Alq_3$

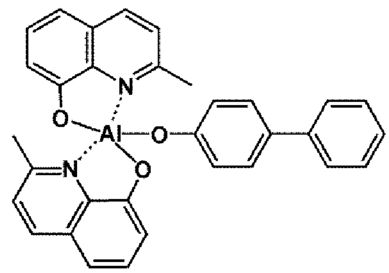

BAlq

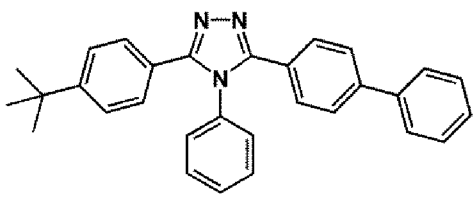

TAZ

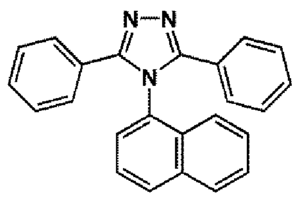

NTAZ

.

In one or more embodiments, the electron transport layer may include at least one of ET1 to ET25, but are not limited thereto:

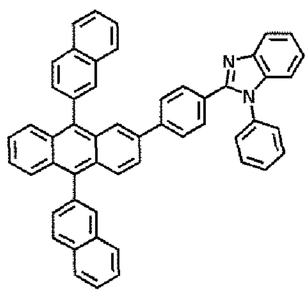

ET1

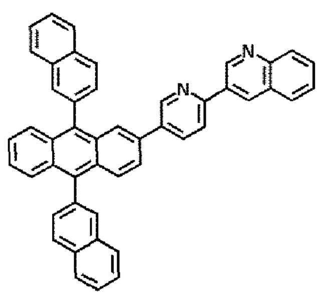

ET2

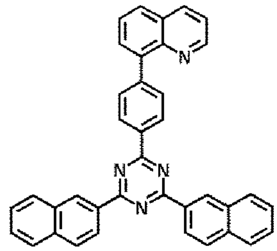

ET3

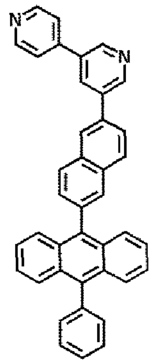

ET4

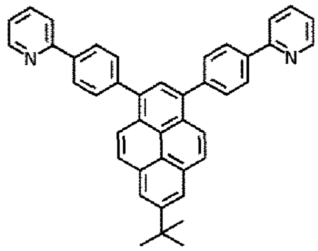

ET5

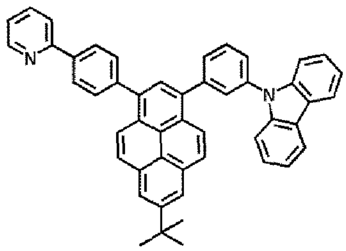

ET6

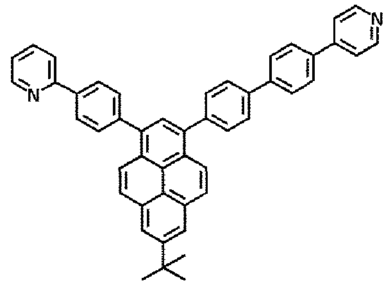

ET7

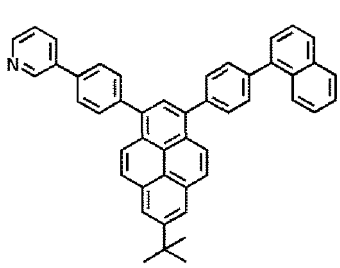

ET8

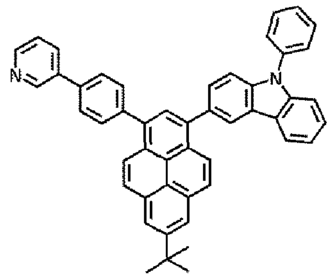

ET9

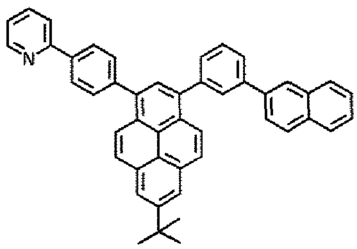

ET10

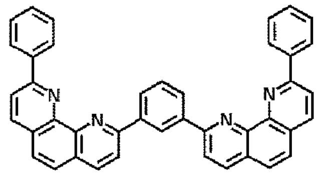

ET11

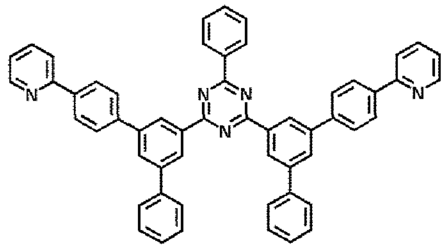

ET12

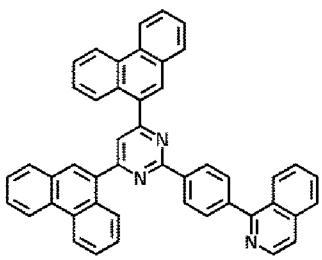

ET13

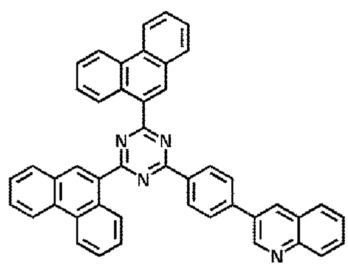

ET14

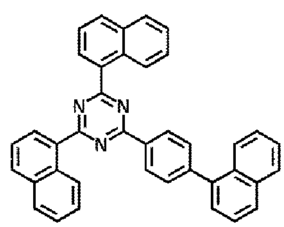

ET15

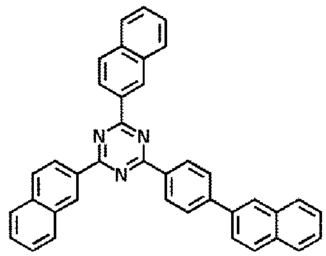

ET16

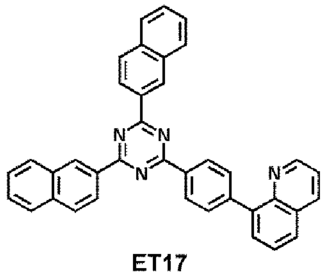

ET17

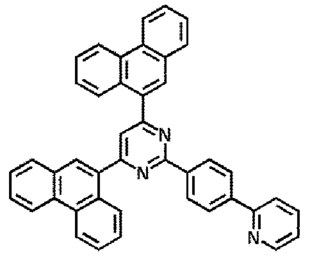

ET18

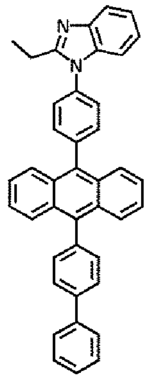

ET19

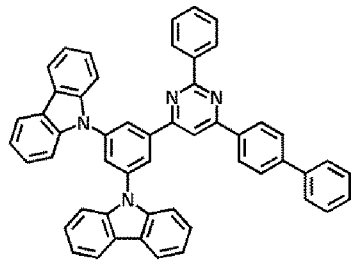

ET20

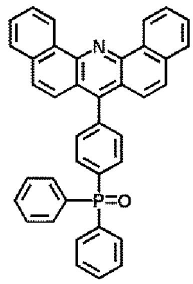

ET21

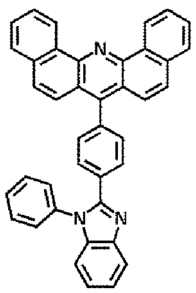

ET22

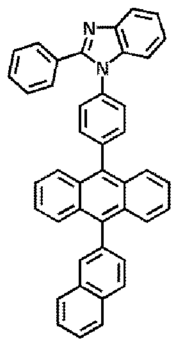

ET23

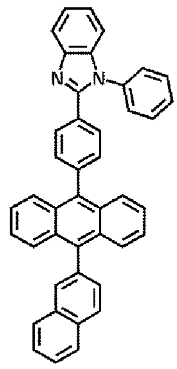

ET24

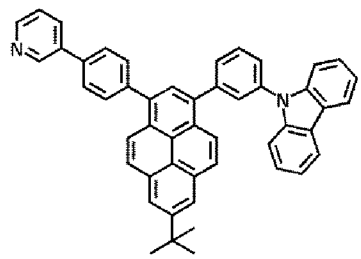

ET25

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2:

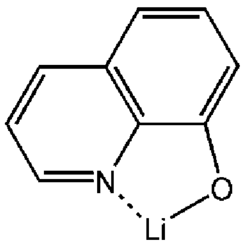

ET-D1

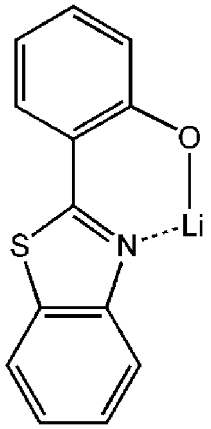

ET-D2 .

The electron transport region may include an electron injection layer that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

Another aspect of the present disclosure provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an iso-butyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof include a methoxy group, an ethoxy group, and an iso-propyloxy (iso-propoxy) group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof, and no aromaticity. Non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having an aromatic system that has at least one heteroatom selected from N, O, P, Si, and S as a ring-forming atom, and 1 to 60 carbon atoms. The term "$C_1$-$C_{60}$ heteroarylene group" as used herein refers to a divalent group having an aromatic system that has at least one heteroatom selected from N, O, P, Si, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein indicates $-OA_{102}$ (wherein $A_{102}$ is the $C_6$-$C_{60}$ aryl group), the term "$C_6$-$C_{60}$ arylthio group" as used herein indicates $-SA_{103}$ (wherein $A_{103}$ is the $C_6$-$C_{60}$ aryl group), and the term "$C_7$-$C_{60}$ arylalkyl group" as used herein indicates $-A_{104}A_{105}$ (wherein $A_{104}$ is the $C_6$-$C_{59}$ aryl group and $A_{105}$ is the $C_1$-$C_{53}$ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group," as used herein, refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

At least one substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the $C_1$-$C_{60}$ heteroaryloxy group, the $C_1$-$C_{60}$ heteroarylthio group, the $C_2$-$C_{60}$ heteroarylalkyl group, the substituted monovalent non-aromatic condensed polycyclic group, and the substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and-$P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group,$-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, wherein

$Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

When a group containing a specified number of carbon atoms is substituted with any of the groups listed in the preceding paragraph, the number of carbon atoms in the resulting "substituted" group is defined as the sum of the carbon atoms contained in the original (unsubstituted) group and the carbon atoms (if any) contained in the substituent. For example, when the term "substituted $C_1$-$C_{30}$ alkyl" refers to a $C_1$-$C_{30}$ alkyl group substituted with $C_6$-$C_{30}$ aryl group, the total number of carbon atoms in the resulting aryl substituted alkyl group is $C_7$-$C_{60}$.

Hereinafter, a compound and an organic light-emitting device according to embodiments are described in detail with reference to Synthesis Examples and Examples. However, the organic light-emitting device is not limited thereto. The wording "B was used instead of A" used in describing Synthesis Examples means that an amount of A used in molar equivalents was identical to an amount of B used in molar equivalent.

EXAMPLES

Synthesis Example 1: Synthesis of Compound 185

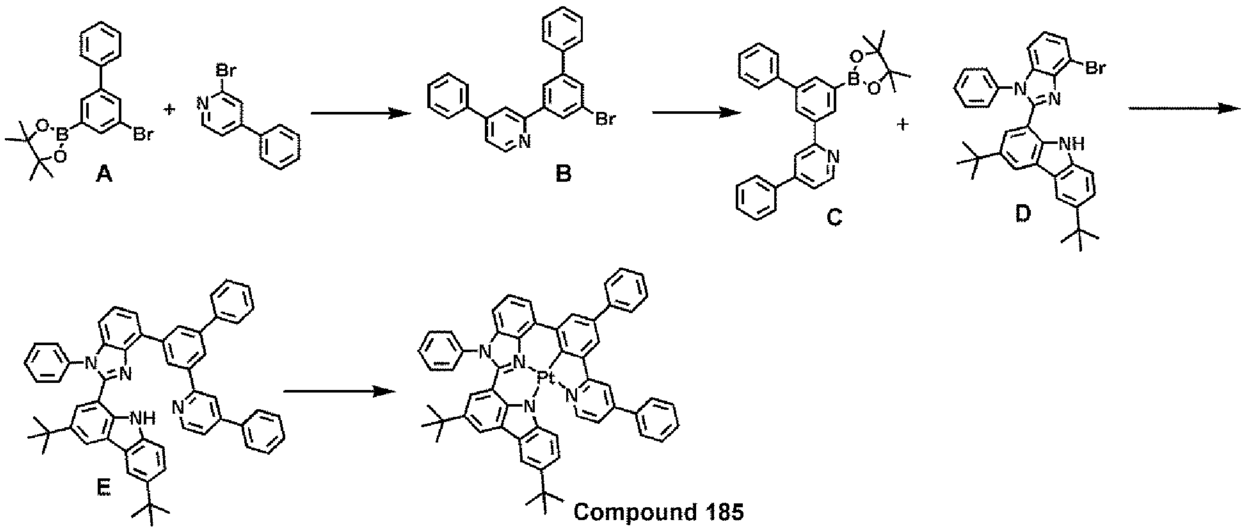

A B C D E Compound 185

Synthesis of Intermediate B (2-(5-bromo-[1,1'-biphenyl]-3-yl)-4-phenylpyridine)

5 grams (g) (17.9 millimoles, mmol, 1.2 equivalents, equiv.) of Intermediate A, 3.5 g (14.9 mmol, 1 equiv.) of 2-bromo-4-phenylpyridine, 1.2 g (1.05 mmol, 0.07 equiv.) of tetrakis(triphenylphosphine)palladium(0), and 5.2 g (37.4 mmol, 2.5 equiv.) of potassium carbonate were mixed with 50 milliliters (mL) (concentration 0.6 molar, M) of a solvent in which tetrahydrofuran (THF), distilled water ($H_2O$), and ethanol (EtOH) were mixed at a ratio of 3:1:1, and the mixture was refluxed for 17 hours. The resultant mixture was cooled to room temperature and a precipitate was filtered. Then, a filtrate obtained therefrom was washed by using ethyl acetate (EA)/$H_2O$ and purified by column chromatography (while increasing a rate of MC/Hex to between 25% and 50%) to obtain 4.2 g (yield: 72%) of Intermediate B. The obtained product was confirmed by Mass Spectrometry and HPLC analysis.
HRMS (MALDI) calcd for $C_{23}H_{16}BrN$: m/z 385.0466, Found: 385.0465.

Synthesis of Intermediate C (4-phenyl-2-(5-(4,4,5,5-tetramethyl-1,3,2-dioxaborolan-2-yl)-[1,1'-biphenyl]-3-yl)pyridine)

4.2 g (0.011 mmol, 1.0 equiv.) of Intermediate B, 4.1 g (0.016 mmol, 1.5 equiv.) of bispinacolatodiboron, 2.1 g (0.022 mmol, 2 equiv.) of potassium acetate, and 0.44 g (0.001 mmol, 0.05 equiv.) of $PdCl_2$(dppf) were mixed with 38 mL (0.8 M) of toluene and the mixture was refluxed for 12 hours. The resultant mixture was cooled to room temperature and a precipitate was filtered. Then, a filtrate obtained therefrom was washed by using EA/$H_2O$ and purified by column chromatography (while increasing a rate of EA/Hex to between 2% and 5%) to obtain 3.5 g (yield: 75%) of Intermediate C. The obtained product was confirmed by Mass Spectrometry and HPLC analysis.
HRMS (MALDI) calcd for $C_{29}H_{28}BNO_2$: m/z 433.2213, Found: 433.2211.

Synthesis of Intermediate E (3,6-di-tert-butyl-1-(1-phenyl-4-(5-(4-phenylpyridin-2-yl)-[1,1'-biphenyl]-3-yl)-1H-benzo[d]imidazol-2-yl)-9H-carbazole)

3.5 g (0.008 mmol, 1.2 equiv.) of Intermediate C, 3.7 g (0.007 mol, 1 equiv.) of Intermediate D (1-(4-bromo-1-phenyl-1H-benzo[d]imidazol-2-yl)-3,6-di-tert-butyl-9H-carbazole), 0.54 g (0.001 mmol, 0.07 equiv.) of tetrakis(triphenylphosphine)palladium(0), and 2.8 g (0.020 mmol, 3 equiv.) of potassium carbonate were mixed with 20 mL of a solvent in which THF and distilled water ($H_2O$) were mixed at a ratio of 3:1, and the mixture was refluxed for 12 hours. The resultant mixture was cooled to room temperature and a precipitate was filtered. The filtrate obtained therefrom was washed by using EA/$H_2O$ and purified by column chromatography (while increasing a rate of EA/Hex to between 20% and 35%) to obtain 3.1 g (yield: 60%) of Intermediate E. The obtained product was confirmed by Mass Spectrometry and HPLC analysis.
HRMS (MALDI) calcd for $C_{56}H_{48}N_4$: m/z 776.3879, Found: 776.3875.

Synthesis of Compound 185

3.1 g (3.99 mmol) of Intermediate E and 1.99 g (4.79 mmol, 1.0 equiv.) of $K_2PtCl_4$ were mixed with 70 mL of a solvent in which 60 mL of AcOH and 10 mL of $H_2O$ were mixed, and the mixture was refluxed for 16 hours. The resultant mixture was cooled to room temperature and a precipitate was filtered. The precipitate was dissolved again in MC,

washed by using $H_2O$, and purified by column chromatography (MC 40%, EA 1%, Hex 59%) to obtain 2.8 g (yield: 72%) of Compound 185. The obtained product was confirmed by Mass Spectrometry and HPLC analysis.
HRMS (MALDI) calcd for $C_{56}H_{46}N_4Pt$: m/z 969.3370, Found: 969.3372.

Synthesis Example 2: Synthesis of Compound 5

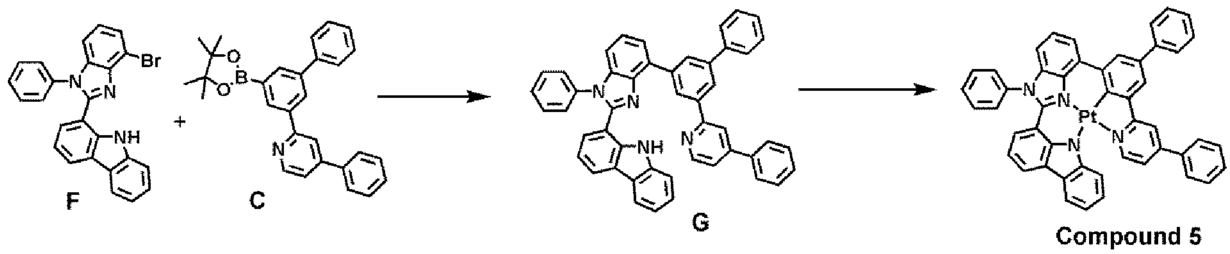

F

C

G

Compound 5

Synthesis of Intermediate G (1-(1-phenyl-4-(5-(4-phenylpyridin-2-yl)-[1,1'-biphenyl]-3-yl)-1H-benzo[d]imidazol-2-yl)-9H-carbazole)

2.3 g (yield: 61%) of Intermediate G was synthesized in the same manner as Intermediate E in Synthesis Example 1, except that 2.5 g (0.006 mmol) of Intermediate F (1-(4-bromo-1-phenyl-1H-benzo[d]imidazol-2-yl)-9H-carbazole) was used instead of Intermediate D, and 2.9 g (0.007 mmol) of Intermediate C was used.
HRMS (MALDI) calcd for $C_{48}H_{32}N_4$: m/z 664.2627, Found: 664.2624.

Synthesis of Compound 5

Compound 5 was synthesized in the same manner as Compound 185 in Synthesis Example 1, except that 2.3 g (3.46 mmol) of Intermediate G was used instead of Intermediate E.
HRMS (MALDI) calcd for $C_{48}H_{30}N_4Pt$: m/z 857.8800, Found: 857.8802

Evaluation Example 1: Evaluation of Photoluminescence Quantum Yields (PLQY)

A $CH_2Cl_2$ solution of polymethyl methacrylate (PMMA) and a mixture of 8 wt% of CBP and Compound 5 (an amount of Compound 5 was 10 parts by weight based on 100 parts by weight of the mixture) were mixed. The resultant mixture was coated on a quartz substrate by using a spin coater, thermally treated at a temperature of 80°C in an oven, and then cooled to room temperature, thereby completing the manufacture of a film.

Photoluminescence quantum yields (PLQY) in film of Compound 5 were evaluated by using a Hamamatsu Photonics absolute PL quantum yield measurement system equipped with a xenon light source, a monochromator, a photonic multichannel analyzer, and an integrating sphere and using PLQY measurement software (Hamamatsu Photonics, Ltd., Shizuoka, Japan). This process was repeated on Compound 185 to evaluate PLQY in film of Compound 185. Results are shown in Table 2.

Table 2

| | Compound 5 | Compound 185 |
|---|---|---|
| PLQY | 0.966 | 0.890 |

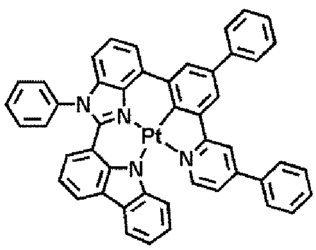

5

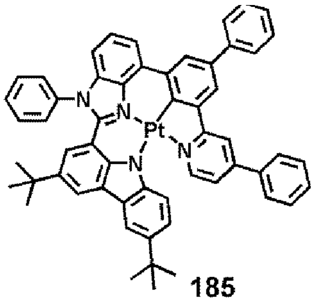

185

Referring to Table 2, it is determined that Compounds 5 and 185 have high PLQY in film.

Evaluation Example 2 : Measurement of Decay Time

A quartz substrate washed by chloroform and distilled water was prepared, and films 1 and 2 each having a thickness of 50 nanometers (nm) were prepared by vacuum-depositing (co-depositing) certain materials shown in Table 3 at a degree of vacuum of $1.3x10^{-5}$ Pa ($10^{-7}$ torr).

Table 3

| Film name | Compound used to manufacture film |
|---|---|
| Film 1 | CBP : Compound 5 (weight ratio of 9:1) |
| Film 2 | CBP : Compound 185 (weight ratio of 9:1) |

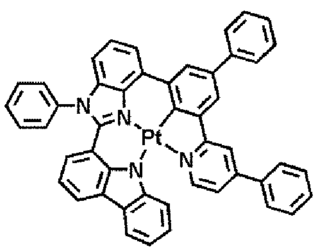

5

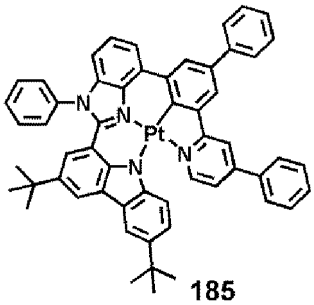

185

Then, PL spectra of the films 1 and 2 prepared as described above were evaluated at room temperature by using a time-resolved photoluminescence (TRPL) measurement system FluoTime 300 (manufactured by PicoQuant) and a pumping source PLS340 (excitation wavelength = 340 nm, spectral width = 20 nm) (manufactured by PicoQuant), wavelengths of main peaks of the PL spectra were determined, and the number of photons emitted from each film at the main peak by a photon pulse (pulse width = 500 picoseconds, ps) applied to each film by PLS340 was measured over time based on Time-Correlated Single Photon Counting (TCSPC). By repeating the above processes, a sufficiently fittable TRPL curve was obtained. Then, a decay time $T_{decay}$(Ex) of each of the films 1 and 2 was obtained by fitting two or more exponential decay functions to a result obtained from the TRPL curve. Results thereof are shown in Table 4. A function represented by Equation 1 was used for the fitting, and the greatest value among $T_{decay}$ values obtained from the exponential decay functions used for the fitting was taken as $T_{decay}$(Ex). At this time, the same measurement was performed once more for the same measurement time as that for calculating the TRPL curve in a dark state (a state in which the pumping signal input to the certain film was blocked) to obtain a baseline or background signal curve. The baseline or background curve was used as a baseline for fitting.

Equation 1 $$f(t) = \sum_{i=1}^{n} A_i\, exp\left(-t/T_{decay,i}\right)$$

Table 4

| Film name | Decay time (microseconds, μs) |
|---|---|
| Film 1 (Compound 5) | 4.809 |
| Film 2 (Compound 185) | 4.464 |

Referring to Table 4, it is determined that Compounds 5 and 185 have a relatively short decay time.

Evaluation Example 3 : Evaluation of HOMO Energy Levels

HOMO energy levels of Compounds 5 and 185 were measured according to a method described in Table 5, and results thereof are shown in Table 6.

Table 5

| | |
|---|---|
| HOMO energy level evaluation method | A voltage-current (V-A) graph of each Compound was obtained by using a cyclic voltammetry (CV) (electrolyte: 0.1 M $Bu_4NPF_6$ / solvent: $CH_2Cl_2$ / electrode: 3-electrode system (working electrode: Pt disc (1 mm diameter), reference electrode: Pt wire, and auxiliary electrode: Pt wire)), and then, HOMO energy level of each Compound was calculated from an oxidation onset potential of the V-A graph. |

Table 6

| Compound No. | HOMO energy level (eV) (found) |
|---|---|
| 5 | -5.22 |
| 185 | -5.20 |

Referring to Table 6, it is determined that Compounds 5 and 18 have electrical characteristics suitable for use in an organic light-emitting device.

Example 1

A glass substrate, on which ITO/Ag/ITO were respectively deposited to thicknesses of 70 Å/1,000 Å/70 Å (Å = angstrom) as an anode, was cut to a size of 50 mm x 50 mm x 0.5 mm (mm = millimeter), sonicated with iso-propyl alcohol and pure water each for 5 minutes, and then cleaned by exposure to ultraviolet (UV) rays and ozone for 30 minutes. Then, the glass substrate was provided to a vacuum deposition apparatus.

2-TNATA was deposited on the anode to form a hole injection layer having a thickness of 600 Å, and 4,4'-bis[N-(1-naphthyl)-N-phenylamino]biphenyl (NPB) was deposited on the hole injection layer to form a hole transport layer having a thickness of 1,350 Å.

CBP (host) and Compound 5 (dopant) were co-deposited on the hole transport layer at a weight ratio of 94:6 to form an emission layer having a thickness of 400 Å, and BCP was deposited on the emission layer to form a hole blocking layer having a thickness of 50 Å. Then, $Alq_3$ was deposited on the hole blocking layer to form an electron transport layer having a thickness of 350 Å, LiF was deposited on the electron transport layer to form an electron injection layer having a thickness of 10 Å, and MgAg was deposited on the electron injection layer at a ratio of 90:10 to form a cathode having a thickness of 120 Å, thereby completing the manufacture of an organic light-emitting device (emitting red light) having a structure of ITO/Ag/ITO / 2-TNATA (600 Å) / NPB (1,350 Å) / CBP + Compound 5 (6 wt%) (400 Å) / BCP (50 Å) / $Alq_3$ (350 Å) / LiF (10 Å) / MgAg (120 Å).

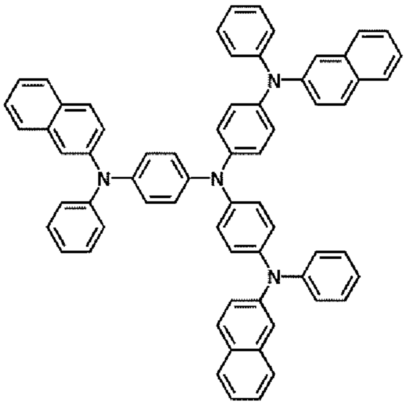

2-TNATA

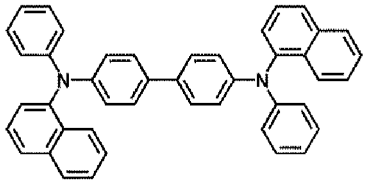

NPB

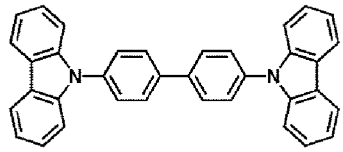

CBP

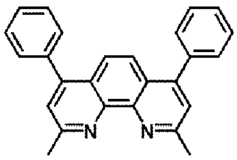

BCP

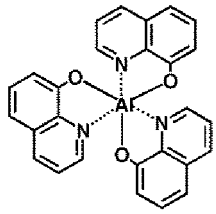

$Alq_3$

Example 2

An organic light-emitting device was manufactured in the same manner as in Example 1, except that Compound 185 shown in Table 7 was used instead of Compound 5 as a dopant in forming an emission layer.

Evaluation Example 4: Evaluation of characteristics of organic light-emitting devices

The driving voltage, emission efficiency, quantum emission efficiency, maximum emission wavelength, and full width at half maximum (FWHM) of the organic light-emitting devices manufactured according to Examples 1 and 2 were evaluated, and evaluation results thereof are shown in Table 7. This evaluation was performed by using a current-voltage meter (Keithley 2400) and a luminance meter (Minolta Cs-1000A).

Table 7

| | Dopant | Driving voltage (V) | Emission efficiency (cd/A) | Quantum emission efficiency (%) | Maximum emission wavelength (nm) | FWHM (nm) |
|---|---|---|---|---|---|---|
| Example 1 | Compound 5 | 3.32 | 77.7 | 24.5 | 567 | 61.6 |
| Example 2 | Compound 185 | 3.40 | 70.6 | 26.3 | 586 | 69.2 |

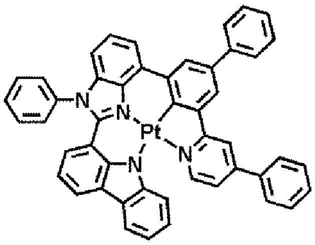

5

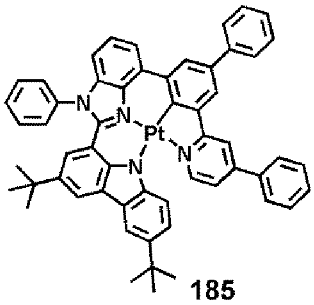

185

Referring to Table 7, it is determined that the organic light-emitting devices of Examples 1 and 2 have excellent driving voltage, emission efficiency, and quantum emission efficiency characteristics and emit red light having a relatively small FWHM.

As described above, the organometallic compounds according to the embodiments of the present disclosure have excellent electrical characteristics and thermal stability, and accordingly, organic light-emitting devices including such organometallic compounds may have excellent driving voltage, emission efficiency, quantum emission efficiency, color purity, and/or lifespan characteristics. Also, due to excellent phosphorescent luminescence characteristics, such organometallic compounds may provide a diagnostic composition having high diagnostic efficiency.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present disclosure as defined by the following claims.

## Claims

1. An organometallic compound represented by Formula 1:
Formula 1

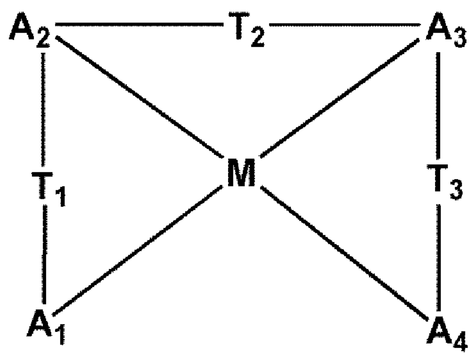

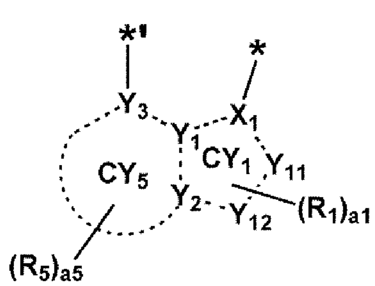

Formula A1-1

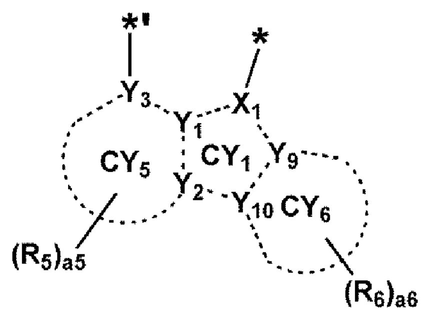

Formula A1-2

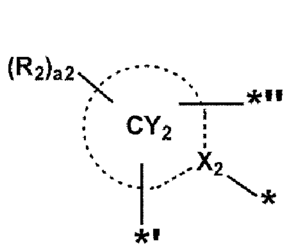

Formula A2-1

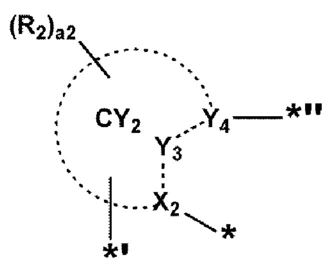

Formula A2-2

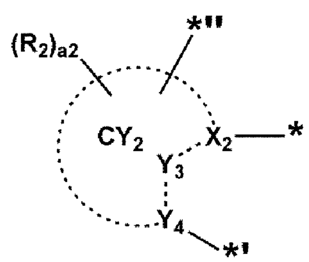

Formula A2-3

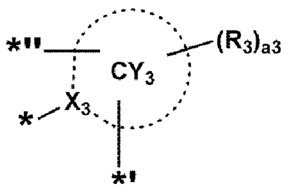

Formula A3-1

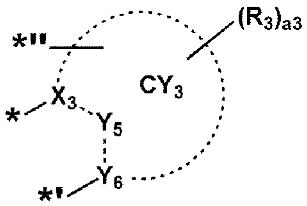

Formula A3-2

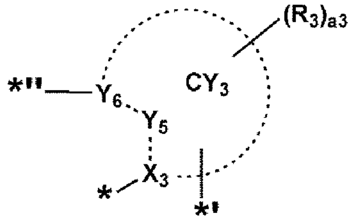

Formula A3-3

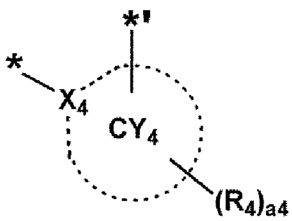

Formula A4-1

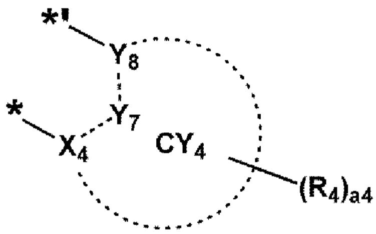

Formula A4-2

,

wherein

M in Formula 1 is platinum (Pt),
in Formula 1, two bonds selected from a bond between $A_1$ and M, a bond between $A_2$ and M, a bond between $A_3$ and M, and a bond between $A_4$ and M are each a covalent bond, and the others thereof are each a coordinate bond,
$A_1$ in Formula 1 is represented by Formula A1-1 or A1-2, and in Formulae A1-1 and A1-2, * indicates a binding site to M in Formula 1, and *' indicates a binding site to $T_1$ in Formula 1,
$A_2$ in Formula 1 is represented by one of Formula A2-1 to A2-3, and in Formulae A2-1 to A2-3, * indicates a binding site to M in Formula 1, *' indicates a binding site to $T_1$ in Formula 1, and *" indicates a binding site to $T_2$ in Formula 1, and in Formula A2-1, the two atoms to which *' and *" are linked are adjacent to $X_2$,
$A_3$ in Formula 1 is represented by one of Formula A3-1 to A3-3, and in Formulae A3-1 to A3-3, * indicates a binding site to M in Formula 1, *" indicates a binding site to $T_2$ in Formula 1, and *' indicates a binding site to $T_3$ in Formula 1, and in Formula A3-1, the two atoms to which *' and *" are linked are adjacent to $X_3$,
$A_4$ in Formula 1 is a non-cyclic moiety comprising a first atom linked to M, or is represented by Formula A4-1 or A4-2, and in Formulae A4-1 and A4-2, * indicates a binding site to M in Formula 1, and *' indicates a binding site to $T_3$ in Formula 1, and in Formula A4-1, the atom to which *' is linked is adjacent to $X_4$,
the first atom is B, N, P, C, Si, O, or S,
in Formulae A1-1, A1-2, A2-1 to A2-3, A3-1 to A3-3, A4-1, and A4-2, $X_1$ to $X_4$ and $Y_1$ to $Y_{10}$ are each independently C or N, and $Y_{11}$ is O, S, N, C, or Si,
$Y_{12}$ is C,
ring $CY_1$ in Formulae A1-1 and A1-2 is a 5-membered ring,
rings $CY_2$ to $CY_6$ in Formulae A1-1, A1-2, A2-1 to A2-3, A3-1 to A3-3, A4-1, and A4-2 are each independently a $C_5$-$C_{30}$ carbocyclic group or a $C_1$-$C_{30}$ heterocyclic group,
$T_1$ to $T_3$ in Formula 1 are each a single bond,
$R_7$ and $R_8$ are optionally linked via a single bond, a double bond, or a first linking group to form a substituted or unsubstituted $C_5$-$C_{30}$ carbocyclic group or a substituted or unsubstituted $C_1$-$C_{30}$ heterocyclic group,
$R_1$ to $R_8$ are each independently selected from hydrogen, deuterium, -F, -Cl,-Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted

or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, and $-P(=O)(Q_8)(Q_9)$,
a1 in Formula A1-1 is an integer from 0 to 4,
a2 to a6 in Formulae A1-1, A1-2, A2-1 to A2-3, A3-1 to A3-3, A4-1, and A4-2 are each independently an integer from 0 to 20,
two of a plurality of neighboring groups $R_2$ are optionally linked to form a substituted or unsubstituted $C_5$-$C_{30}$ carbocyclic group or a substituted or unsubstituted $C_1$-$C_{30}$ heterocyclic group,
two of a plurality of neighboring groups $R_3$ are optionally linked to form a substituted or unsubstituted $C_5$-$C_{30}$ carbocyclic group or a substituted or unsubstituted $C_1$-$C_{30}$ heterocyclic group,
two of a plurality of neighboring groups $R_4$ are optionally linked to form a substituted or unsubstituted $C_5$-$C_{30}$ carbocyclic group or a substituted or unsubstituted $C_1$-$C_{30}$ heterocyclic group,
two of a plurality of neighboring groups $R_5$ are optionally linked to form a substituted or unsubstituted $C_5$-$C_{30}$ carbocyclic group or a substituted or unsubstituted $C_1$-$C_{30}$ heterocyclic group,
two of a plurality of neighboring groups $R_6$ are optionally linked to form a substituted or unsubstituted $C_5$-$C_{30}$ carbocyclic group or a substituted or unsubstituted $C_1$-$C_{30}$ heterocyclic group,
two or more neighboring groups selected from $R_2$ to $R_5$ are optionally linked to form a substituted or unsubstituted $C_5$-$C_{30}$ carbocyclic group or a substituted or unsubstituted $C_1$-$C_{30}$ heterocyclic group,
$A_1$ and $A_4$ in Formula 1 are not linked to each other,
i) when $A_1$ in Formula 1 is represented by Formula A1-1, the organometallic compound represented by Formula 1 satisfies "Condition 1", and ii) when $A_1$ in Formula 1 is represented by Formula A1-2, the organometallic compound represented by Formula 1 satisfies at least one of "Condition 1" to "Condition 3",

"Condition 1"
$A_2$ in Formula 1 is represented by Formula A2-2 or A2-3,
"Condition 2"
$A_3$ in Formula 1 is represented by Formula A3-2 or A3-3, and
"Condition 3"
$A_4$ in Formula 1 is represented by Formula A4-2,

wherein at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group is selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F,-Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$

heteroarylalkyl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$,$-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$,$-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

**2.** The organometallic compound of claim 1, wherein
a bond between $A_1$ and M and a bond between $A_3$ and M are each a covalent bond, and a bond between $A_2$ and M and a bond between $A_4$ and M are each a coordinate bond, or
a bond between $A_1$ and M and a bond between $A_4$ and M are each a covalent bond, and a bond between $A_2$ and M and a bond between $A_3$ and M are each a coordinate bond.

**3.** The organometallic compound of claims 1 or 2, wherein
ring $CY_1$ is selected from a pyrrole group, a furan group, a thiophene group, a silole group, a pyrazole group, an imidazole group, a triazole group, a tetrazole group, an oxazole group, an isoxazole group, a thiazole group, an isothiazole group, an oxadiazole group, a thiadiazole group, an oxatriazole group, and a thiatriazole group.

**4.** The organometallic compound of any of claims 1-3, wherein
rings $CY_2$ to $CY_6$ are each independently selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a 5,6,7,8-tetrahydroisoquinoline group, and a 5,6,7,8-tetrahydroquinoline group.

**5.** The organometallic compound of any of claims 1-4, wherein
at least one of rings $CY_2$ to $CY_4$ is a condensed ring with at least one 5-membered ring and at least one 6-membered ring or a condensed ring with at least two 6-membered rings,
the 5-membered ring is selected from a cyclopentadiene group, a furan group, a thiophene group, a pyrrole group,

a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and
the 6-membered ring is selected from a cyclohexane group, a cyclohexene group, a benzene group, a pyridine group, a pyrimidine group, a pyrazine group, and a pyridazine group.

**6.** The organometallic compound of any of claims 1-5, wherein
$R_1$ to $R_8$ are each independently selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$,$-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I,$-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and $-Si(Q_{33})(Q_{34})(Q_{35})$; and
$-N(Q_1)(Q_2)$, $-Si(Q_3)(Q_4)(Q_5)$, $-B(Q_6)(Q_7)$, and $-P(=O)(Q_8)(Q_9)$, and
$Q_1$ to $Q_9$ and $Q_{33}$ to $Q_{35}$ are each independently selected from:
$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CH_3$, $-CD_2CD_3$, $-CD_2CD_2H$, and$-CD_2CDH_2$;
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group.

7. The organometallic compound of any of claims 1-6, wherein
$R_1$ to $R_8$ are each independently selected from hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, groups represented by Formulae 9-1 to 9-19, groups represented by Formulae 10-1 to 10-161, $-N(Q_1)(Q_2)$, $-Si(Q_3)(Q_4)(Q_5)$, $-B(Q_6)(Q_7)$, and $-P(=O)(Q_8)(Q_9)$:

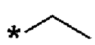
Formula 9-1
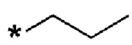
Formula 9-2
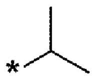
Formula 9-3
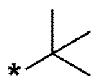
Formula 9-4
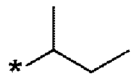
Formula 9-5
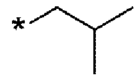
Formula 9-6
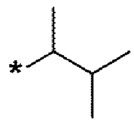
Formula 9-7

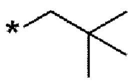
Formula 9-8
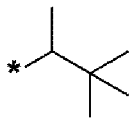
Formula 9-9
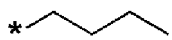
Formula 9-10
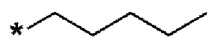
Formula 9-11
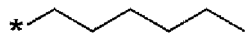
Formula 9-12

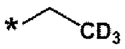
Formula 9-13
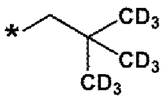
Formula 9-14
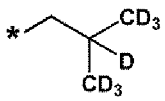
Formula 9-15
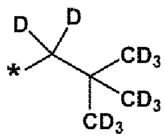
Formula 9-16
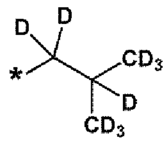
Formula 9-17
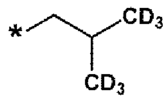
Formula 9-18

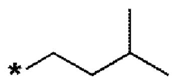
Formula 9-19

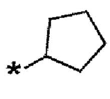
Formula 10-1
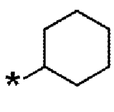
Formula 10-2
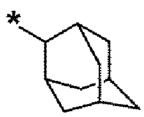
Formula 10-3
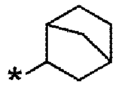
Formula 10-4
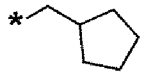
Formula 10-5
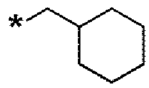
Formula 10-6
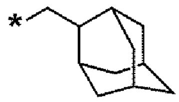
Formula 10-7

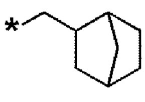
Formula 10-8
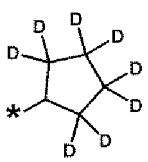
Formula 10-9
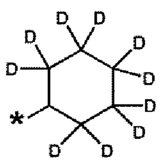
Formula 10-10
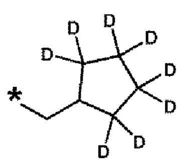
Formula 10-11
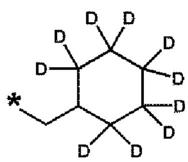
Formula 10-12
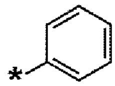
Formula 10-13

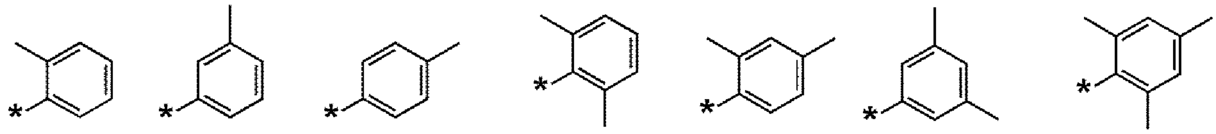

Formula 10-14 Formula 10-15 Formula 10-16 Formula 10-17 Formula 10-18 Formula 10-19 Formula 10-20

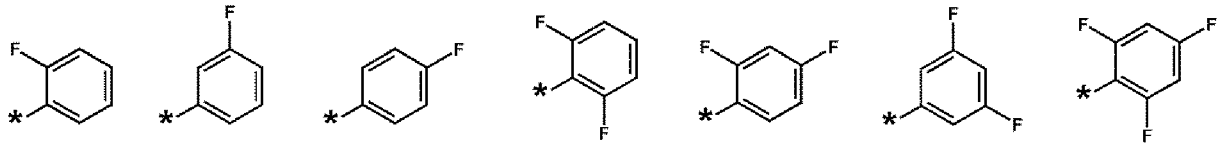

Formula 10-21 Formula 10-22 Formula 10-23 Formula 10-24 Formula 10-25 Formula 10-26 Formula 10-27

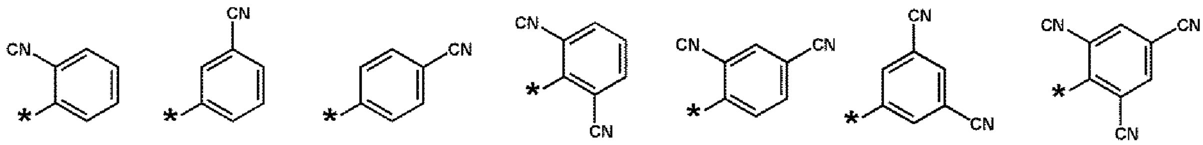

Formula 10-28 Formula 10-29 Formula 10-30 Formula 10-31 Formula 10-32 Formula 10-33 Formula 10-34

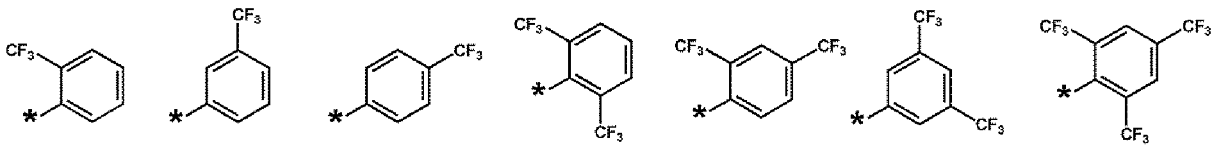

Formula 10-35 Formula 10-36 Formula 10-37 Formula 10-38 Formula 10-39 Formula 10-40 Formula 10-41

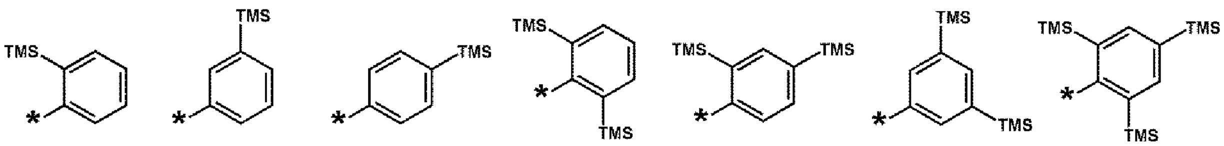

Formula 10-42 Formula 10-43 Formula 10-44 Formula 10-45 Formula 10-46 Formula 10-47 Formula 10-48

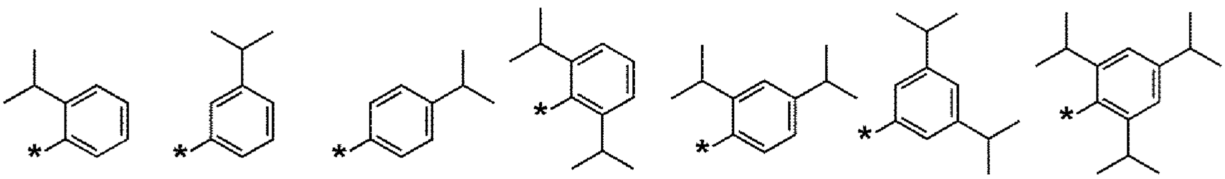

Formula 10-49 Formula 10-50 Formula 10-51 Formula 10-52 Formula 10-53 Formula 10-54 Formula 10-55

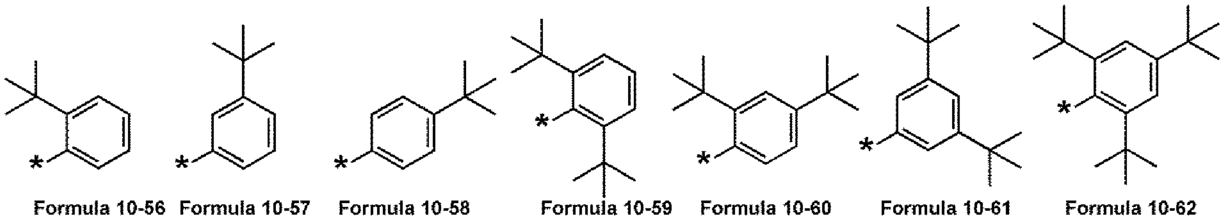

Formula 10-56 Formula 10-57 Formula 10-58 Formula 10-59 Formula 10-60 Formula 10-61 Formula 10-62

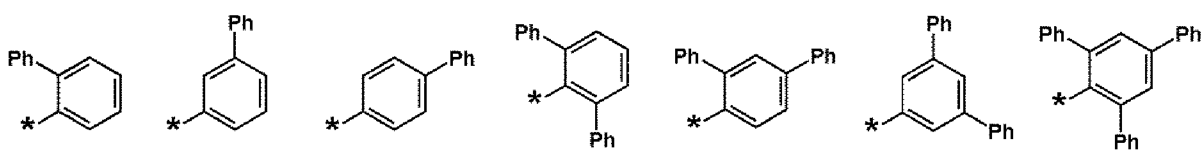

Formula 10-63 Formula 10-64 Formula 10-65 Formula 10-66 Formula 10-67 Formula 10-68 Formula 10-69

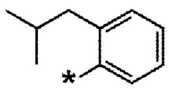
Formula 10-70

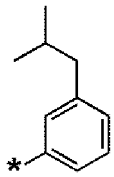
Formula 10-71

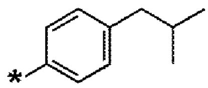
Formula 10-72

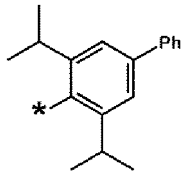
Formula 10-73

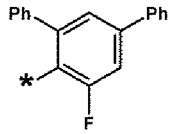
Formula 10-74

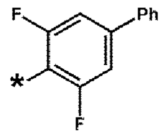
Formula 10-75

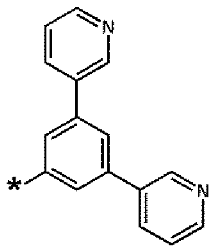
Formula 10-76

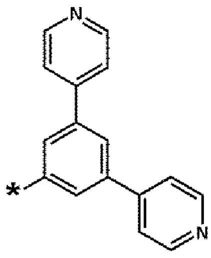
Formula 10-77

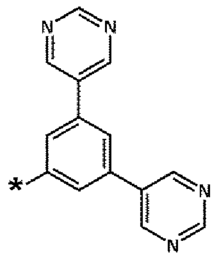
Formula 10-78

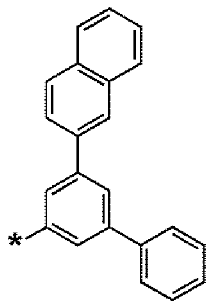
Formula 10-79

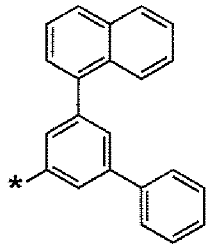
Formula 10-80

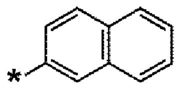
Formula 10-81

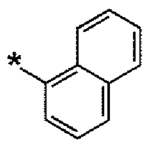
Formula 10-82

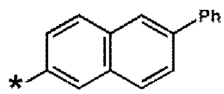
Formula 10-83

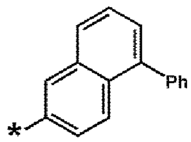
Formula 10-84

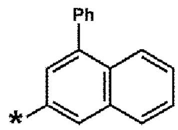
Formula 10-85

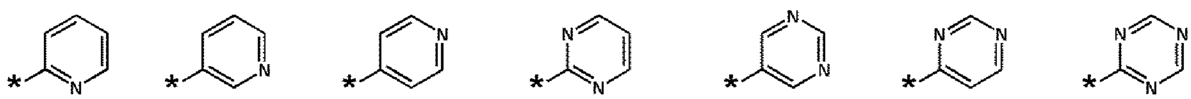
Formula 10-86 Formula 10-87 Formula 10-88 Formula 10-89 Formula 10-90 Formula 10-91 Formula 10-92

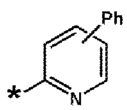
Formula 10-93

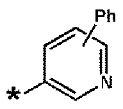
Formula 10-94

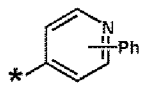
Formula 10-95

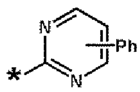
Formula 10-96

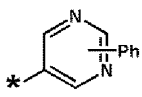
Formula 10-97

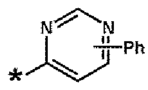
Formula 10-98

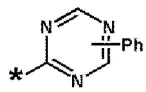
Formula 10-99

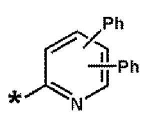
Formula 10-100

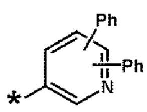
Formula 10-101

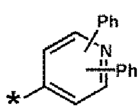
Formula 10-102

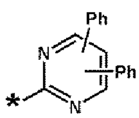
Formula 10-103

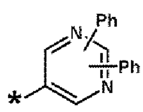
Formula 10-104

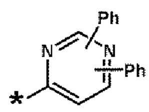
Formula 10-105

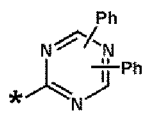
Formula 10-106

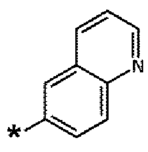
Formula 10-107

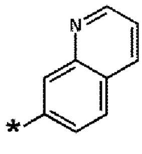
Formula 10-108

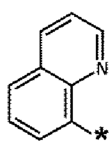
Formula 10-109

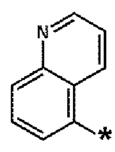
Formula 10-110

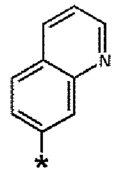
Formula 10-111

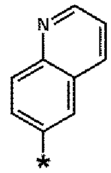
Formula 10-112

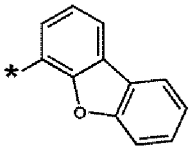
Formula 10-113

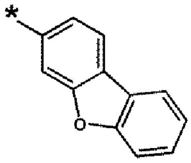
Formula 10-114

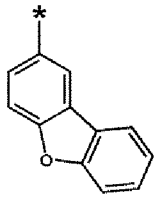
Formula 10-115

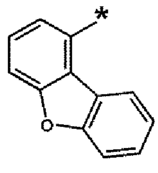
Formula 10-116

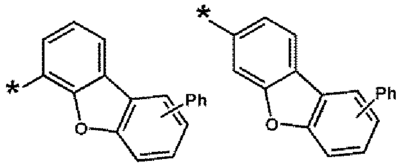
Formula 10-117 Formula 10-118

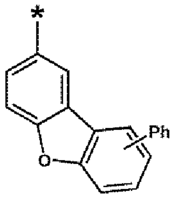
Formula 10-119

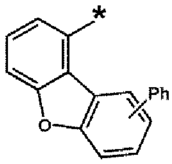
Formula 10-120

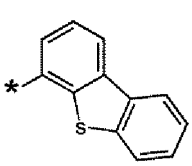
Formula 10-121

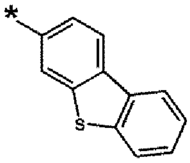
Formula 10-122

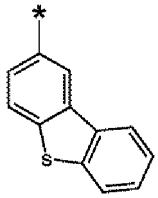
Formula 10-123

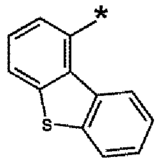
Formula 10-124

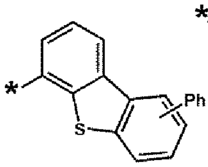
Formula 10-125

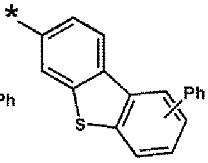
Formula 10-126

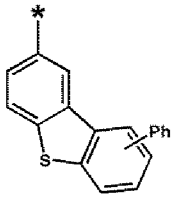
Formula 10-127

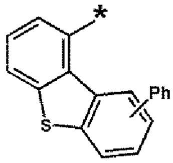
Formula 10-128

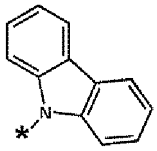
Formula 10-129

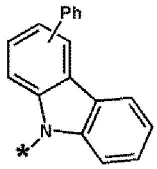
Formula 10-130

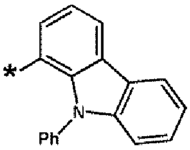
Formula 10-131

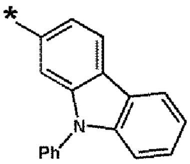
Formula 10-132

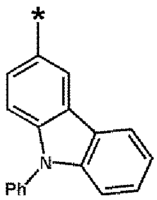
Formula 10-133

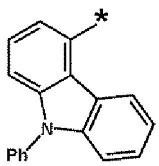
Formula 10-134

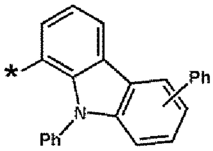
Formula 10-135

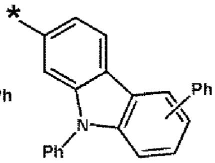
Formula 10-136

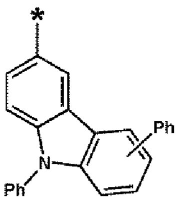
Formula 10-137

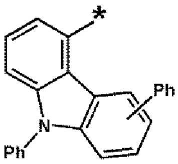
Formula 10-138

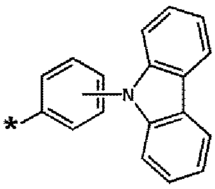
Formula 10-139

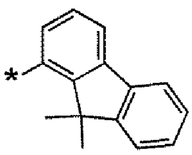
Formula 10-140

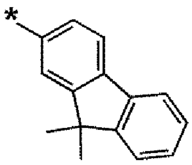
Formula 10-141

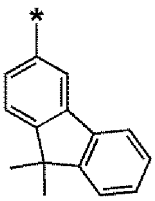
Formula 10-142

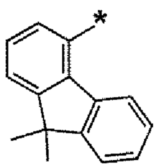
Formula 10-143

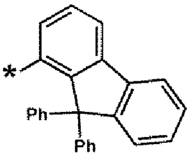
Formula 10-144

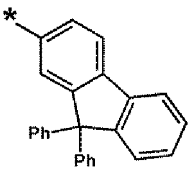
Formula 10-145

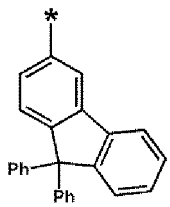
Formula 10-146

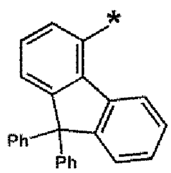
Formula 10-147

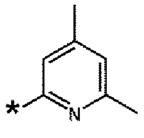 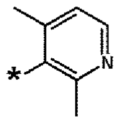 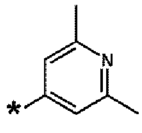 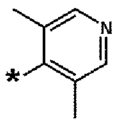 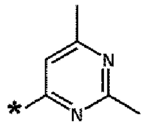 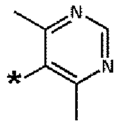 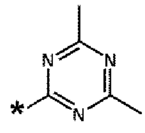

Formula 10-148 Formula 10-149 Formula 10-150 Formula 10-151 Formula 10-152 Formula 10-153 Formula 10-154

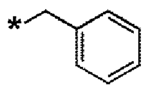 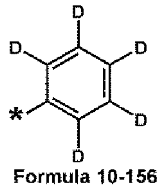 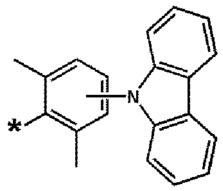 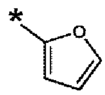 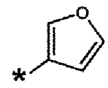 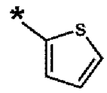 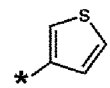

Formula 10-155 Formula 10-156 Formula 10-157 Formula 10-158 Formula 10-159 Formula 10-160 Formula 10-161

,

wherein, in Formulae 9-1 to 9-19 and 10-1 to 10-161, "Ph" indicates a phenyl group, "TMS" indicates a trimethylsilyl group, and * indicates a binding site to a neighboring atom and $Q_1$ to $Q_9$ are the same as described in claim 1.

**8.** The organometallic compound of any of claims 1-7, wherein $A_1$ is represented by one of Formulae A1-1(1) to A1-1(24) and A1-2(1) to A1-2(8):

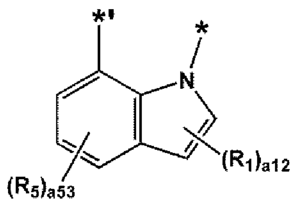 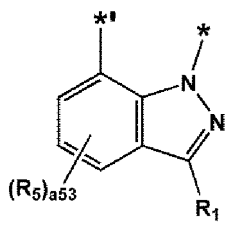 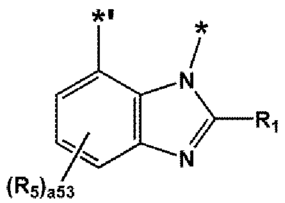 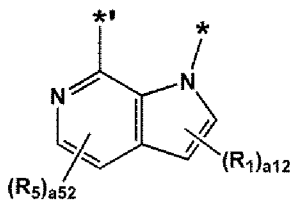

Formula A1-1(1) Formula A1-1(2) Formula A1-1(3) Formula A1-1(4)

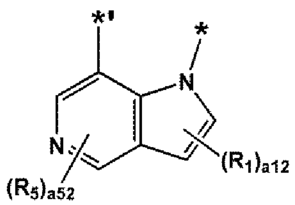 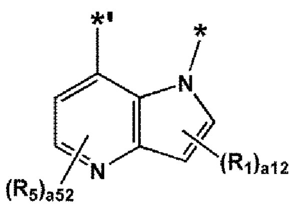 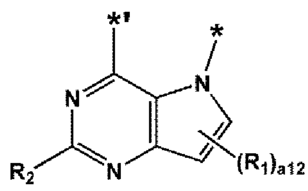 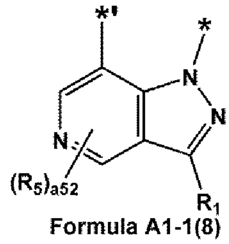

Formula A1-1(5) Formula A1-1(6) Formula A1-1(7) Formula A1-1(8)

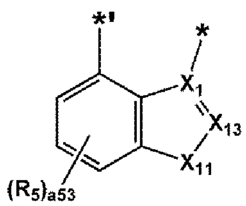 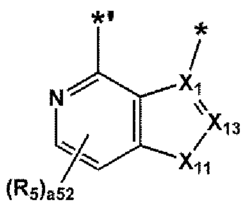 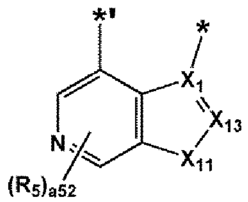 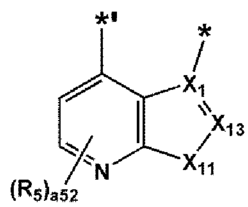

Formula A1-1(9) Formula A1-1(10) Formula A1-1(11) Formula A1-1(12)

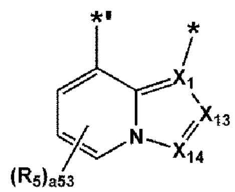
Formula A1-1(13)

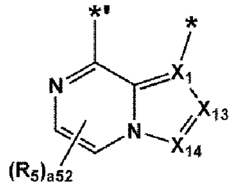
Formula A1-1(14)

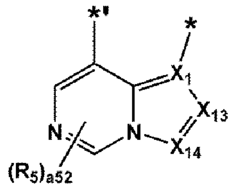
Formula A1-1(15)

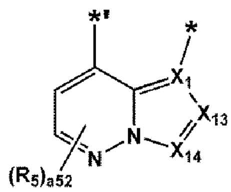
Formula A1-1(16)

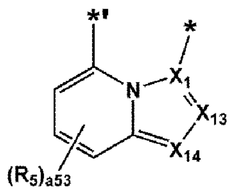
Formula A1-1(17)

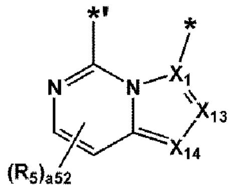
Formula A1-1(18)

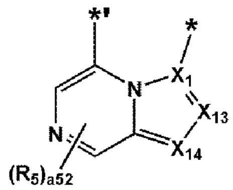
Formula A1-1(19)

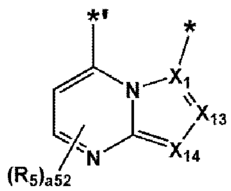
Formula A1-1(20)

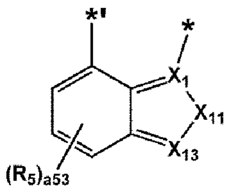
Formula A1-1(21)

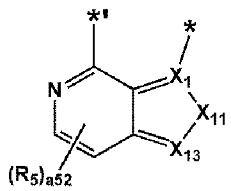
Formula A1-1(22)

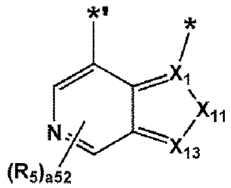
Formula A1-1(23)

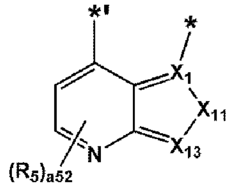
Formula A1-1(24)

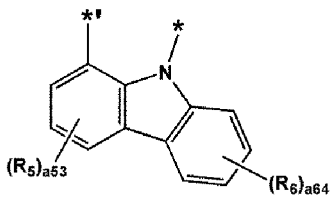
Formula A1-2(1)

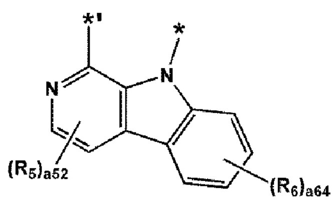
Formula A1-2(2)

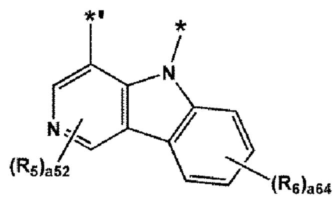
Formula A1-2(3)

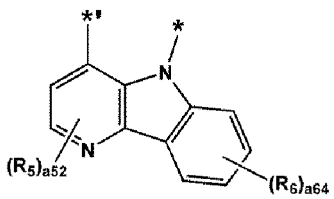
Formula A1-2(4)

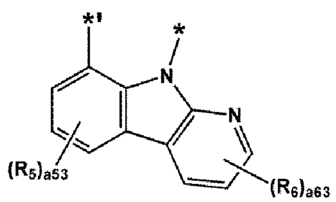
Formula A1-2(5)

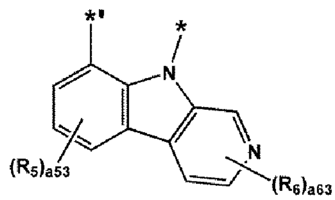
Formula A1-2(6)

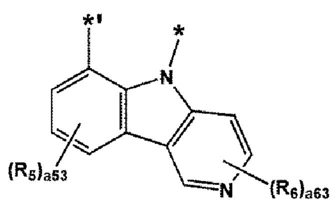
Formula A1-2(7)

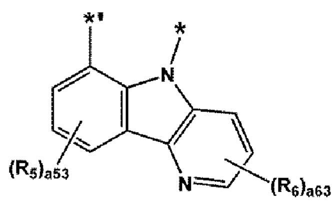
Formula A1-2(8)

,

wherein, in Formulae A1-1(1) to A1-1(24) and A1-2(1) to A1-2(8),

$X_1$, $R_1$, $R_5$, $R_6$, *, and *' are the same as described in claim 1,

$X_{11}$ is O, S, $N(R_{11})$, $C(R_{11})(R_{12})$, or $Si(R_{11})(R_{12})$,
$X_{13}$ is N or $C(R_{13})$,
$X_{14}$ is N or $C(R_{14})$,
$R_{11}$ to $R_{14}$ are the same as described in connection with $R_1$,
a64 is an integer from 0 to 4,
a53 and a63 are each independently an integer from 0 to 3, and
a12 and a52 are each independently an integer from 0 to 2; and/or

wherein
$A_2$ is represented by one of Formulae A2-1(1) to A2-1(17), A2-2(1) to A2-2(58), and A2-3(1) to A2-3(58):

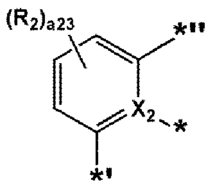
Formula A2-1(1)

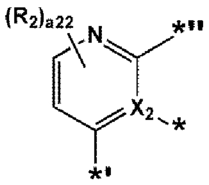
Formula A2-1(2)

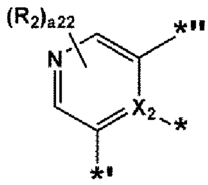
Formula A2-1(3)

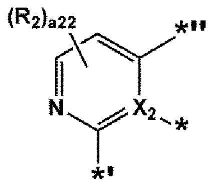
Formula A2-1(4)

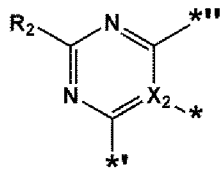
Formula A2-1(5)

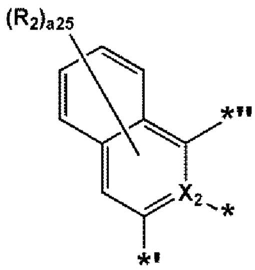
Formula A2-1(6)

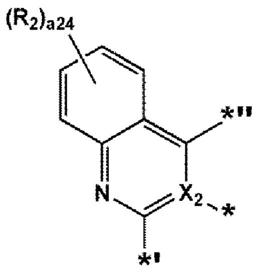
Formula A2-1(7)

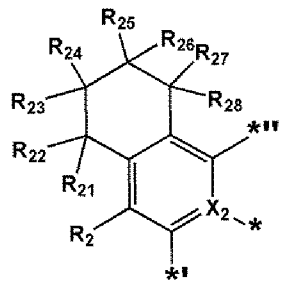
Formula A2-1(8)

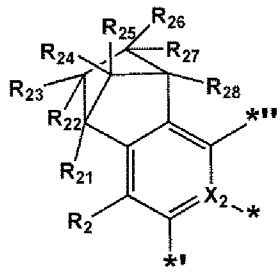
Formula A2-1(9)

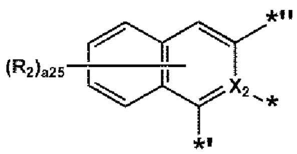
Formula A2-1(10)

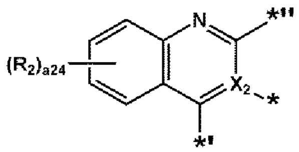
Formula A2-1(11)

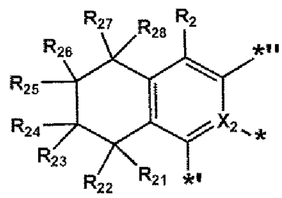
Formula A2-1(12)

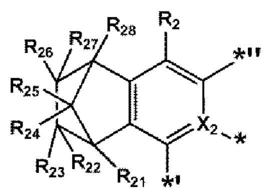
Formula A2-1(13)

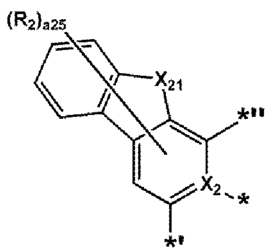
Formula A2-1(14)

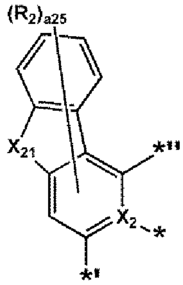
Formula A2-1(15)

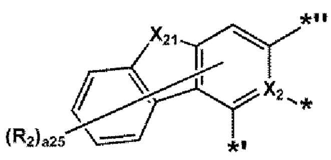
Formula A2-1(16)

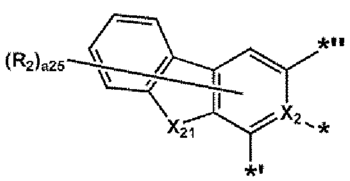
Formula A2-1(17)

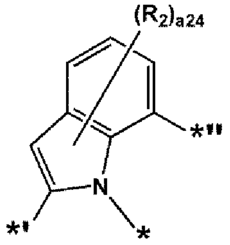

Formula A2-2(1)

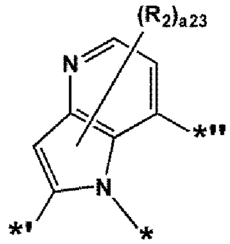

Formula A2-2(2)

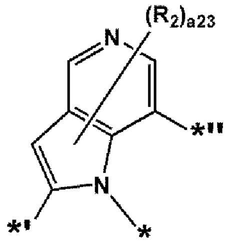

Formula A2-2(3)

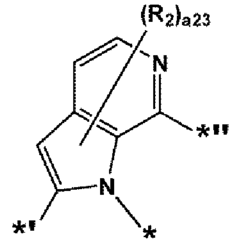

Formula A2-2(4)

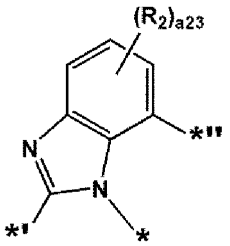

Formula A2-2(5)

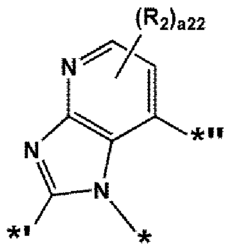

Formula A2-2(6)

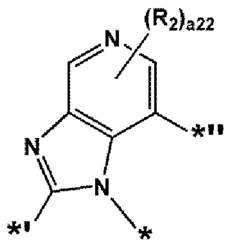

Formula A2-2(7)

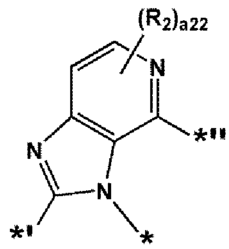

Formula A2-2(8)

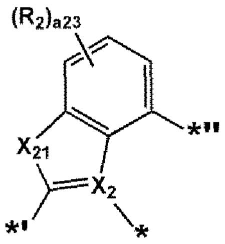

Formula A2-2(9)

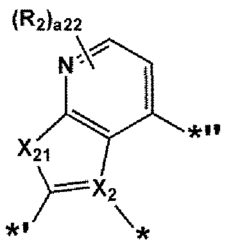

Formula A2-2(10)

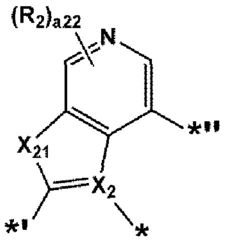

Formula A2-2(11)

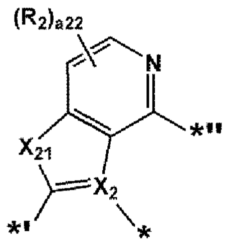

Formula A2-2(12)

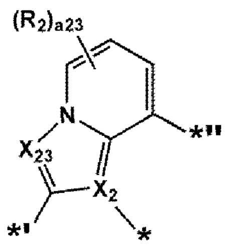

Formula A2-2(13)

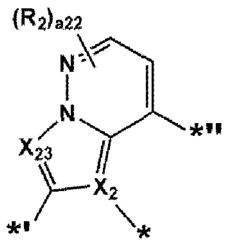

Formula A2-2(14)

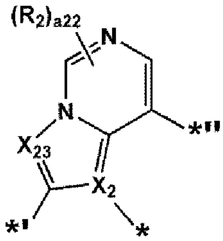

Formula A2-2(15)

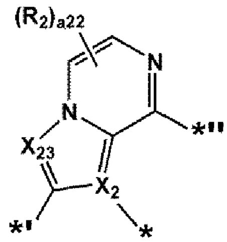

Formula A2-2(16)

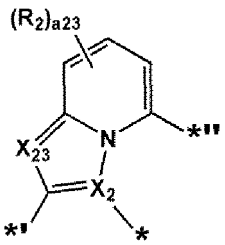

Formula A2-2(17)

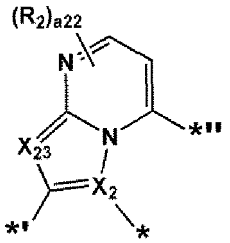

Formula A2-2(18)

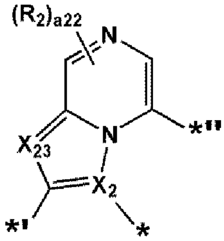

Formula A2-2(19)

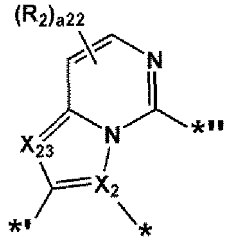

Formula A2-2(20)

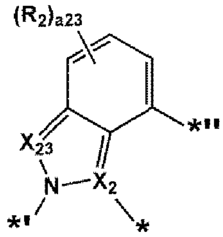

Formula A2-2(21)

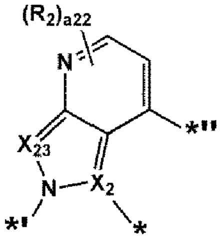

Formula A2-2(22)

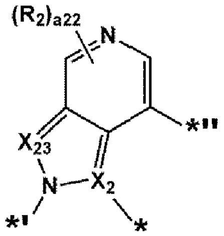

Formula A2-2(23)

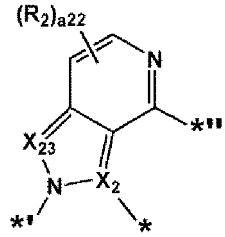

Formula A2-2(24)

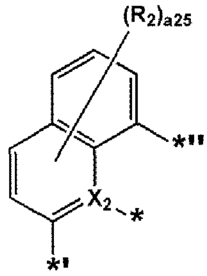

Formula A2-2(25)

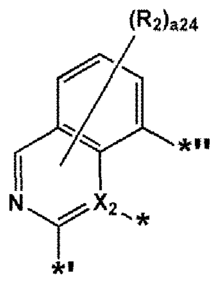

Formula A2-2(26)

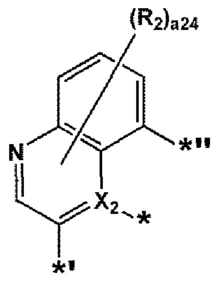

Formula A2-2(27)

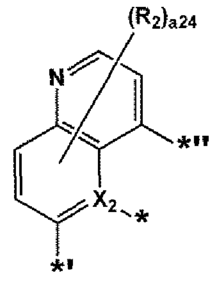

Formula A2-2(28)

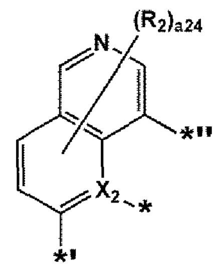

Formula A2-2(29)

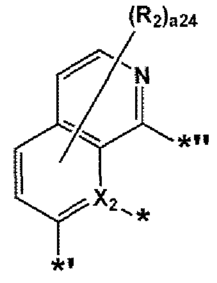

Formula A2-2(30)

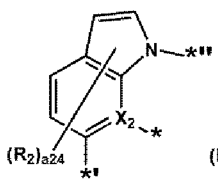

Formula A2-2(31)

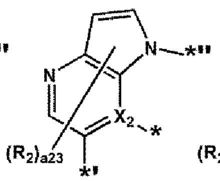

Formula A2-2(32)

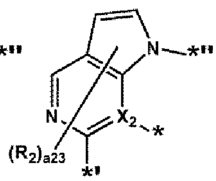

Formula A2-2(33)

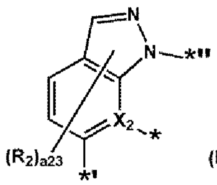

Formula A2-2(34)

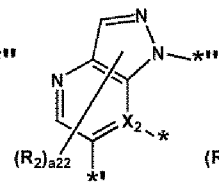

Formula A2-2(35)

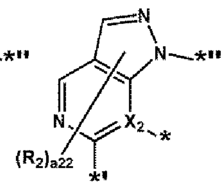

Formula A2-2(36)

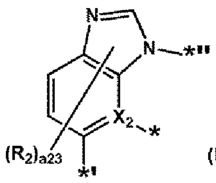

Formula A2-2(37)

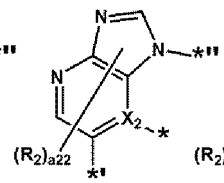

Formula A2-2(38)

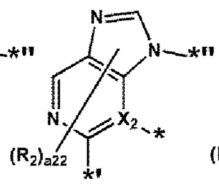

Formula A2-2(39)

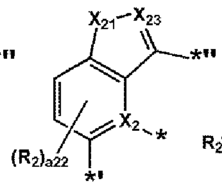

Formula A2-2(40)

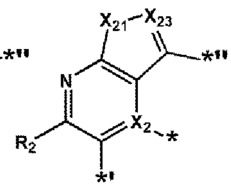

Formula A2-2(41)

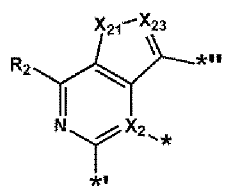

Formula A2-2(42)

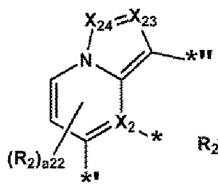

Formula A2-2(43)

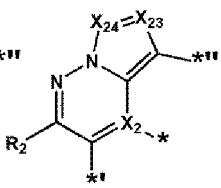

Formula A2-2(44)

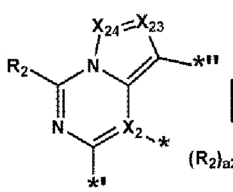

Formula A2-2(45)

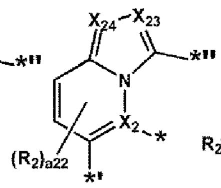

Formula A2-2(46)

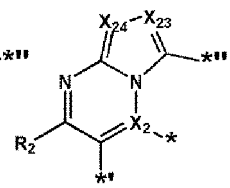

Formula A2-2(47)

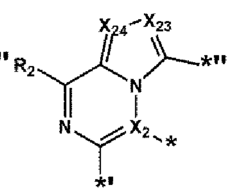

Formula A2-2(48)

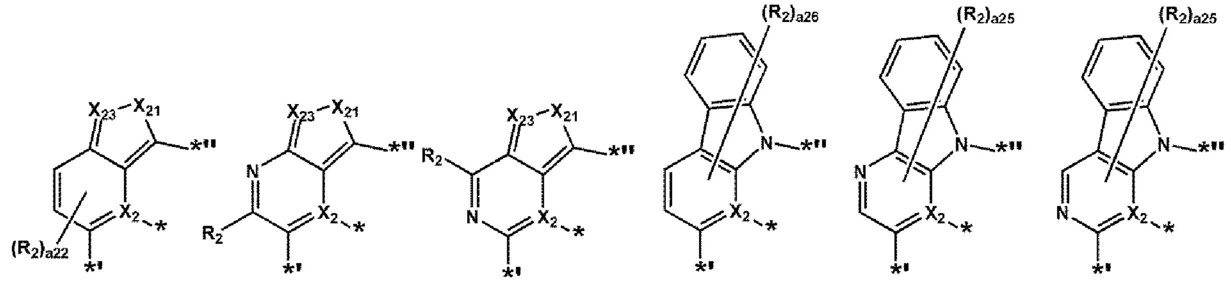

Formula A2-2(49) Formula A2-2(50) Formula A2-2(51) Formula A2-2(52) Formula A2-2(53) Formula A2-2(54)

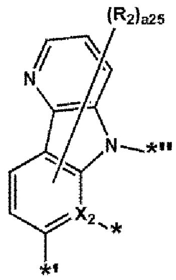

Formula A2-2(55)

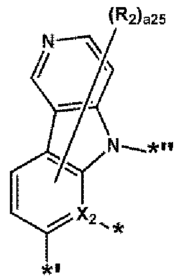

Formula A2-2(56)

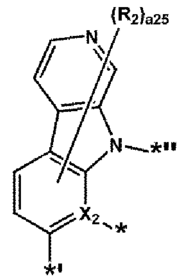

Formula A2-2(57)

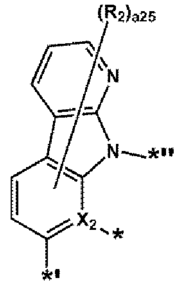

Formula A2-2(58)

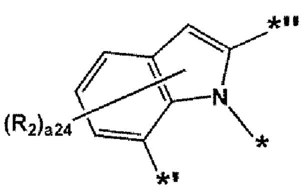

Formula A2-3(1)

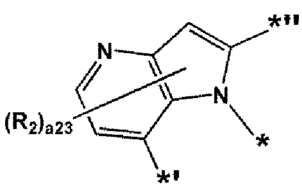

Formula A2-3(2)

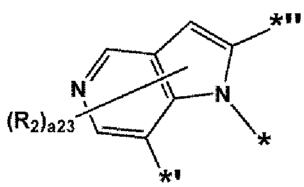

Formula A2-3(3)

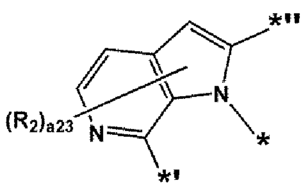

Formula A2-3(4)

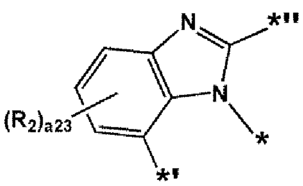

Formula A2-3(5)

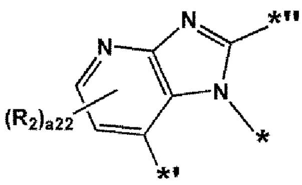

Formula A2-3(6)

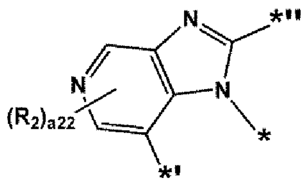

Formula A2-3(7)

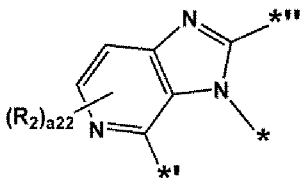

Formula A2-3(8)

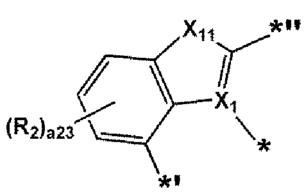

Formula A2-3(9)

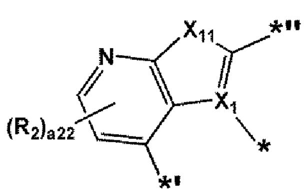

Formula A2-3(10)

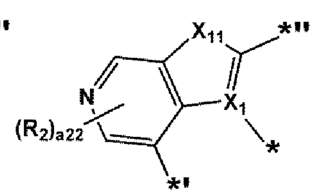

Formula A2-3(11)

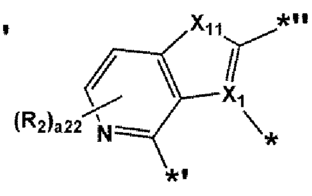

Formula A2-3(12)

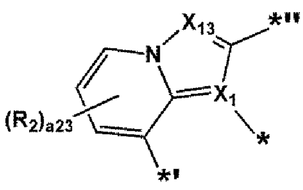

Formula A2-3(13)

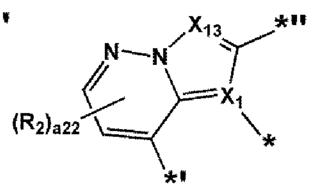

Formula A2-3(14)

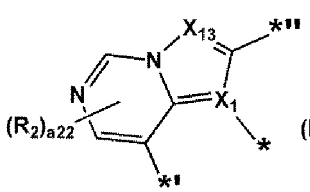

Formula A2-3(15)

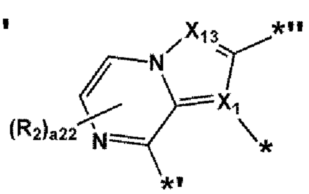

Formula A2-3(16)

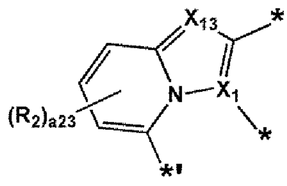

Formula A2-3(17)

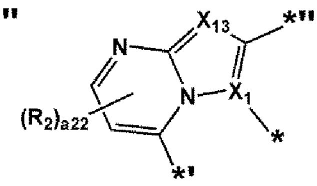

Formula A2-3(18)

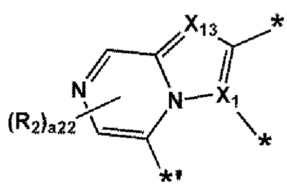

Formula A2-3(19)

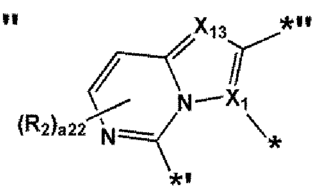

Formula A2-3(20)

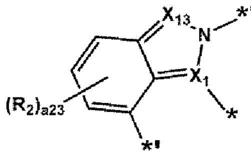

Formula A2-3(21)

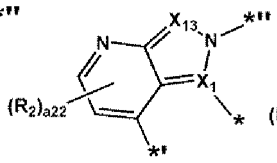

Formula A2-3(22)

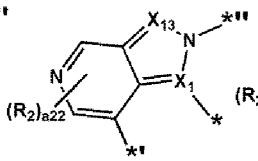

Formula A2-3(23)

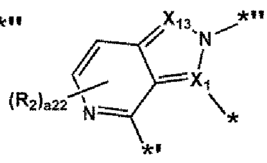

Formula A2-3(24)

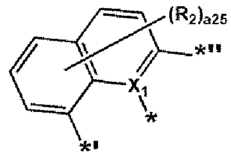

Formula A2-3(25)

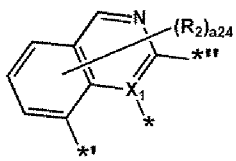

Formula A2-3(26)

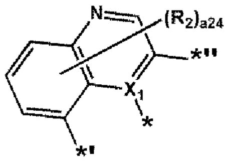

Formula A2-3(27)

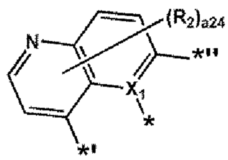

Formula A2-3(28)

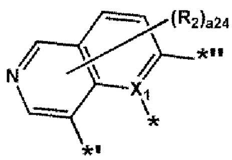

Formula A2-3(29)

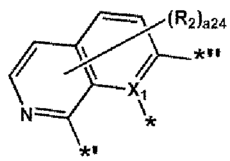

Formula A2-3(30)

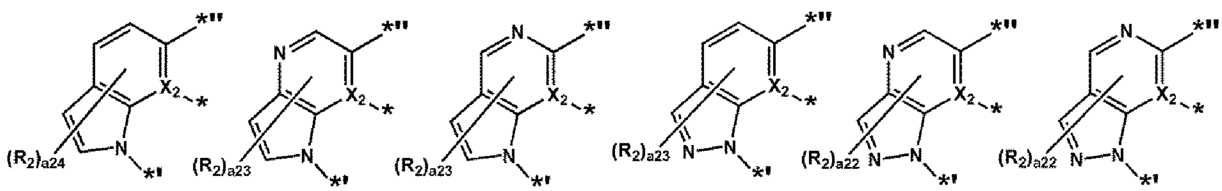

Formula A2-3(31) Formula A2-3(32) Formula A2-3(33) Formula A2-3(34) Formula A2-3(35) Formula A2-3(36)

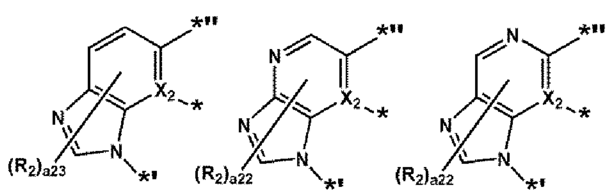

Formula A2-3(37) Formula A2-3(38) Formula A2-3(39)

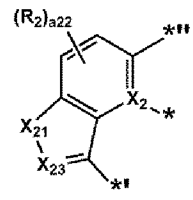

Formula A2-3(40)

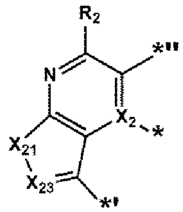

Formula A2-3(41)

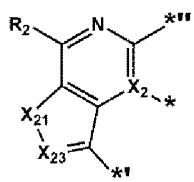

Formula A2-3(42)

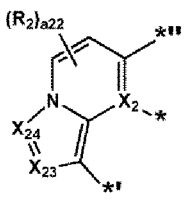

Formula A2-3(43)

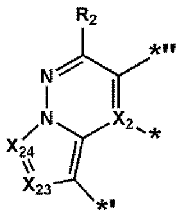

Formula A2-3(44)

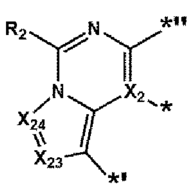

Formula A2-3(45)

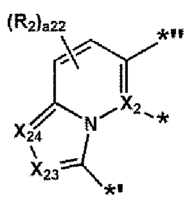

Formula A2-3(46)

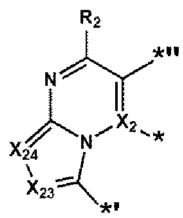

Formula A2-3(47)

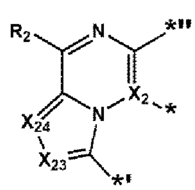

Formula A2-3(48)

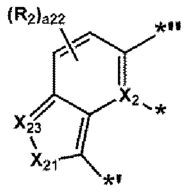
Formula A2-3(49)

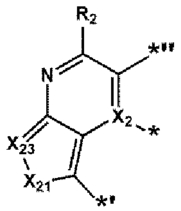
Formula A2-3(50)

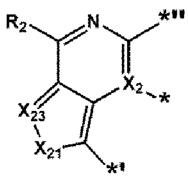
Formula A2-3(51)

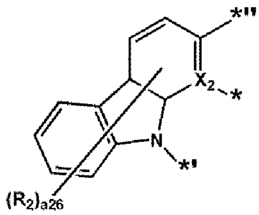
Formula A2-3(52)

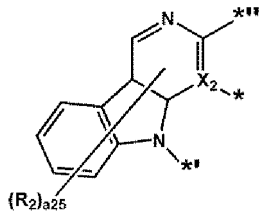
Formula A2-3(53)

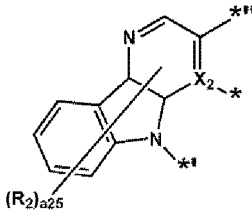
Formula A2-3(54)

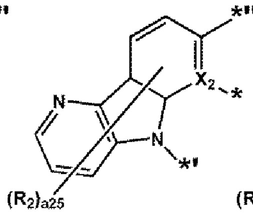
Formula A2-3(55)

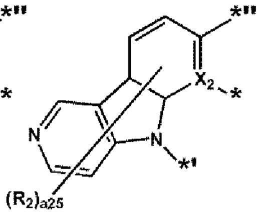
Formula A2-3(56)

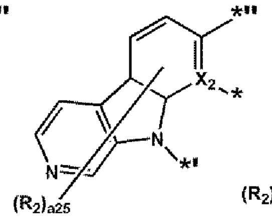
Formula A2-3(57)

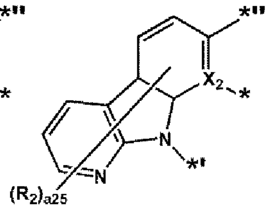
Formula A2-3(58)

,

wherein, in Formulae A2-1(1) to A2-1(17), A2-2(1) to A2-2(58), and A2-3(1) to A2-3(58),

$X_2$ and $R_2$ are the same as described in claim 1,
$X_{21}$ is O, S, $N(R_{21})$, $C(R_{21})(R_{22})$, or $Si(R_{21})(R_{22})$,
$X_{23}$ is N or $C(R_{23})$,
$X_{24}$ is N or $C(R_{24})$,
$R_{21}$ to $R_{28}$ are the same as described in connection with $R_2$ in claim 1,
a26 is an integer from 0 to 6,
a25 is an integer from 0 to 5,
a24 is an integer from 0 to 4,
a23 is an integer from 0 to 3,
a22 is an integer from 0 to 2, and
*, *', and *" are the same as described in connection with *, *', and *" in Formula A2-1; and/or

wherein
$A_3$ is represented by one of Formulae A3-1(1) to A3-1(21), A3-2(1) to A3-2(58), and A3-3(1) to A3-3(58):

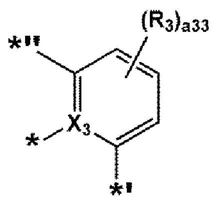
Formula A3-1(1)

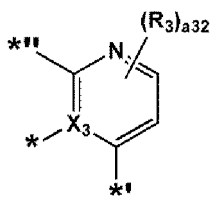
Formula A3-1(2)

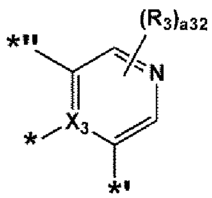
Formula A3-1(3)

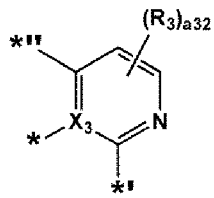
Formula A3-1(4)

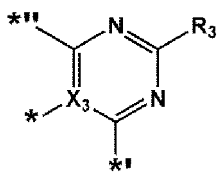
Formula A3-1(5)

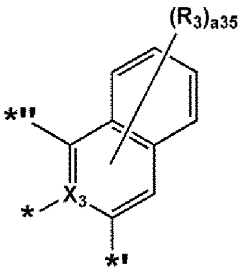
Formula A3-1(6)

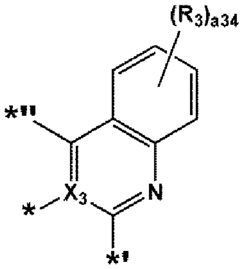
Formula A3-1(7)

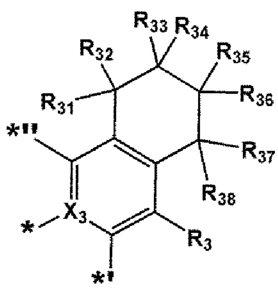
Formula A3-1(8)

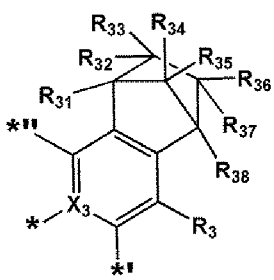
Formula A3-1(9)

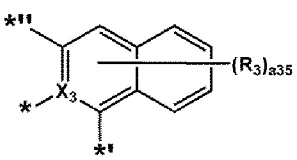
Formula A3-1(10)

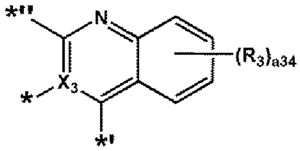
Formula A3-1(11)

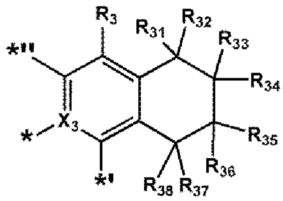
Formula A3-1(12)

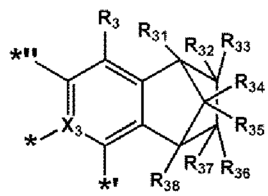
Formula A3-1(13)

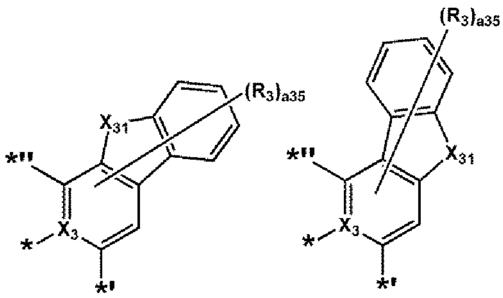
Formula A3-1(14)

Formula A3-1(15)

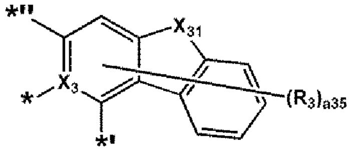
Formula A3-1(16)

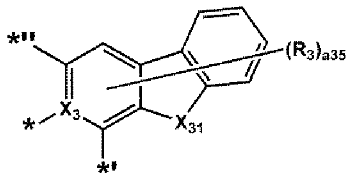
Formula A3-1(17)

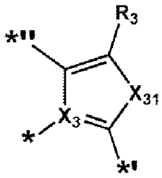
Formula A3-1(18)

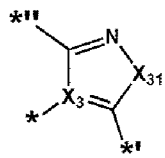
Formula A3-1(19)

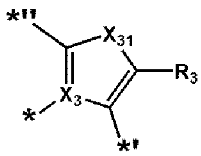
Formula A3-1(20)

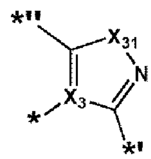
Formula A3-1(21)

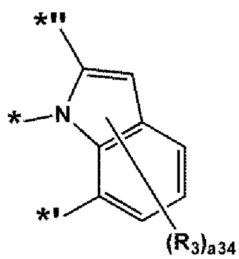
Formula A3-2(1)

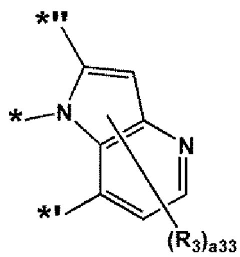
Formula A3-2(2)

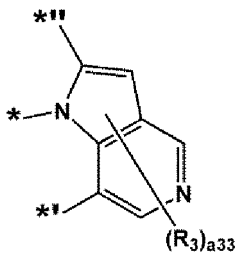
Formula A3-2(3)

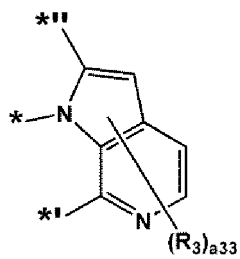
Formula A3-2(4)

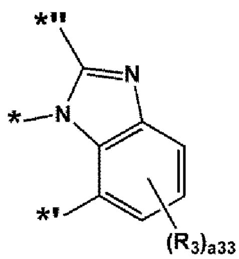
Formula A3-2(5)

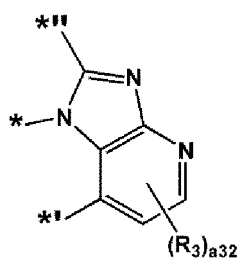
Formula A3-2(6)

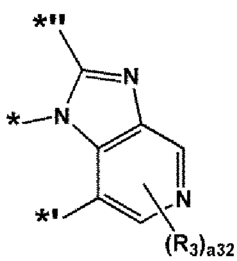
Formula A3-2(7)

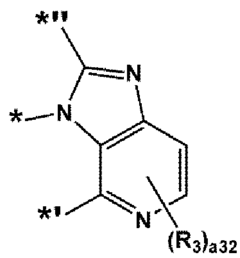
Formula A3-2(8)

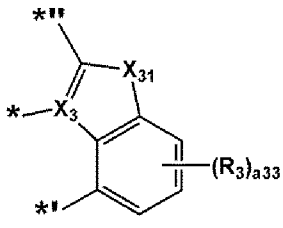

Formula A3-2(9)

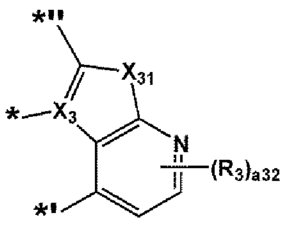

Formula A3-2(10)

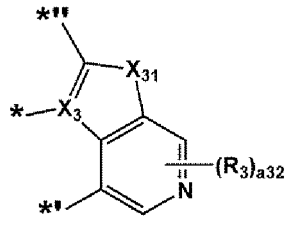

Formula A3-2(11)

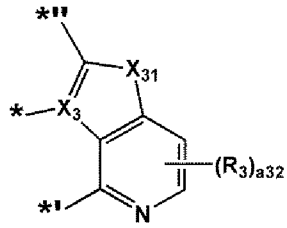

Formula A3-2(12)

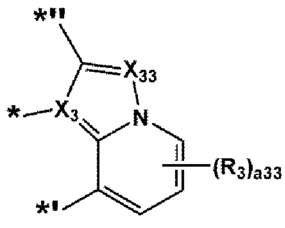

Formula A3-2(13)

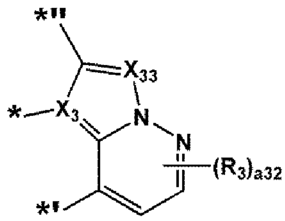

Formula A3-2(14)

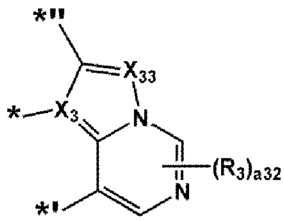

Formula A3-2(15)

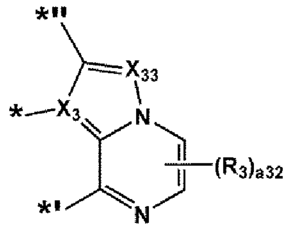

Formula A3-2(16)

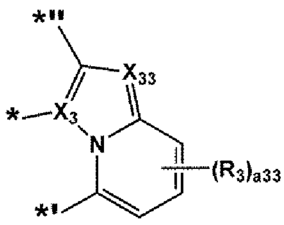

Formula A3-2(17)

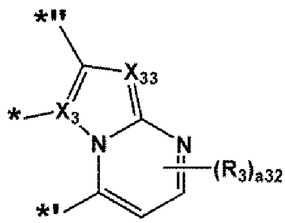

Formula A3-2(18)

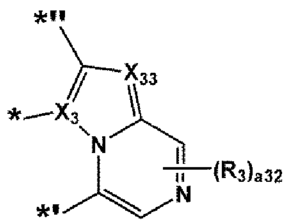

Formula A3-2(19)

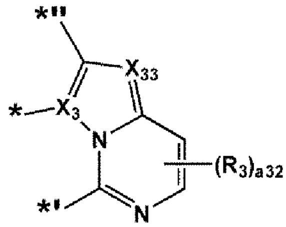

Formula A3-2(20)

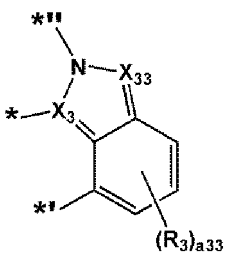

Formula A3-2(21)

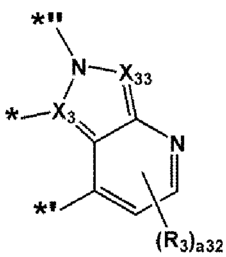

Formula A3-2(22)

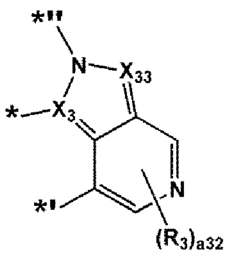

Formula A3-2(23)

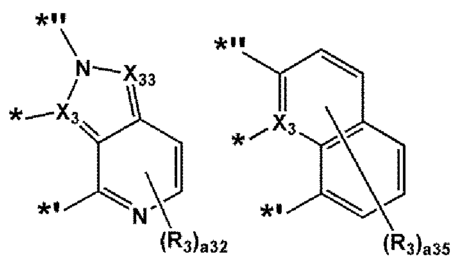

Formula A3-2(24) Formula A3-2(25)

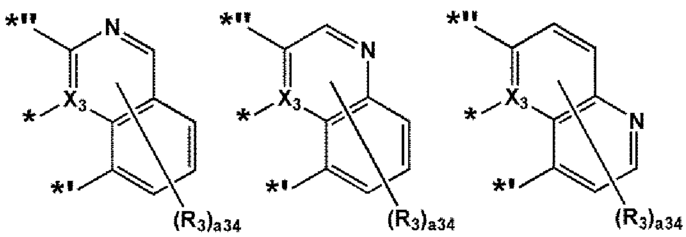

Formula A3-2(26) Formula A3-2(27) Formula A3-2(28)

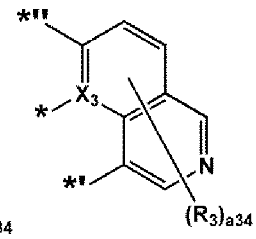

Formula A3-2(29)

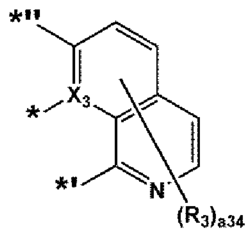

Formula A3-2(30)

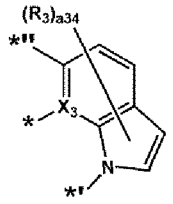
Formula A3-2(31)

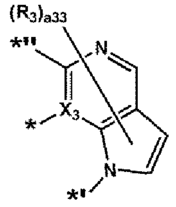
Formula A3-2(32)

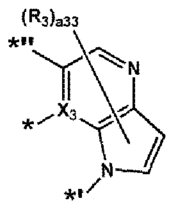
Formula A3-2(33)

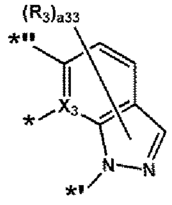
Formula A3-2(34)

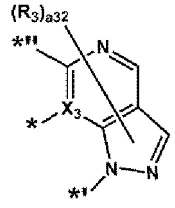
Formula A3-2(35)

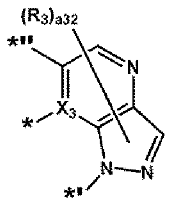
Formula A3-2(36)

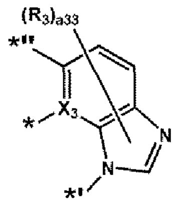
Formula A3-2(37)

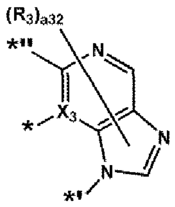
Formula A3-2(38)

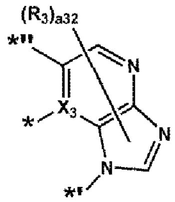
Formula A3-2(39)

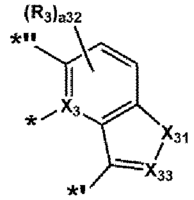
Formula A3-2(40)

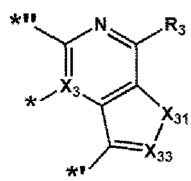
Formula A3-2(41)

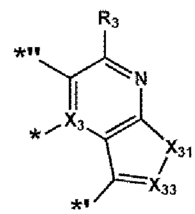
Formula A3-2(42)

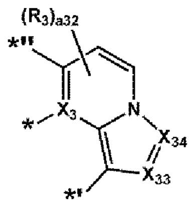
Formula A3-2(43)

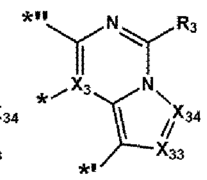
Formula A3-2(44)

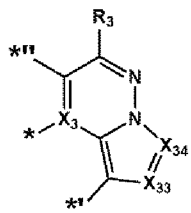
Formula A3-2(45)

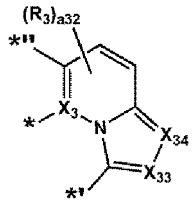
Formula A3-2(46)

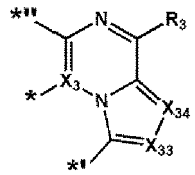
Formula A3-2(47)

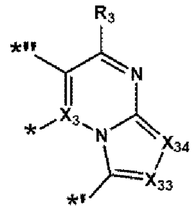
Formula A3-2(48)

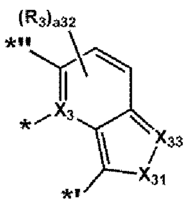
Formula A3-2(49)

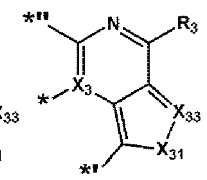
Formula A3-2(50)

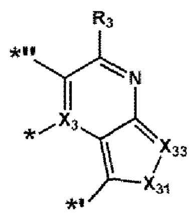
Formula A3-2(51)

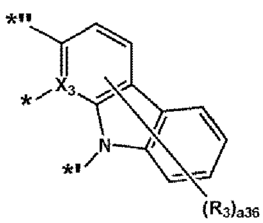
Formula A3-2(52)

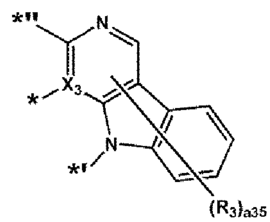
Formula A3-2(53)

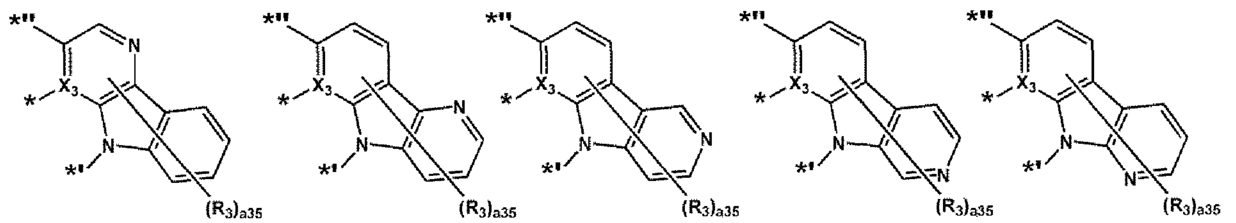
Formula A3-2(54) Formula A3-2(55) Formula A3-2(56) Formula A3-2(57) Formula A3-2(58)

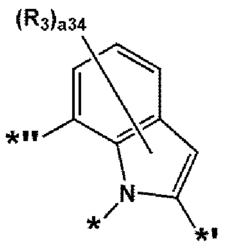
Formula A3-3(1)

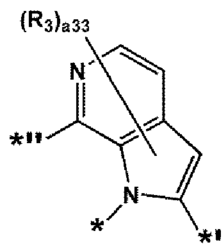
Formula A3-3(2)

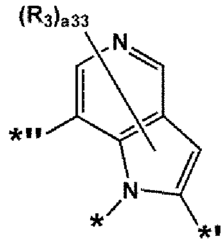
Formula A3-3(3)

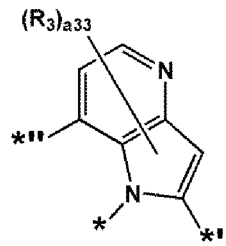
Formula A3-3(4)

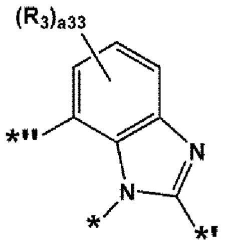
Formula A3-3(5)

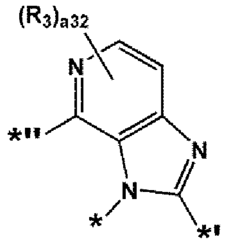
Formula A3-3(6)

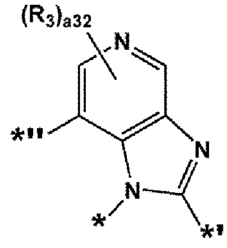
Formula A3-3(7)

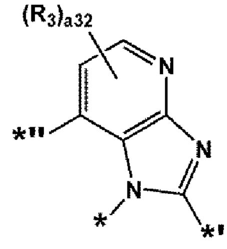
Formula A3-3(8)

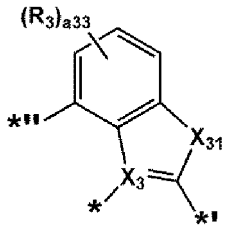
Formula A3-3(9)

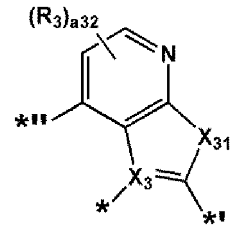
Formula A3-3(10)

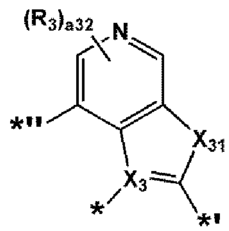
Formula A3-3(11)

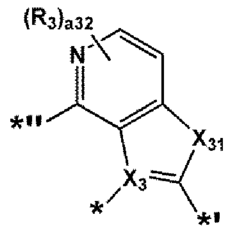
Formula A3-3(12)

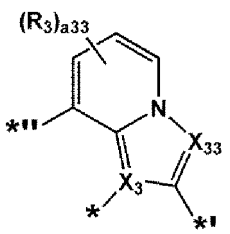
Formula A3-3(13)

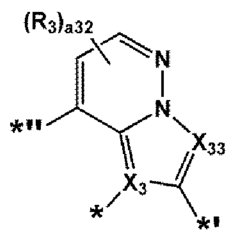
Formula A3-3(14)

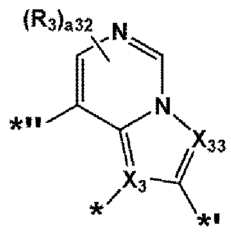
Formula A3-3(15)

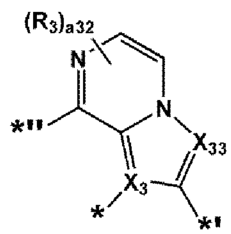
Formula A3-3(16)

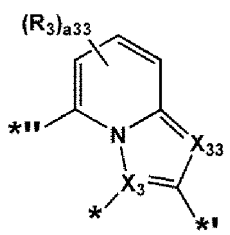
Formula A3-3(17)

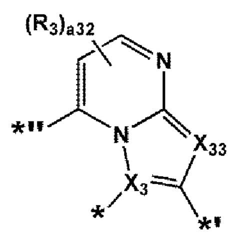
Formula A3-3(18)

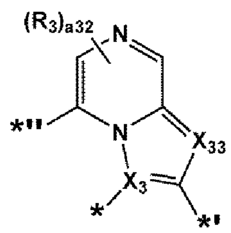
Formula A3-3(19)

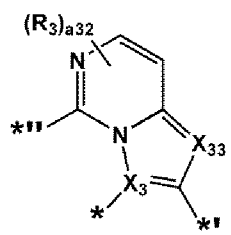
Formula A3-3(20)

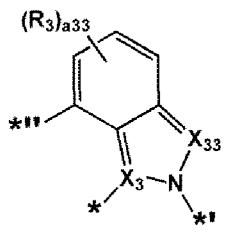
Formula A3-3(21)

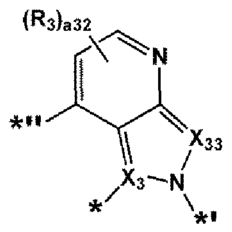
Formula A3-3(22)

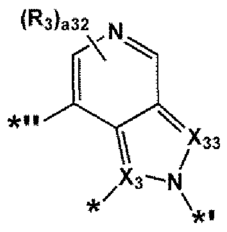
Formula A3-3(23)

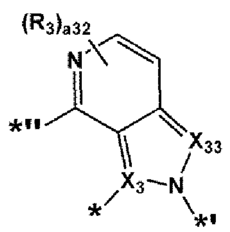
Formula A3-3(24)

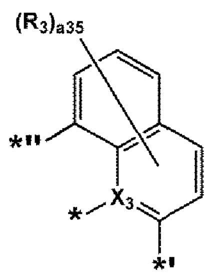
Formula A3-3(25)

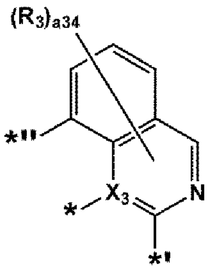
Formula A3-3(26)

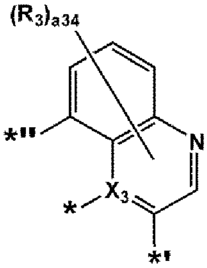
Formula A3-3(27)

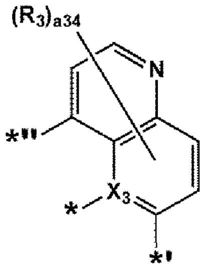
Formula A3-3(28)

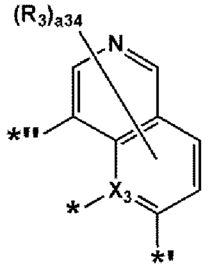
Formula A3-3(29)

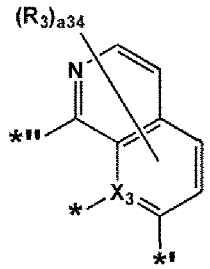
Formula A3-3(30)

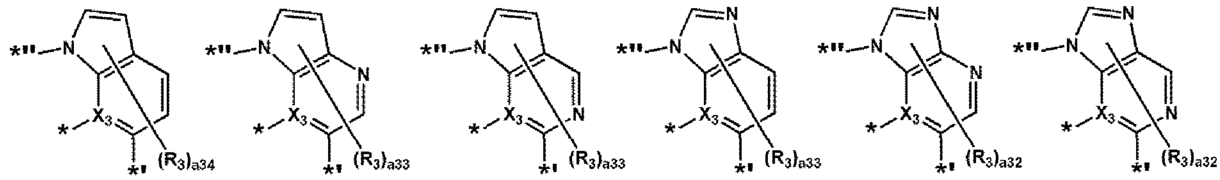
Formula A3-3(31) Formula A3-3(32) Formula A3-3(33) Formula A3-3(34) Formula A3-3(35) Formula A3-3(36)

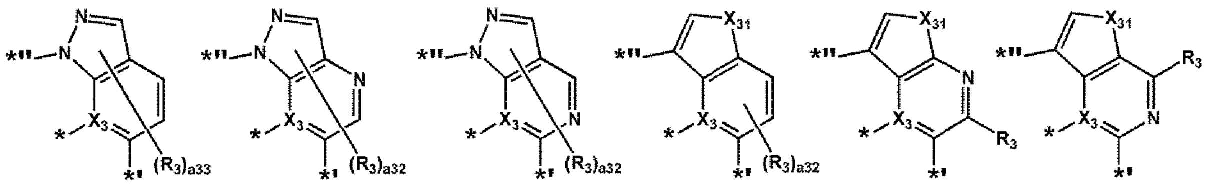
Formula A3-3(37) Formula A3-3(38) Formula A3-3(39) Formula A3-3(40) Formula A3-3(41) Formula A3-3(42)

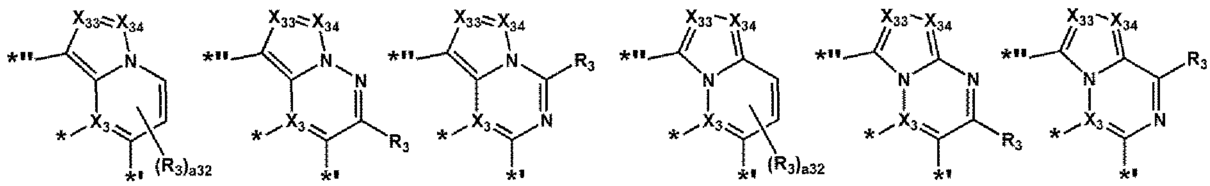
Formula A3-3(43) Formula A3-3(44) Formula A3-3(45) Formula A3-3(46) Formula A3-3(47) Formula A3-3(48)

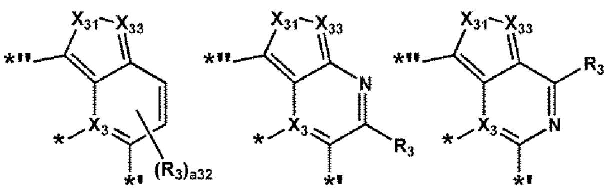
Formula A3-3(49) Formula A3-3(50) Formula A3-3(51)

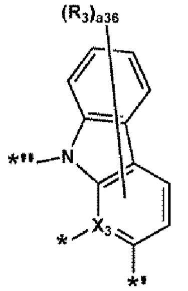
Formula A3-3(52)

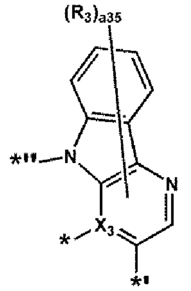
Formula A3-3(53)

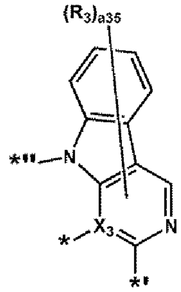
Formula A3-3(54)

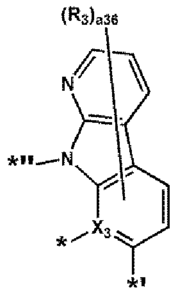
Formula A3-3(55)

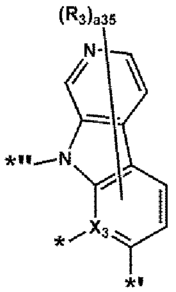
Formula A3-3(56)

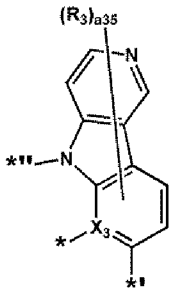
Formula A3-3(57)

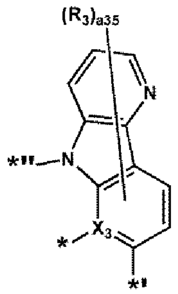
Formula A3-3(58)

,

wherein, in Formulae A3-1(1) to A3-1(21), A3-2(1) to A3-2(58), and A3-3(1) to A3-3(58),

$X_3$ and $R_3$ are the same as described in claim 1,
$X_{31}$ is O, S, $N(R_{31})$, $C(R_{31})(R_{32})$, or $Si(R_{31})(R_{32})$,
$X_{33}$ is N or $C(R_{33})$,
$X_{34}$ is N or $C(R_{34})$,
$R_{31}$ to $R_{38}$ are the same as described in connection with $R_3$ in claim 1,
a36 is an integer from 0 to 6,
a35 is an integer from 0 to 5,
a34 is an integer from 0 to 4,
a33 is an integer from 0 to 3,
a32 is an integer from 0 to 2, and
*, *', and *" are the same as described in connection with *, *', and *" in Formula A3-1; and/or

wherein
$A_4$ is represented by one of Formulae A4-1(1) to A4-1(44) and A4-2(1) to A4-2(71):

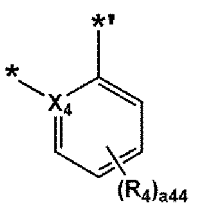
Formula A4-1(1)

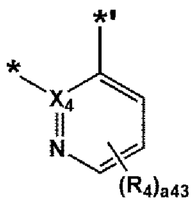
Formula A4-1(2)

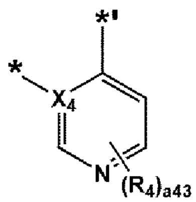
Formula A4-1(3)

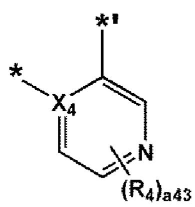
Formula A4-1(4)

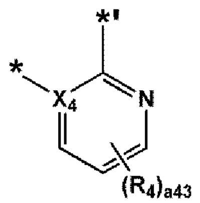
Formula A4-1(5)

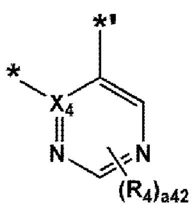
Formula A4-1(6)

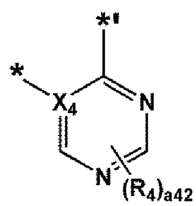
Formula A4-1(7)

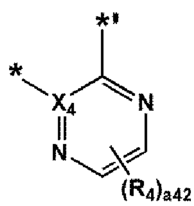
Formula A4-1(8)

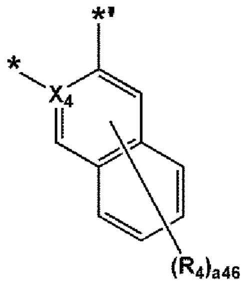
Formula A4-1(9)

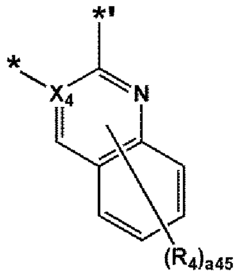
Formula A4-1(10)

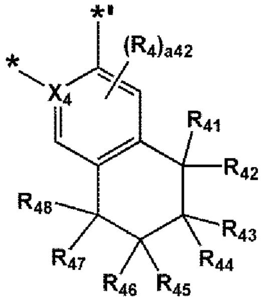
Formula A4-1(11)

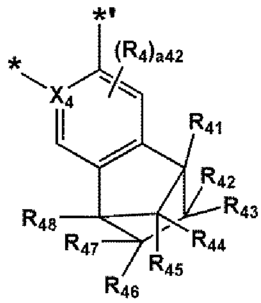
Formula A4-1(12)

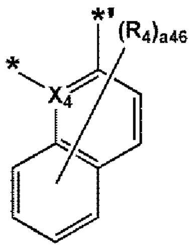
Formula A4-1(13)

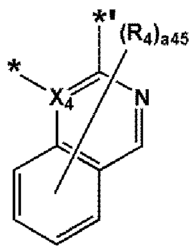
Formula A4-1(14)

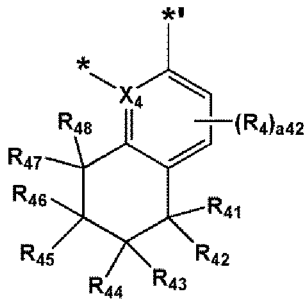
Formula A4-1(15)

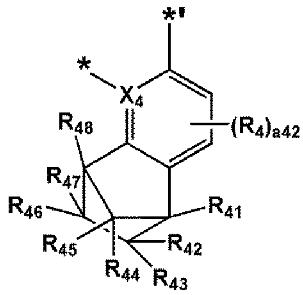
Formula A4-1(16)

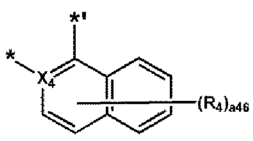
Formula A4-1(17)

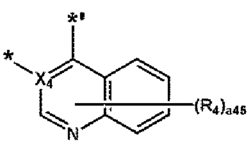
Formula A4-1(18)

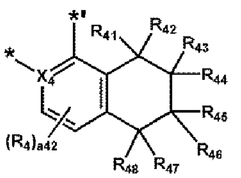
Formula A4-1(19)

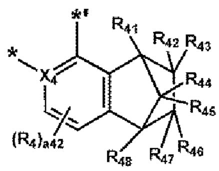
Formula A4-1(20)

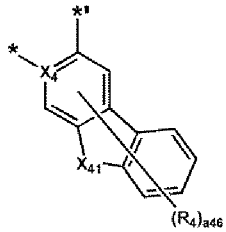
Formula A4-1(21)

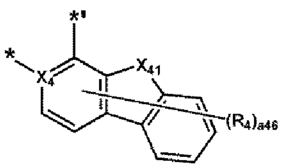
Formula A4-1(22)

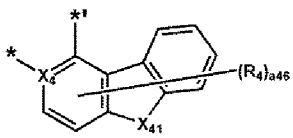
Formula A4-1(23)

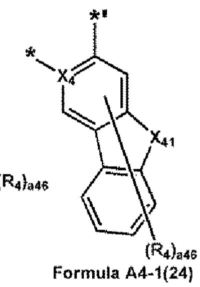
Formula A4-1(24)

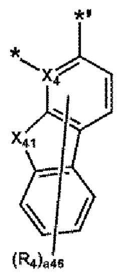
Formula A4-1(25)

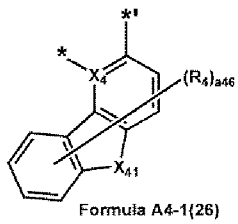
Formula A4-1(26)

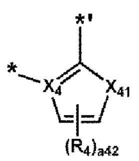
Formula A4-1(27)

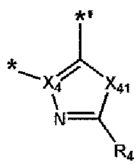
Formula A4-1(28)

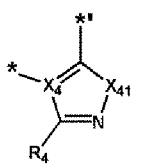
Formula A4-1(29)

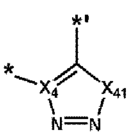
Formula A4-1(30)

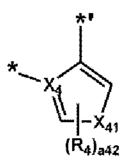
Formula A4-1(31)

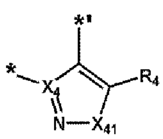
Formula A4-1(32)

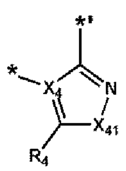
Formula A4-1(33)

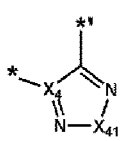
Formula A4-1(34)

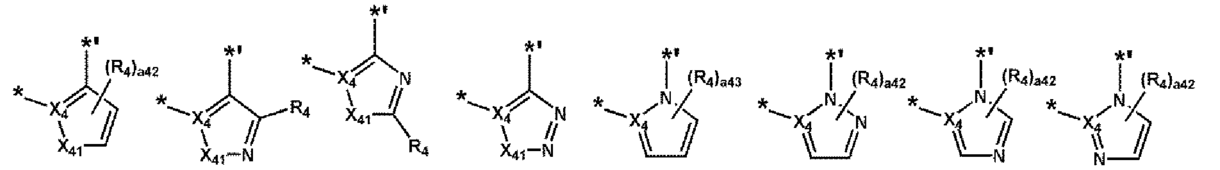

Formula A4-1(35) Formula A4-1(36) Formula A4-1(37) Formula A4-1(38) Formula A4-1(39) Formula A4-1(40) Formula A4-1(41) Formula A4-1(42)

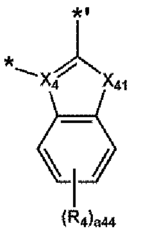

Formula A4-1(43)

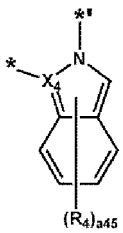

Formula A4-1(44)

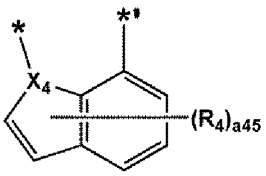

Formula A4-2(1)

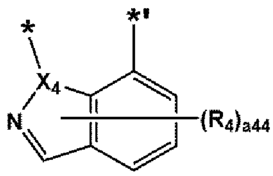

Formula A4-2(2)

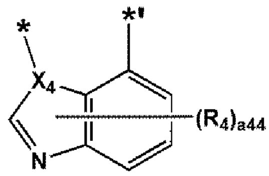

Formula A4-2(3)

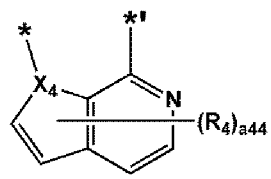

Formula A4-2(4)

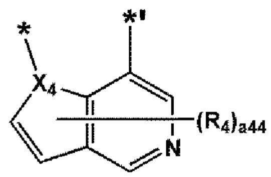

Formula A4-2(5)

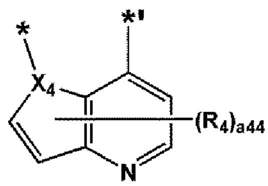

Formula A4-2(6)

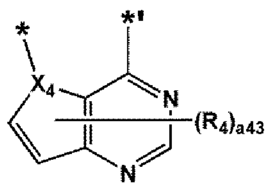

Formula A4-2(7)

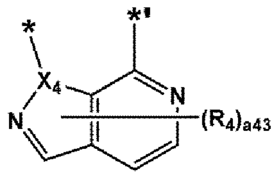

Formula A4-2(8)

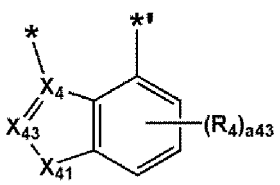

Formula A4-2(9)

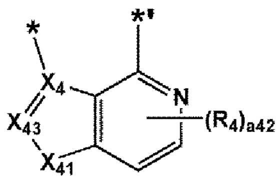

Formula A4-2(10)

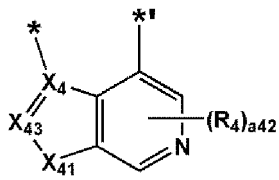

Formula A4-2(11)

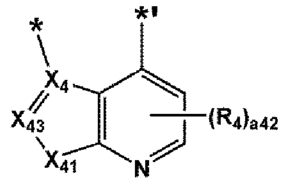

Formula A4-2(12)

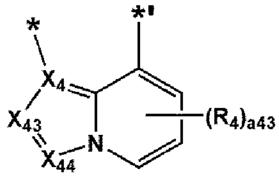

Formula A4-2(13)

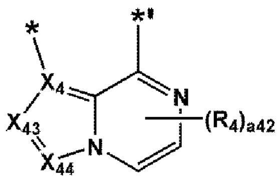

Formula A4-2(14)

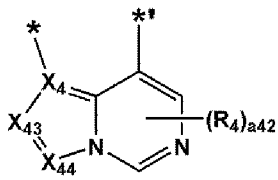

Formula A4-2(15)

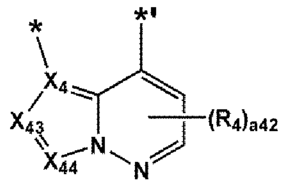

Formula A4-2(16)

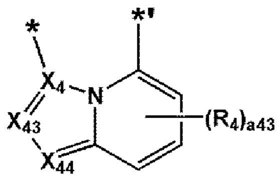
Formula A4-2(17)

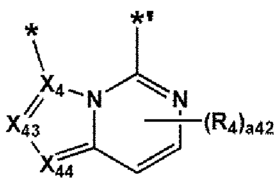
Formula A4-2(18)

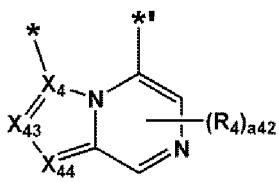
Formula A4-2(19)

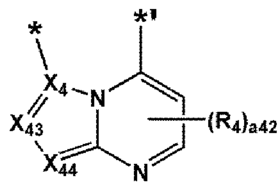
Formula A4-2(20)

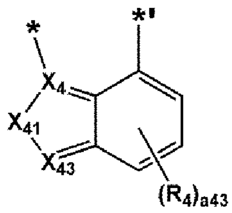
Formula A4-2(21)

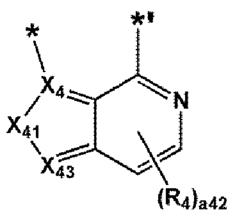
Formula A4-2(22)

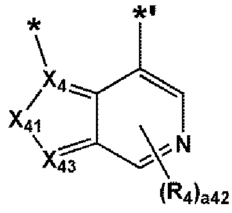
Formula A4-2(23)

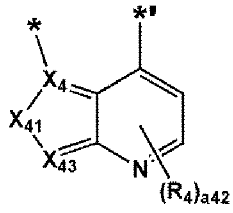
Formula A4-2(24)

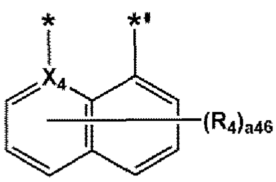
Formula A4-2(25)

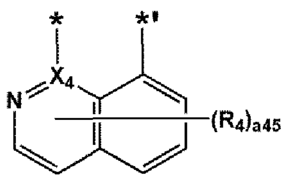
Formula A4-2(26)

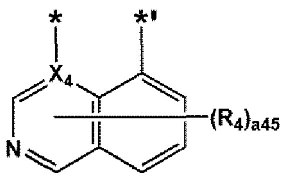
Formula A4-2(27)

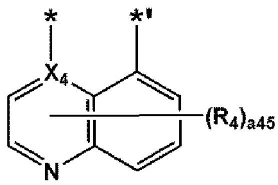
Formula A4-2(28)

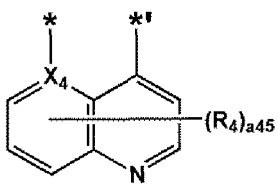
Formula A4-2(29)

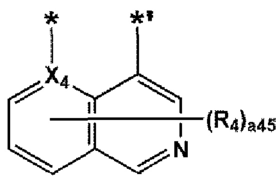
Formula A4-2(30)

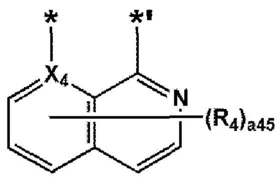
Formula A4-2(31)

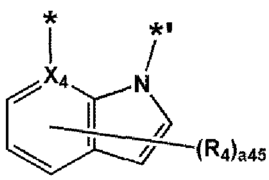
Formula A4-2(32)

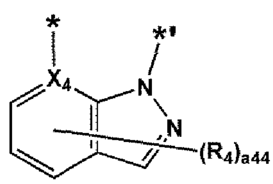
Formula A4-2(33)

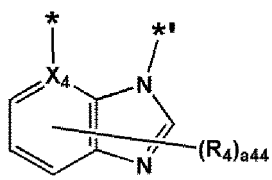
Formula A4-2(34)

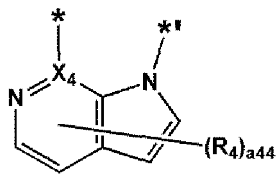
Formula A4-2(35)

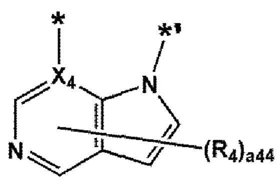
Formula A4-2(36)

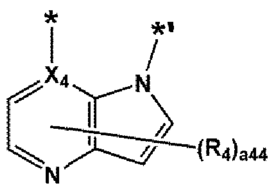
Formula A4-2(37)

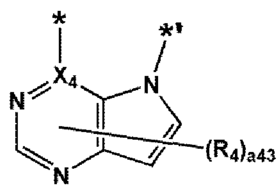
Formula A4-2(38)

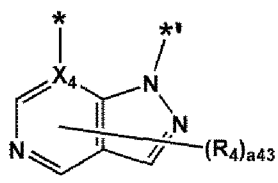
Formula A4-2(39)

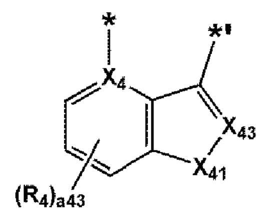
Formula A4-2(40)

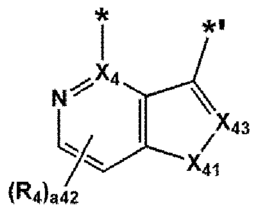
Formula A4-2(41)

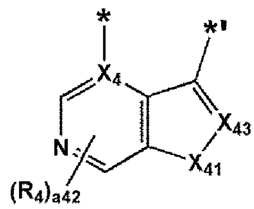
Formula A4-2(42)

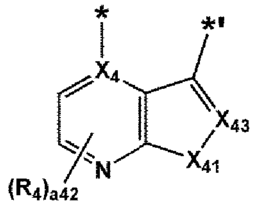
Formula A4-2(43)

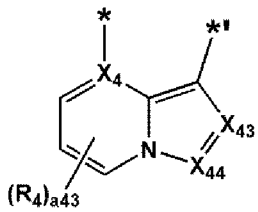
Formula A4-2(44)

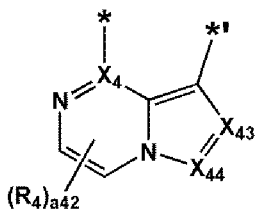
Formula A4-2(45)

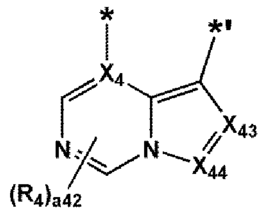
Formula A4-2(46)

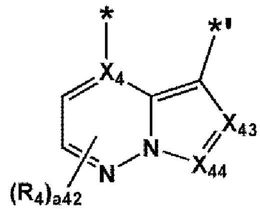
Formula A4-2(47)

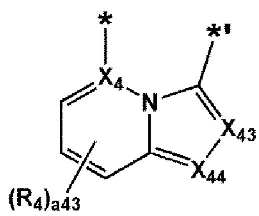
Formula A4-2(48)

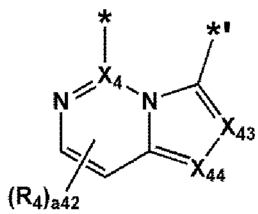
Formula A4-2(49)

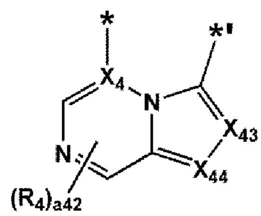
Formula A4-2(50)

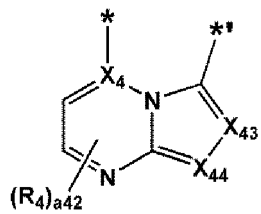
Formula A4-2(51)

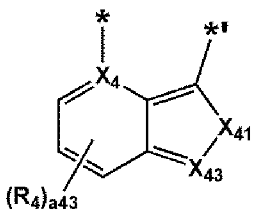
Formula A4-2(52)

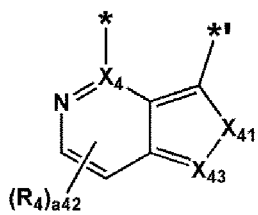
Formula A4-2(53)

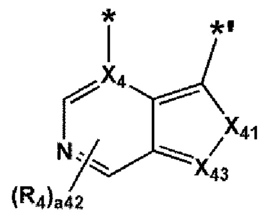
Formula A4-2(54)

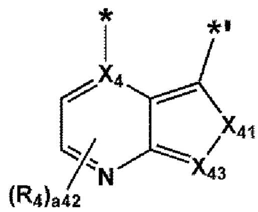
Formula A4-2(55)

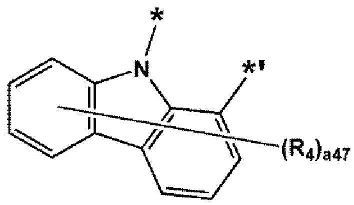
Formula A4-2(56)

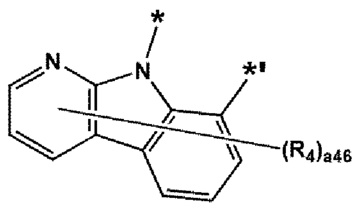
Formula A4-2(57)

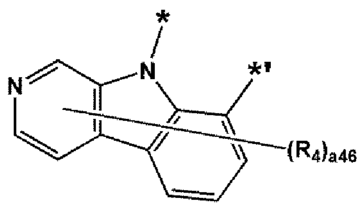
Formula A4-2(58)

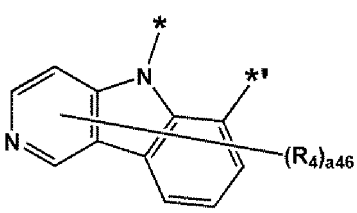
Formula A4-2(59)

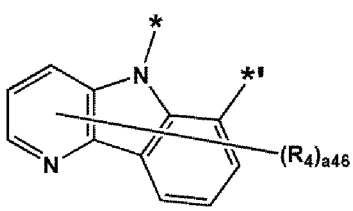
Formula A4-2(60)

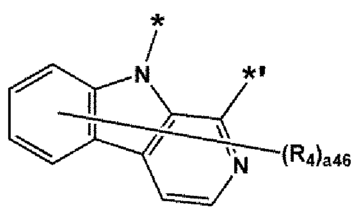
Formula A4-2(61)

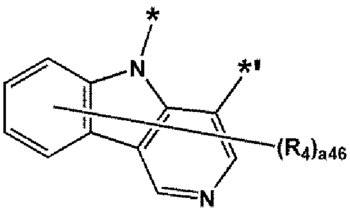
Formula A4-2(62)

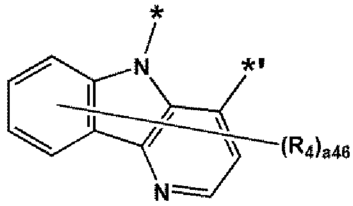
Formula A4-2(63)

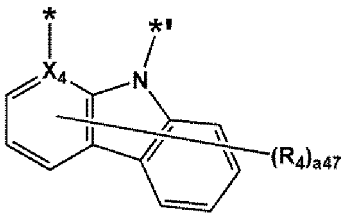
Formula A4-2(64)

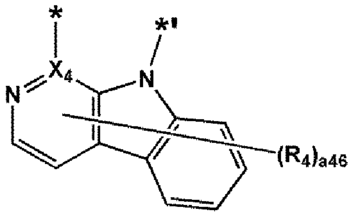
Formula A4-2(65)

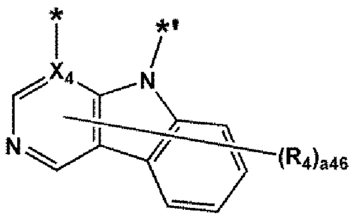
Formula A4-2(66)

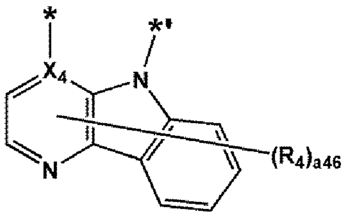
Formula A4-2(67)

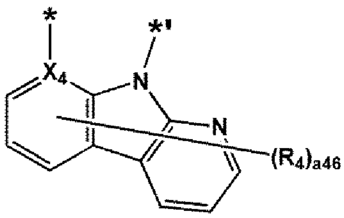
Formula A4-2(68)

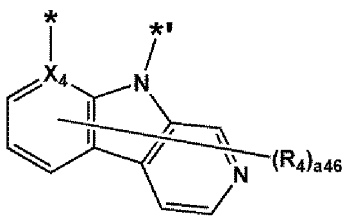
Formula A4-2(69)

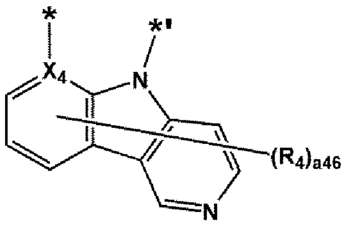
Formula A4-2(70)

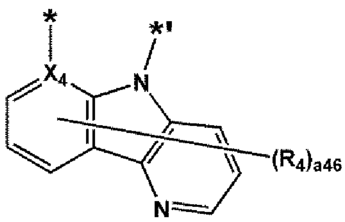
Formula A4-2(71)

,

wherein, in Formulae A4-1(1) to A4-1(44) and A4-2(1) to A4-2(71),

$X_4$, $R_4$, *, and *' are the same as described in claim 1,
$X_{41}$ is O, S, $N(R_{41})$, $C(R_{41})(R_{42})$, or $Si(R_{41})(R_{42})$,
$X_{43}$ is N or $C(R_{43})$,
$X_{44}$ is N or $C(R_{44})$,
$R_{41}$ to $R_{48}$ are the same as described in connection with $R_4$,
a47 is an integer from 0 to 7,
a46 is an integer from 0 to 6,
a45 is an integer from 0 to 5,
a44 is an integer from 0 to 4,
a43 is an integer from 0 to 3, and
a42 is an integer from 0 to 2.

**9.** The organometallic compound of any of claims 1-8, wherein
$A_2$ is represented by Formula A2-2; and/or
wherein
$A_1$ is represented by one of Formulae A1-1-1 to A1-1-10 and A1-2-1 to A1-2-4,

$A_2$ is represented by one of Formulae A2-2-1 to A2-2-4,
$A_3$ is represented by one of Formulae A3-1-1 to A3-1-10, and
$A_4$ is represented by one of Formulae A4-1-1 to A4-1-14:

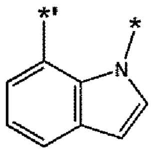
Formula A1-1-1

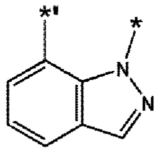
Formula A1-1-2

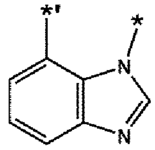
Formula A1-1-3

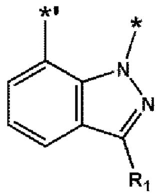
Formula A1-1-4

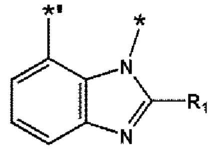
Formula A1-1-5

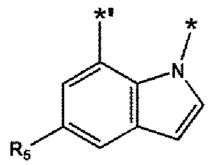
Formula A1-1-6

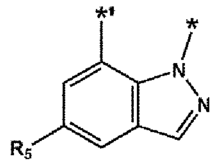
Formula A1-1-7

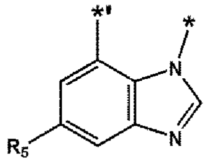
Formula A1-1-8

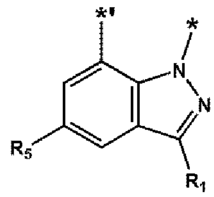
Formula A1-1-9

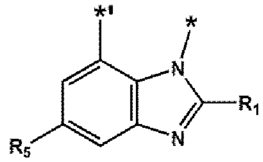
Formula A1-1-10

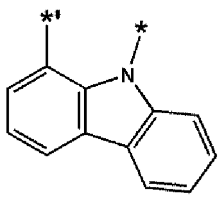
Formula A1-2-1

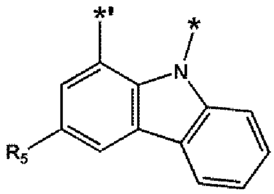
Formula A1-2-2

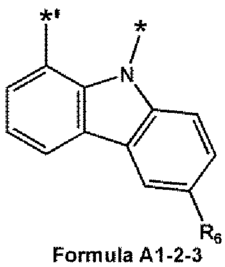
Formula A1-2-3

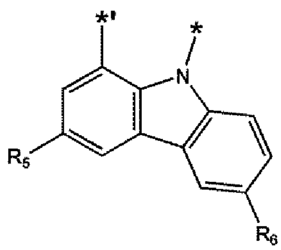
Formula A1-2-4

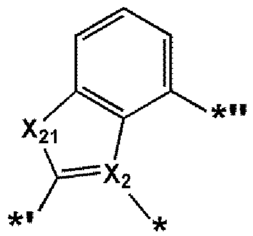
Formula A2-2-1

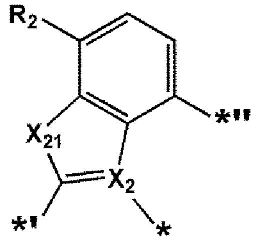
Formula A2-2-2

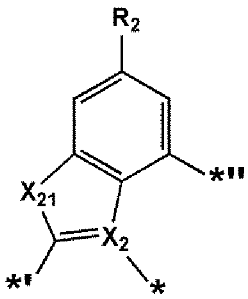
Formula A2-2-3

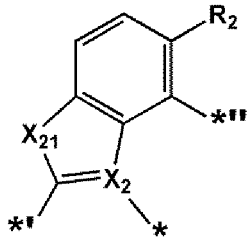
Formula A2-2-4

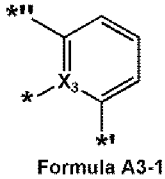
Formula A3-1-1

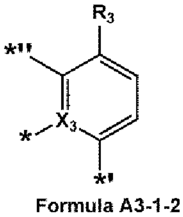
Formula A3-1-2

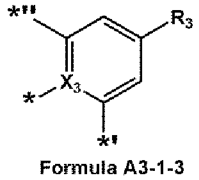
Formula A3-1-3

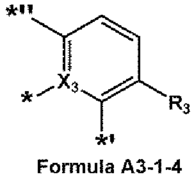
Formula A3-1-4

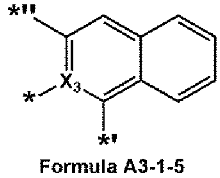
Formula A3-1-5

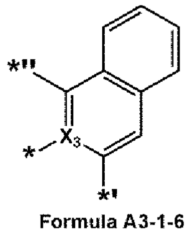
Formula A3-1-6

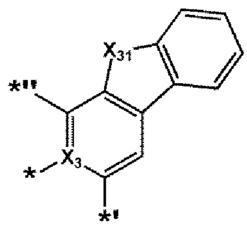

Formula A3-1-7

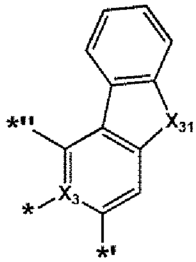

Formula A3-1-8

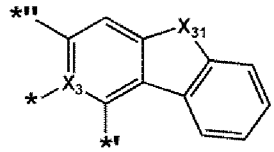

Formula A3-1-9

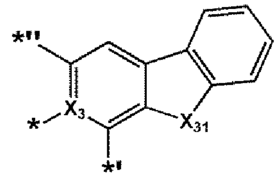

Formula A3-1-10

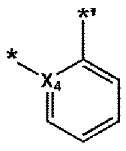

Formula A4-1-1

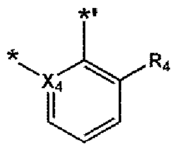

Formula A4-1-2

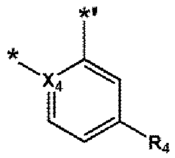

Formula A4-1-3

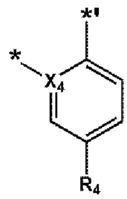

Formula A4-1-4

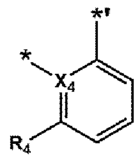

Formula A4-1-5

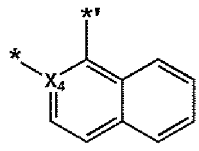

Formula A4-1-6

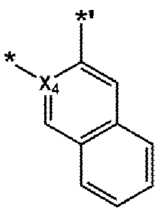

Formula A4-1-7

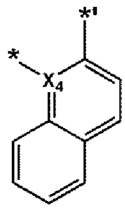

Formula A4-1-8

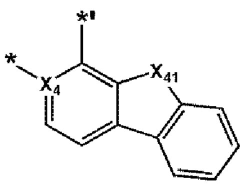

Formula A4-1-9

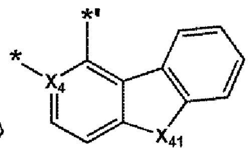

Formula A4-1-10

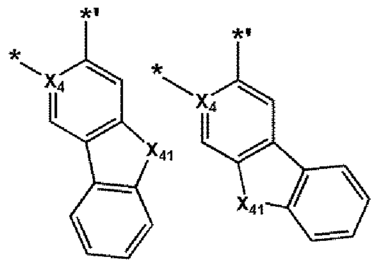

Formula A4-1-11 Formula A4-1-12

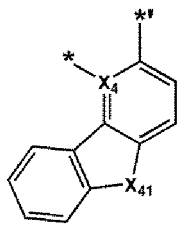

Formula A4-1-13

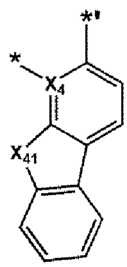

Formula A4-1-14

wherein, in Formulae A1-1-1 to A1-1-10, A1-2-1 to A1-2-4, A2-2-1 to A2-2-4, A3-1-1 to A3-1-10, and A4-1-1 to A4-1-14

$X_1$ to $X_4$ and $R_1$ to $R_6$ are the same as described in claim 1, provided that $R_1$ to $R_6$ are not hydrogen,

$X_{21}$ is O, S, $N(R_{21})$, $C(R_{21})(R_{22})$, or $Si(R_{21})(R_{22})$, and $R_{21}$ and $R_{22}$ are the same as described in connection with $R_2$ in claim 1,

$X_{31}$ is O, S, $N(R_{31})$, $C(R_{31})(R_{32})$, or $Si(R_{31})(R_{32})$, and $R_{31}$ and $R_{32}$ are the same as described in connection with $R_3$ in claim 1,

$X_{41}$ is O, S, $N(R_{41})$, $C(R_{41})(R_{42})$, or $Si(R_{41})(R_{42})$, and $R_{41}$ and $R_{42}$ are the same as described in connection with $R_4$ in claim 1,

in Formulae A1-1-1 to A1-1-10 and A1-2-1 to A1-2-4, * indicates a binding site to M in Formula 1, and *' indicates a binding site to $T_1$ in Formula 1,

in Formulae A2-2-1 to A2-2-4, * indicates a binding site to M in Formula 1, *' indicates a binding site to $T_1$ in Formula 1, and *" indicates a binding site to $T_2$ in Formula 1,

in Formulae A3-1-1 to A3-1-10, * indicates a binding site to M in Formula 1, *" indicates a binding site to $T_2$ in Formula 1, and *' indicates a binding site to $T_3$ in Formula 1, and

in Formulae A4-1-1 to A4-1-14, * indicates a binding site to M in Formula 1, and *' indicates a binding site to $T_3$

in Formula 1.

**10.** The organometallic compound of any of claims 1-9, wherein the organometallic compound is one of Compounds 1 to 273:

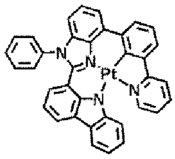
1

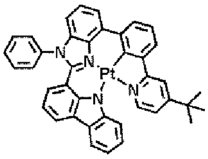
2

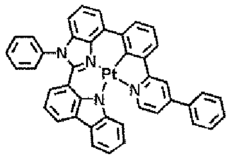
3

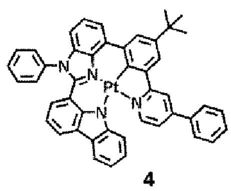
4

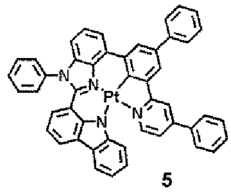
5

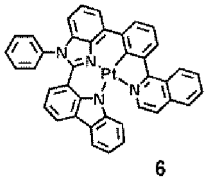
6

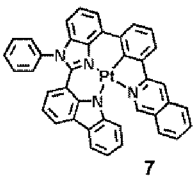
7

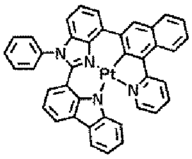
8

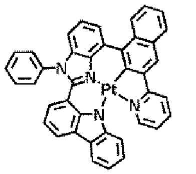
9

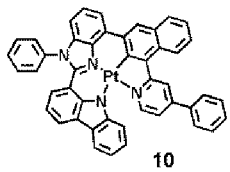
10

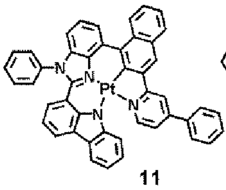
11

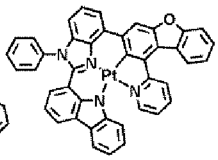
12

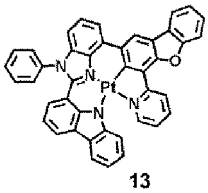
13

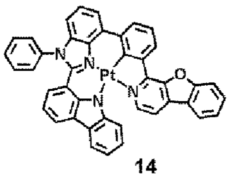
14

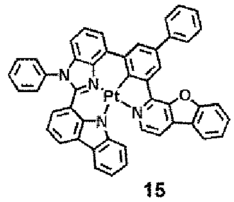
15

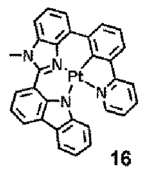
16

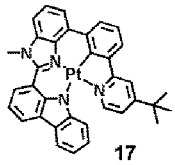
17

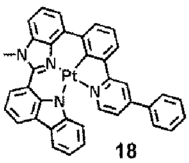
18

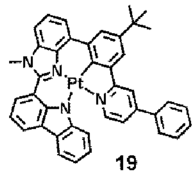
19

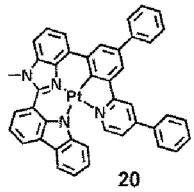
20

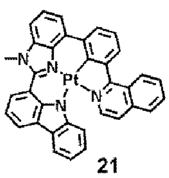
21

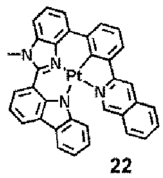
22

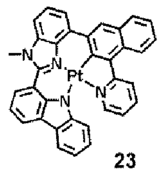
23

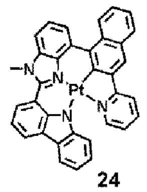
24

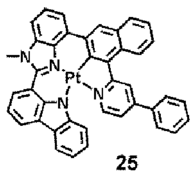
25

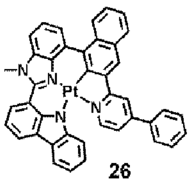
26

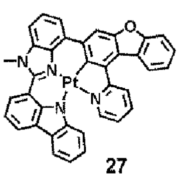
27

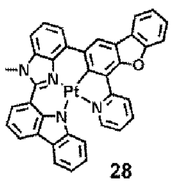
28

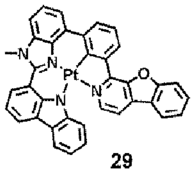
29

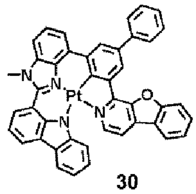
30

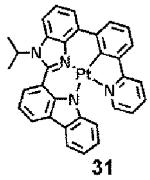
31
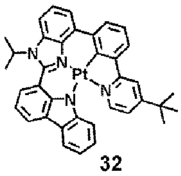
32
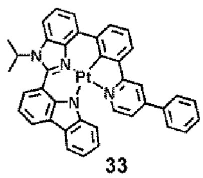
33
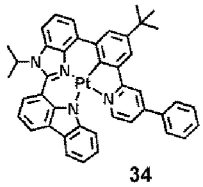
34
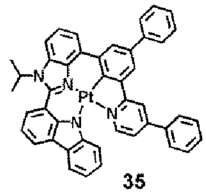
35

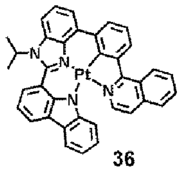
36
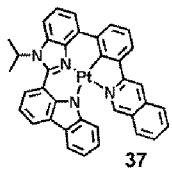
37
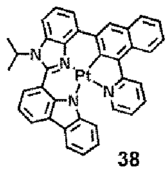
38
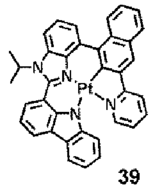
39
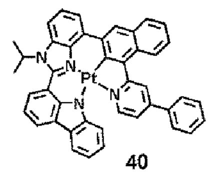
40

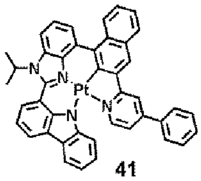
41
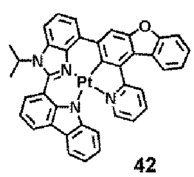
42
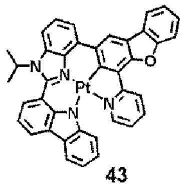
43
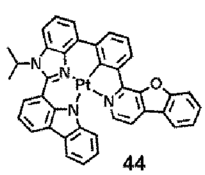
44
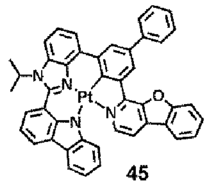
45

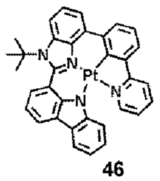
46
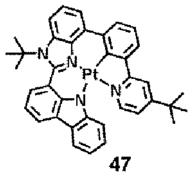
47
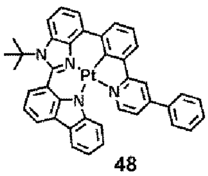
48
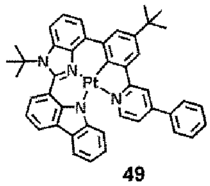
49
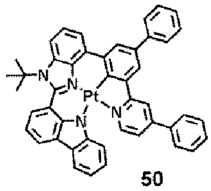
50

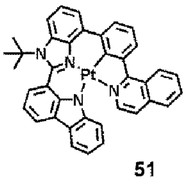
51
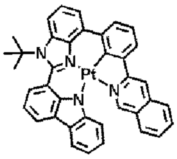
52
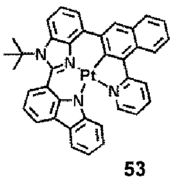
53
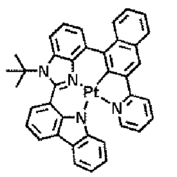
54
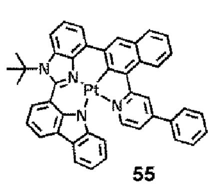
55

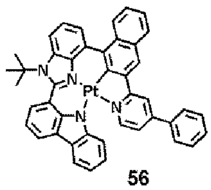
56
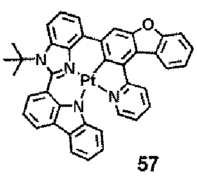
57
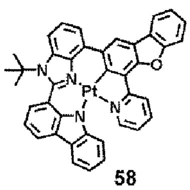
58
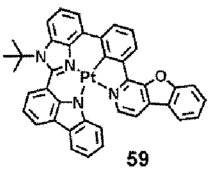
59
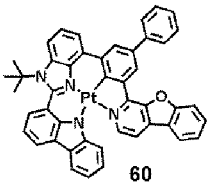
60

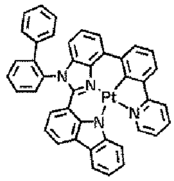
61
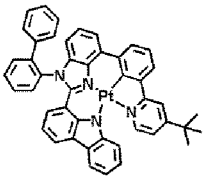
62
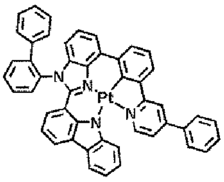
63
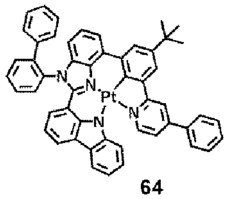
64
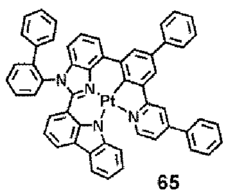
65

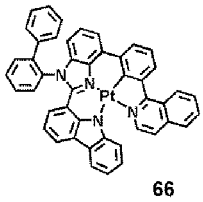 66
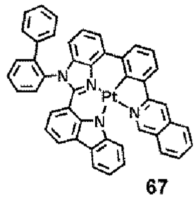 67
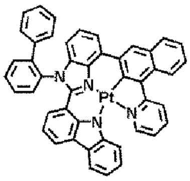 68
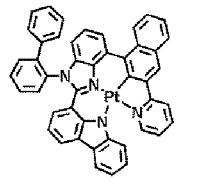 69
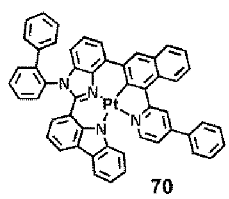 70

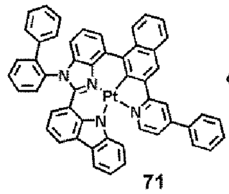 71
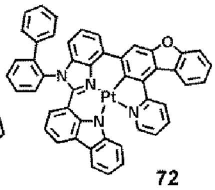 72
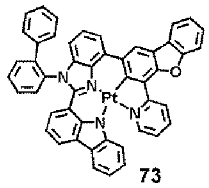 73
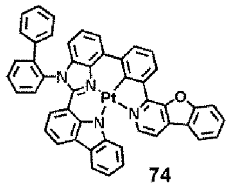 74
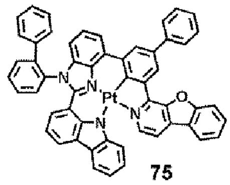 75

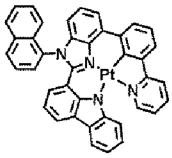 76
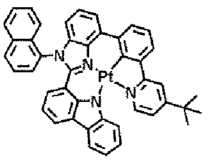 77
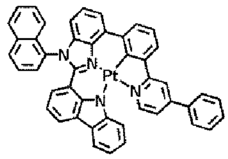 78
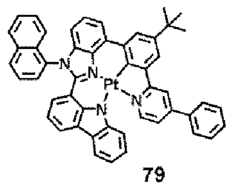 79
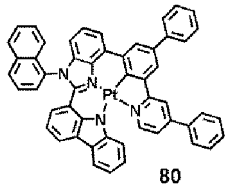 80

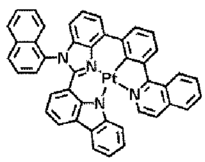 81
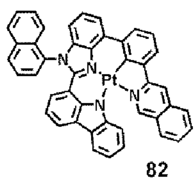 82
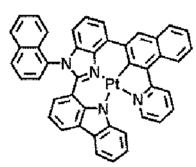 83
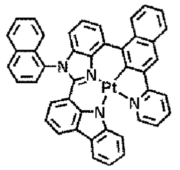 84
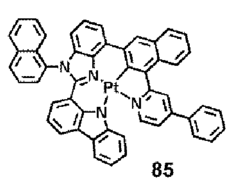 85

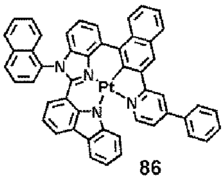 86
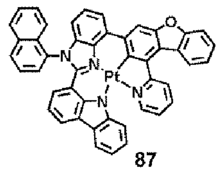 87
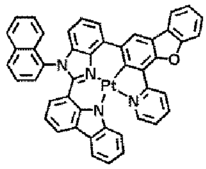 88
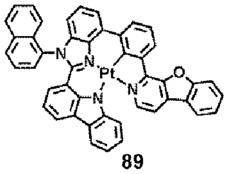 89
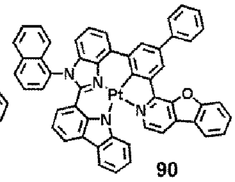 90

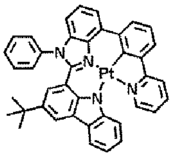 91
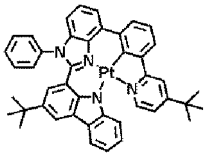 92
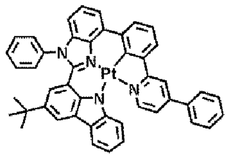 93
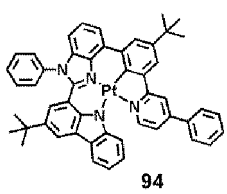 94
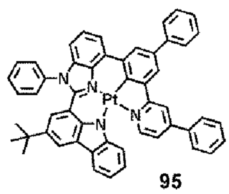 95

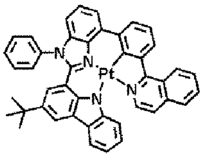 96
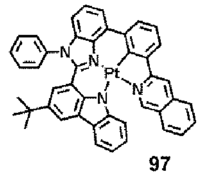 97
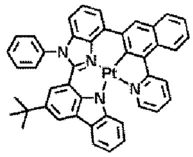 98
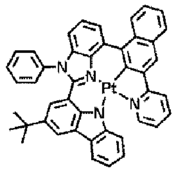 99
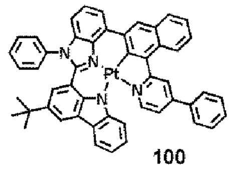 100

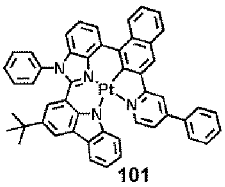
101
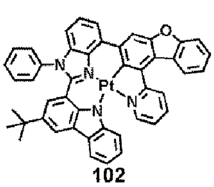
102
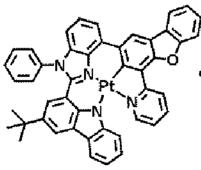
103
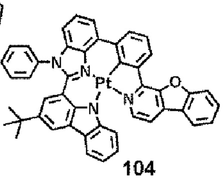
104
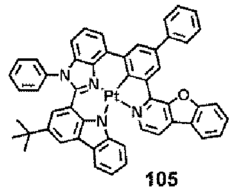
105

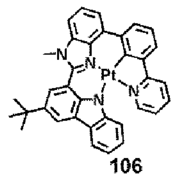
106
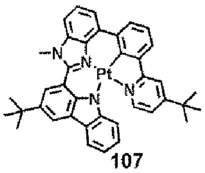
107
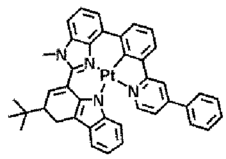
108
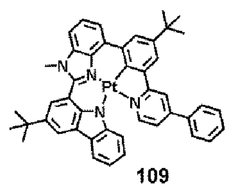
109
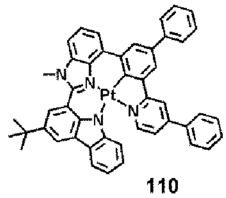
110

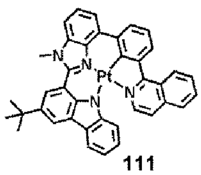
111
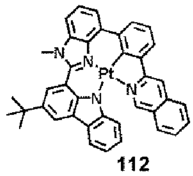
112
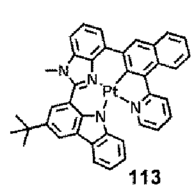
113
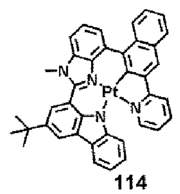
114
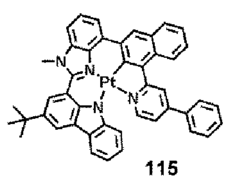
115

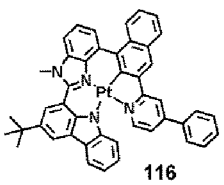
116
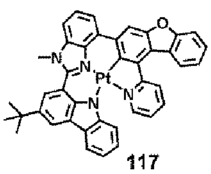
117
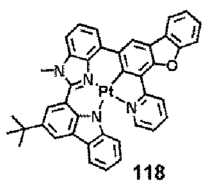
118
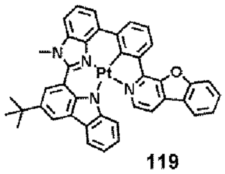
119
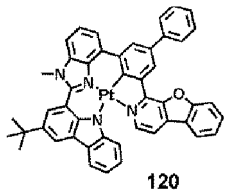
120

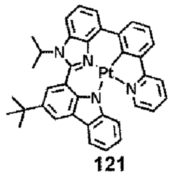
121
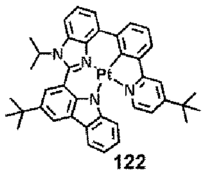
122
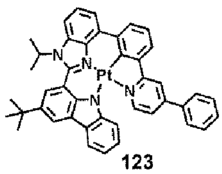
123
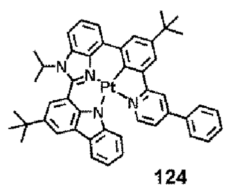
124
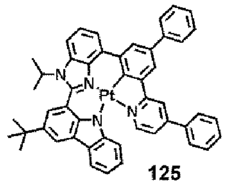
125

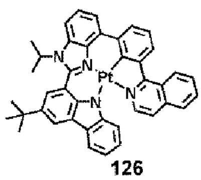
126
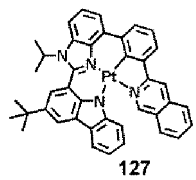
127
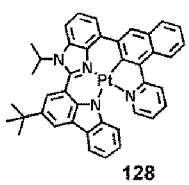
128
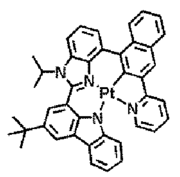
129
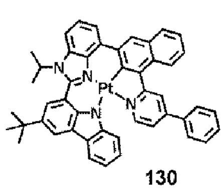
130

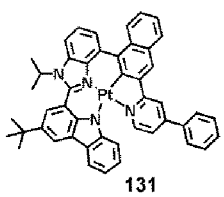
131
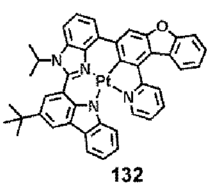
132
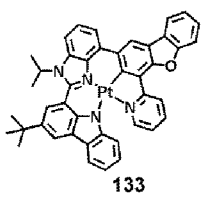
133
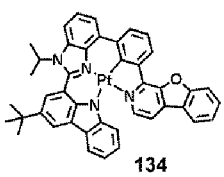
134
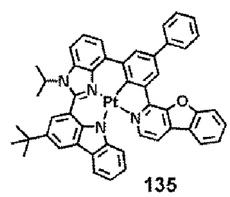
135

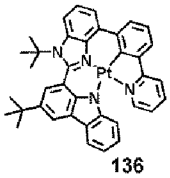
136

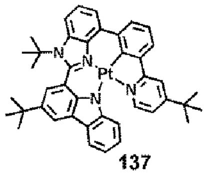
137

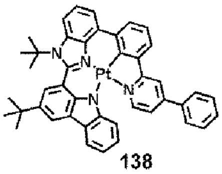
138

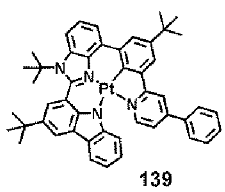
139

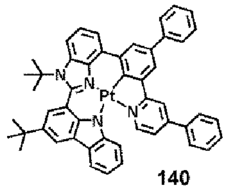
140

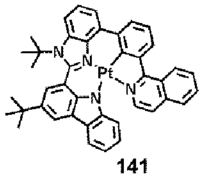
141

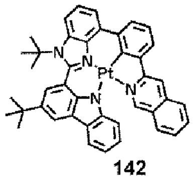
142

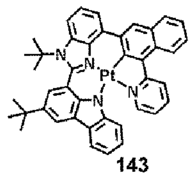
143

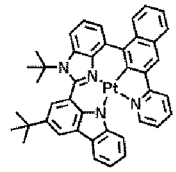
144

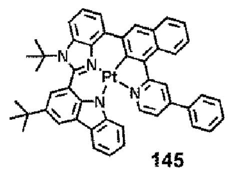
145

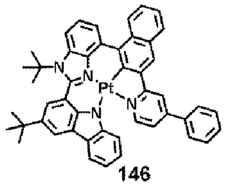
146

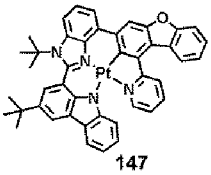
147

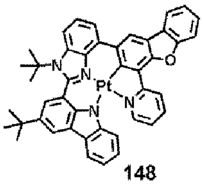
148

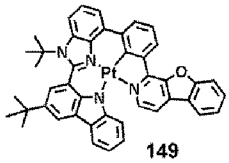
149

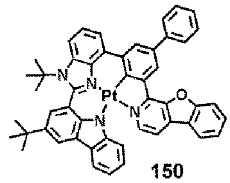
150

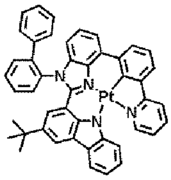
151

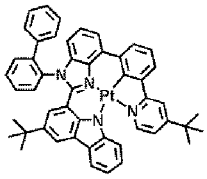
152

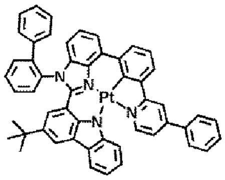
153

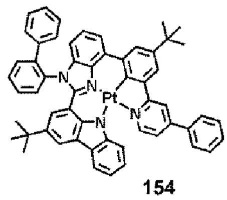
154

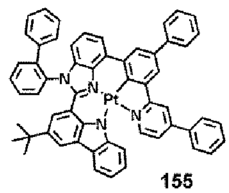
155

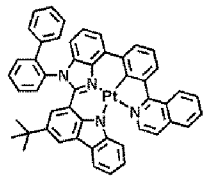
156

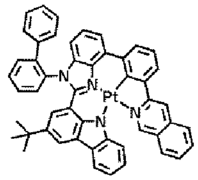
157

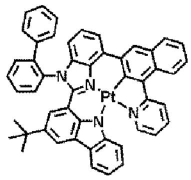
158

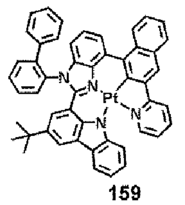
159

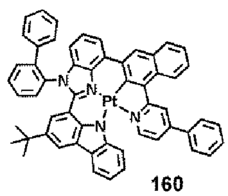
160

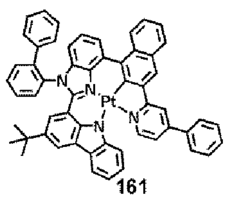
161

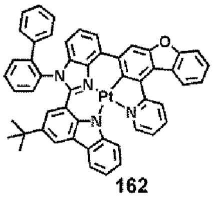
162

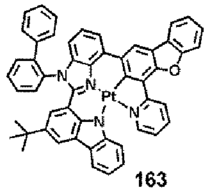
163

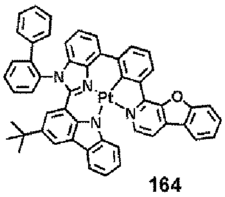
164

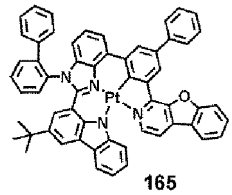
165

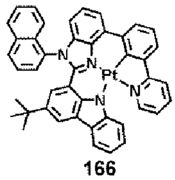
166

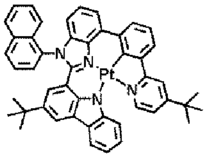
167

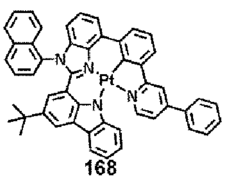
168

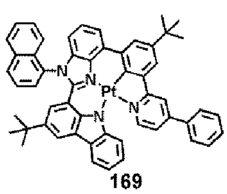
169

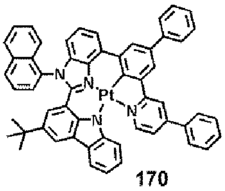
170

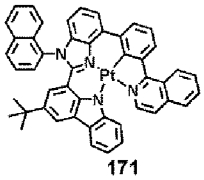
171

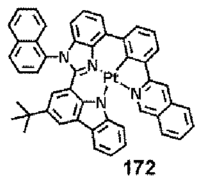
172

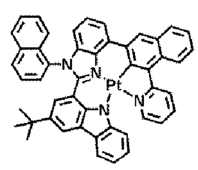
173

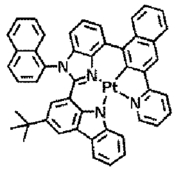
174

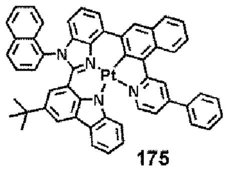
175

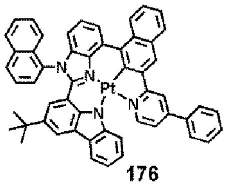
176

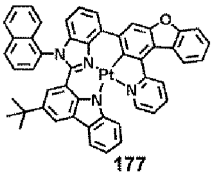
177

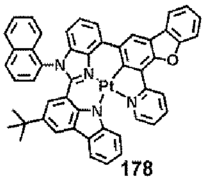
178

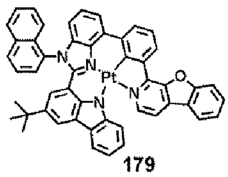
179

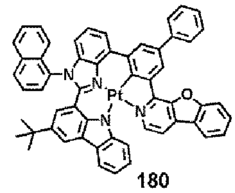
180

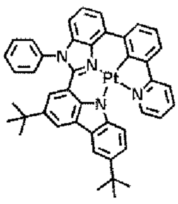
181

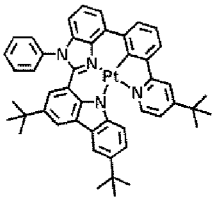
182

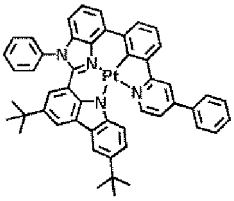
183

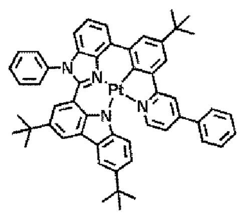
184

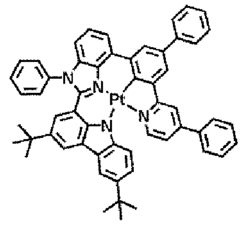
185

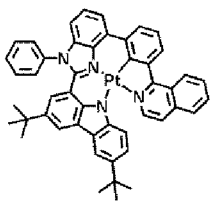
186

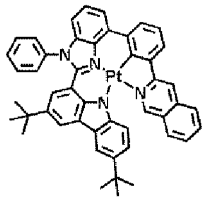
187

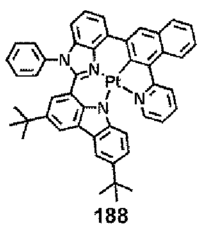
188

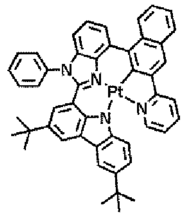
189

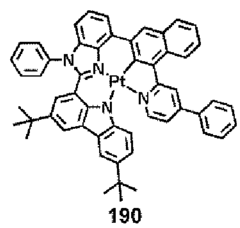
190

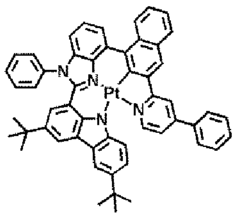
191

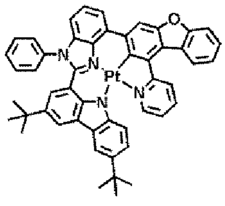
192

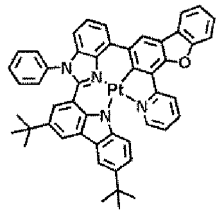
193

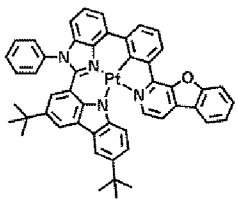
194

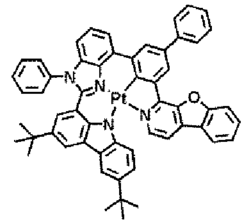
195

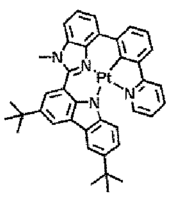
196

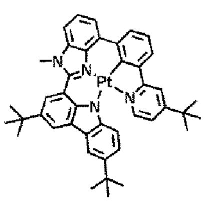
197

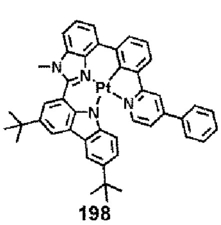
198

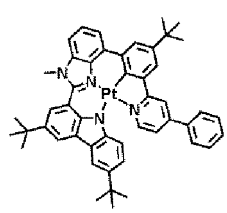
199

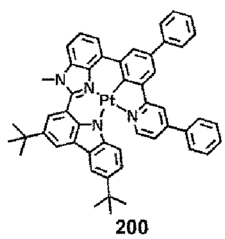
200

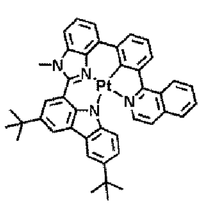
201
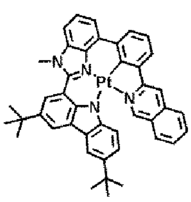
202
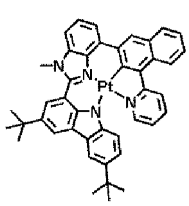
203
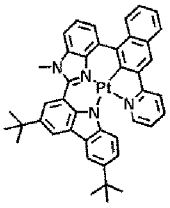
204
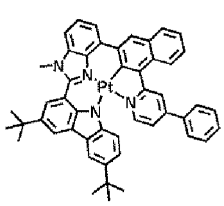
205

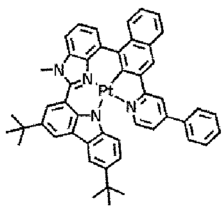
206
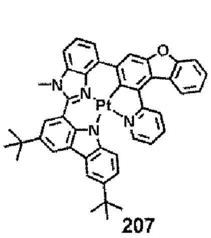
207
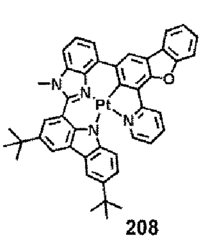
208
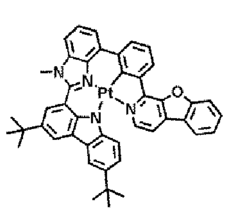
209
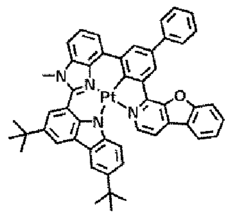
210

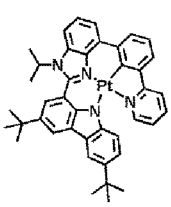
211
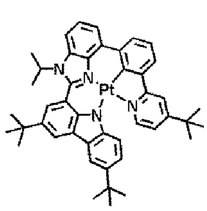
212
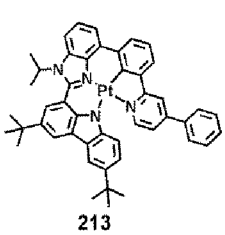
213
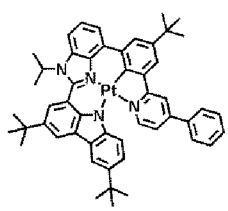
214
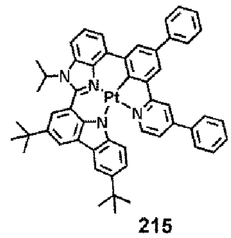
215

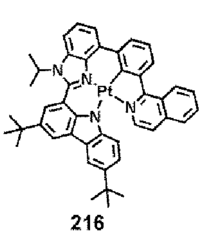
216
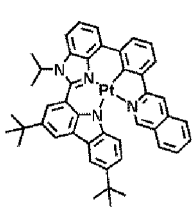
217
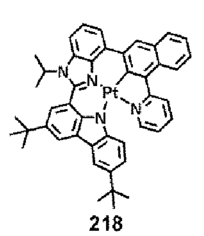
218
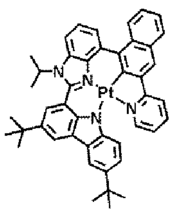
219
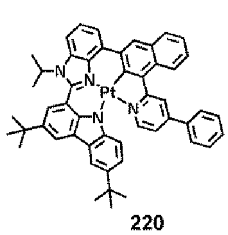
220

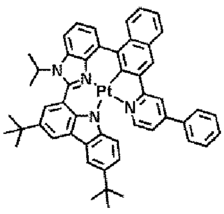
221
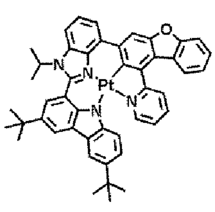
222
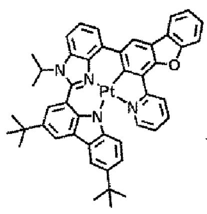
223
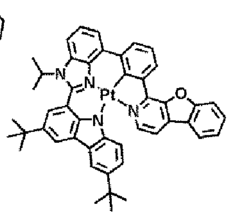
224
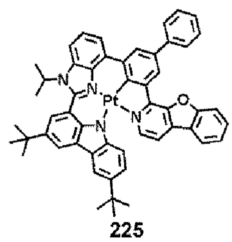
225

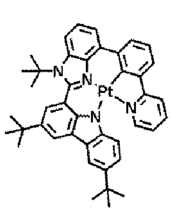
226
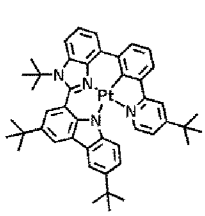
227
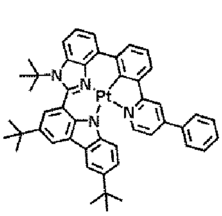
228
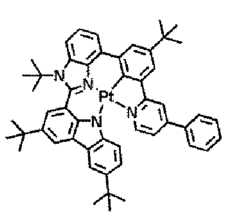
229
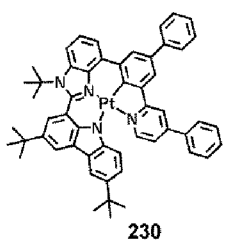
230

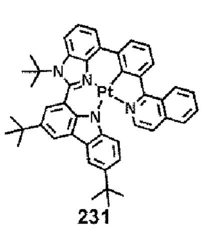
231
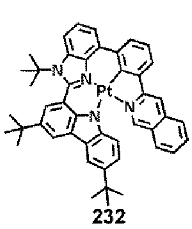
232
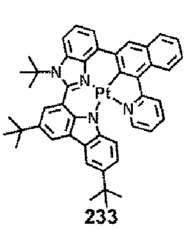
233
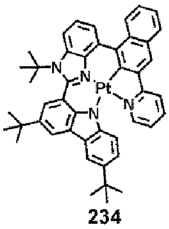
234
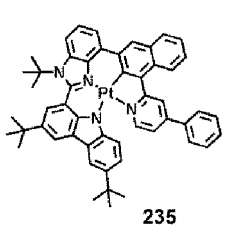
235

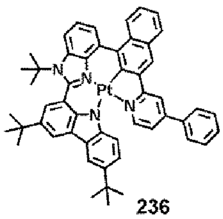
236
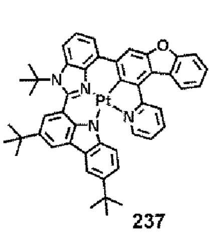
237
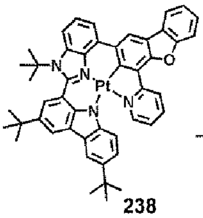
238
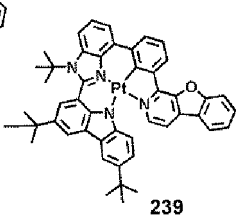
239
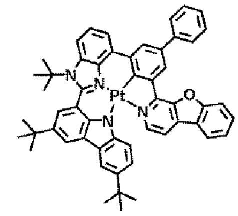
240

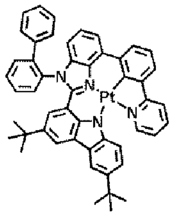
241
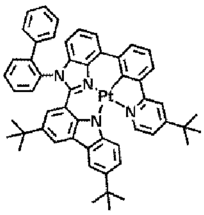
242
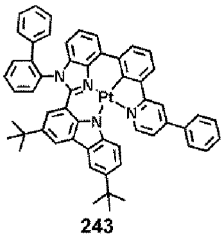
243
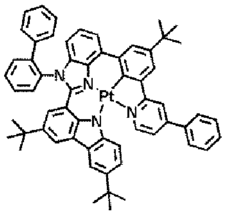
244
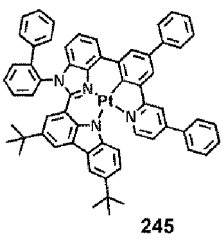
245

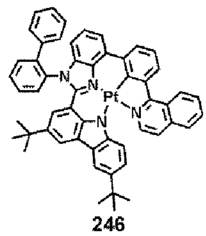
246
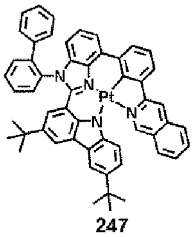
247
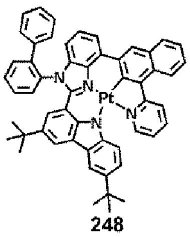
248
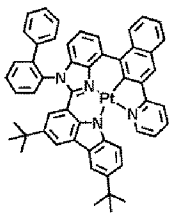
249
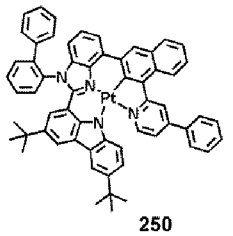
250

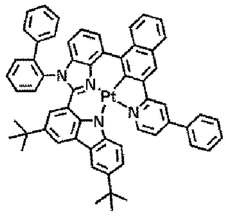
251
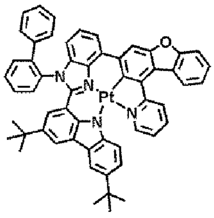
252
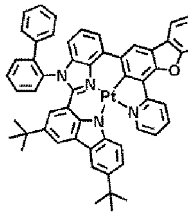
253
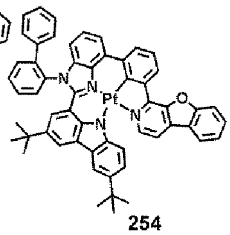
254
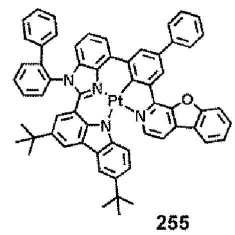
255

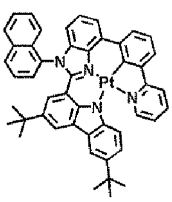
256
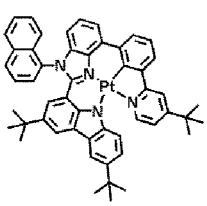
257
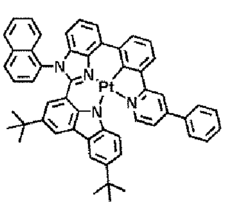
258
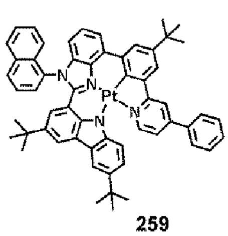
259
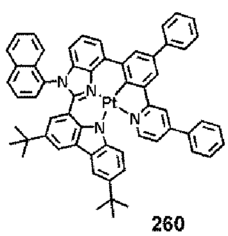
260

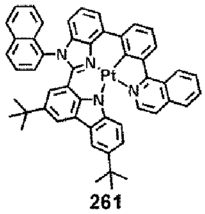
261

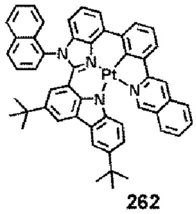
262

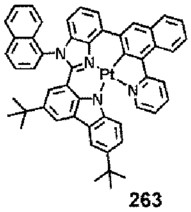
263

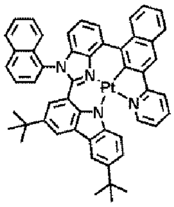
264

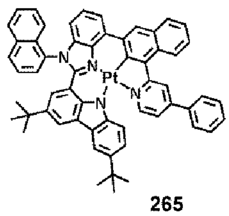
265

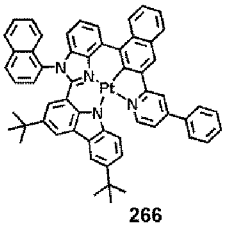
266

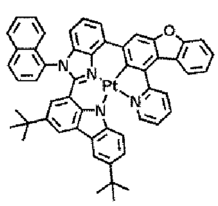
267

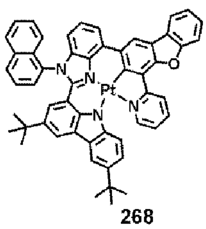
268

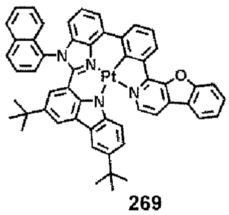
269

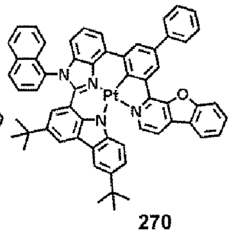
270

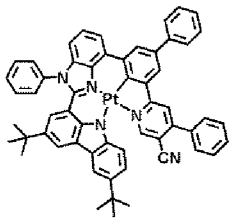
271

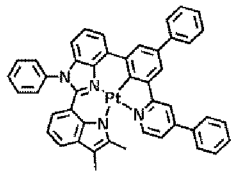
272

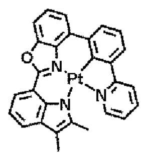
273 .

**11.** An organic light-emitting device comprising:

a first electrode;
a second electrode; and
an organic layer disposed between the first electrode and the second electrode, wherein the organic layer comprises an emission layer and at least one organometallic compound of any of claims 1-10.

**12.** The organic light-emitting device of claim 11, wherein
the first electrode is an anode,
the second electrode is a cathode,
the organic layer further comprises a hole transport region disposed between the first electrode and the emission layer and an electron transport region disposed between the emission layer and the second electrode,
wherein the hole transport region comprises a hole injection layer, a hole transport layer, an electron blocking layer, or any combination thereof, and
wherein the electron transport region comprises a hole blocking layer, an electron transport layer, an electron injection layer, or any combination thereof.

**13.** The organic light-emitting device of claims 11 or 12, wherein
the emission layer comprises the organometallic compound.

**14.** The organic light-emitting device of claim 13, wherein
the emission layer further comprises a host, and wherein an amount of the host is larger than an amount of the organometallic compound.

**15.** A diagnostic composition comprising at least one of the organometallic compound of any of claims 1-10.

## Patentansprüche

**1.** Organometallische Verbindung, repräsentiert durch Formel 1:

Formel 1

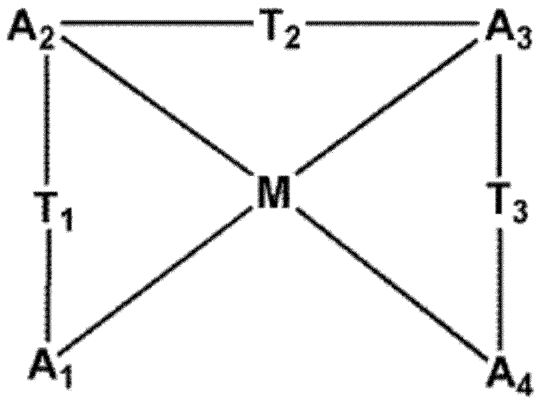

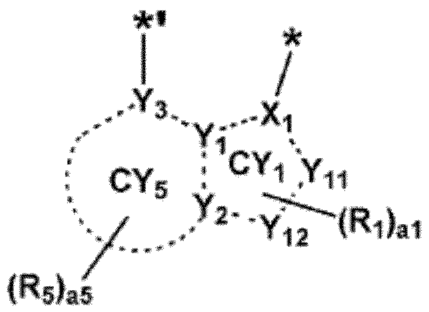

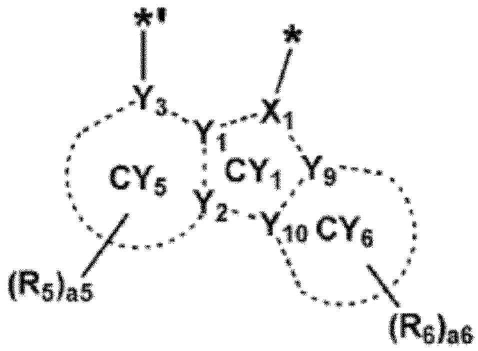

Formel A1-1 Formel A1-2

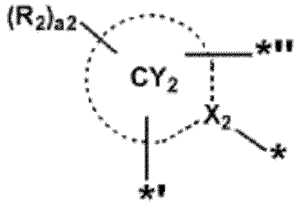

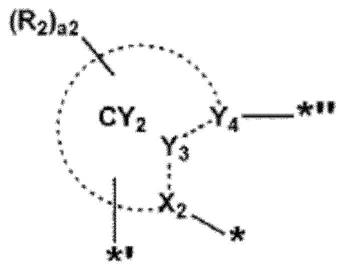

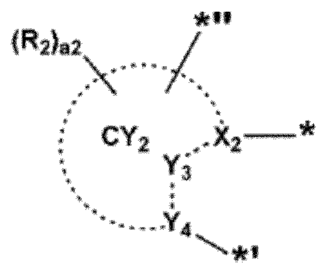

Formel A2-1 Formel A2-2 Formel A2-3

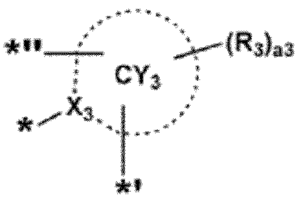

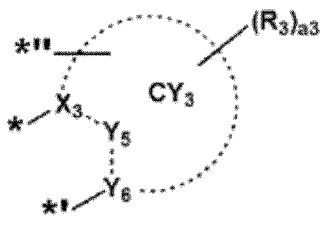

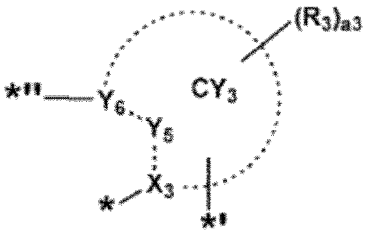

Formel A3-1 Formel A3-2 Formel A3-3

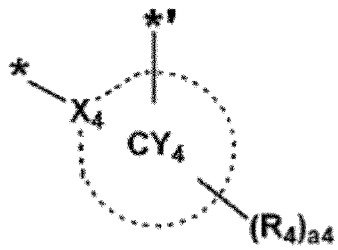

Formel A4-1

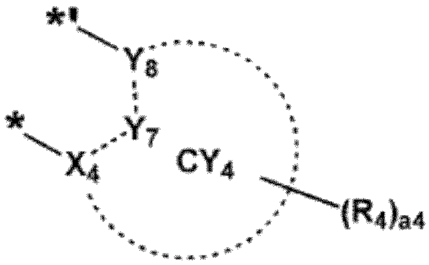

Formel A4-2,

wobei

M in Formel 1 Platin (Pt) ist,

in Formel 1 zwei Bindungen, ausgewählt aus einer Bindung zwischen $A_1$ und M, einer Bindung zwischen $A_2$ und M, einer Bindung zwischen $A_3$ und M und einer Bindung zwischen $A_4$ und M jeweils eine kovalente Bindung sind und die anderen von diesen jeweils eine koordinative Bindung sind,

$A_1$ in Formel 1 durch Formel A1-1 oder A1-2 repräsentiert wird und in den Formeln A1-1 und A1-2 * eine Bindungsstelle zu M in Formel 1 anzeigt und *' eine Bindungsstelle zu $T_1$ in Formel 1 anzeigt,

$A_2$ in Formel 1 durch eine von Formel A2-1 bis A2-3 repräsentiert wird und in den Formeln A2-1 bis A2-3 * eine Bindungsstelle zu M in Formel 1 anzeigt, *' eine Bindungsstelle zu $T_1$ in Formel 1 anzeigt und *" eine Bindungsstelle zu $T_2$ in Formel 1 anzeigt, und in Formel A2-1 die zwei Atome, mit denen *' und *" verknüpft sind, an $X_2$ angrenzen,

$A_3$ in Formel 1 durch eine von Formel A3-1 bis A3-3 repräsentiert wird und in den Formeln A3-1 bis A3-3 * eine Bindungsstelle zu M in Formel 1 anzeigt, *" eine Bindungsstelle zu $T_2$ in Formel 1 anzeigt und *' eine Bindungsstelle zu $T_3$ in Formel 1 anzeigt, und in Formel A3-1 die zwei Atome, mit denen *' und *" verknüpft sind, an $X_3$ angrenzen,

$A_4$ in Formel 1 eine nicht cyklische Gruppierung ist, beinhaltend ein erstes Atom, das mit M verknüpft ist, oder durch Formel A4-1 oder A4-2 repräsentiert wird, in den Formeln A4-1 und A4-2 * eine Bindungsstelle zu M in Formel 1 anzeigt und *' eine Bindungsstelle zu $T_3$ in Formel 1 anzeigt, und in Formel A4-1 das Atom, mit dem *' verknüpft ist, an $X_4$ angrenzt,

das erste Atom B, N, P, C, Si, O oder S ist,

in den Formeln A1-1, A1-2, A2-1 bis A2-3, A3-1 bis A3-3, A4-1 und A4-2 $X_1$ bis $X_4$ und $Y_1$ bis $Y_{10}$ jeweils unabhängig C oder N sind und $Y_{11}$ O, S, N, C oder Si ist,

$Y_{12}$ C ist,

der Ring $CY_1$ in den Formeln A1-1 und A1-2 ein 5-gliedriger Ring ist,

die Ringe $CY_2$ bis $CY_6$ in den Formeln A1-1, A1-2, A2-1 bis A2-3, A3-1 bis A3-3, A4-1 und A4-2 jeweils unabhängig eine carbocyclische $C_5$-$C_{30}$-Gruppe oder eine heterocyclische $C_1$-$C_{30}$-Gruppe sind,

$T_1$ bis $T_3$ in der Formel 1 jeweils eine Einzelbindung sind,

$R_7$ und $R_8$ optional über eine Einzelbindung, eine Doppelbindung oder eine erste Verknüpfungsgruppe verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden,

$R_1$ und $R_8$ unabhängig ausgewählt sind aus Wasserstoff, Deuterium, -F, -Cl, -Br, -I, $-SF_5$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkynylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten $C_2$-$C_{60}$-Heteroarylalkylgruppe, einer substituierten oder unsubstituierten, monovalenten, nicht

aromatischen, kondensierten, polycyclischen Gruppe, einer substituierten oder unsubstituierten, monovalenten, nicht aromatischen, kondensierten, heteropolycyclischen Gruppe, $-N(Q_1)(Q_2)$, $-Si(Q_3)(Q_4)(Q_5)$, $-B(Q_6)(Q_7)$ und $-P(=O)(Q_8)(Q_9)$,

a1 in Formel A1-1 eine ganze Zahl von 0 bis 4 ist,

a2 bis a6 in den Formeln A1-1, A1-2, A2-1 bis A2-3, A3-1 bis A3-3, A4-1 und A4-2 jeweils unabhängig eine ganze Zahl von 0 bis 20 sind,

zwei von einer Vielzahl von benachbarten Gruppen $R_2$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden,

zwei von einer Vielzahl von benachbarten Gruppen $R_3$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden,

zwei von einer Vielzahl von benachbarten Gruppen $R_4$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden,

zwei von einer Vielzahl von benachbarten Gruppen $R_5$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden,

zwei von einer Vielzahl von benachbarten Gruppen $R_6$ optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden,

zwei oder mehrere benachbarte Gruppen, ausgewählt aus $R_2$ bis $R_5$, optional verknüpft sind, um eine substituierte oder unsubstituierte carbocyclische $C_5$-$C_{30}$-Gruppe oder eine substituierte oder unsubstituierte heterocyclische $C_1$-$C_{30}$-Gruppe zu bilden,

$A_1$ und $A_4$ in Formel 1 nicht miteinander verknüpft sind,

i) wenn $A_1$ in Formel 1 durch Formel A1-1 repräsentiert wird, die durch Formel 1 repräsentierte organometallische Verbindung "Bedingung 1" erfüllt, und ii) wenn $A_1$ in Formel 1 durch Formel A1-2 repräsentiert wird, die durch Formel 1 repräsentierte organometallische Verbindung mindestens eine von "Bedingung 1" bis "Bedingung 3" erfüllt,

"Bedingung 1"
$A_2$ in Formel 1 durch Formel A2-2 oder A2-3 repräsentiert wird,
"Bedingung 2"
$A_3$ in Formel 1 durch Formel A3-2 oder A3-3 repräsentiert wird, und
"Bedingung 3"
$A_4$ in Formel 1 durch Formel A4-2 repräsentiert wird,

wobei mindestens ein Substituent der substituierten carbocyclischen $C_5$-$C_{30}$-Gruppe, der substituierten heterocyclischen $C_1$-$C_{30}$-Gruppe, der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_7$-$C_{60}$-Arylalkylgruppe, der substituierten $C_1$-$C_{60}$-Heteroarylgruppe, der substituierten $C_1$-$C_{60}$-Heteroaryloxygruppe, der substituierten $C_1$-$C_{60}$-Heteroarylthiogruppe, der substituierten $C_2$-$C_{60}$-Heteroarylalkylgruppe, der substituierten, monovalenten, nicht aromatischen, kondensierten, polycyclischen Gruppe und der substituierten, monovalenten, nicht aromatischen, kondensierten, heteropolycyclischen Gruppe ausgewählt ist aus:

Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;

einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, jeweils substituiert mit mindestens einem, ausgewählt aus Deuterium, -F, -Cl, -Br, -I, - $CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer

$C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nicht aromatischen, kondensierten, polycyclischen Gruppe, einer monovalenten, nicht aromatischen, kondensierten, heteropolycyclischen Gruppe, -N($Q_{11}$)($Q_{12}$), -Si($Q_{13}$)($Q_{14}$)($Q_{15}$), -B($Q_{16}$)($Q_{17}$) und -P(=O)($Q_{18}$)($Q_{19}$);

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nicht aromatischen, kondensierten, polycyclischen Gruppe, einer monovalenten, nicht aromatischen, kondensierten, heteropolycyclischen Gruppe;

einer $C_3$-$C_{10}$-Cycloalkylgruppe, einer $C_1$-$C_{10}$-Heterocycloalkylgruppe, einer $C_{3-10}$Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nicht aromatischen, kondensierten, polycyclischen Gruppe und einer monovalenten, nicht aromatischen, kondensierten, heteropolycyclischen Gruppe, jeweils substituiert mit einem ausgewählt aus Deuterium, -F, -Cl, -Br, -I, -$CD_3$, -$CD_2H$, -$CDH_2$, -$CF_3$, -$CF_2H$, -$CFH_2$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{60}$-Alkylgruppe, einer $C_2$-$C_{60}$-alkenylgruppe, einer $C_2$-$C_{60}$-Alkynylgruppe, einer $C_1$-$C_{60}$-Alkoxygruppe, einer $C_3$-$C_{10}$Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nicht aromatischen, kondensierten, polycyclischen Gruppe, einer monovalenten, nicht aromatischen, kondensierten, heteropolycyclischen Gruppe, -N($Q_{21}$)($Q_{22}$), -Si($Q_{23}$)($Q_{24}$)($Q_{25}$), -B($Q_{26}$)($Q_{27}$) und -P(=O)($Q_{28}$)($Q_{29}$), und

-N($Q_{31}$)($Q_{32}$), -Si($Q_{33}$)($Q_{34}$)($Q_{35}$), -B($Q_{36}$)($Q_{37}$) und -P(=O)($Q_{38}$)($Q_{39}$) und

$Q_1$ bis $Q_9$, $Q_{11}$ bis $Q_{19}$, $Q_{21}$ bis $Q_{29}$ und $Q_{31}$ bis $Q_{39}$ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{60}$-Alkylgruppe, einer $C_1$-$C_{60}$-Alkylgruppe, substituiert mit mindestens einem ausgewählt aus Deuterium, einer $C_1$-$C_{60}$-Alkylgruppe und einer $C_6$-$C_{60}$-Arylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe, substituiert mit mindestens einem ausgewählt aus Deuterium, einer $C_1$-$C_{60}$-Alkylgruppe und einer $C_6$-$C_{60}$-Arylgruppe, einer $C_6$-$C_{60}$Aryloxygruppe, einer $C_6$-$C_{60}$Arylthiogruppe, einer $C_7$-$C_{60}$Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nicht aromatischen, kondensierten, polycyclischen Gruppe und einer monovalenten, nicht aromatischen, kondensierten, heteropolycyclischen Gruppe.

**2.** Organometallische Verbindung gemäß Anspruch 1, wobei
eine Bindung zwischen $A_1$ und M und eine Bindung zwischen $A_3$ und M jeweils eine kovalente Bindung sind und eine Bindung zwischen $A_2$ und M und eine Bindung zwischen $A_4$ und M jeweils eine koordinative Bindung sind, oder eine Bindung zwischen $A_1$ und M und eine Bindung zwischen $A_4$ und M jeweils eine kovalente Bindung sind und eine Bindung zwischen $A_2$ und M und eine Bindung zwischen $A_3$ und M jeweils eine koordinative Bindung sind.

**3.** Organometallische Verbindung gemäß den Ansprüchen 1 oder 2, wobei
der Ring $CY_1$ aus einer Pyrrolgruppe, einer Furangruppe, einer Thiophengruppe, einer Silolgruppe, einer Pyrazolgruppe, einer Imidazolgruppe, einer Triazolgruppe, einer Tetrazolgruppe, einer Oxazolgruppe, einer Isoxazolgruppe, einer Thiazolgruppe, einer Isothiazolgruppe, einer Oxadiazolgruppe, einer Thiadiazolgruppe, einer Oxatriazole groupgruppe und einer Thiatriazolgruppe ausgewählt ist.

**4.** Organometallische Verbindung gemäß einem der Ansprüche 1-3, wobei
die Ringe $CY_2$ bis $CY_6$ unabhängig ausgewählt sind aus einer Benzolgruppe, einer Naphthalengruppe, einer Anthracengruppe, einer Phenanthrengruppe, einer Triphenylengruppe, einer Pyrengruppe, einer Chrysengruppe, einer

Cyclopentadiengruppe, einer 1,2,3,4-Tetrahydronaphthalengruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Azafluorengruppe, einer Azacarbazolgruppe, einer Azadibenzofurangruppe, einer Azadibenzothiophengruppe, einer Azadibenzosilolgruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrrolgruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer Benzoxazolgruppe, einer Benzothiazolgruppe, einer Benzooxadiazolgruppe, einer Benzothiadiazolgruppe, einer 5,6,7,8-Tetrahydroisochinolingruppe und einer 5,6,7,8-Tetrahydrochinolingruppe.

**5.** Organometallische Verbindung gemäß einem der Ansprüche 1-4, wobei mindestens einer der Ringe $CY_2$ bis $CY_4$ ein kondensierter Ring mit mindestens einem 5-gliedrigen Ring und mindestens einem 6-gliedrigen Ring oder ein kondensierter Ring mit mindestens zwei 6-gliedrigen Ringen ist,
wobei der 5-gliedrige Ring ausgewählt ist aus einer Cyclopentadiengruppe, einer Furangruppe, einer Thiophengruppe, einer Pyrrolgruppe, einer Silolgruppe, einer Oxazolgruppe, einer Isoxazolgruppe, einer Oxadiazolgruppe, einer Isoxadiazolgruppe, einer Oxatriazolgruppe, einer Isoxatriazolgruppe, einer Thiazolgruppe, einer Isothiazolgruppe, einer Thiadiazolgruppe, einer Isothiadiazolgruppe, einer Thiatriazolgruppe, einer Isothiatriazolgruppe, einer Pyrazolgruppe, einer Imidazolgruppe, einer Triazolgruppe, einer Tetrazolgruppe, einer Azasilolgruppe, einer Diazasilolgruppe und einer Triazasilolgruppe, und
wobei der 6-gliedrige Ring ausgewählt ist aus einer Cyclohexangruppe, einer Cyclohexengruppe, einer Benzolgruppe, einer Pyridingruppe, einer Pyrimidingruppe, einer Pyrazingruppe und einer Pyridazingruppe.

**6.** Organometallische Verbindung gemäß einem der Ansprüche 1-5, wobei
$R_1$ bis $R_8$ jeweils unabhängig ausgewählt sind aus:

Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, $-SF_5$, einer $C_1$-$C_{20}$-Alkylgruppe und einer $C_1$-$C_{20}$-Alkoxygruppe,
einer $C_1$-$C_{20}$-Alkylgruppe und einer $C_1$-$C_{20}$-alkoxygruppe, jeweils substituiert mit mindestens einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{10}$-Alkylgruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer a cycloheptyl group, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe einer Cyclohexenylgruppe, einer Cycloheptenylgruppe, einer Phenylgruppe, einer Naphthylgruppe, einer Fluorenylgruppe,

einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgroup, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem ausgewählt aus Deuterium, -F, -Cl, -Br, -I, - $CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Schwefelsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenyl gruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe und $-Si(Q_{33})(Q_{34})(Q_{35})$; und

- $N(Q_1)(Q_2)$, $-Si(Q_3)(Q_4)(Q_5)$, $-B(Q_6)(Q_7)$, und $-P(=O)(Q_8)(Q_9)$, und

$Q_1$ bis $Q_9$ und $Q_{33}$ bis $Q_{35}$ jeweils unabhängig ausgewählt sind aus:

- $CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CH_3$, $-CD_2CD_3$, $-CD_2CD_2H$ und - $CD_2CDH_2$;

einer n-Propylgruppe, einer Iso-Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppeund einer Naphthylgruppe; und
einer n-Propylgruppe, einer Iso-Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit mindestens einem ausgewählt aus Deuterium, einer $C_1$-$C_{10}$-Alkylgruppe und einer Phenylgruppe.

**7.** Organometallische Verbindung gemäß einem der Ansprüche 1-6, wobei
$R_1$ bis $R_8$ jeweils unabhängig ausgewählt sind aus Wasserstoff, Deuterium, -F, einer Cyanogruppe, einer Nitrogruppe, $-SF_5$, $-CH_3$, $-CD_3$, $-CD_2H$, $-CDH_2$, $-CF_3$, $-CF_2H$, $-CFH_2$, Gruppen repräsentiert durch die Formeln 9-1 bis 9-19, Gruppen repräsentiert durch die Formeln 10-1 bis 10-161, $-N(Q_1)(Q_2)$, $-Si(Q_3)(Q_4)(Q_5)$, $-B(Q_6)(Q_7)$ und $-P(=O)(Q_8)(Q_9)$:

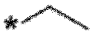
Formel 9-1

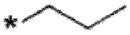
Formel 9-2

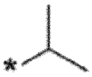
Formel 9-3

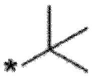
Formel 9-4

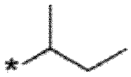
Formel 9-5

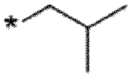
Formel 9-6

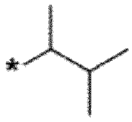
Formel 9-7

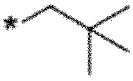
Formel 9-8

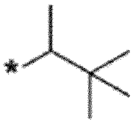
Formel 9-9

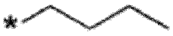
Formel 9-10

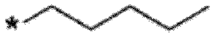
Formel 9-11

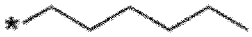
Formel 9-12

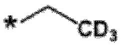
Formel 9-13

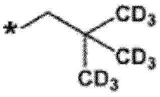
Formel 9-14

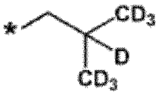
Formel 9-15

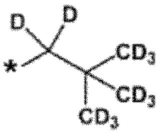
Formel 9-16

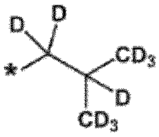
Formel 9-17

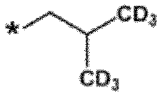
Formel 9-18

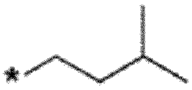
Formel 9-19

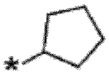
Formel 10-1

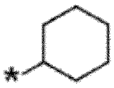
Formel 10-2

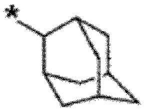
Formel 10-3

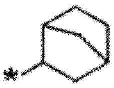
Formel 10-4

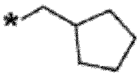
Formel 10-5

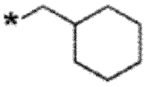
Formel 10-6

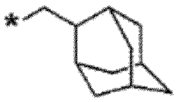
Formel 10-7

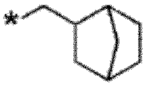
Formel 10-8

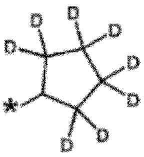
Formel 10-9

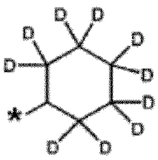
Formel 10-10

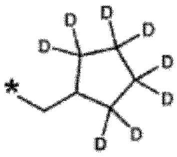
Formel 10-11

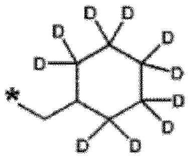
Formel 10-12

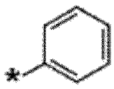
Formel 10-13

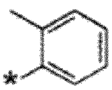
Formel 10-14

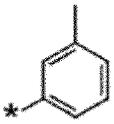
Formel 10-15

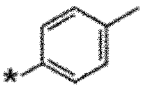
Formel 10-16

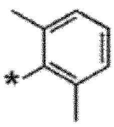
Formel 10-17

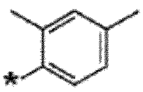
Formel 10-18

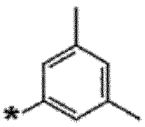
Formel 10-19

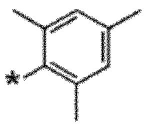
Formel 10-20

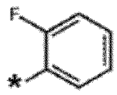
Formel 10-21

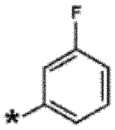
Formel 10-22

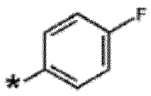
Formel 10-23

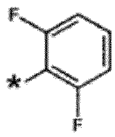
Formel 10-24

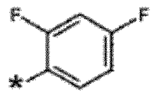
Formel 10-25

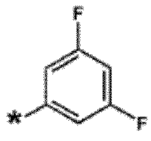
Formel 10-26

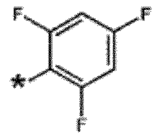
Formel 10-27

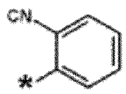
Formel 10-28

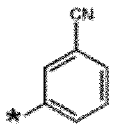
Formel 10-29

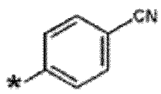
Formel 10-30

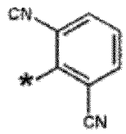
Formel 10-31

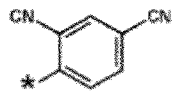
Formel 10-32

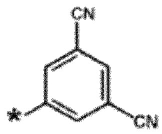
Formel 10-33

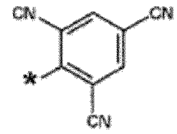
Formel 10-34

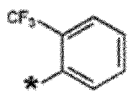
Formel 10-35

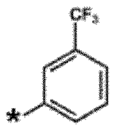
Formel 10-36

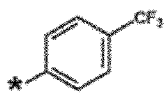
Formel 10-37

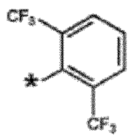
Formel 10-38

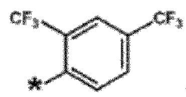
Formel 10-39

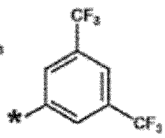
Formel 10-40

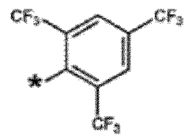
Formel 10-41

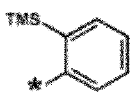
Formel 10-42

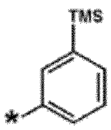
Formel 10-43

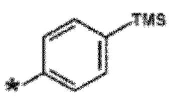
Formel 10-44

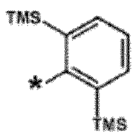
Formel 10-45

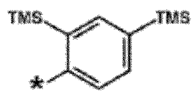
Formel 10-46

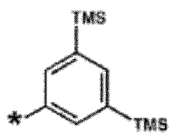
Formel 10-47

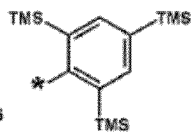
Formel 10-48

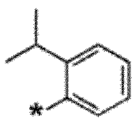
Formel 10-49

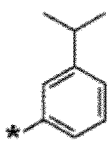
Formel 10-50

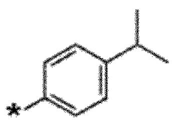
Formel 10-51

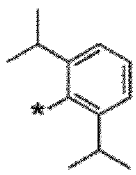
Formel 10-52

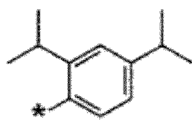
Formel 10-53

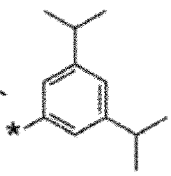
Formel 10-54

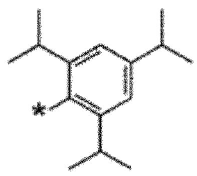
Formel 10-55

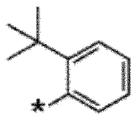
Formel 10-56

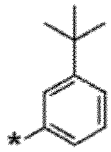
Formel 10-57

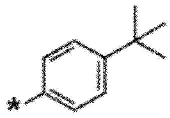
Formel 10-58

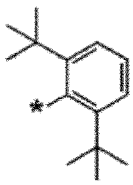
Formel 10-59

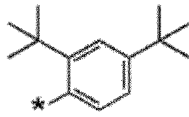
Formel 10-60

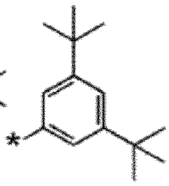
Formel 10-61

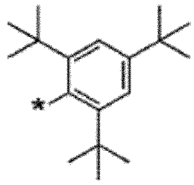
Formel 10-62

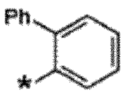
Formel 10-63

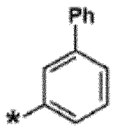
Formel 10-64

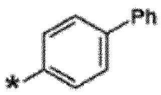
Formel 10-65

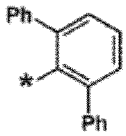
Formel 10-66

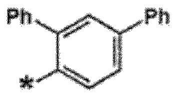
Formel 10-67

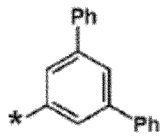
Formel 10-68

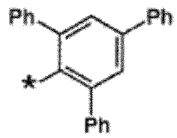
Formel 10-69

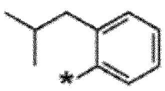
Formel 10-70

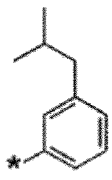
Formel 10-71

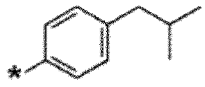
Formel 10-72

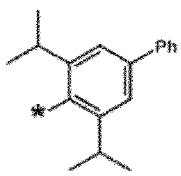
Formel 10-73

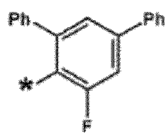
Formel 10-74

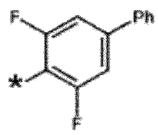
Formel 10-75

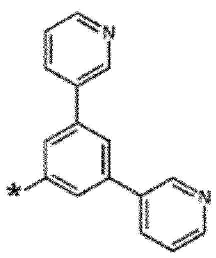
Formel 10-76

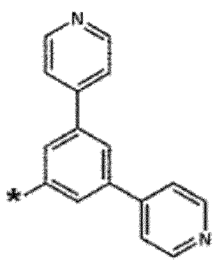
Formel 10-77

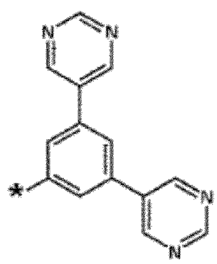
Formel 10-78

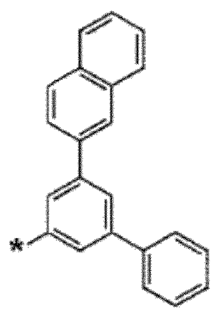
Formel 10-79

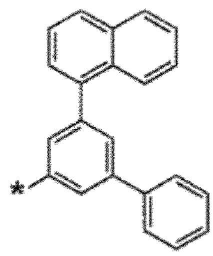
Formel 10-80

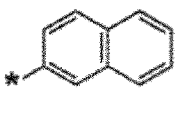
Formel 10-81

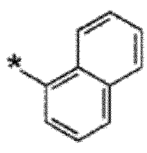
Formel 10-82

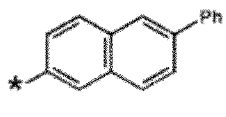
Formel 10-83

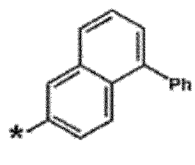
Formel 10-84

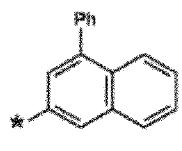
Formel 10-85

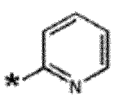
Formel 10-86

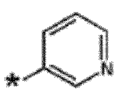
Formel 10-87

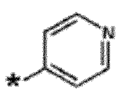
Formel 10-88

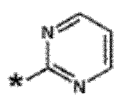
Formel 10-89

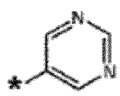
Formel 10-90

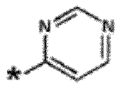
Formel 10-91

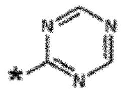
Formel 10-92

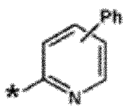
Formel 10-93

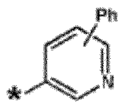
Formel 10-94

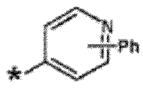
Formel 10-95

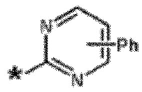
Formel 10-96

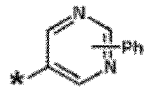
Formel 10-97

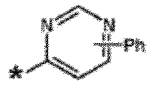
Formel 10-98

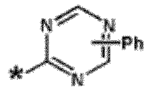
Formel 10-99

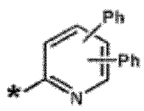
Formel 10-100

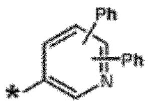
Formel 10-101

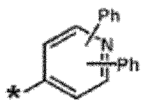
Formel 10-102

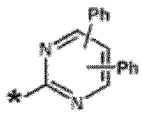
Formel 10-103

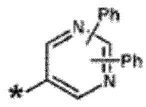
Formel 10-104

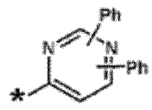
Formel 10-105

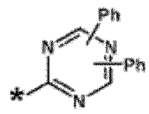
Formel 10-106

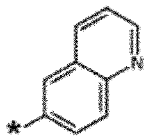
Formel 10-107

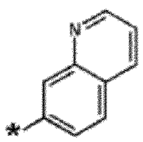
Formel 10-108

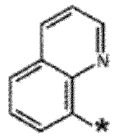
Formel 10-109

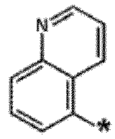
Formel 10-110

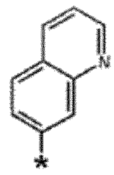
Formel 10-111

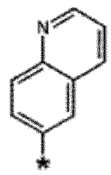
Formel 10-112

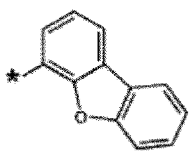
Formel 10-113

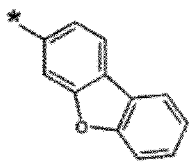
Formel 10-114

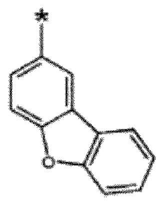
Formel 10-115

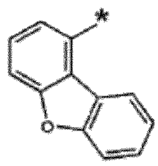
Formel 10-116

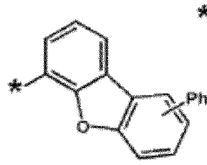
Formel 10-117

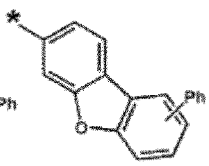
Formel 10-118

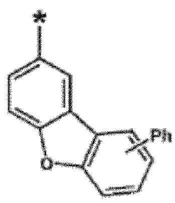
Formel 10-119

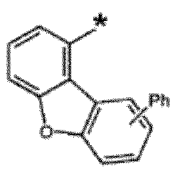
Formel 10-120

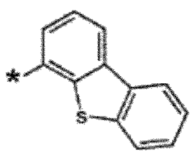
Formel 10-121

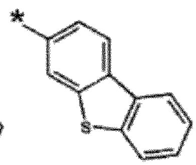
Formel 10-122

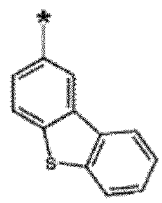
Formel 10-123

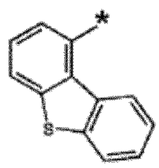
Formel 10-124

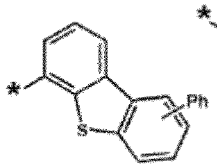
Formel 10-125

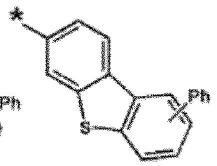
Formel 10-126

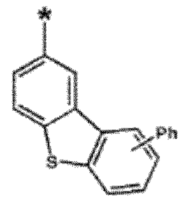
Formel 10-127

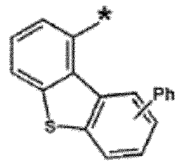
Formel 10-128

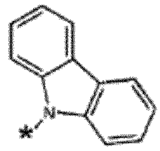
Formel 10-129

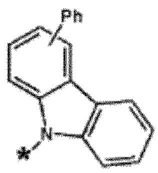
Formel 10-130

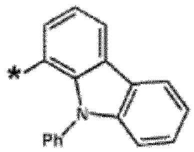
Formel 10-131

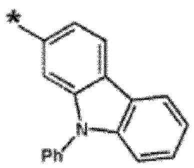
Formel 10-132

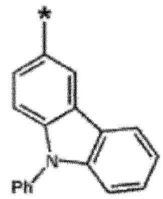
Formel 10-133

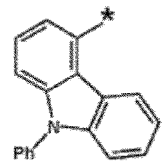
Formel 10-134

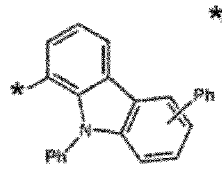
Formel 10-135

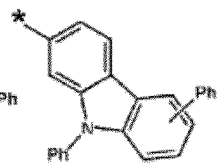
Formel 10-136

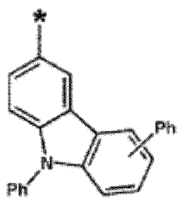
Formel 10-137

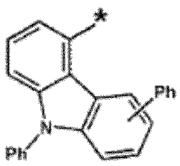
Formel 10-138

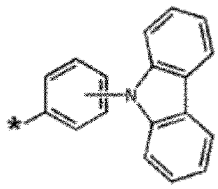
Formel 10-139

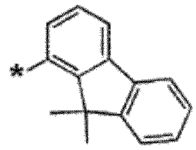
Formel 10-140

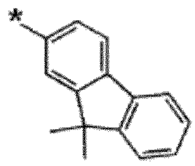
Formel 10-141

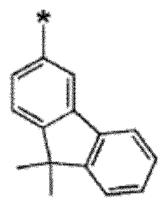
Formel 10-142

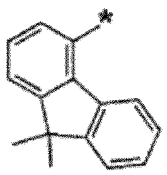
Formel 10-143

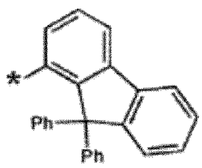
Formel 10-144

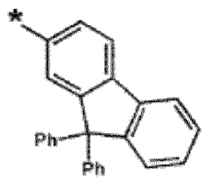
Formel 10-145

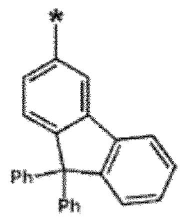
Formel 10-146

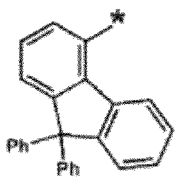
Formel 10-147

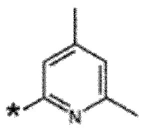
Formel 10-148

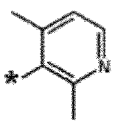
Formel 10-149

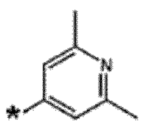
Formel 10-150

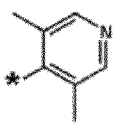
Formel 10-151

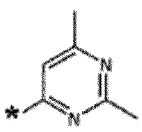
Formel 10-152

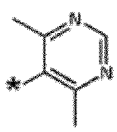
Formel 10-153

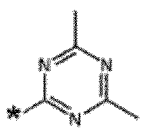
Formel 10-154

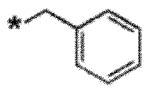
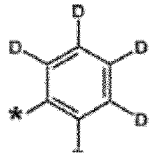
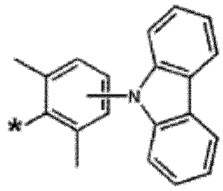
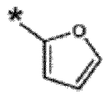
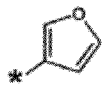
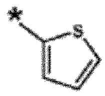
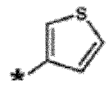

Formel 10-155 | Formel 10-156 | Formel 10-157 | Formel 10-158 | Formel 10-159 | Formel 10-160 | Formel 10-161

,

wobei in den Formeln 9-1 bis 9-19 und 10-1 bis 10-161 "Ph" eine Phenylgruppe anzeigt, "TMS" eine Trimethylsilylgruppe anzeigt und * eine Bindungsstelle zu einem benachbarten Atom anzeigt und $Q_1$ bis $Q_9$ die gleichen wie in Anspruch 1 beschrieben sind.

**8.** Organometallische Verbindung gemäß einem der Ansprüche 1-7, wobei
$A_1$ repräsentiert wird durch eine der Formeln A1-1(1) bis A1-1(24) und A1-2(1) bis A1-2(8):

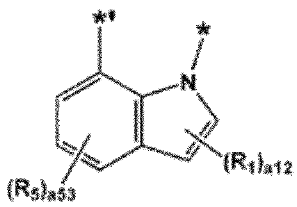
Formel A1-1(1)

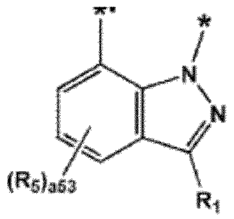
Formel A1-1(2)

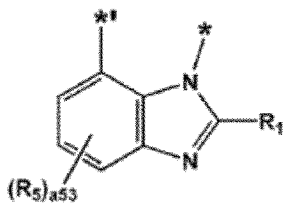
Formel A1-1(3)

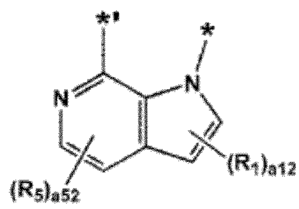
Formel A1-1(4)

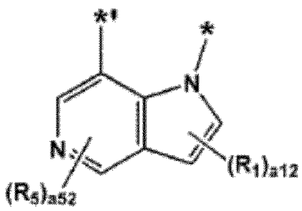
Formel A1-1(5)

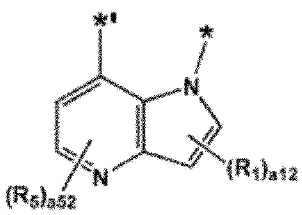
Formel A1-1(6)

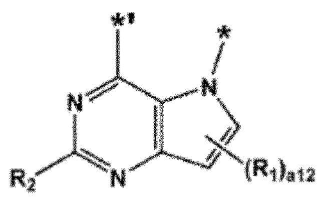
Formel A1-1(7)

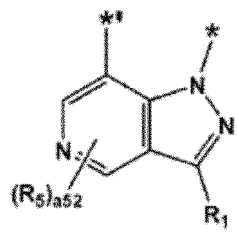
Formel A1-1(8)

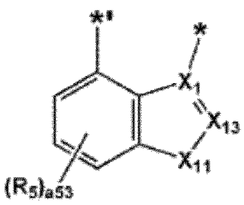
Formel A1-1(9)

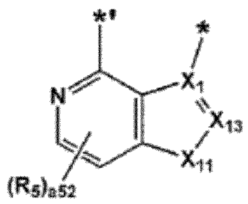
Formel A1-1(10)

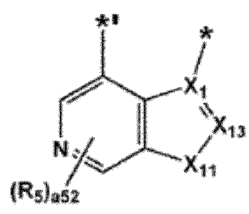
Formel A1-1(11)

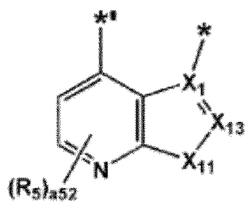
Formel A1-1(12)

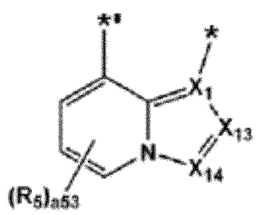

Formel A1-1(13)

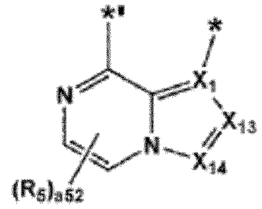

Formel A1-1(14)

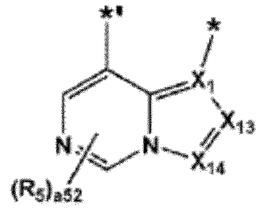

Formel A1-1(15)

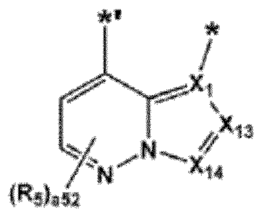

Formel A1-1(16)

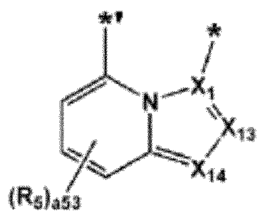

Formel A1-1(17)

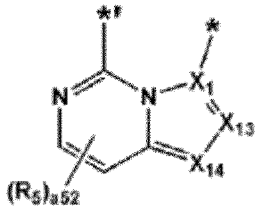

Formel A1-1(18)

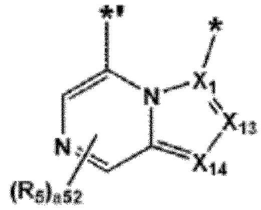

Formel A1-1(19)

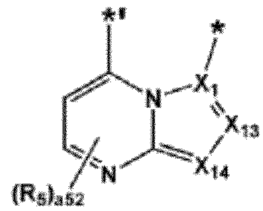

Formel A1-1(20)

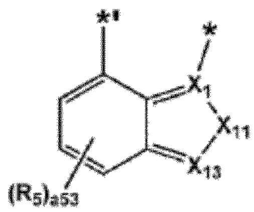

Formel A1-1(21)

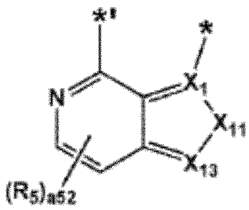

Formel A1-1(22)

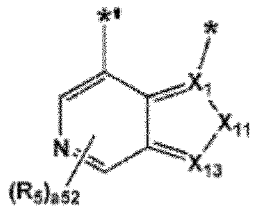

Formel A1-1(23)

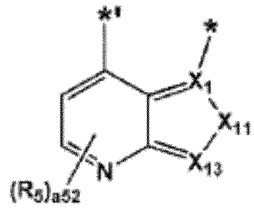

Formel A1-1(24)

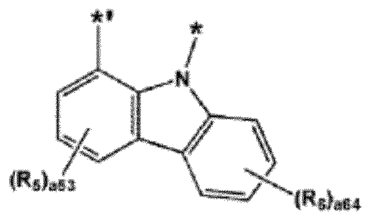

Formel A1-2(1)

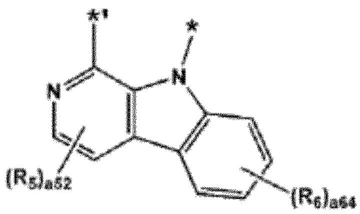

Formel A1-2(2)

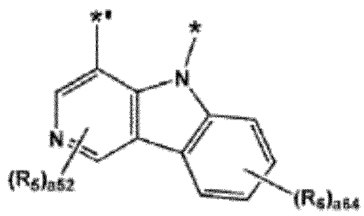

Formel A1-2(3)

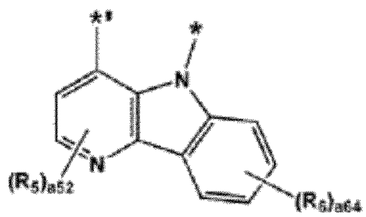

Formel A1-2(4)

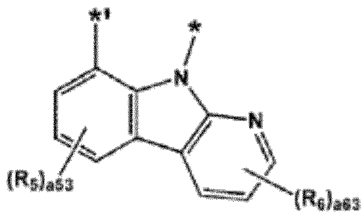

Formel A1-2(5)

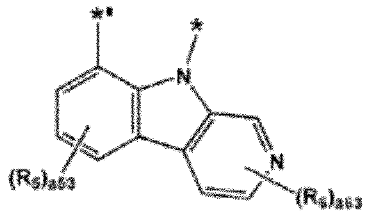

Formel A1-2(6)

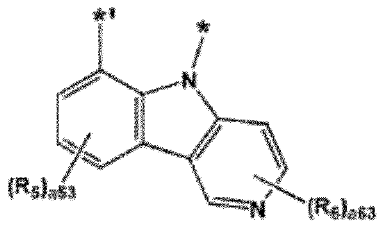

Formel A1-2(7)

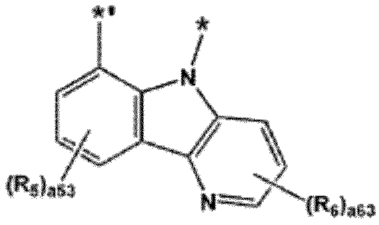

Formel A1-2(8)

,

wobei in den Formeln A1-1(1) bis A1-1(24) und A1-2(1) bis A1-2(8)

$X_1$, $R_1$, $R_5$, $R_6$, * und *' die gleichen wie in Anspruch 1 beschrieben sind,
$X_{11}$ O, S, $N(R_{11})$, $C(R_{11})(R_{12})$ oder $Si(R_{11})(R_{12})$ ist,
$X_{13}$ N oder $C(R_{13})$ ist,
$X_{14}$ N oder $C(R_{14})$ ist,
$R_{11}$ bis $R_{14}$ die gleichen wie in Verbindung mit $R_1$ beschrieben sind,
a64 eine ganze Zahl von 0 bis 4 ist,
a53 und a63 jeweils unabhängig eine ganze Zahl von 0 bis 3 sind und
a12 und a52 jeweils unabhängig eine ganze Zahl von 0 bis 2 sind; und/oder

wobei
$A_2$ repräsentiert wird durch eine der Formeln A2-1(1) bis A2-1(17), A2-2(1) bis A2- 2(58) und A2-3(1) bis A2-3(58):

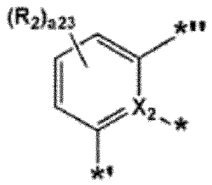

Formel A2-1(1)

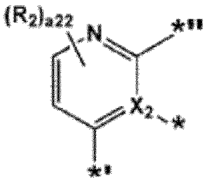

Formel A2-1(2)

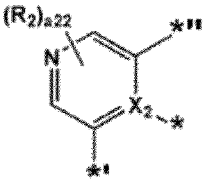

Formel A2-1(3)

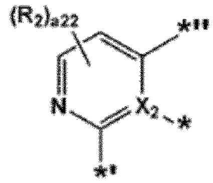

Formel A2-1(4)

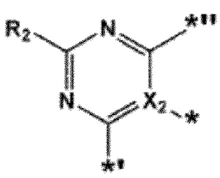

Formel A2-1(5)

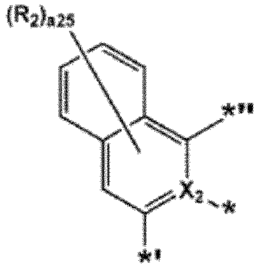

Formel A2-1(6)

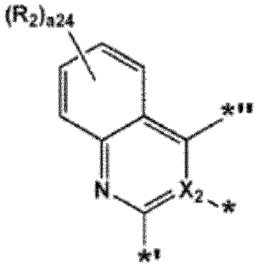

Formel A2-1(7)

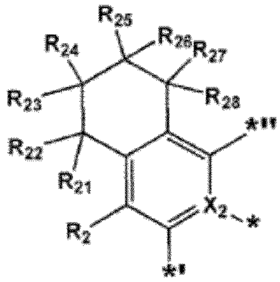

Formel A2-1(8)

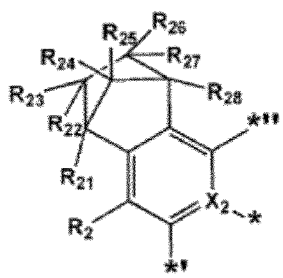

Formel A2-1(9)

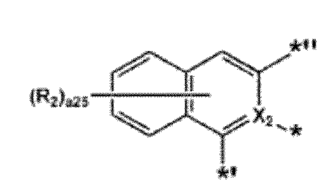

Formel A2-1(10)

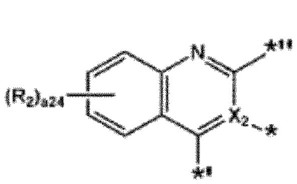

Formel A2-1(11)

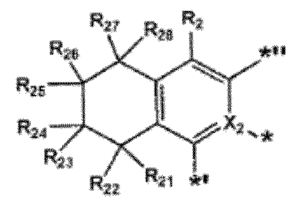

Formel A2-1(12)

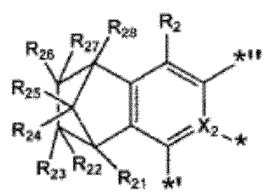

Formel A2-1(13)

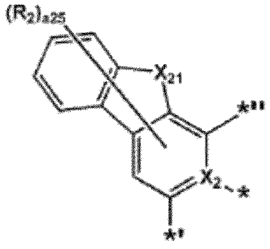
Formel A2-1(14)

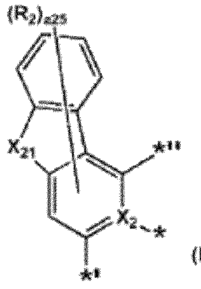
Formel A2-1(15)

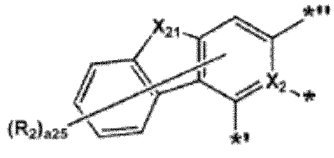
Formel A2-1(16)

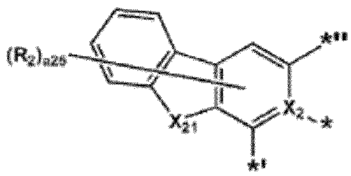
Formel A2-1(17)

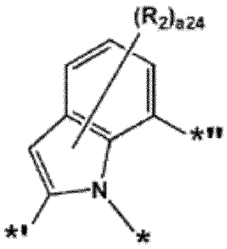
Formel A2-2(1)

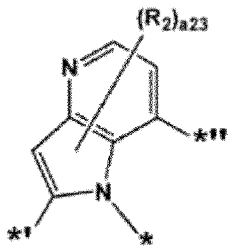
Formel A2-2(2)

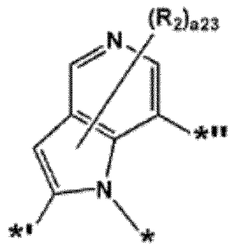
Formel A2-2(3)

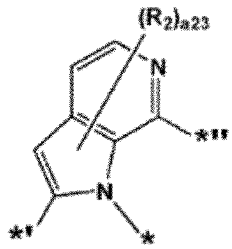
Formel A2-2(4)

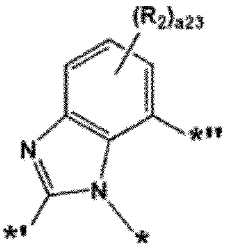
Formel A2-2(5)

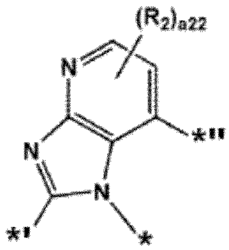
Formel A2-2(6)

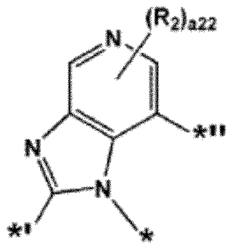
Formel A2-2(7)

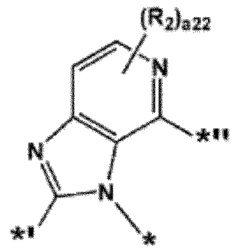
Formel A2-2(8)

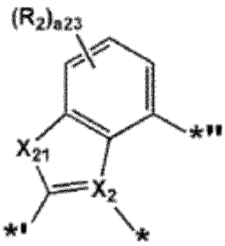
Formel A2-2(9)

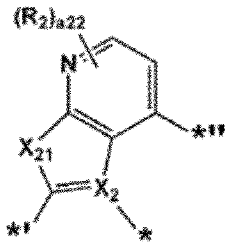
Formel A2-2(10)

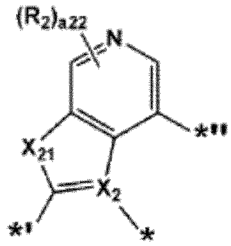
Formel A2-2(11)

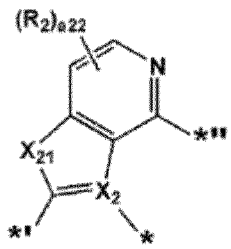
Formel A2-2(12)

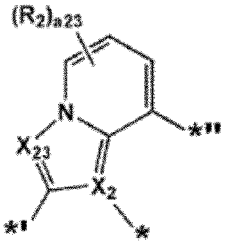

Formel A2-2(13)

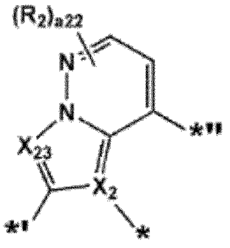

Formel A2-2(14)

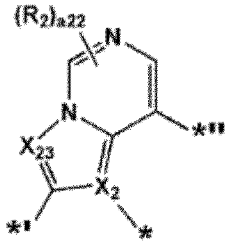

Formel A2-2(15)

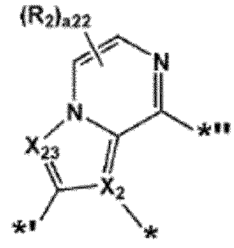

Formel A2-2(16)

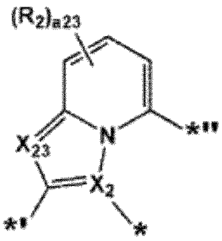

Formel A2-2(17)

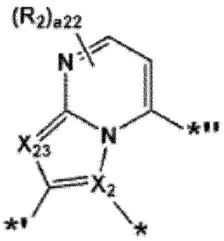

Formel A2-2(18)

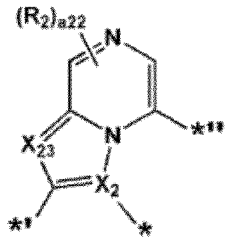

Formel A2-2(19)

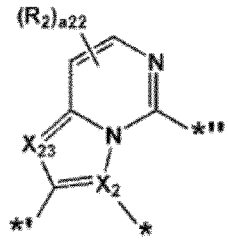

Formel A2-2(20)

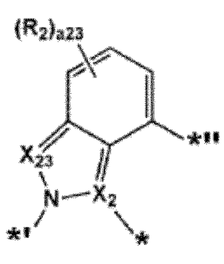

Formel A2-2(21)

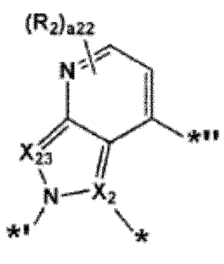

Formel A2-2(22)

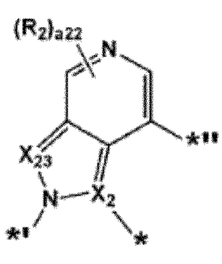

Formel A2-2(23)

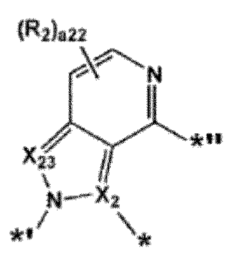

Formel A2-2(24)

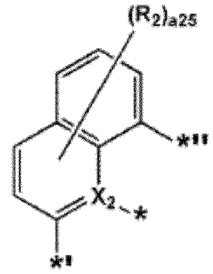

Formel A2-2(25)

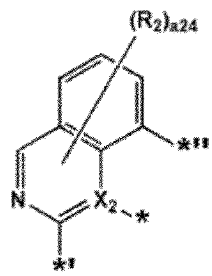

Formel A2-2(26)

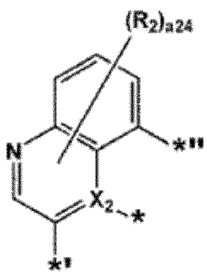

Formel A2-2(27)

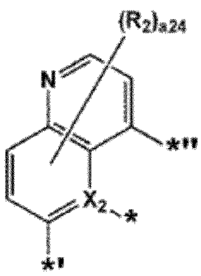

Formel A2-2(28)

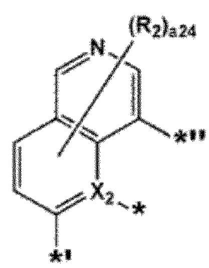

Formel A2-2(29)

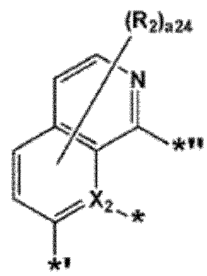

Formel A2-2(30)

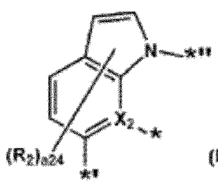

Formel A2-2(31)

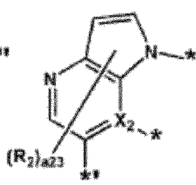

Formel A2-2(32)

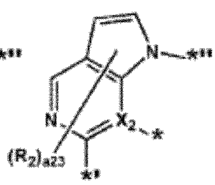

Formel A2-2(33)

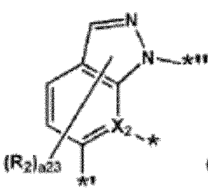

Formel A2-2(34)

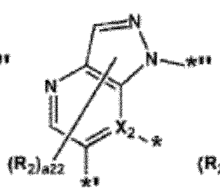

Formel A2-2(35)

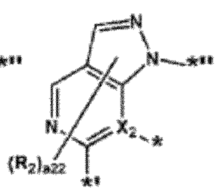

Formel A2-2(36)

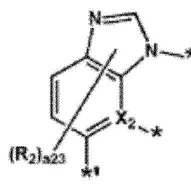

Formel A2-2(37)

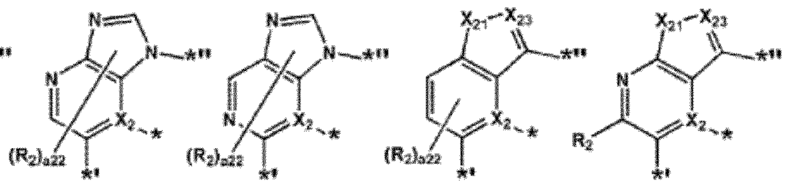

Formel A2-2(38) Formel A2-2(39) Formel A2-2(40) Formel A2-2(41)

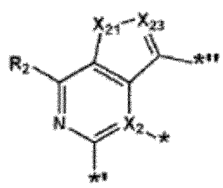

Formel A2-2(42)

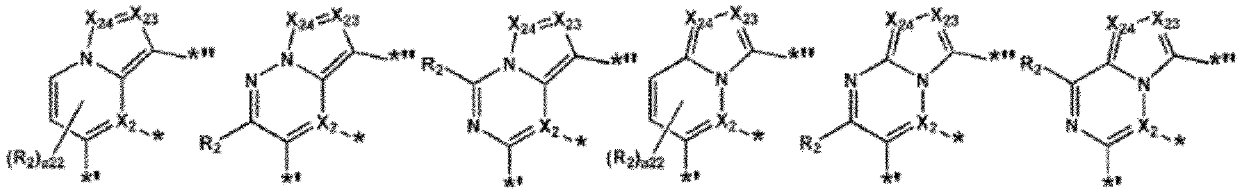

Formel A2-2(43) Formel A2-2(44) Formel A2-2(45) Formel A2-2(46) Formel A2-2(47) Formel A2-2(48)

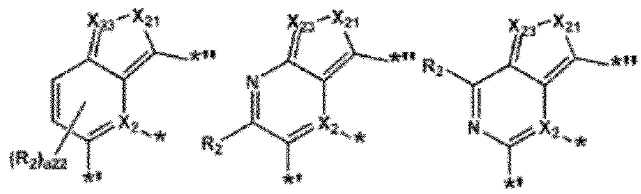

Formel A2-2(49) Formel A2-2(50) Formel A2-2(51)

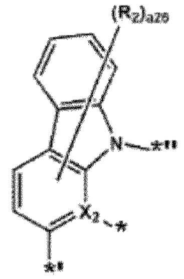

Formel A2-2(52)

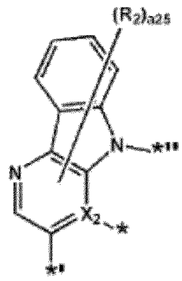

Formel A2-2(53)

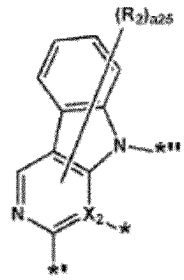

Formel A2-2(54)

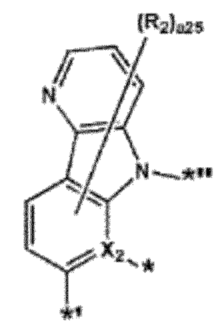

Formel A2-2(55)

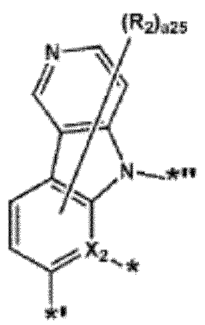

Formel A2-2(56)

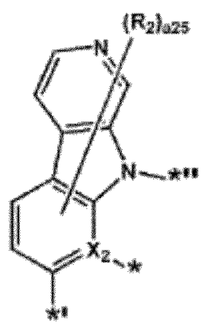

Formel A2-2(57)

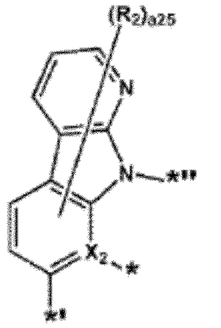

Formel A2-2(58)

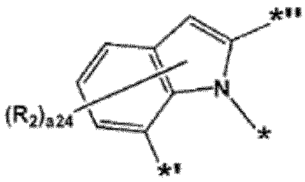

Formel A2-3(1)

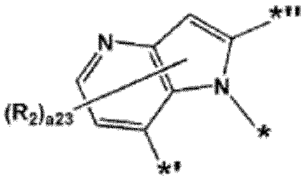

Formel A2-3(2)

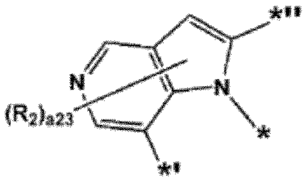

Formel A2-3(3)

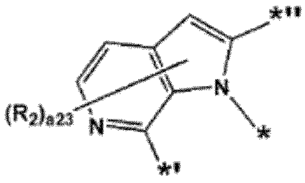

Formel A2-3(4)

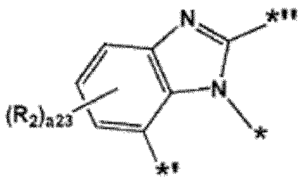

Formel A2-3(5)

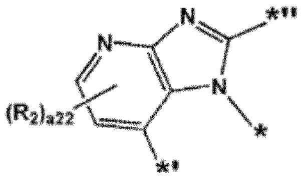

Formel A2-3(6)

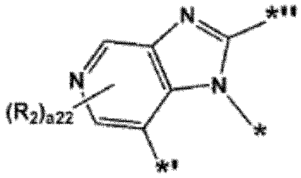

Formel A2-3(7)

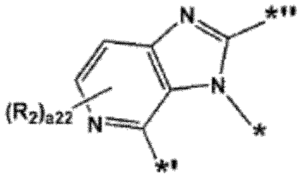

Formel A2-3(8)

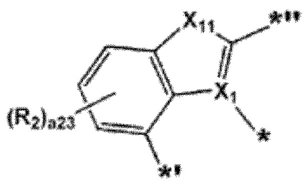

Formel A2-3(9)

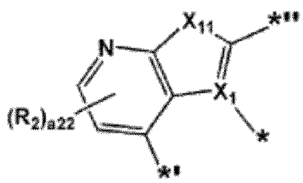

Formel A2-3(10)

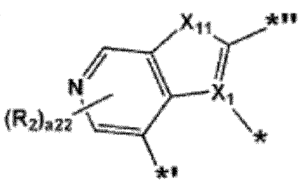

Formel A2-3(11)

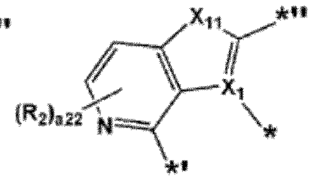

Formel A2-3(12)

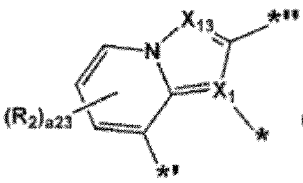

Formel A2-3(13)

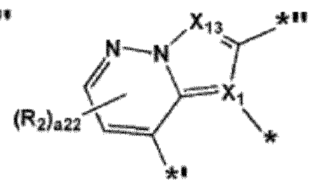

Formel A2-3(14)

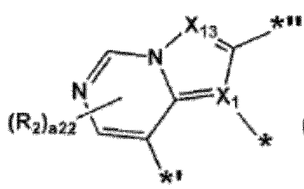

Formel A2-3(15)

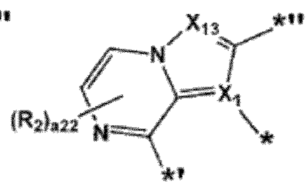

Formel A2-3(16)

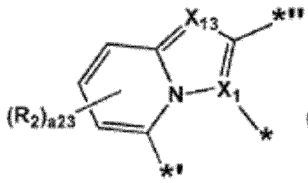

Formel A2-3(17)

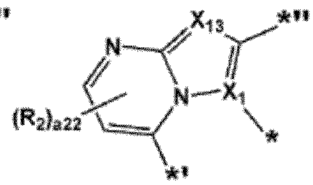

Formel A2-3(18)

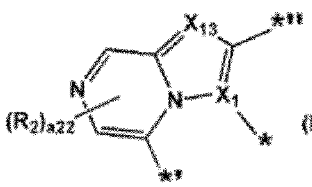

Formel A2-3(19)

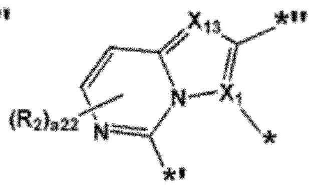

Formel A2-3(20)

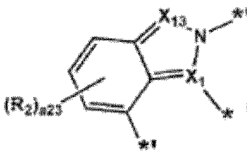

Formel A2-3(21)

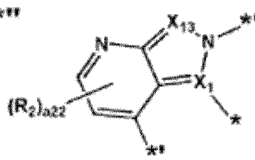

Formel A2-3(22)

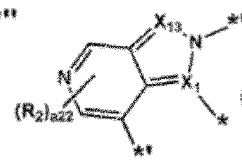

Formel A2-3(23)

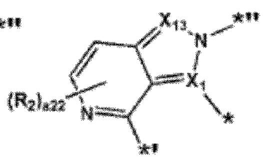

Formel A2-3(24)

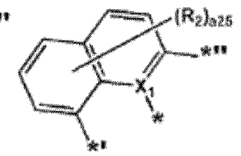

Formel A2-3(25)

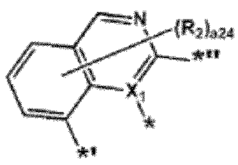 Formel A2-3(26)

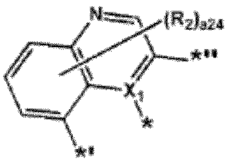 Formel A2-3(27)

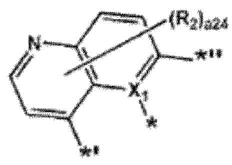 Formel A2-3(28)

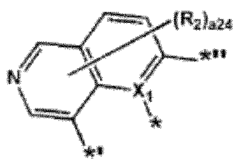 Formel A2-3(29)

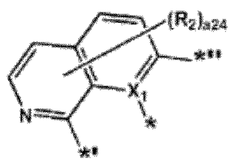 Formel A2-3(30)

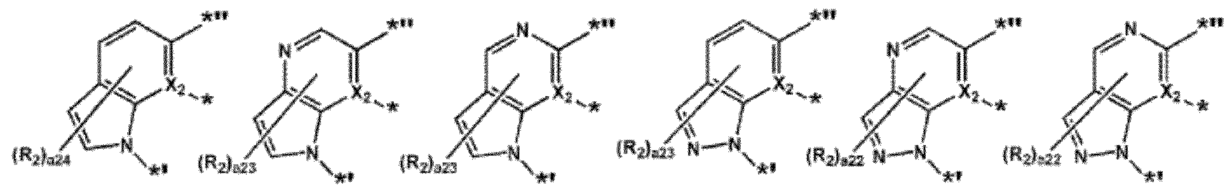

Formel A2-3(31) Formel A2-3(32) Formel A2-3(33) Formel A2-3(34) Formel A2-3(35) Formel A2-3(36)

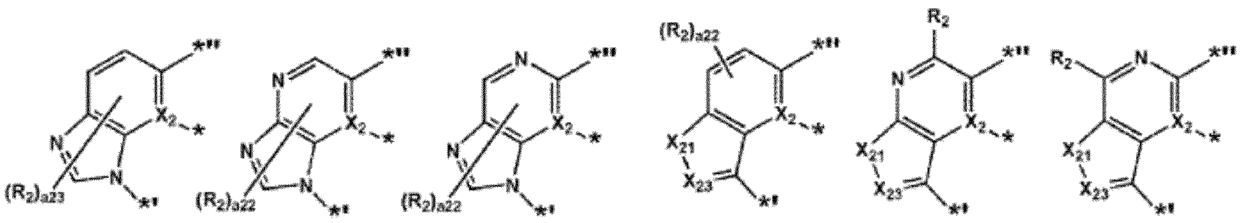

Formel A2-3(37) Formel A2-3(38) Formel A2-3(39) Formel A2-3(40) Formel A2-3(41) Formel A2-3(42)

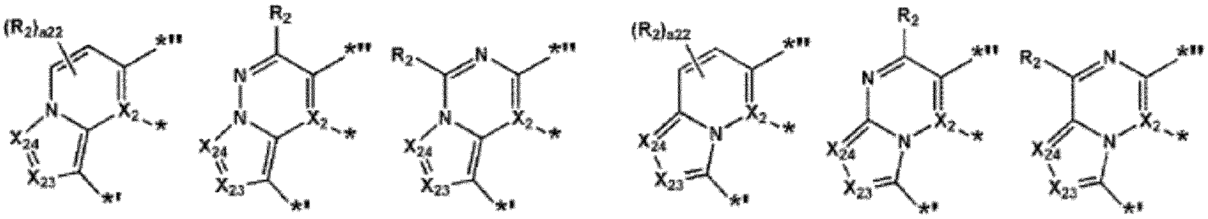

Formel A2-3(43) Formel A2-3(44) Formel A2-3(45) Formel A2-3(46) Formel A2-3(47) Formel A2-3(48)

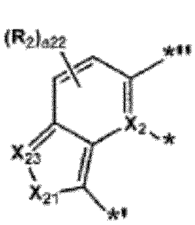 Formel A2-3(49)

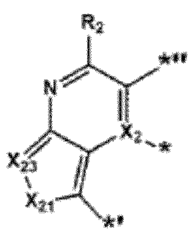 Formel A2-3(50)

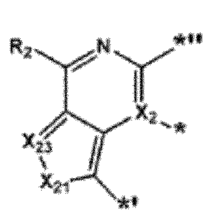 Formel A2-3(51)

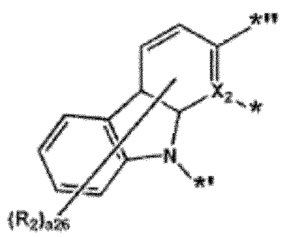 Formel A2-3(52)

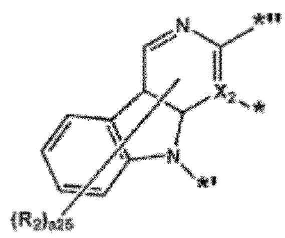 Formel A2-3(53)

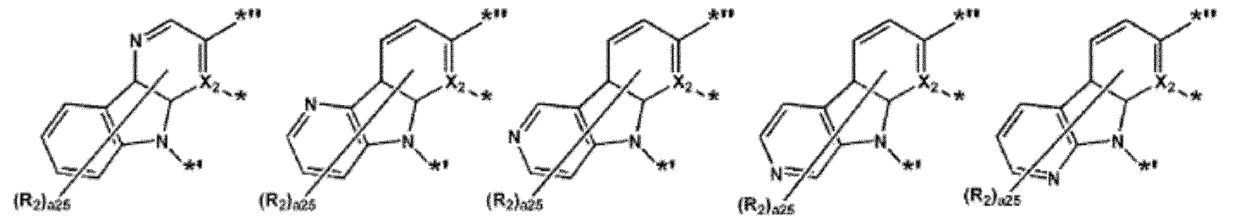

Formel A2-3(54) Formel A2-3(55) Formel A2-3(56) Formel A2-3(57) Formel A2-3(58)

,

wobei in den Formel A2-1(1) bis A2-1(17), A2-2(1) bis A2-2(58) und A2-3(1) bis A2-3(58)

$X_2$ und $R_2$ die gleichen wie in Anspruch 1 beschrieben sind,
$X_{21}$ O, S, $N(R_{21})$, $C(R_{21})(R_{22})$ oder $Si(R_{21})(R_{22})$ ist,
$X_{23}$ N oder $C(R_{23})$ ist,
$X_{24}$ N oder $C(R_{24})$ ist,
$R_{21}$ bis $R_{28}$ die gleichen wie in Verbindung mit $R_2$ in Anspruch 1 beschrieben sind,
a26 eine ganze Zahl von 0 bis 6 ist,
a25 eine ganze Zahl von 0 bis 5 ist,
a24 eine ganze Zahl von 0 bis 4 ist,
a23 eine ganze Zahl von 0 bis 3 ist,
a22 eine ganze Zahl von 0 bis 2 ist, und
*, *' und *" die gleichen wie in Verbindung mit *, *' und *" in Formel A2-1 beschrieben sind; und/oder

wobei
$A_3$ repräsentiert wird durch eine der Formeln A3-1(1) bis A3-1(21), A3-2(1) bis A3- 2(58) und A3-3(1) bis A3-3(58):

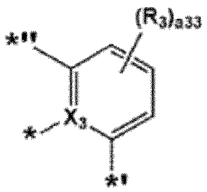

Formel A3-1(1)

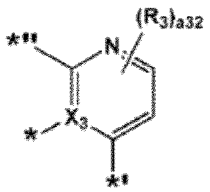

Formel A3-1(2)

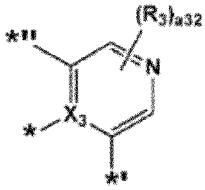

Formel A3-1(3)

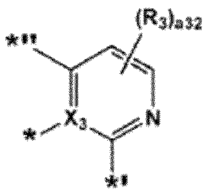

Formel A3-1(4)

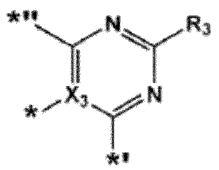

Formel A3-1(5)

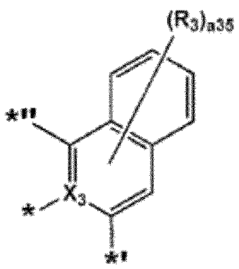

Formel A3-1(6)

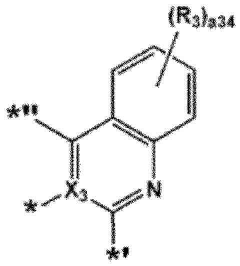

Formel A3-1(7)

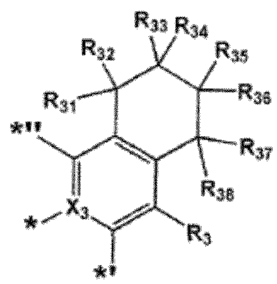

Formel A3-1(8)

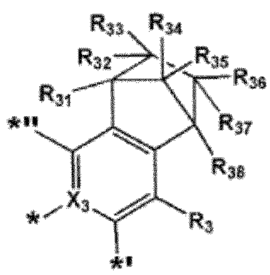

Formel A3-1(9)

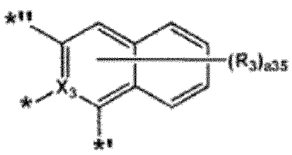
Formel A3-1(10)

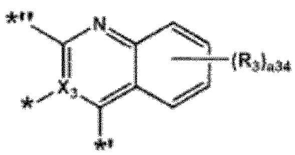
Formel A3-1(11)

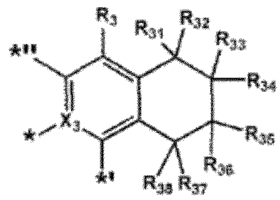
Formel A3-1(12)

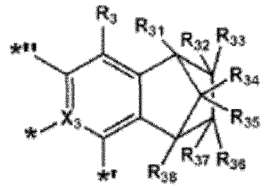
Formel A3-1(13)

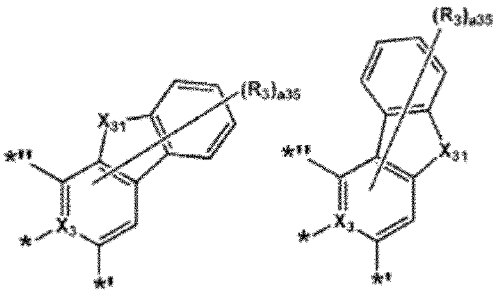
Formel A3-1(14)

Formel A3-1(15)

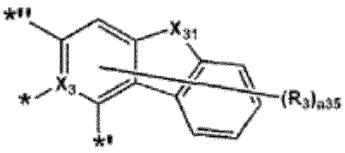
Formel A3-1(16)

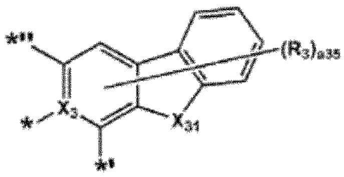
Formel A3-1(17)

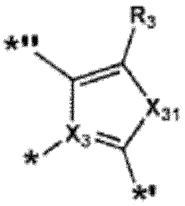
Formel A3-1(18)

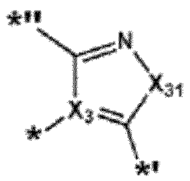
Formel A3-1(19)

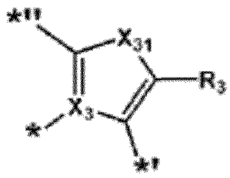
Formel A3-1(20)

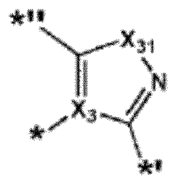
Formel A3-1(21)

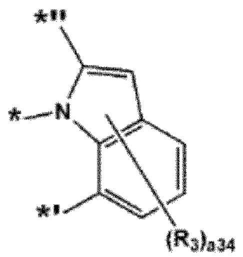
Formel A3-2(1)

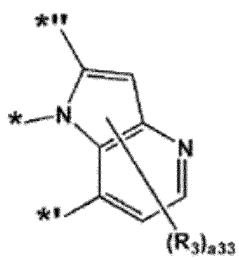
Formel A3-2(2)

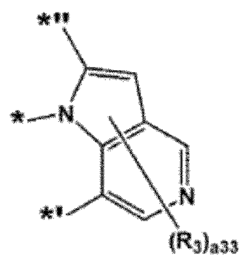
Formel A3-2(3)

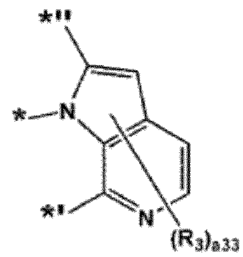
Formel A3-2(4)

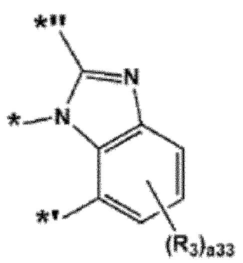
Formel A3-2(5)

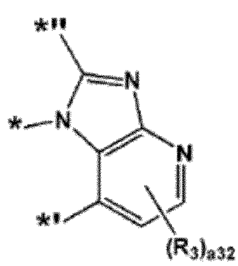
Formel A3-2(6)

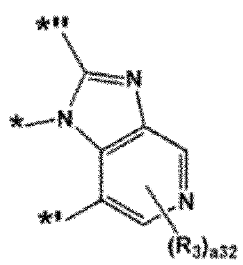
Formel A3-2(7)

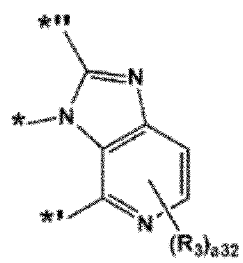
Formel A3-2(8)

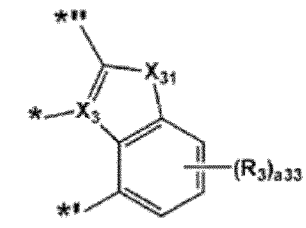
Formel A3-2(9)

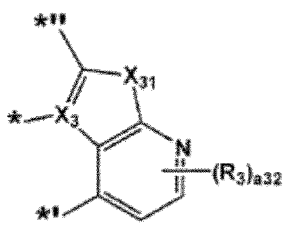
Formel A3-2(10)

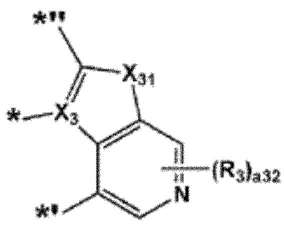
Formel A3-2(11)

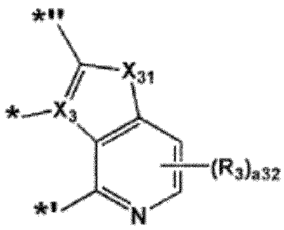
Formel A3-2(12)

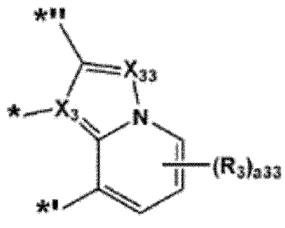
Formel A3-2(13)

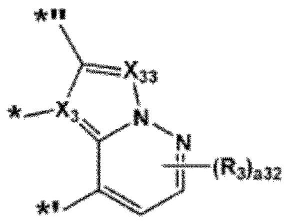
Formel A3-2(14)

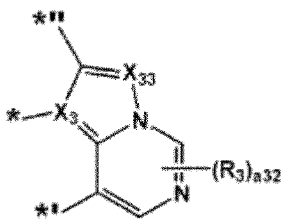
Formel A3-2(15)

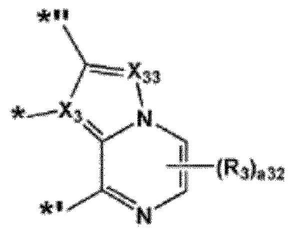
Formel A3-2(16)

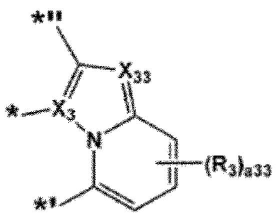
Formel A3-2(17)

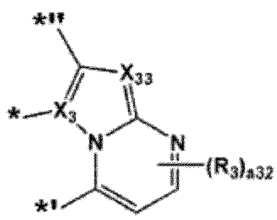
Formel A3-2(18)

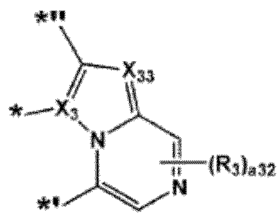
Formel A3-2(19)

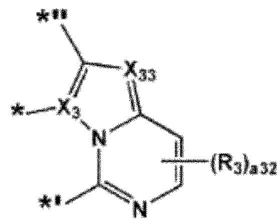
Formel A3-2(20)

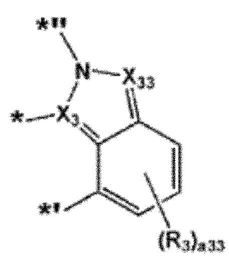
Formel A3-2(21)

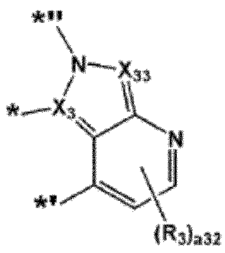
Formel A3-2(22)

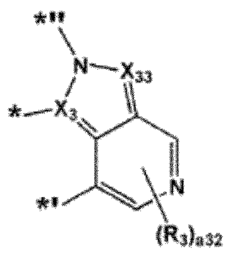
Formel A3-2(23)

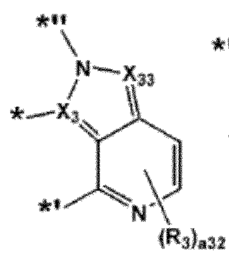
Formel A3-2(24)

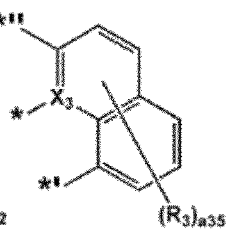
Formel A3-2(25)

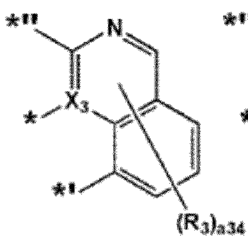
Formel A3-2(26)

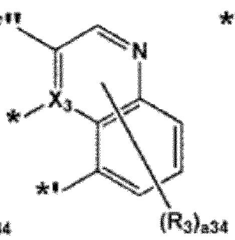
Formel A3-2(27)

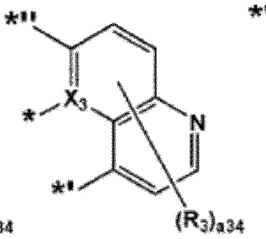
Formel A3-2(28)

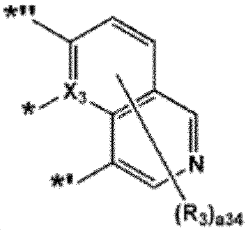
Formel A3-2(29)

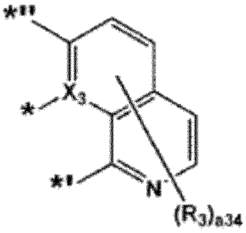
Formel A3-2(30)

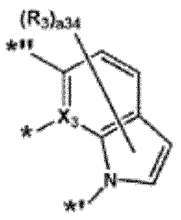
Formel A3-2(31)

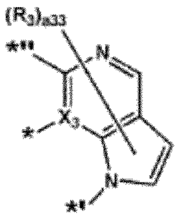
Formel A3-2(32)

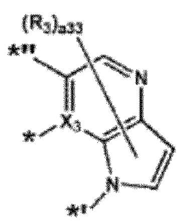
Formel A3-2(33)

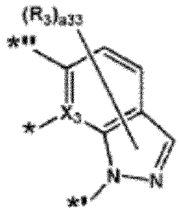
Formel A3-2(34)

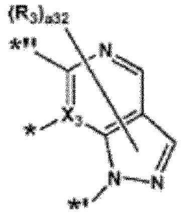
Formel A3-2(35)

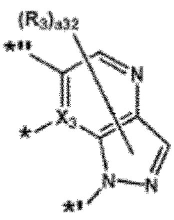
Formel A3-2(36)

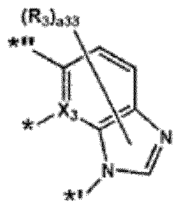
Formel A3-2(37)

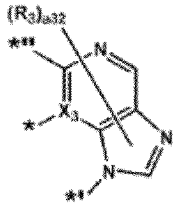
Formel A3-2(38)

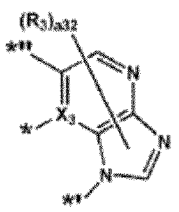
Formel A3-2(39)

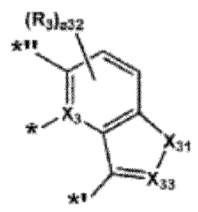
Formel A3-2(40)

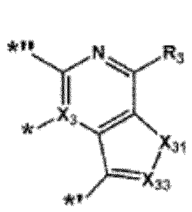
Formel A3-2(41)

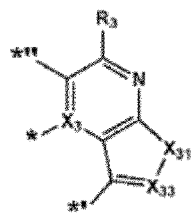
Formel A3-2(42)

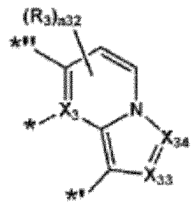
Formel A3-2(43)

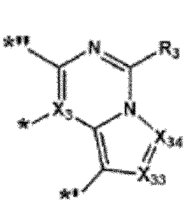
Formel A3-2(44)

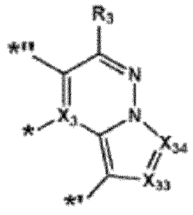
Formel A3-2(45)

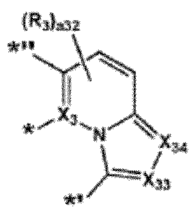
Formel A3-2(46)

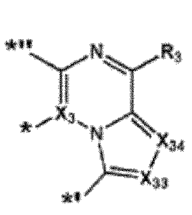
Formel A3-2(47)

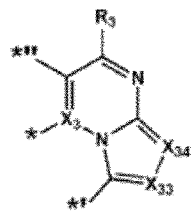
Formel A3-2(48)

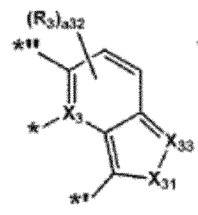
Formel A3-2(49)

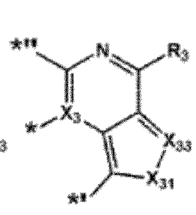
Formel A3-2(50)

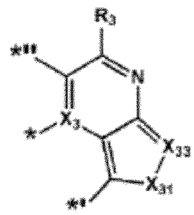
Formel A3-2(51)

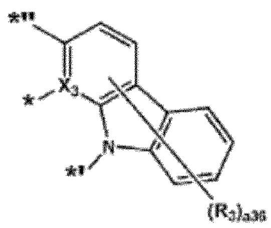
Formel A3-2(52)

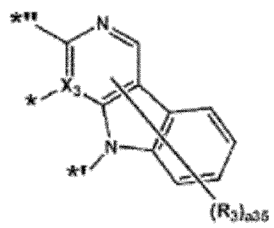
Formel A3-2(53)

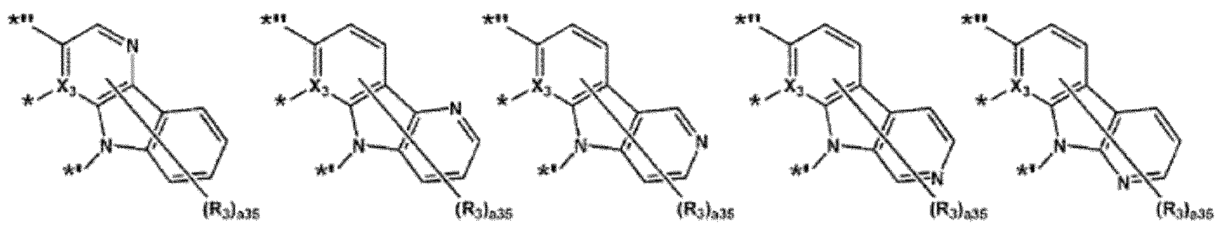
Formel A3-2(54) Formel A3-2(55) Formel A3-2(56) Formel A3-2(57) Formel A3-2(58)

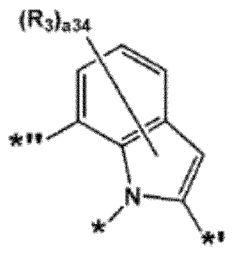
Formel A3-3(1)

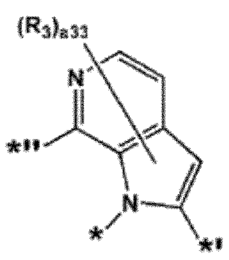
Formel A3-3(2)

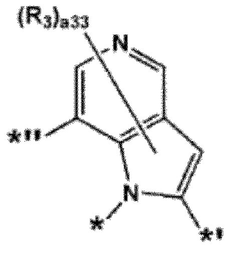
Formel A3-3(3)

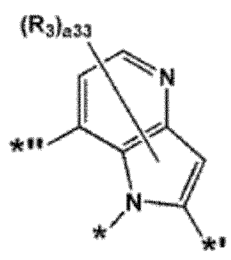
Formel A3-3(4)

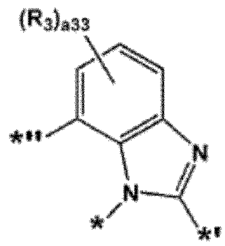
Formel A3-3(5)

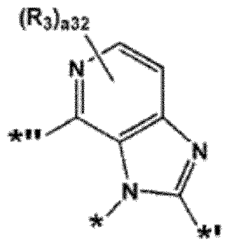
Formel A3-3(6)

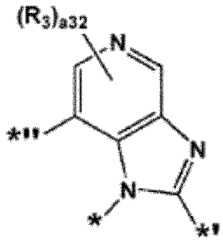
Formel A3-3(7)

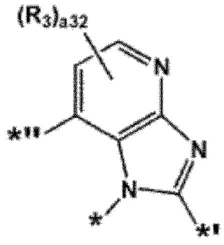
Formel A3-3(8)

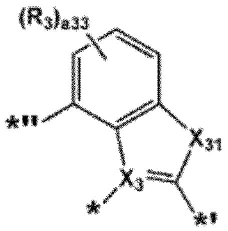
Formel A3-3(9)

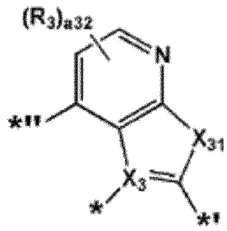
Formel A3-3(10)

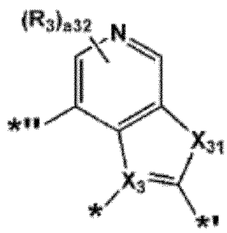
Formel A3-3(11)

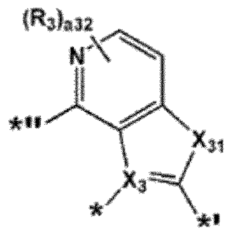
Formel A3-3(12)

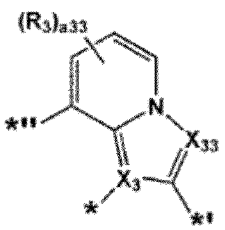
Formel A3-3(13)

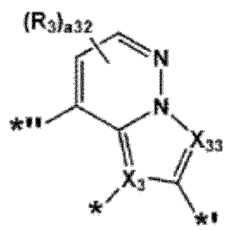
Formel A3-3(14)

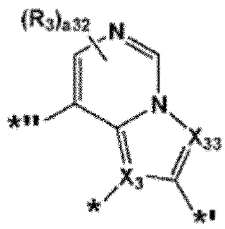
Formel A3-3(15)

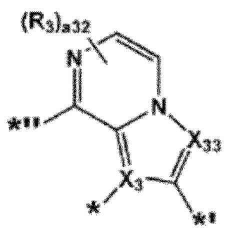
Formel A3-3(16)

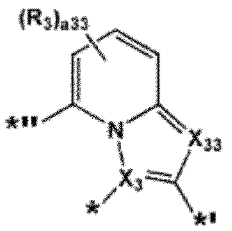
Formel A3-3(17)

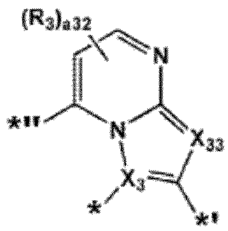
Formel A3-3(18)

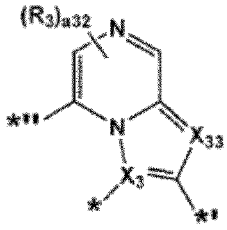
Formel A3-3(19)

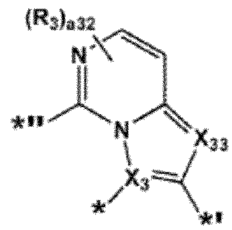
Formel A3-3(20)

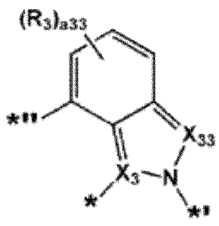 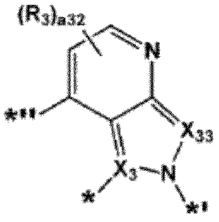 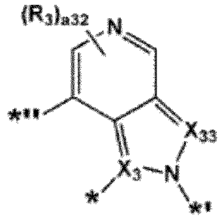 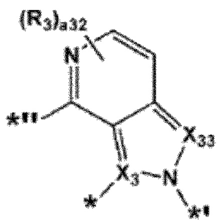 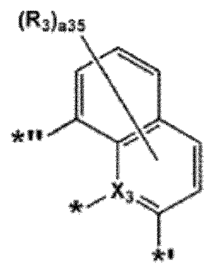

Formel A3-3(21) Formel A3-3(22) Formel A3-3(23) Formel A3-3(24) Formel A3-3(25)

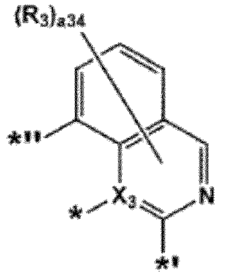 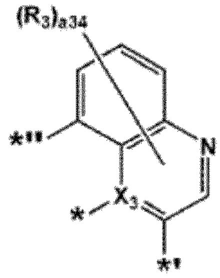 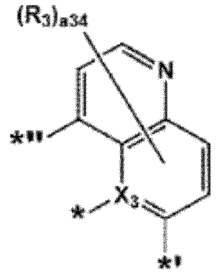 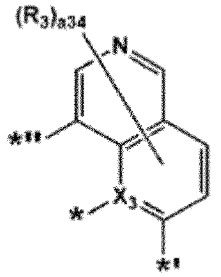 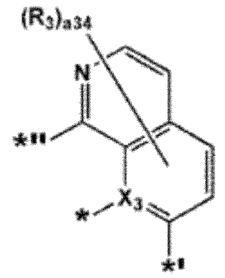

Formel A3-3(26) Formel A3-3(27) Formel A3-3(28) Formel A3-3(29) Formel A3-3(30)

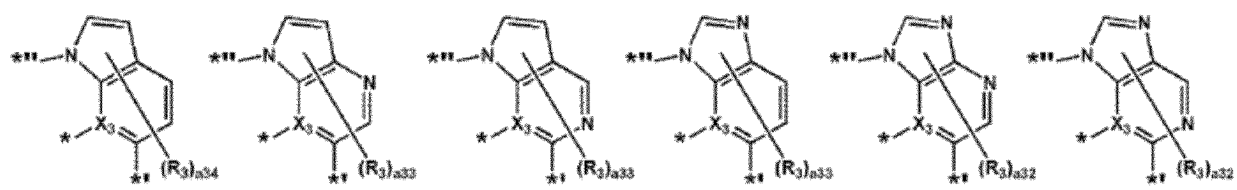

Formel A3-3(31) Formel A3-3(32) Formel A3-3(33) Formel A3-3(34) Formel A3-3(35) Formel A3-3(36)

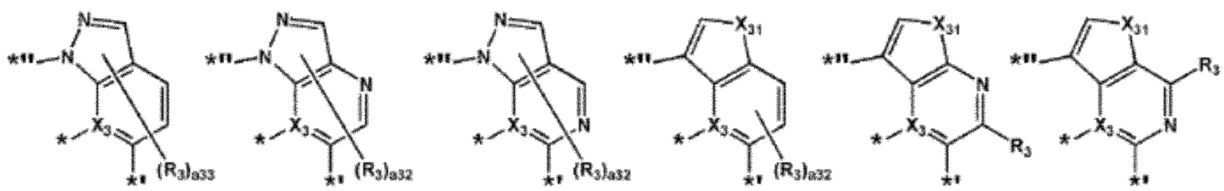

Formel A3-3(37) Formel A3-3(38) Formel A3-3(39) Formel A3-3(40) Formel A3-3(41) Formel A3-3(42)

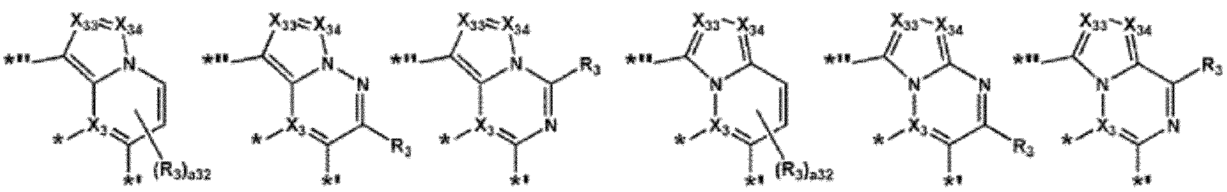

Formel A3-3(43) Formel A3-3(44) Formel A3-3(45) Formel A3-3(46) Formel A3-3(47) Formel A3-3(48)

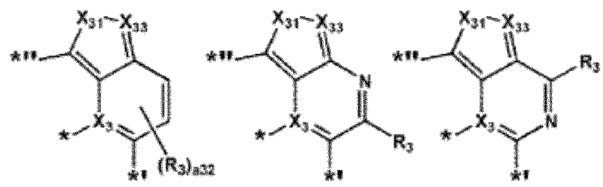

Formel A3-3(49) Formel A3-3(50) Formel A3-3(51)

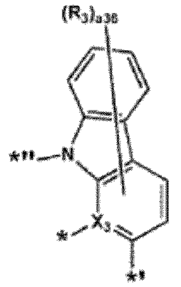

Formel A3-3(52)

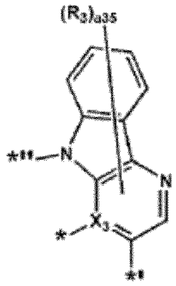

Formel A3-3(53)

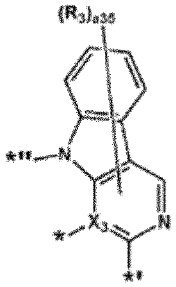

Formel A3-3(54)

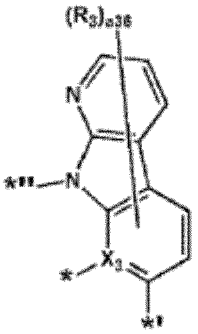

Formel A3-3(55)

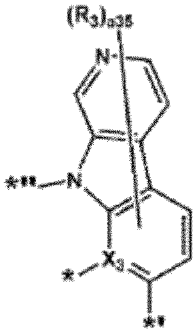

Formel A3-3(56)

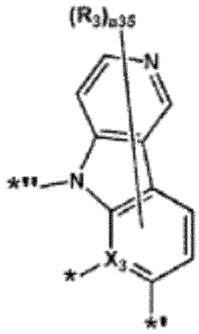

Formel A3-3(57)

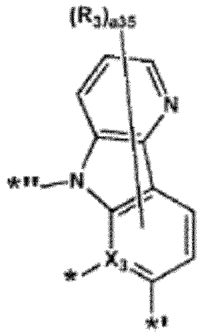

Formel A3-3(58)

wobei in den Formeln A3-1(1) bis A3-1(21), A3-2(1) bis A3-2(58) und A3-3(1) bis A3-3(58)

$X_3$ und $R_3$ die gleichen wie in Anspruch 1 beschrieben sind,
$X_{31}$ O, S, $N(R_{31})$, $C(R_{31})(R_{32})$ oder $Si(R_{31})(R_{32})$ ist,
$X_{33}$ N oder $C(R_{33})$ ist,
$X_{34}$ N oder $C(R_{34})$ ist,
$R_{31}$ bis $R_{38}$ die gleichen wie in Verbindung mit $R_3$ in Anspruch 1 beschrieben sind,
a36 eine ganze Zahl von 0 bis 6 ist,
a35 eine ganze Zahl von 0 bis 5 ist,
a34 eine ganze Zahl von 0 bis 4 ist,
a33 eine ganze Zahl von 0 bis 3 ist,
a32 eine ganze Zahl von 0 bis 2 ist, und
*, *' und *" die gleichen wie in Verbindung mit *, *' und *" in Formel A3-1 beschrieben sind; und/oder

wobei
$A_4$ repräsentiert wird durch eine der Formeln A4-1(1) bis A4-1(44) und A4-2(1) bis A4-2(71):

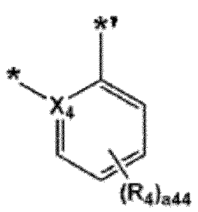

Formel A4-1(1)

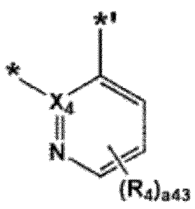

Formel A4-1(2)

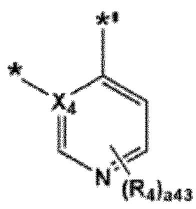

Formel A4-1(3)

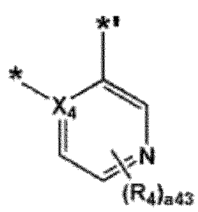

Formel A4-1(4)

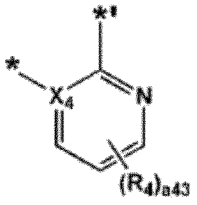
Formel A4-1(5)

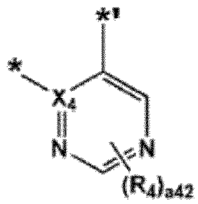
Formel A4-1(6)

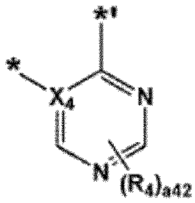
Formel A4-1(7)

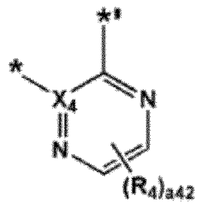
Formel A4-1(8)

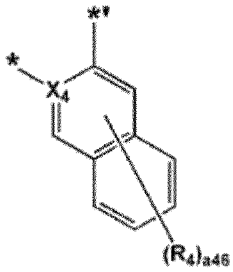
Formel A4-1(9)

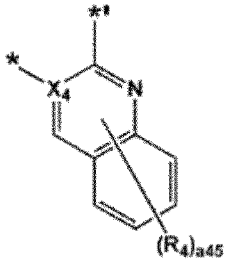
Formel A4-1(10)

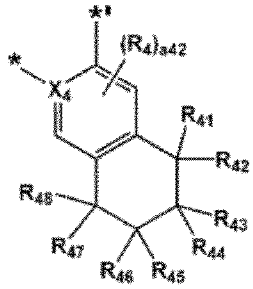
Formel A4-1(11)

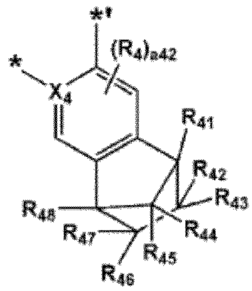
Formel A4-1(12)

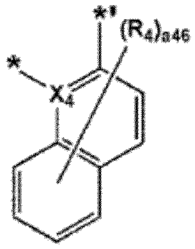
Formel A4-1(13)

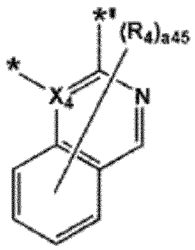
Formel A4-1(14)

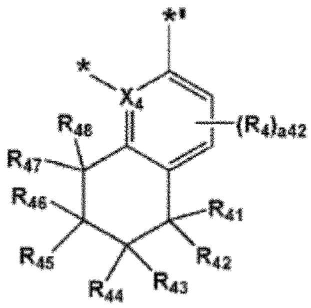
Formel A4-1(15)

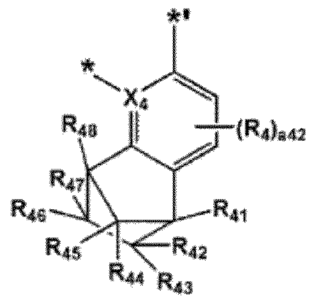
Formel A4-1(16)

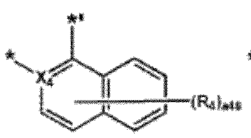
Formel A4-1(17)

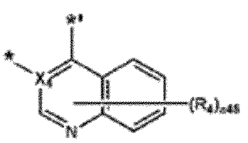
Formel A4-1(18)

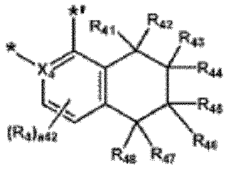
Formel A4-1(19)

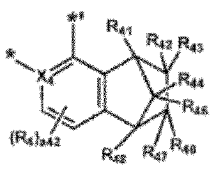
Formel A4-1(20)

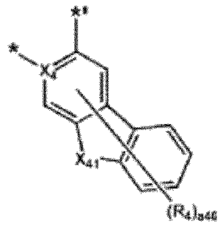
Formel A4-1(21)

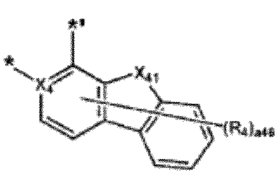
Formel A4-1(22)

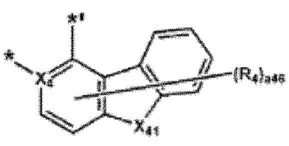
Formel A4-1(23)

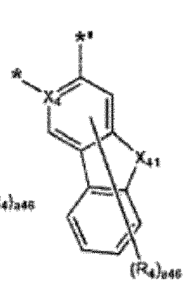
Formel A4-1(24)

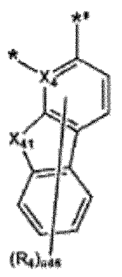
Formel A4-1(25)

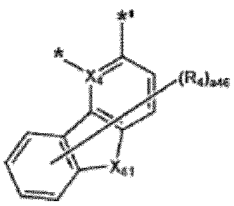
Formel A4-1(26)

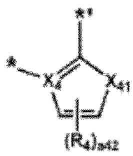
Formel A4-1(27)

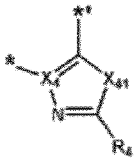
Formel A4-1(28)

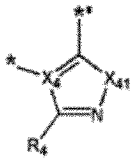
Formel A4-1(29)

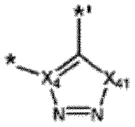
Formel A4-1(30)

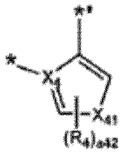
Formel A4-1(31)

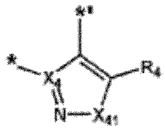
Formel A4-1(32)

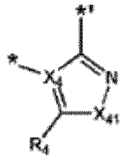
Formel A4-1(33)

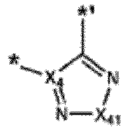
Formel A4-1(34)

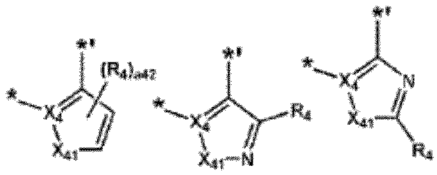
Formel A4-1(35) Formel A4-1(36) Formel A4-1(37)

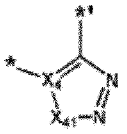
Formel A4-1(38)

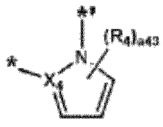
Formel A4-1(39)

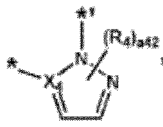
Formel A4-1(40)

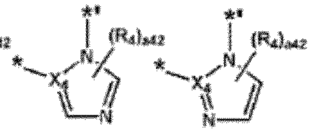
Formel A4-1(41) Formel A4-1(42)

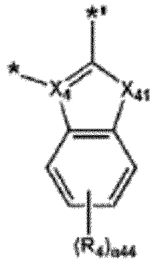
Formel A4-1(43)

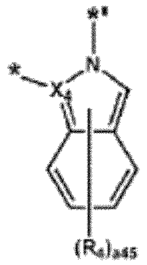
Formel A4-1(44)

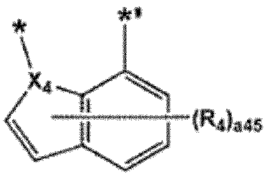
Formel A4-2(1)

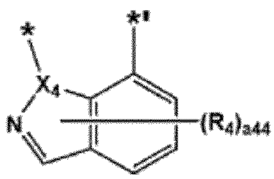
Formel A4-2(2)

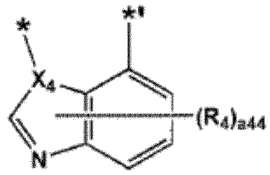
Formel A4-2(3)

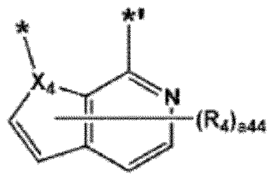
Formel A4-2(4)

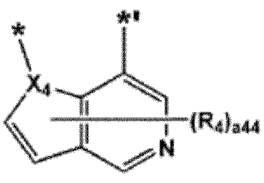
Formel A4-2(5)

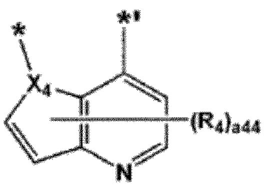
Formel A4-2(6)

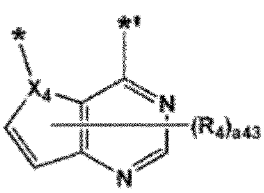
Formel A4-2(7)

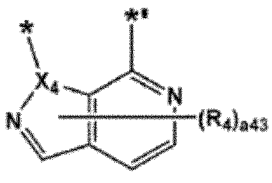
Formel A4-2(8)

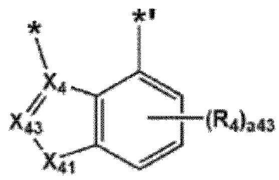
Formel A4-2(9)

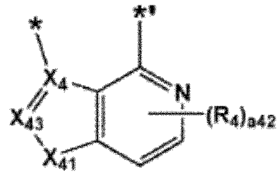
Formel A4-2(10)

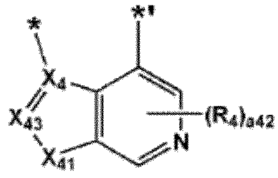
Formel A4-2(11)

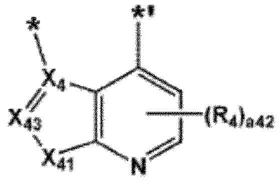
Formel A4-2(12)

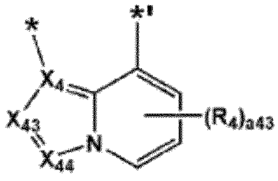
Formel A4-2(13)

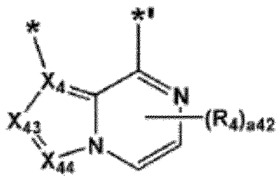
Formel A4-2(14)

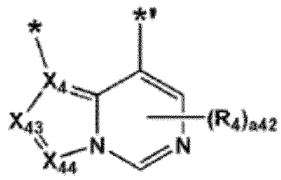
Formel A4-2(15)

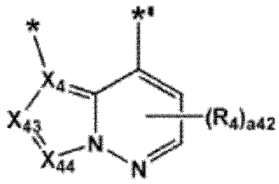
Formel A4-2(16)

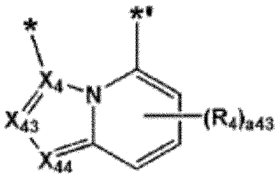
Formel A4-2(17)

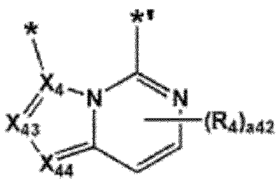
Formel A4-2(18)

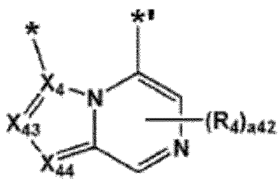
Formel A4-2(19)

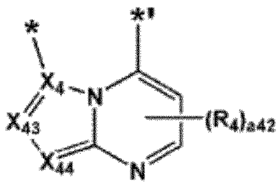
Formel A4-2(20)

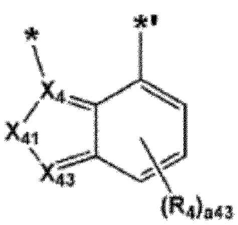
Formel A4-2(21)

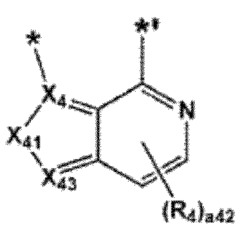
Formel A4-2(22)

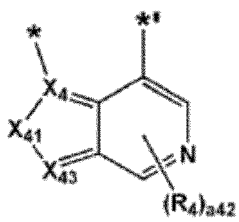
Formel A4-2(23)

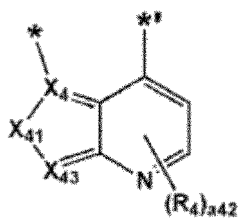
Formel A4-2(24)

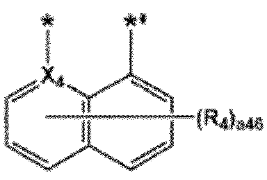
Formel A4-2(25)

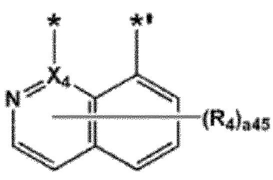
Formel A4-2(26)

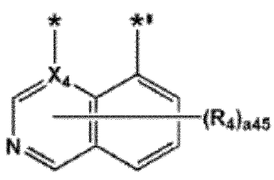
Formel A4-2(27)

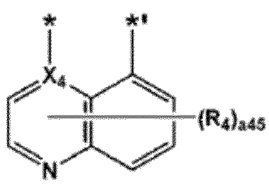
Formel A4-2(28)

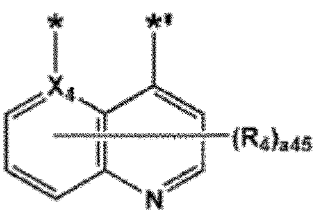
Formel A4-2(29)

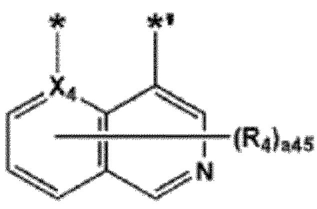
Formel A4-2(30)

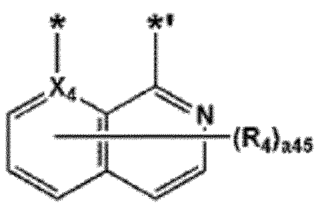
Formel A4-2(31)

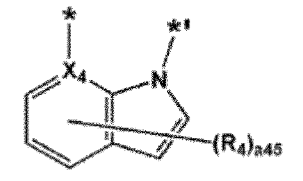
Formel A4-2(32)

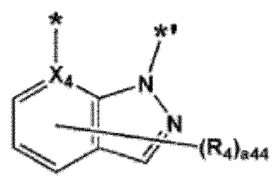
Formel A4-2(33)

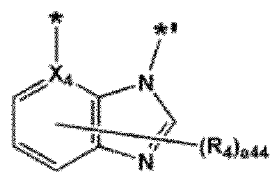
Formel A4-2(34)

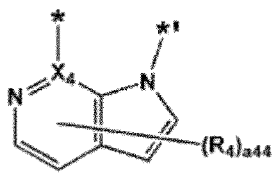
Formel A4-2(35)

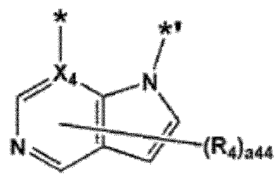
Formel A4-2(36)

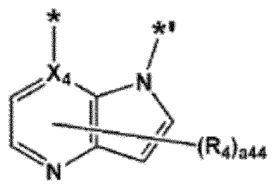
Formel A4-2(37)

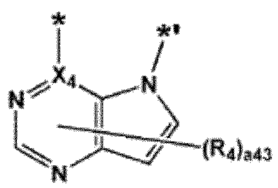
Formel A4-2(38)

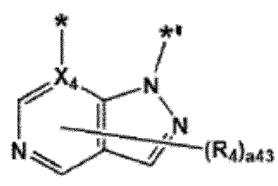
Formel A4-2(39)

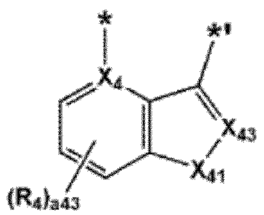
Formel A4-2(40)

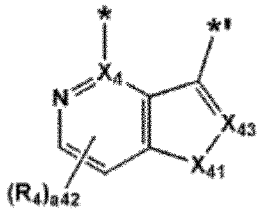
Formel A4-2(41)

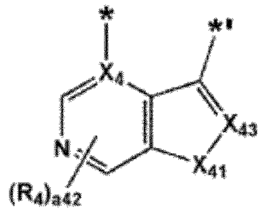
Formel A4-2(42)

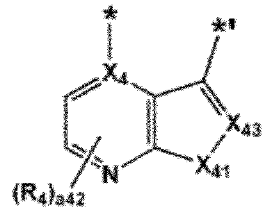
Formel A4-2(43)

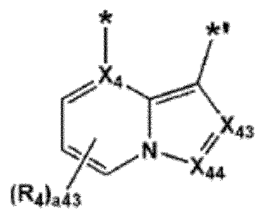
Formel A4-2(44)

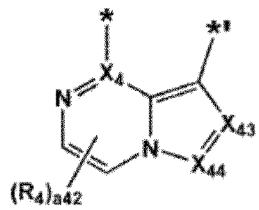
Formel A4-2(45)

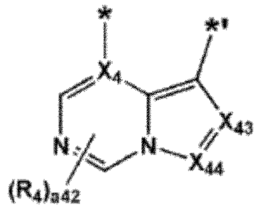
Formel A4-2(46)

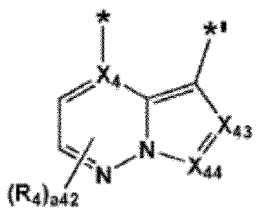
Formel A4-2(47)

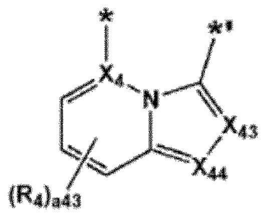
Formel A4-2(48)

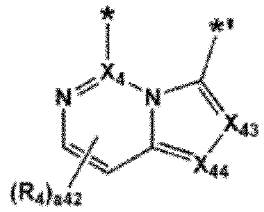
Formel A4-2(49)

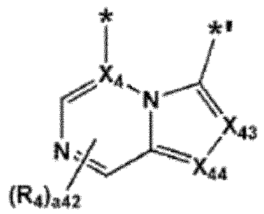
Formel A4-2(50)

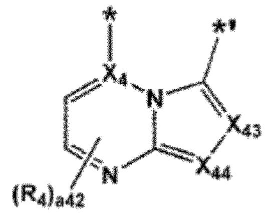
Formel A4-2(51)

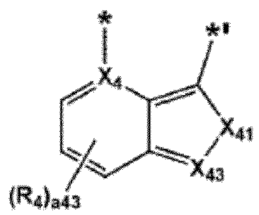
Formel A4-2(52)

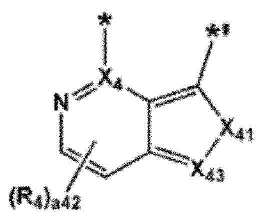
Formel A4-2(53)

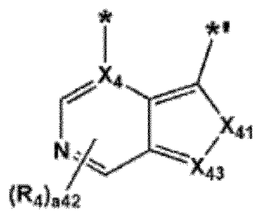
Formel A4-2(54)

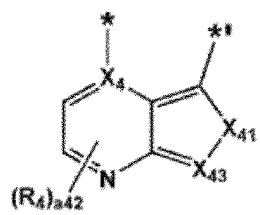
Formel A4-2(55)

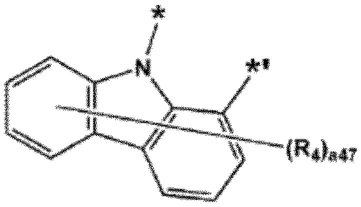

Formel A4-2(56)

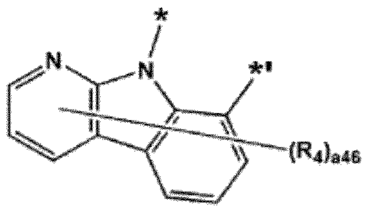

Formel A4-2(57)

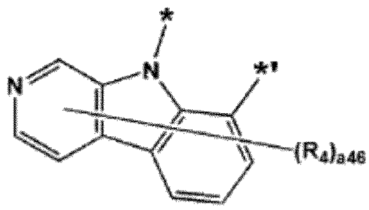

Formel A4-2(58)

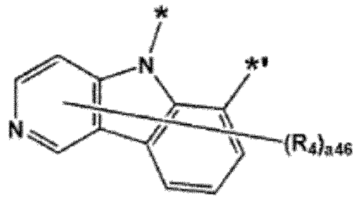

Formel A4-2(59)

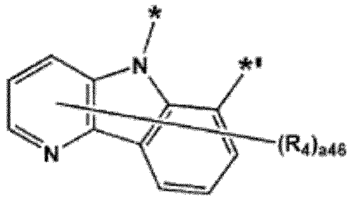

Formel A4-2(60)

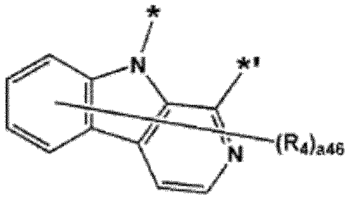

Formel A4-2(61)

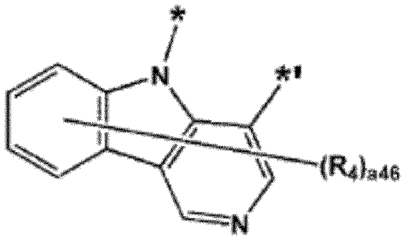

Formel A4-2(62)

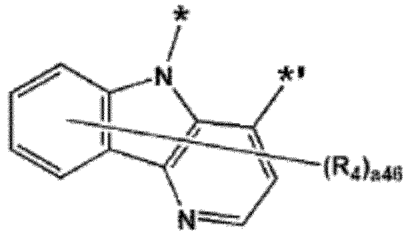

Formel A4-2(63)

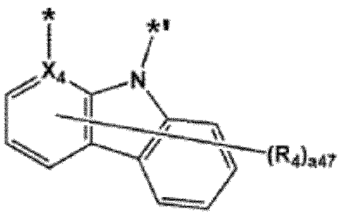

Formel A4-2(64)

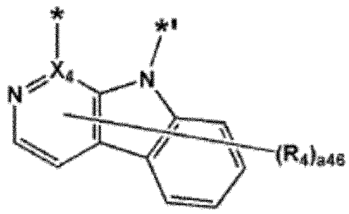

Formel A4-2(65)

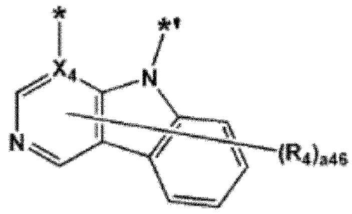

Formel A4-2(66)

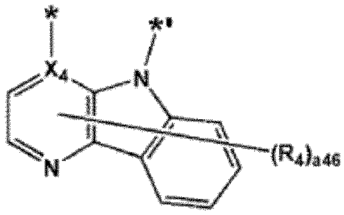

Formel A4-2(67)

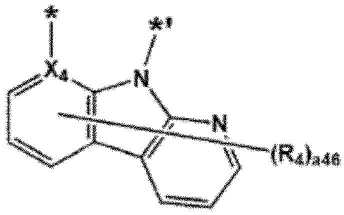

Formel A4-2(68)

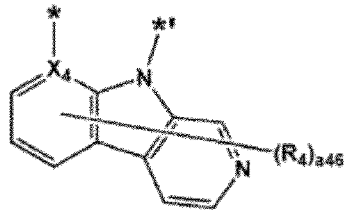

Formel A4-2(69)

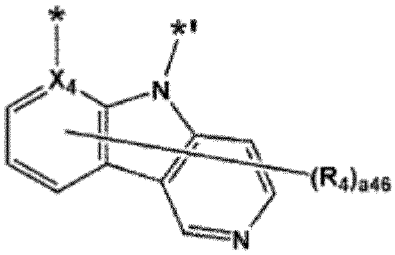

Formel A4-2(70)

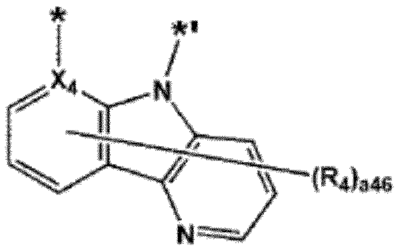

Formel A4-2(71)

,

wobei in den Formeln A4-1(1) bis A4-1(44) und A4-2(1) bis A4-2(71),

$X_4$, $R_4$ * und *' die gleichen wie in Anspruch 1 beschrieben sind,
$X_{41}$ O, S, N($R_{41}$), C($R_{41}$)($R_{42}$) oder Si($R_{41}$)($R_{42}$) ist,
$X_{43}$ N oder C($R_{43}$) ist,
$X_{44}$ N oder C($R_{44}$) ist,
$R_{41}$ bis $R_{48}$ die gleichen wie in Verbindung mit $R_4$ beschrieben sind,
a47 eine ganze Zahl von 0 bis 7 ist,
a46 eine ganze Zahl von 0 bis 6 ist,
a45 eine ganze Zahl von 0 bis 5 ist,
a44 eine ganze Zahl von 0 bis 4 ist,
a43 eine ganze Zahl von 0 bis 3 ist und
a42 eine ganze Zahl von 0 bis 2 ist.

**9.** Organometallische Verbindung gemäß einem der Ansprüche 1-8, wobei
$A_2$ durch Formel A2-2 repräsentiert wird; und/oder
wobei
$A_1$ repräsentiert wird durch eine der Formeln A1-1-1 bis A1-1-10 und A1-2-1 bis Al-2-4,
$A_2$ repräsentiert wird durch eine der Formeln A2-2-1 bis A2-2-4,
$A_3$ repräsentiert wird durch eine der Formeln A3-1-1 bis A3-1-10,
$A_4$ repräsentiert wird durch eine der Formeln A4-1-1 bis A4-1-14:

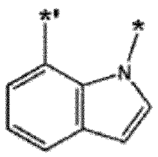

Formel A1-1-1

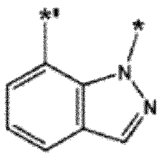

Formel A1-1-2

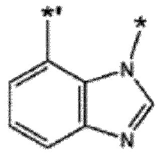

Formel A1-1-3

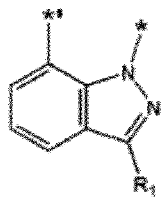

Formel A1-1-4

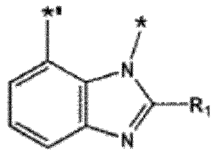

Formel A1-1-5

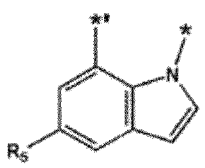

Formel A1-1-6

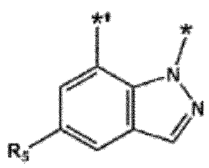

Formel A1-1-7

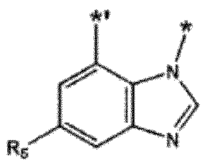

Formel A1-1-8

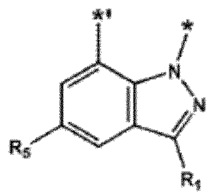

Formel A1-1-9

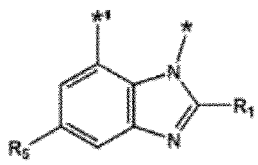

Formel A1-1-10

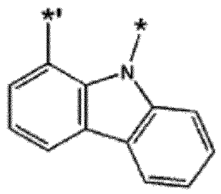
Formel A1-2-1

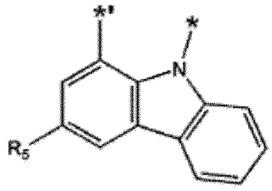
Formel A1-2-2

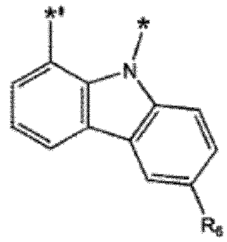
Formel A1-2-3

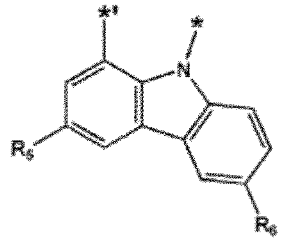
Formel A1-2-4

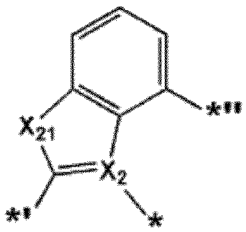
Formel A2-2-1

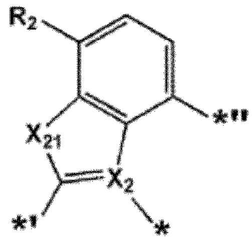
Formel A2-2-2

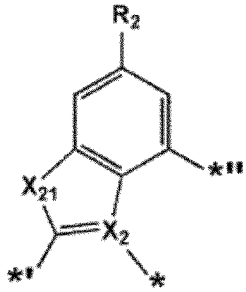
Formel A2-2-3

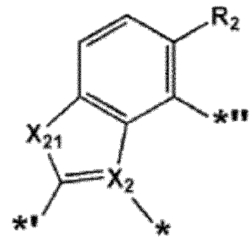
Formel A2-2-4

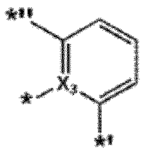
Formel A3-1-1

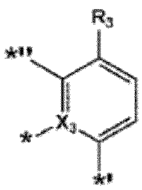
Formel A3-1-2

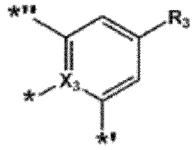
Formel A3-1-3

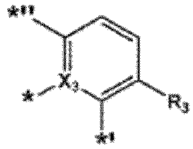
Formel A3-1-4

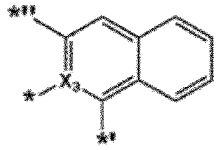
Formel A3-1-5

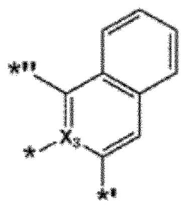
Formel A3-1-6

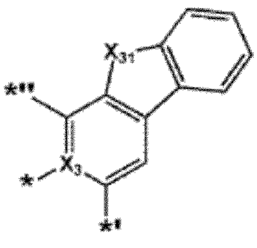
Formel A3-1-7

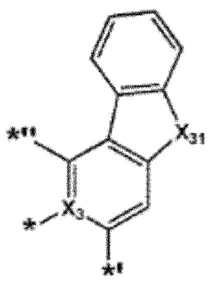
Formel A3-1-8

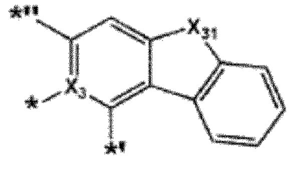
Formel A3-1-9

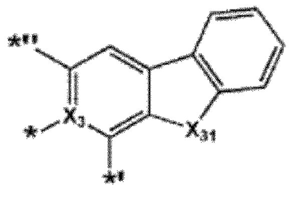
Formel A3-1-10

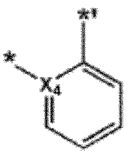

Formel A4-1-1

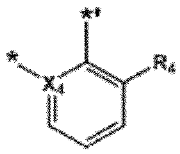

Formel A4-1-2

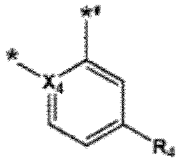

Formel A4-1-3

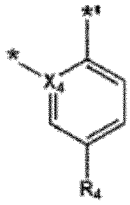

Formel A4-1-4

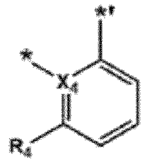

Formel A4-1-5

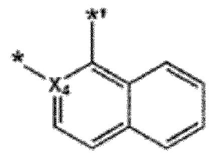

Formel A4-1-6

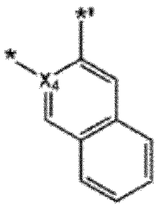

Formel A4-1-7

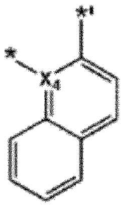

Formel A4-1-8

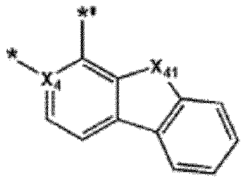

Formel A4-1-9

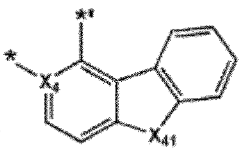

Formel A4-1-10

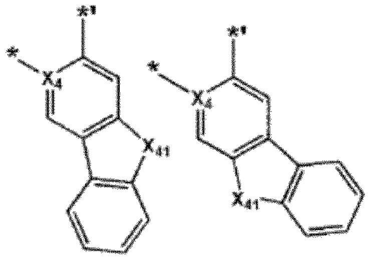

Formel A4-1-11

Formel A4-1-12

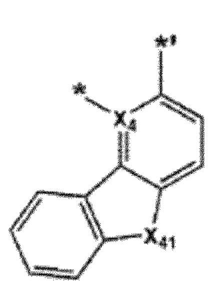

Formel A4-1-13

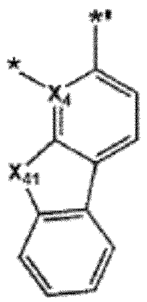

Formel A4-1-14

,

wobei in den Formeln A1-1-1 bis A1-1-10, A1-2-1 bis A1-2-4, A2-2-1 bis A2-2-4, A3-1-1 bis A3-1-10 und A4-1-1 bis A4-1-14

$X_1$ bis $X_4$ und $R_1$ bis $R_6$ die gleichen wie in Anspruch 1 beschrieben sind, sofern $R_1$ bis $R_6$ nicht Wasserstoff sind,
$X_{21}$ O, S, $N(R_{21})$, $C(R_{21})(R_{22})$ oder $Si(R_{21})(R_{22})$ ist und $R_{21}$ und $R_{22}$ die gleichen wie in Verbindung mit $R_2$ in Anspruch 1 beschrieben sind,
$X_{31}$ O, S, $N(R_{31})$, $C(R_{31})(R_{32})$ oder $Si(R_{31})(R_{32})$ ist und $R_{31}$ und $R_{32}$ die gleichen wie in Verbindung mit $R_3$ in Anspruch 1 beschrieben sind,
$X_{41}$ O, S, $N(R_{41})$, $C(R_{41})(R_{12})$ oder $Si(R_{41})(R_{42})$ ist und $R_{41}$ und $R_{42}$ die gleichen wie in Verbindung mit $R_4$ in Anspruch 1 beschrieben sind,
in den Formeln A1-1-1 bis A1-1-10 und A1-2-1 bis A1-2-4 * eine Bindungsstelle zu M in Formel 1 anzeigt und *' eine Bindungsstelle zu $T_1$ in Formel 1 anzeigt,
in den Formeln A2-2-1 bis A2-2-4 * eine Bindungsstelle zu M in Formel 1 anzeigt und *' eine Bindungsstelle zu $T_1$ in Formel 1 anzeigt und *" eine Bindungsstelle zu $T_2$ in Formel 1 anzeigt,
in den Formeln A3-1-1 bis A3-1-10 * eine Bindungsstelle zu M in Formel 1 anzeigt und *" eine Bindungsstelle zu $T_2$ in Formel 1 anzeigt und *' eine Bindungsstelle zu $T_3$ in Formel 1 anzeigt, und
in den Formeln A4-1-1 bis A4-1-14 * eine Bindungsstelle zu M in Formel 1 anzeigt und *' eine Bindungsstelle zu $T_3$ in Formel 1 anzeigt.

**10.** Organometallische Verbindung gemäß einem der Ansprüche 1-9, wobei die organometallische Verbindung eine der Verbindungen 1 bis 273 ist:

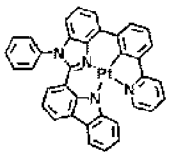
1
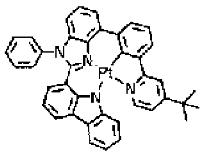
2
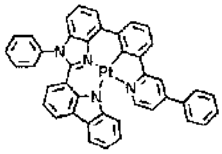
3
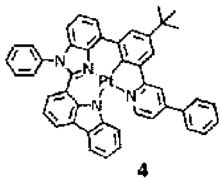
4
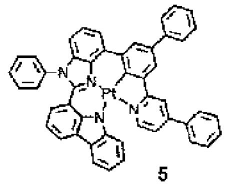
5
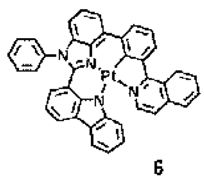
6
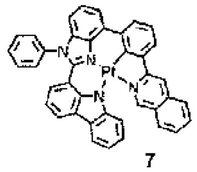
7
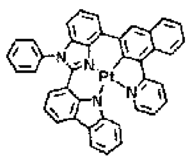
8
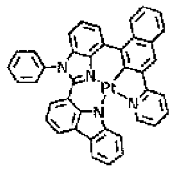
9
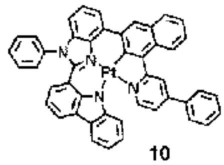
10
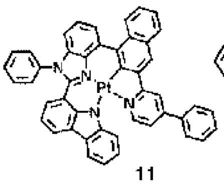
11
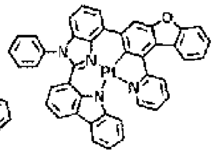
12
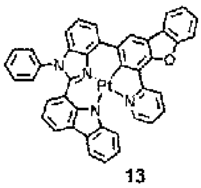
13
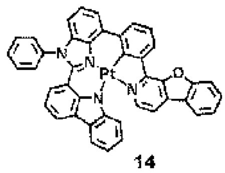
14
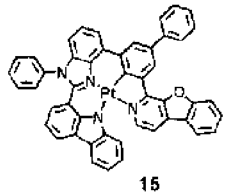
15
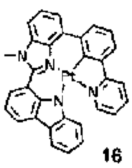
16
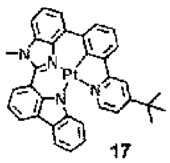
17
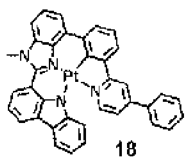
18
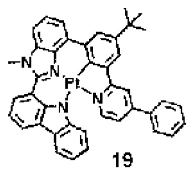
19
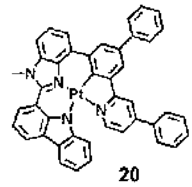
20
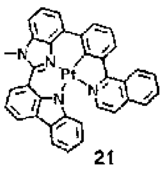
21
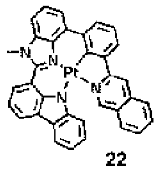
22
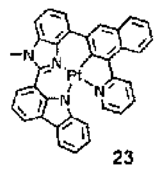
23
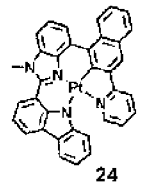
24
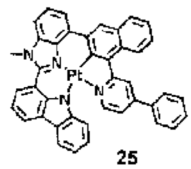
25
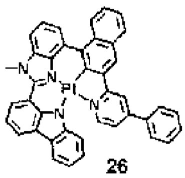
26
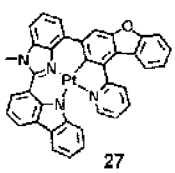
27
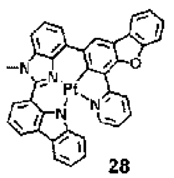
28
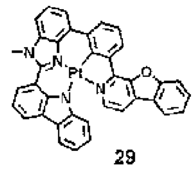
29
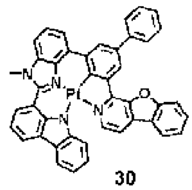
30
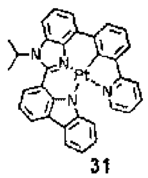
31
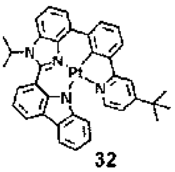
32
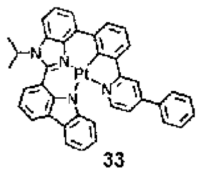
33
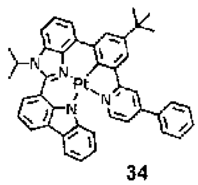
34
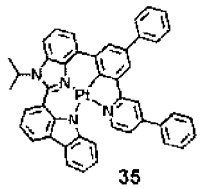
35

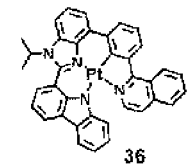
36

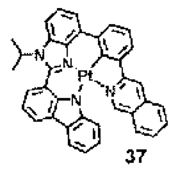
37

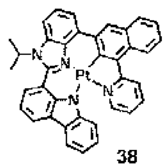
38

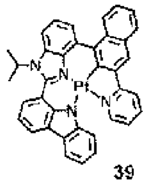
39

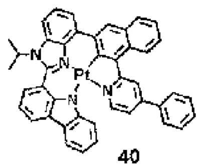
40

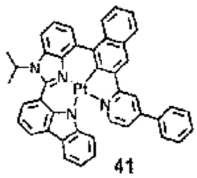
41

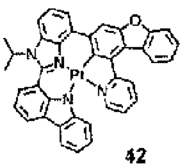
42

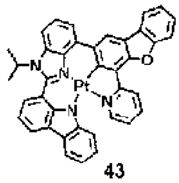
43

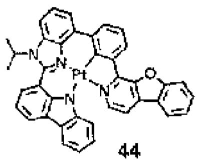
44

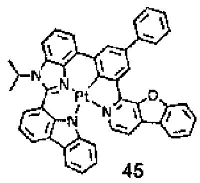
45

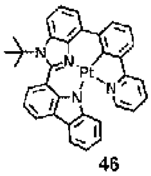
46

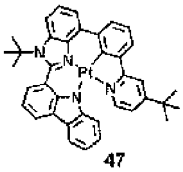
47

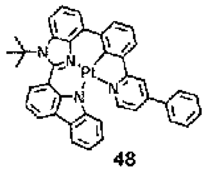
48

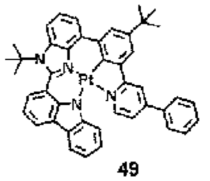
49

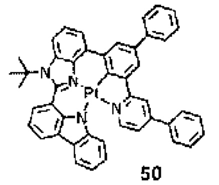
50

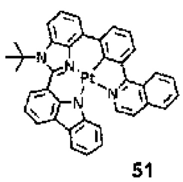
51

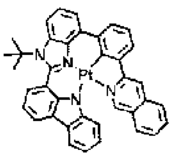
52

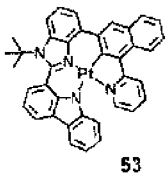
53

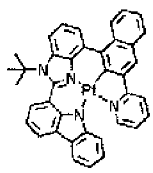
54

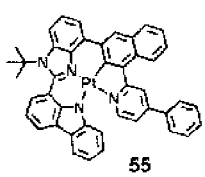
55

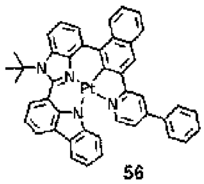
56

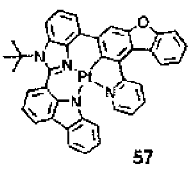
57

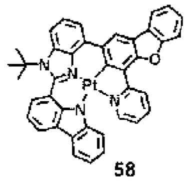
58

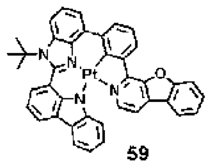
59

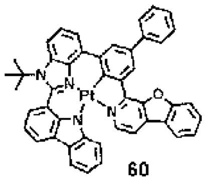
60

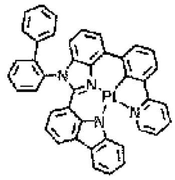
61

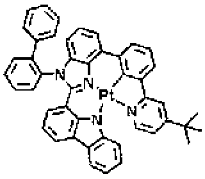
62

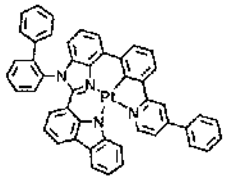
63

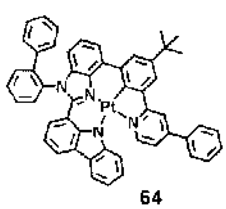
64

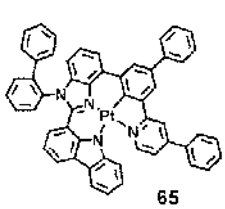
65

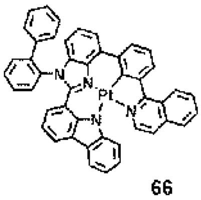
66

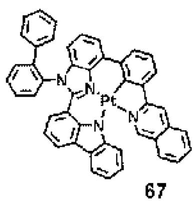
67

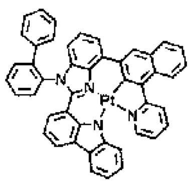
68

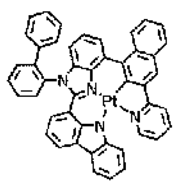
69

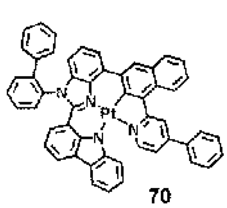
70

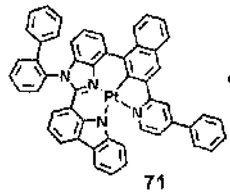
71
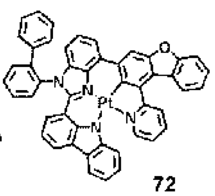
72
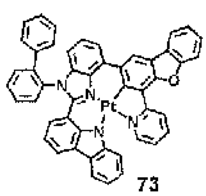
73
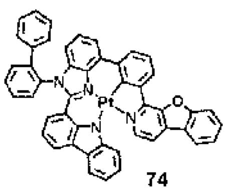
74
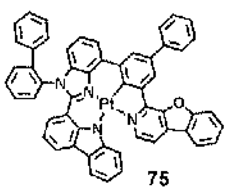
75

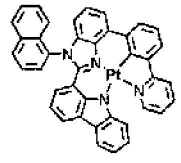
76
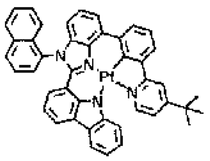
77
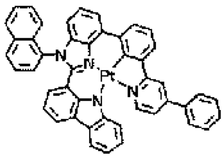
78
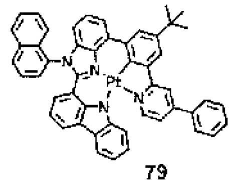
79
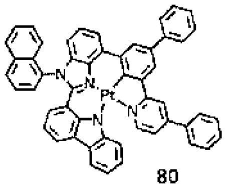
80

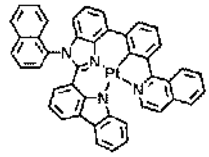
81
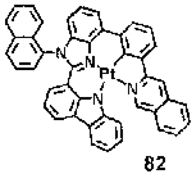
82
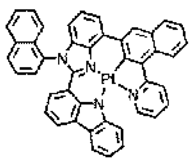
83
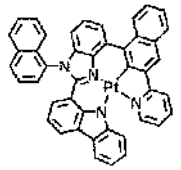
84
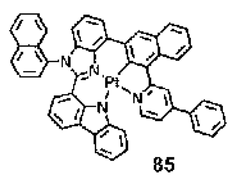
85

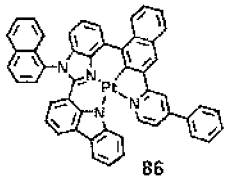
86
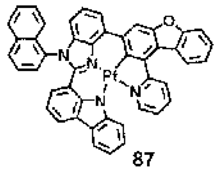
87
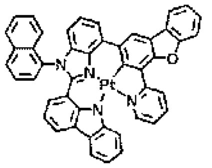
88
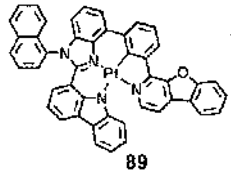
89
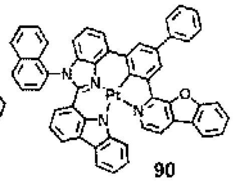
90

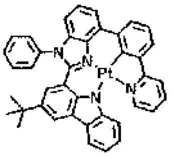
91
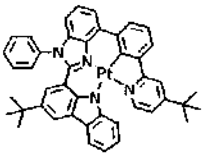
92
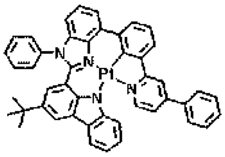
93
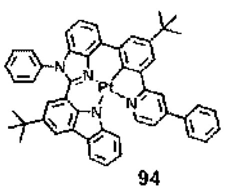
94
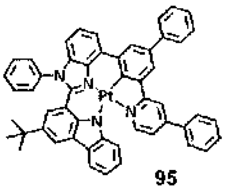
95

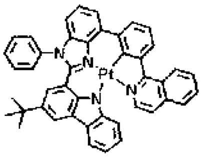
96
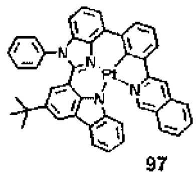
97
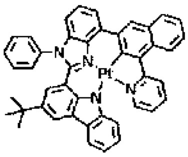
98
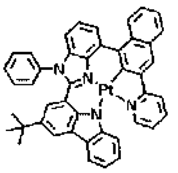
99
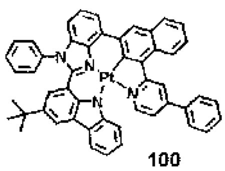
100

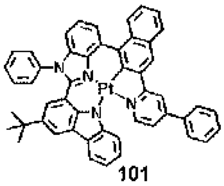
101
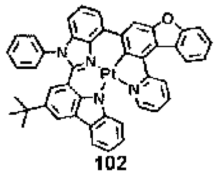
102
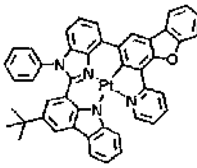
103
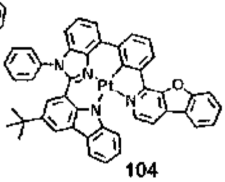
104
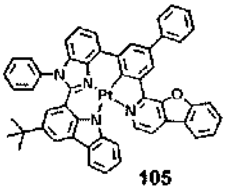
105

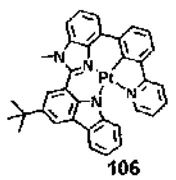
106

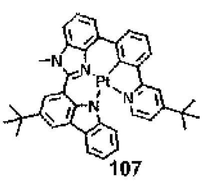
107

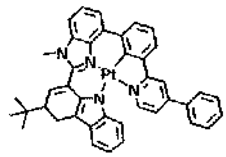
108

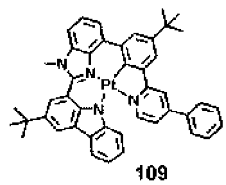
109

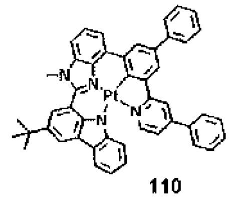
110

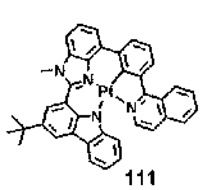
111

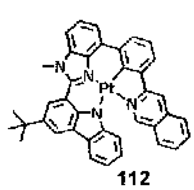
112

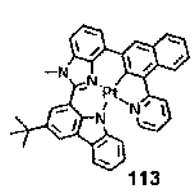
113

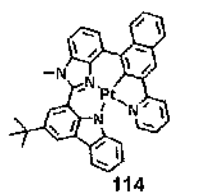
114

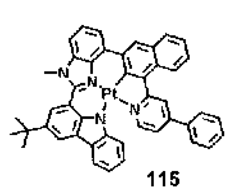
115

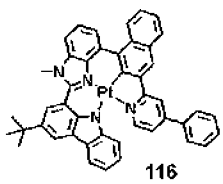
116

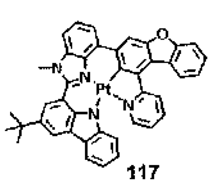
117

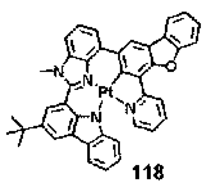
118

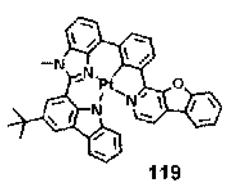
119

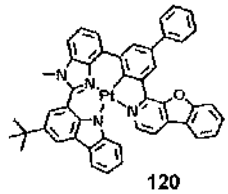
120

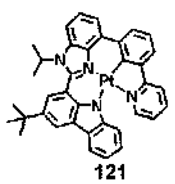
121

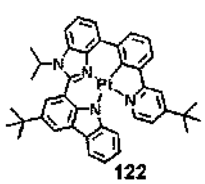
122

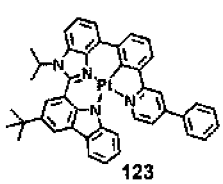
123

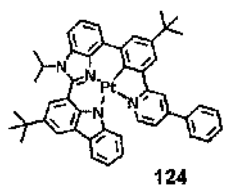
124

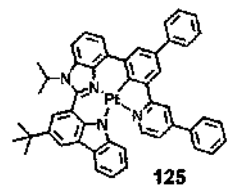
125

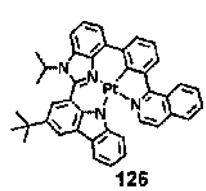
126

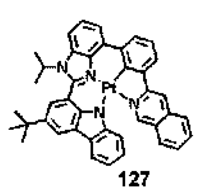
127

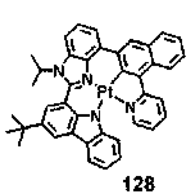
128

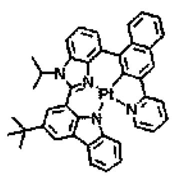
129

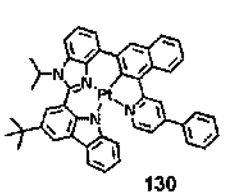
130

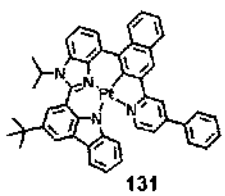
131

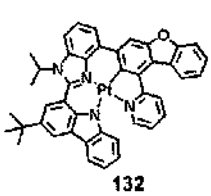
132

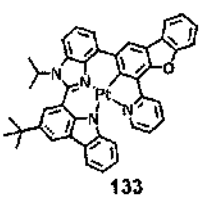
133

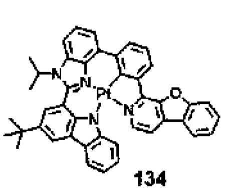
134

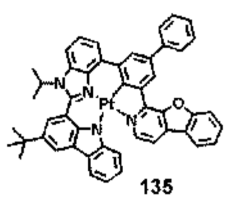
135

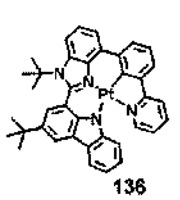
136

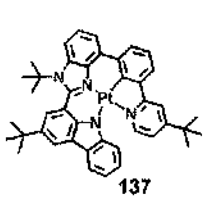
137

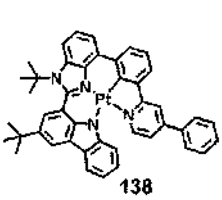
138

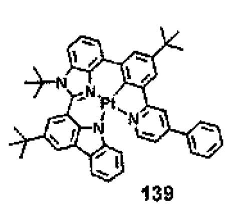
139

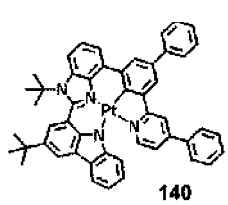
140

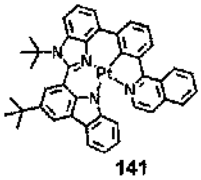
141

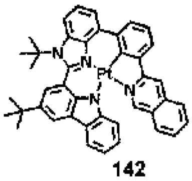
142

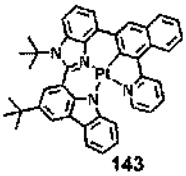
143

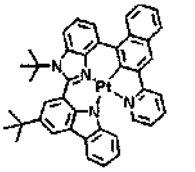
144

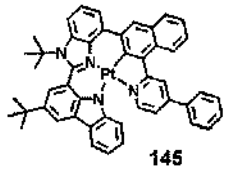
145

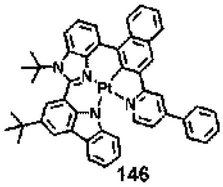
146

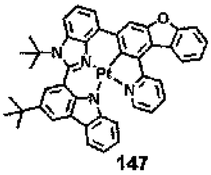
147

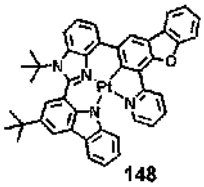
148

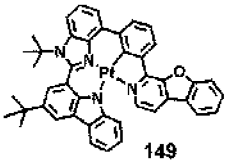
149

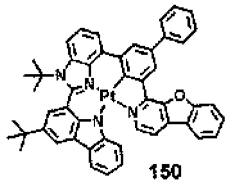
150

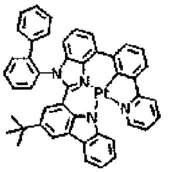
151

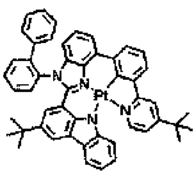
152

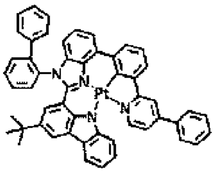
153

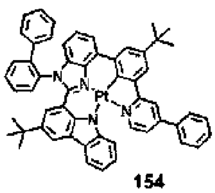
154

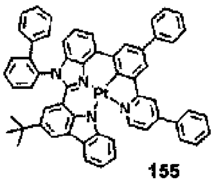
155

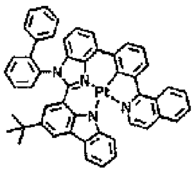
156

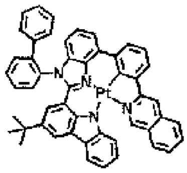
157

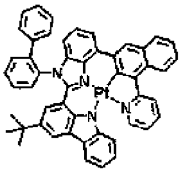
158

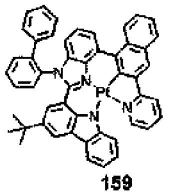
159

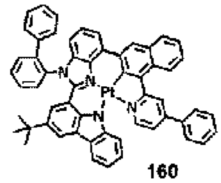
160

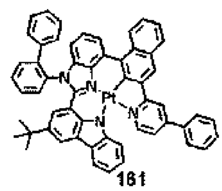
161

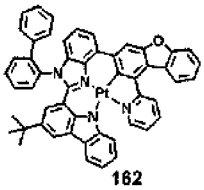
162

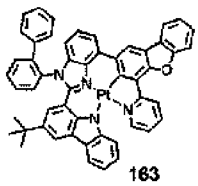
163

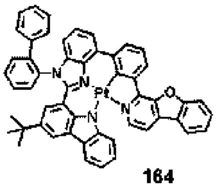
164

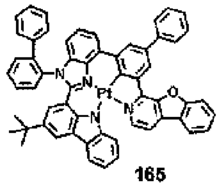
165

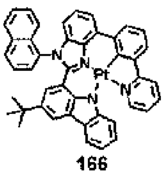
166

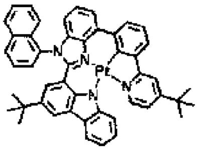
167

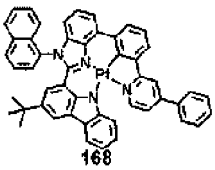
168

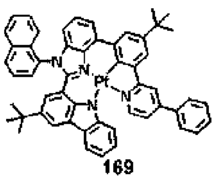
169

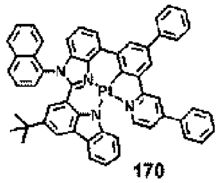
170

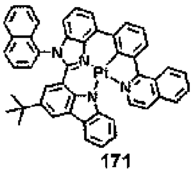
171

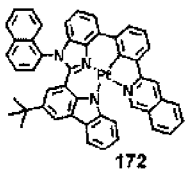
172

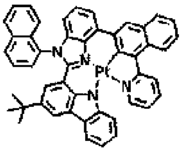
173

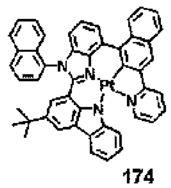
174

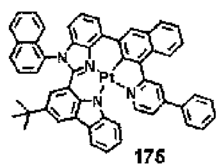
175

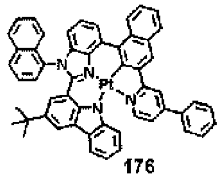
176

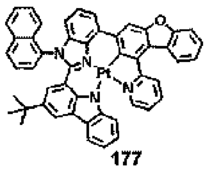
177

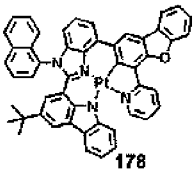
178

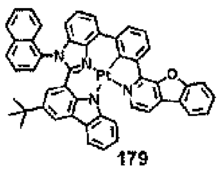
179

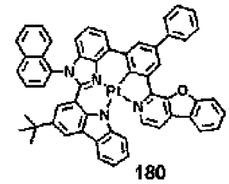
180

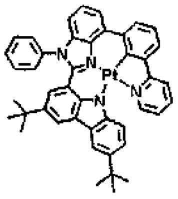
181

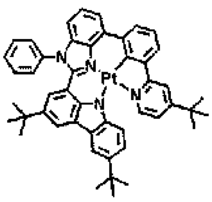
182

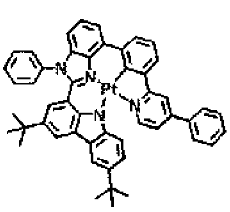
183

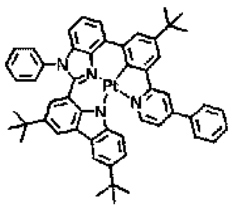
184

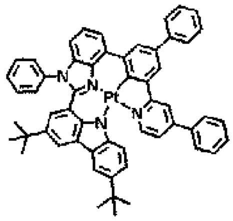
185

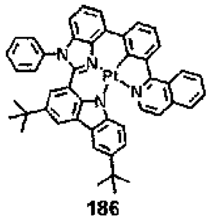
186

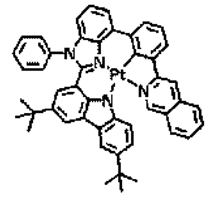
187

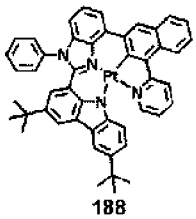
188

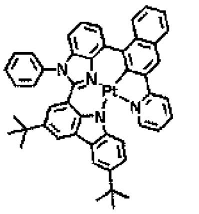
189

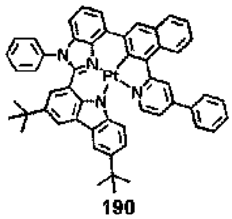
190

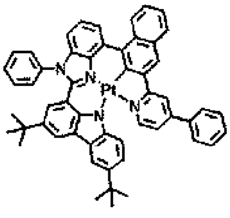
191

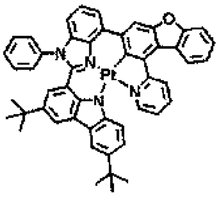
192

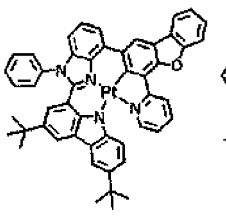
193

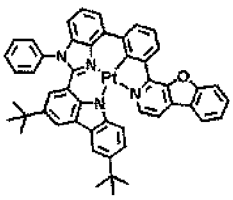
194

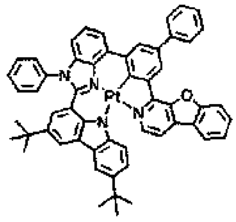
195

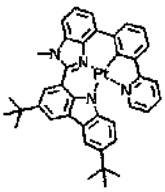
196

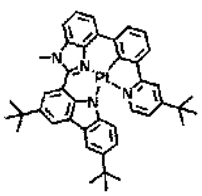
197

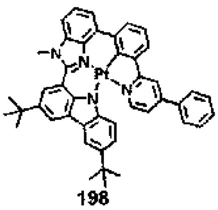
198

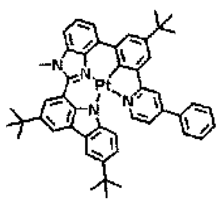
199

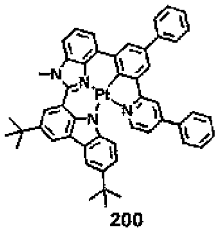
200

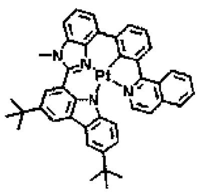
201

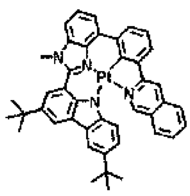
202

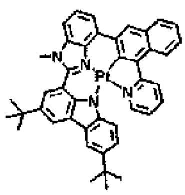
203

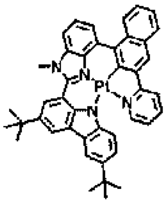
204

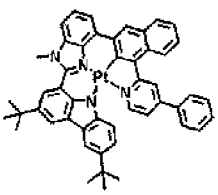
205

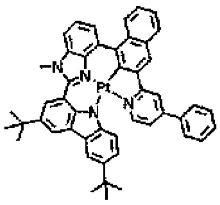
206

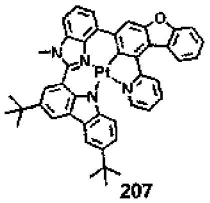
207

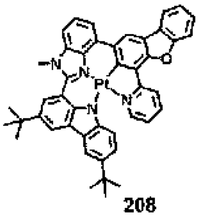
208

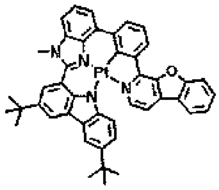
209

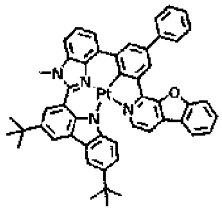
210

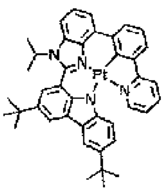
211

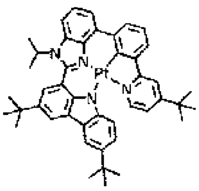
212

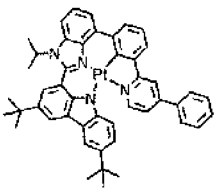
213

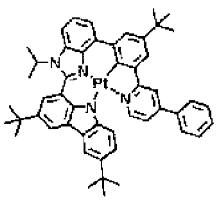
214

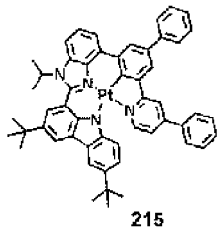
215

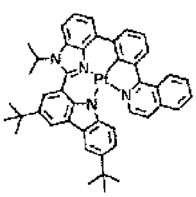
216

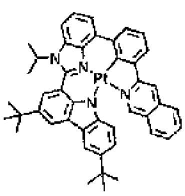
217

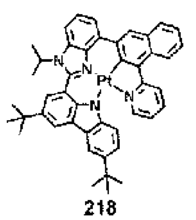
218

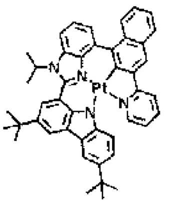
219

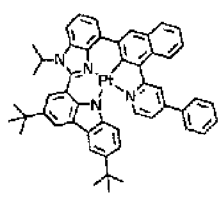
220

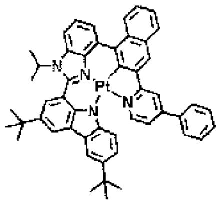
221

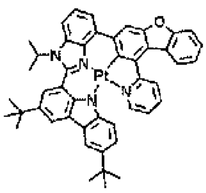
222

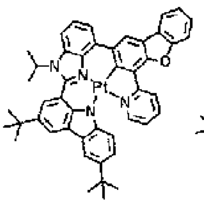
223

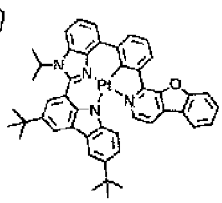
224

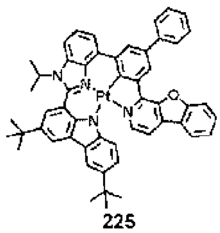
225

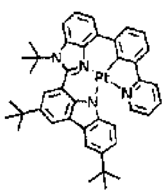
226

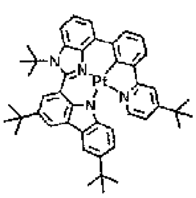
227

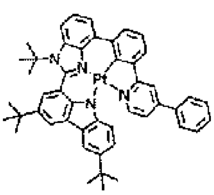
228

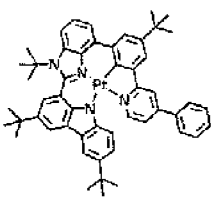
229

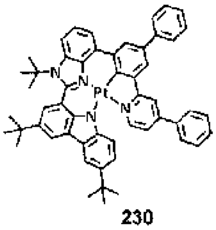
230

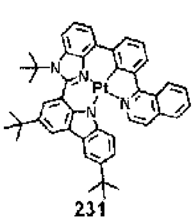
231

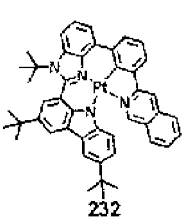
232

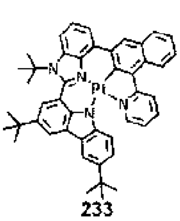
233

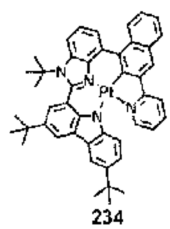
234

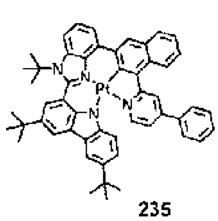
235

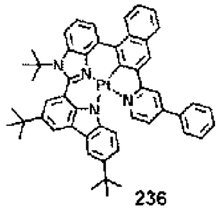
236
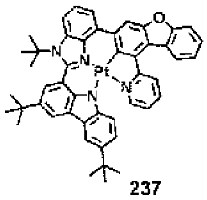
237
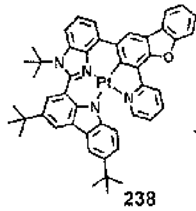
238
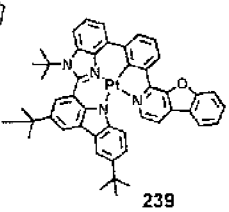
239
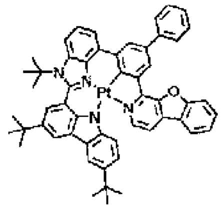
240

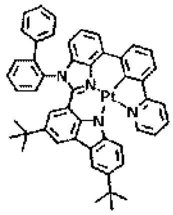
241
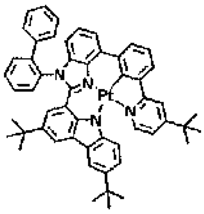
242
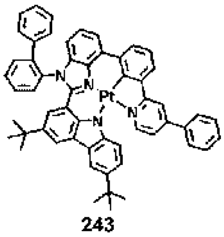
243
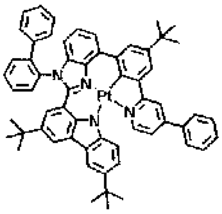
244
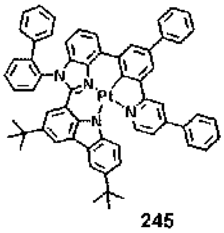
245

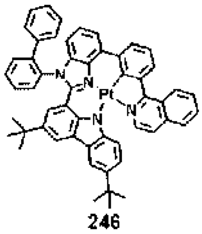
246
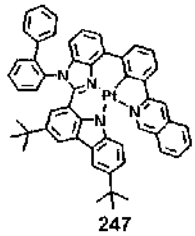
247
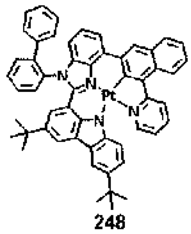
248
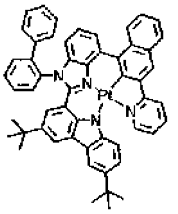
249
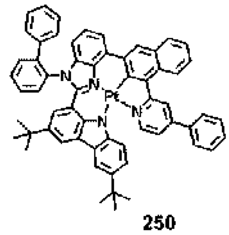
250

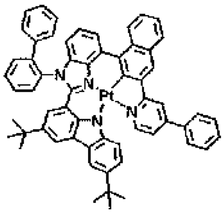
251
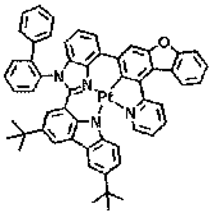
252
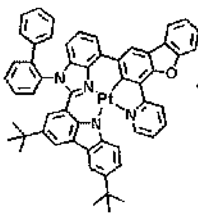
253
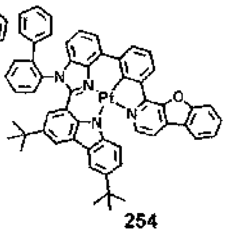
254
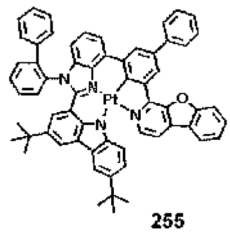
255

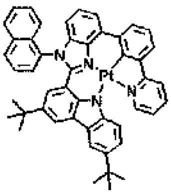
256
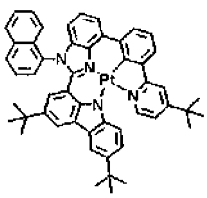
257
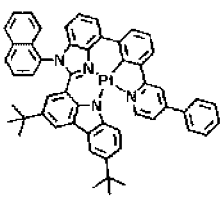
258
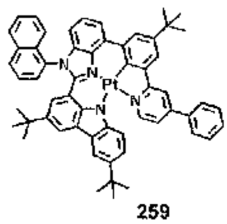
259
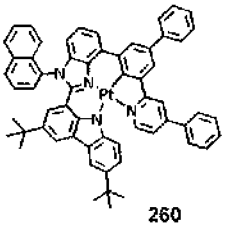
260

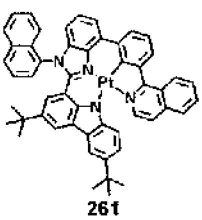
261
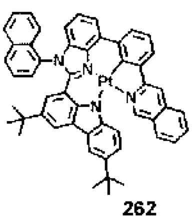
262
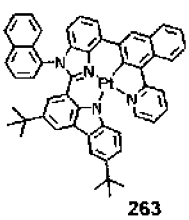
263
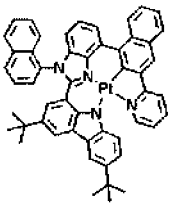
264
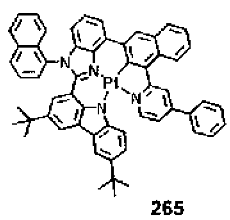
265

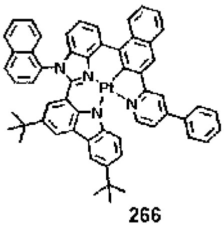
266
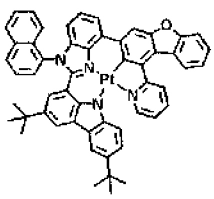
267
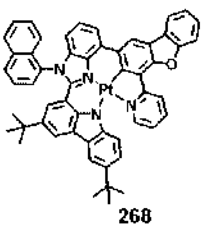
268
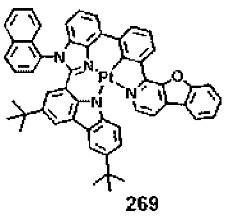
269
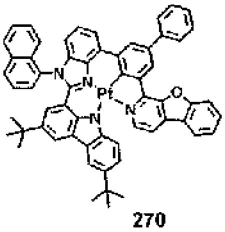
270

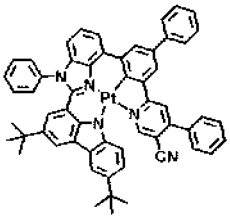
271
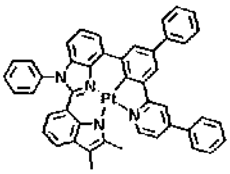
272
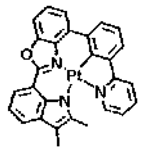
273

**11.** Organische lichtemittierende Vorrichtung, die Folgendes beinhaltet:

eine erste Elektrode;
eine zweite Elektrode; und
eine organische Schicht, die zwischen der ersten Elektrode und der zweiten Elektrode angeordnet ist, wobei die organische Schicht eine Emissionsschicht und mindestens eine organometallische Verbindung gemäß einem der Ansprüche 1-10 beinhaltet.

**12.** Organische lichtemittierende Vorrichtung gemäß Anspruch 11, wobei
die erste Elektrode eine Anode ist,
die zweite Elektrode eine Kathode ist,
die organische Schicht ferner eine Lochtransportregion, die zwischen der ersten Elektrode und der Emissionsschicht angeordnet ist, und eine Elektronentransportregion, die zwischen der Emissionsschicht und der zweiten Elektrode angeordnet ist, beinhaltet
wobei die Lochtransportregion eine Lochinjektionsschicht, eine Lochtransportschicht, eine Elektronenblockierschicht oder eine Kombination davon beinhaltet; und
wobei die Elektronentransportregion eine Elektronenblockierschicht, eine Elektronentransportschicht, eine Elektroneninjektionsschicht oder eine Kombination davon beinhaltet.

**13.** Organische lichtemittierende Vorrichtung gemäß den Ansprüchen 11 oder 12, wobei
die Emissionsschicht die organometallische Verbindung beinhaltet.

**14.** Organische lichtemittierende Vorrichtung gemäß Anspruch 13, wobei
die Emissionsschicht ferner einen Wirt beinhaltet und wobei eine Menge des Wirts größer als eine Menge der organometallischen Verbindung ist.

**15.** Diagnosezusammensetzung, die mindestens eine der organometallischen Verbindung gemäß einem der Ansprüche 1-10 beinhaltet.

## Revendications

**1.** Composé organométallique représenté par la Formule 1 :

Formule 1

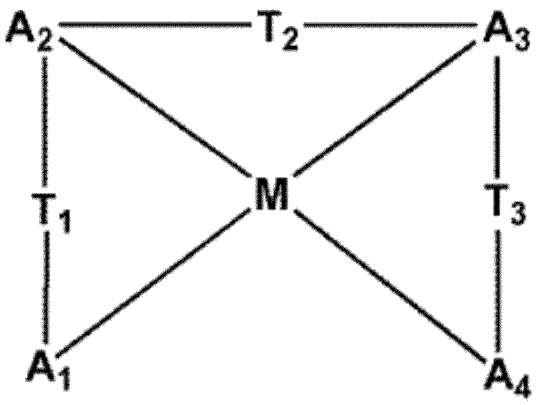

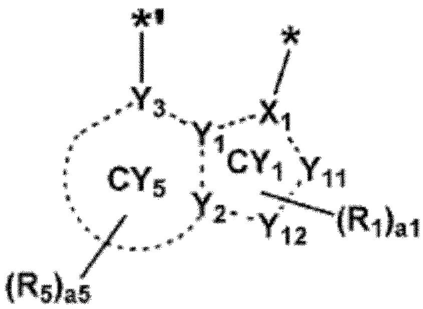

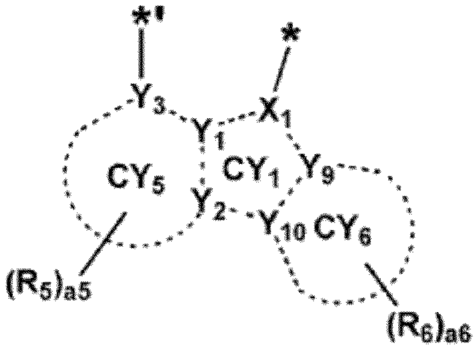

Formule A1-1

Formule A1-2

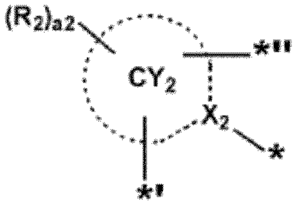

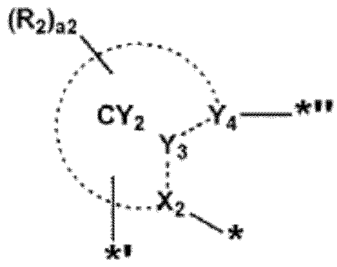

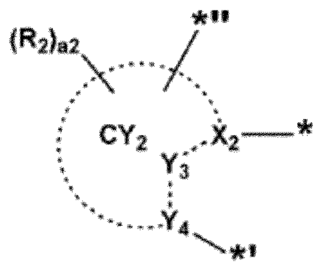

Formule A2-1

Formule A2-2

Formule A2-3

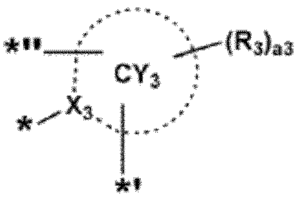

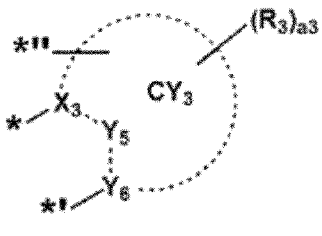

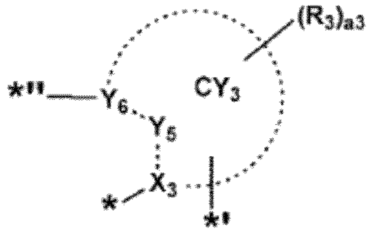

Formule A3-1

Formule A3-2

Formule A3-3

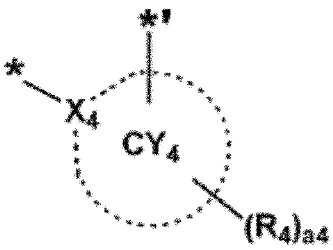

Formule A4-1

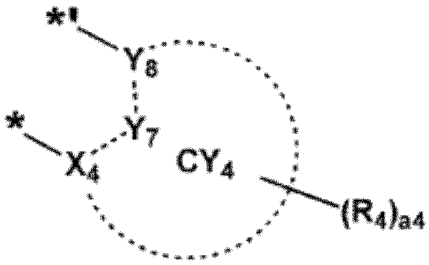

Formule A4-2,

où

M, dans la Formule 1, est le platine (Pt),

dans la Formule 1, deux liaisons sélectionnées parmi une liaison entre $A_1$ et M, une liaison entre $A_2$ et M, une liaison entre $A_3$ et M, et une liaison entre $A_4$ et M sont chacune une liaison covalente, et les autres sont chacune une liaison de coordination,

$A_1$ dans la Formule 1 est représenté par la Formule A1-1 ou A1-2, et dans les Formules A1-1 et A1-2, * indique un site de fixation à M dans la Formule 1, et *' indique un site de fixation à $T_1$ dans la Formule 1,

$A_2$ dans la Formule 1 est représenté par l'une des Formules A2-1 à A2-3, et dans les Formules A2-1 à A2-3, * indique un site de fixation à M dans la Formule 1, *' indique un site de fixation à $T_1$ dans la Formule 1, et *'' indique un site de fixation à $T_2$ dans la Formule 1, et dans la Formule A2-1, les deux atomes auxquels sont reliés *' et *'' sont adjacents à $X_2$,

$A_3$ dans la Formule 1 est représenté par l'une des Formules A3-1 à A3-3, et dans les Formules A3-1 à A3-3, * indique un site de fixation à M dans la Formule 1, *'' indique un site de fixation à $T_2$ dans la Formule 1, et *' indique un site de fixation à $T_3$ dans la Formule 1, et dans la Formule A3-1, les deux atomes auxquels sont reliés *' et *'' sont adjacents à $X_3$,

$A_4$ dans la Formule 1 est un groupement non cyclique comprenant un premier atome relié à M, ou est représenté par la Formule A4-1 ou A4-2, et dans les Formules A4-1 et A4-2, * indique un site de fixation à M dans la Formule 1, et *' indique un site de fixation à $T_3$ dans la Formule 1, et dans la Formule A4-1, l'atome auquel est relié *' est adjacent à $X_4$,

le premier atome est B, N, P, C, Si, O, ou S,

dans les Formules A1-1, A1-2, A2-1 à A2-3, A3-1 à A3-3, A4-1, et A4-2, $X_1$ à $X_4$ et $Y_1$ à $Y_{10}$ sont chacun indépendamment C ou N, et $Y_{11}$ est O, S, N, C, ou Si,

$Y_{12}$ est C,

l'anneau $CY_1$ dans les Formules A1-1 et A1-2 est un anneau de 5 membres,

les anneaux $CY_2$ à $CY_6$ dans les Formules A1-1, A1-2, A2-1 à A2-3, A3-1 à A3-3, A4-1, et A4-2 sont chacun indépendamment un groupe carbocyclique $C_5$-$C_{30}$ ou un groupe hétérocyclique $C_1$-$C_{30}$,

$T_1$ à $T_3$ dans la Formule 1 sont chacun une liaison simple,

$R_7$ et $R_8$ sont optionnellement reliés via une liaison simple, une liaison double, ou un premier groupe de liaison pour former un groupe carbocyclique $C_5$-$C_{30}$ substitué ou non substitué ou un groupe hétérocyclique $C_1$-$C_{30}$ substitué ou non substitué,

$R_1$ à $R_8$ sont chacun indépendamment sélectionnés entre : hydrogène, deutérium, -F, -Cl, - Br, -I, -$SF_5$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe arylalkyle $C_7$-$C_{60}$ substitué ou non substitué, un groupe hétéroaryle $C_1$-$C_{60}$ substitué ou non substitué, un groupe hétéroaryloxy $C_1$-$C_{60}$ substitué ou non substitué, un groupe hétéroarylthio $C_1$-$C_{60}$ substitué ou non substitué, un groupe hétéroarylalkyle $C_2$-$C_{60}$ substitué ou non substitué, un groupe polycyclique condensé non aromatique monovalent substitué ou on substitué, un groupe hétéropolycyclique condensé non aromatique monovalent substitué ou non substitué, - $N(Q_1)(Q_2)$, -$Si(Q_3)(Q_4)(Q_5)$, -$B(Q_6)(Q_7)$, et -$P(=O)(Q_8)(Q_9)$,

a1 dans 1a Formule A1-1 est un nombre entier de 0 to 4,
a2 à a6 dans les Formules A1-1, A1-2, A2-1 à A2-3, A3-1 à A3-3, A4-1, et A4-2 sont chacun indépendamment un nombre entier de 0 à 20,
deux d'une pluralité de groupes voisins $R_2$ sont optionnellement reliés pour former un groupe carbocyclique $C_5$-$C_{30}$ substitué ou non substitué ou un groupe hétérocyclique $C_1$-$C_{30}$ substitué ou non substitué,
deux d'une pluralité de groupes voisins $R_3$ sont optionnellement reliés pour former un groupe carbocyclique $C_5$-$C_{30}$ substitué ou non substitué ou un groupe hétérocyclique $C_1$-$C_{30}$ substitué ou non substitué,
deux d'une pluralité de groupes voisins $R_4$ sont optionnellement reliés pour former un groupe carbocyclique $C_5$-$C_{30}$ substitué ou non substitué ou un groupe hétérocyclique $C_1$-$C_{30}$ substitué ou non substitué,
deux d'une pluralité de groupes voisins $R_5$ sont optionnellement reliés pour former un groupe carbocyclique $C_5$-$C_{30}$ substitué ou non substitué ou un groupe hétérocyclique $C_1$-$C_{30}$ substitué ou non substitué,
deux d'une pluralité de groupes voisins $R_6$ sont optionnellement reliés pour former un groupe carbocyclique $C_5$-$C_{30}$ substitué ou non substitué ou un groupe hétérocyclique $C_1$-$C_{30}$ substitué ou non substitué,
deux groupes voisins ou plus sélectionnés parmi $R_2$ à $R_5$ sont optionnellement reliés pour former un groupe carbocyclique $C_5$-$C_{30}$ substitué ou non substitué ou un groupe hétérocyclique $C_1$-$C_{30}$ substitué ou non substitué,
$A_1$ et $A_4$ dans la Formule 1 ne sont pas reliés l'un à l'autre,
i) quand $A_1$ dans la Formule 1 est représenté par la Formule A1-1, le composé organométallique représenté par la Formule 1 remplit la « Condition 1 », et ii) quand $A_1$ dans la Formule 1 est représenté par la Formule A1-2, le composé organométallique représenté par la Formule 1 remplit au moins l'une de la « Condition 1 » à la « Condition 3 »,

« Condition 1 »
$A_2$ dans la Formule 1 est représenté par la Formule A2-2 ou A2-3,
« Condition 2 »
$A_3$ dans la Formule 1 est représenté par la Formule A3-2 ou A3-3, et
« Condition 3 »
$A_4$ dans la Formule 1 est représenté par la Formule A4-2,

où au moins un substituant du groupe carbocyclique $C_5$-$C_{30}$ substitué, du groupe hétérocyclique $C_1$-$C_{30}$ substitué, du groupe alkyle $C_1$-$C_{60}$ substitué, du groupe alkényle $C_2$-$C_{60}$ substitué, du groupe alkynyle $C_2$-$C_{60}$ substitué, du groupe alkoxy $C_1$-$C_{60}$ substitué, du groupe cycloalkyle $C_3$-$C_{10}$ substitué, du groupe hétérocycloalkyle $C_1$-$C_{10}$ substitué, du groupe cycloalkényle $C_3$-$C_{10}$ substitué, du groupe hétérocycloalkényle $C_1$-$C_{10}$ substitué, du groupe aryle $C_6$-$C_{60}$ substitué, du groupe aryloxy $C_6$-$C_{60}$ substitué, du groupe arylthio $C_6$-$C_{60}$ substitué, du groupe arylalkyle $C_7$-$C_{60}$ substitué, du groupe hétéroaryle $C_1$-$C_{60}$ substitué, du groupe hétéroaryloxy $C_1$-$C_{60}$ substitué, du groupe hétéroarylthio $C_1$-$C_{60}$ substitué, du groupe hétéroarylalkyle $C_2$-$C_{60}$ substitué, du groupe polycyclique condensé non aromatique monovalent substitué et du groupe hétéropolycyclique condensé non aromatique monovalent substitué est sélectionné entre :

deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$ ;
un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$, chacun substitué avec au moins un élément sélectionné entre : deutérium, -F, - Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-B(Q_{16})(Q_{17})$, et $-P(=O)(Q_{18}(Q_{19})$ ;
un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non

aromatique monovalent, et un groupe hétéropolycyclique condensé non aromatique monovalent ;
un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, et un groupe hétéropolycyclique condensé non aromatique monovalent, chacun substitué avec au moins un élément sélectionné entre : deutérium, -F, -Cl, -Br, -I, $-CD_3$, $-CD_2H$, $-CDH_2$, $-CF_3$, - $CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloakényle $C_3$-$C_{10}$, un groupe hétérocycloalkényle $C_{1^-10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, un groupe hétéropolycyclique condensé non aromatique monovalent, $-N(Q_{21})(Q_{22})$, - $Si(Q_{23})(Q_{24})(Q_{25}$, $-B(Q_{26})(Q_{27})$, et $-P(=O)(Q_{28})(Q_{29})$; et
$-N(Q_{31}(Q_{32})$, $-Si(Q_{33})(Q_{34})(Q_{35})$, $-B(Q_{36})(Q_{37})$, et $-P(=O)(Q_{38})(Q_{39})$, et
$Q_1$ à $Q_9$, $Q_{11}$ à $Q_{19}$, $Q_{21}$ à $Q_{29}$, et $Q_{31}$ à $Q_{39}$ sont chacun indépendamment sélectionnés entre : hydrogène, deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkyle $C_1$-$C_{60}$ substitué avec au moins un élément sélectionné entre : deutérium, un groupe alkyle $C_1$-$C_{60}$, et un groupe aryle $C_6$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$- $C_{10}$, un groupe aryle $C_6$-$C_{60}$, un groupe aryle $C_6$-$C_{60}$ substitué avec au moins un élément sélectionné entre : deutérium, un groupe alkyle $C_1$-$C_{60}$, et un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent et un groupe hétéropolycyclique condensé non aromatique monovalent.

**2.** Composé organométallique selon la revendication 1, dans lequel
une liaison entre $A_1$ et M et une liaison entre $A_3$ et M sont chacune une liaison covalente, et une liaison entre $A_2$ et M et une liaison entre $A_4$ et M sont chacune une liaison de coordination, ou
une liaison entre $A_1$ et M et une liaison entre $A_4$ et M sont chacune une liaison covalente, et une liaison entre $A_2$ et M et une liaison entre $A_3$ et M sont chacune une liaison de coordination.

**3.** Composé organométallique selon la revendication 1 ou 2, dans lequel
l'anneau $CY_1$ est sélectionné entre : un groupe pyrrole, un groupe furane, un groupe thiophène, un groupe silole, un groupe pyrazole, un groupe imidazole, un groupe triazole, un groupe tétrazole, un groupe oxazole, un groupe isoxazole, un groupe thiazole, un groupe isothiazole, un groupe oxadiazole, un groupe thiadiazole, un groupe oxatriazole, et un groupe thiatriazole.

**4.** Composé organométallique selon l'une quelconque des revendications 1-3, dans lequel
les anneaux $CY_2$ à $CY_6$ sont chacun indépendamment sélectionnés entre : un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphthalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzooxadiazole, un groupe benzothiadiazole, un groupe 5,6,7,8-tétrahydroisoquinoline, et un groupe 5,6,7,8-tétrahydroquinoline.

**5.** Composé organométallique selon l'une quelconque des revendications 1-4, dans lequel au moins l'un des anneaux $CY_2$ à $CY_4$ est un anneau condensé ayant au moins un anneau de 5 membres et au moins un anneau de 6 membres ou un anneau condensé ayant au moins deux anneaux de 6 membres,
l'anneau de 5 membres est sélectionné entre : un groupe cyclopentadiène, un groupe furane, un groupe thiophène, un groupe pyrrole, un groupe silole, un groupe oxazole, un groupe isoxazole, un groupe oxadiazole, un groupe isoxadiazole, un groupe oxatriazole, un groupe isoxatriazole, un groupe thiazole, un groupe isothiazole, un groupe thiadiazole, un groupe isothiadiazole, un groupe thiatriazole, un groupe isothiatriazole, un groupe pyrazole, un groupe imidazole, un groupe triazole, un groupe tétrazole, un groupe azasilole, un groupe diazasilole, et un groupe triazasilole, et
l'anneau de 6 membres est sélectionné entre : un groupe cyclohexane, un groupe cyclohexène, un groupe benzène, un groupe pyridine, un groupe pyrimidine, un groupe pyrazine, et un groupe pyridazine.

**6.** Composé organométallique selon l'une quelconque des revendications 1-5, dans lequel
$R_1$ à $R_8$ sont chacun indépendamment sélectionnés entre :

hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, $-SF_5$, un groupe alkyle $C_1$-$C_{20}$, et un groupe alkoxy $C_1$-$C_{20}$ ;
un groupe alkyle $C_1$-$C_{20}$ et un groupe alkoxy $C_1$-$C_{20}$, chacun substitué avec au moins un élément sélectionné entre : deutérium, -F, -Cl, -Br, -I, $-CD_3$, $-CD_2H$, $-CDH_2$, $-CF_3$, $-CF_2H$, - $CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{10}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle, et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, et un groupe imidazopyrimidinyle, chacun substitué avec au moins un élément sélectionné entre : deutérium, -F, -Cl, -Br, -I, - $CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique

ou un sel de celui-ci, un groupe acide phosphorique ou un sel de celui-ci, un groupe alkyle $C_1$-$C_{20}$, un groupe alkoxy $C_1$-$C_{20}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle, et $-Si(Q_{33})(Q_{34})(Q_{35})$, et
$-N(Q_1)(Q_2)$,$-Si(Q_3)(Q_4)(Q_5)$, $-B(Q_6)(Q_7)$, et $-P(=O)(Q_8)(Q_9)$, et
$Q_1$ à $Q_9$ et $Q_{33}$ à $Q_{35}$ sont chacun indépendamment sélectionnés entre :

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CH_3$, $-CD_2CD_3$, $-CD_2CD_2H$, et - $CD_2CDH_2$ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec- pentyle, un groupe tert-pentyle, un groupe phényle, et un groupe naphtyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphthyle, chacun substitué avec au moins un élément sélectionné entre : deutérium, un groupe alkyle $C_1$-$C_{10}$ et un groupe phényle.

**7.** Composé organométallique selon l'une quelconque des revendications 1-6, dans lequel
$R_1$ à $R_8$ sont chacun indépendamment sélectionnés entre : hydrogène, deutérium, -F, un groupe cyano, un groupe nitro, $-SF_5$, $-CH_3$, $-CD_3$, $-CD_2H$, $-CDH_2$, $-CF_3$, $-CF_2H$, $-CFH_2$, des groupes représentés par les Formules 9-1 à 9-19, des groupes représentés par les Formules 10-1 à 10-161, $-N(Q_1)(Q_2)$,$-Si(Q_3)(Q_4)(Q_5)$, $-B(Q_6)(Q_7)$, et $-P(=O)(Q_8)(Q_9)$ :

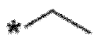
Formule 9-1

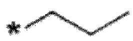
Formule 9-2

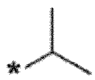
Formule 9-3

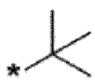
Formule 9-4

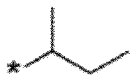
Formule 9-5

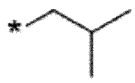
Formule 9-6

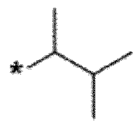
Formule 9-7

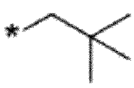
Formule 9-8

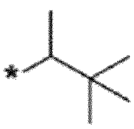
Formule 9-9

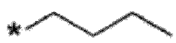
Formule 9-10

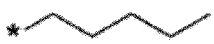
Formule 9-11

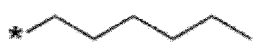
Formule 9-12

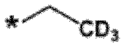
Formule 9-13

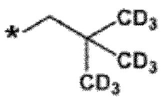
Formule 9-14

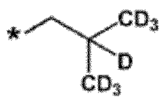
Formule 9-15

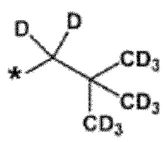
Formule 9-16

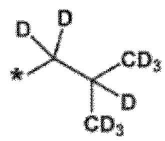
Formule 9-17

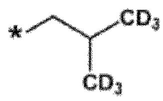
Formule 9-18

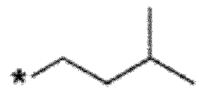

Formule 9-19

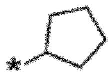

Formule 10-1

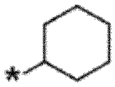

Formule 10-2

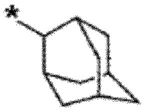

Formule 10-3

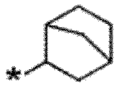

Formule 10-4

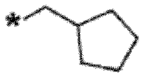

Formule 10-5

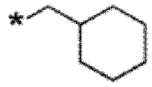

Formule 10-6

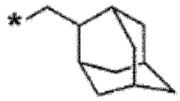

Formule 10-7

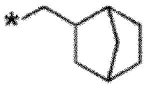

Formule 10-8

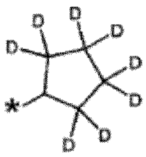

Formule 10-9

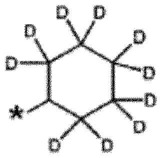

Formule 10-10

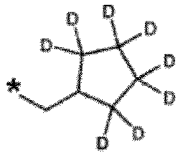

Formule 10-11

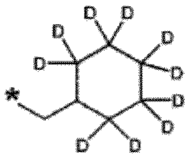

Formule 10-12

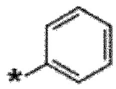

Formule 10-13

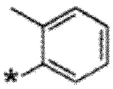

Formule 10-14

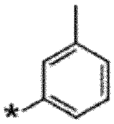

Formule 10-15

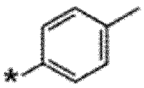

Formule 10-16

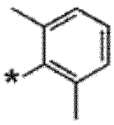

Formule 10-17

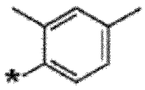

Formule 10-18

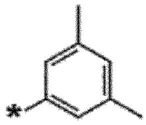

Formule 10-19

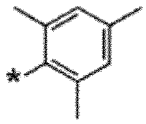

Formule 10-20

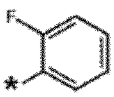

Formule 10-21

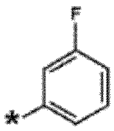

Formule 10-22

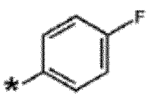

Formule 10-23

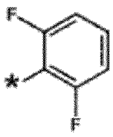

Formule 10-24

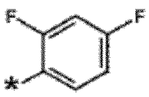

Formule 10-25

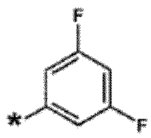

Formule 10-26

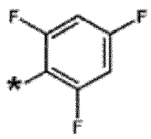

Formule 10-27

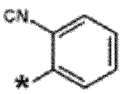

Formule 10-28

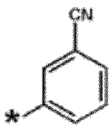

Formule 10-29

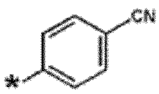

Formule 10-30

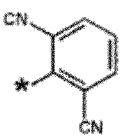

Formule 10-31

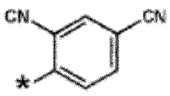

Formule 10-32

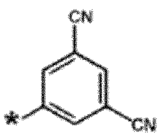

Formule 10-33

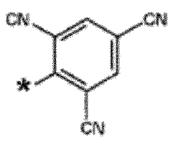

Formule 10-34

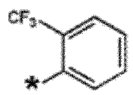
Formule 10-35

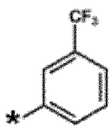
Formule 10-36

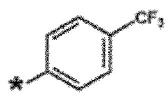
Formule 10-37

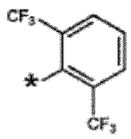
Formule 10-38

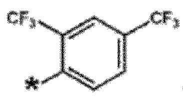
Formule 10-39

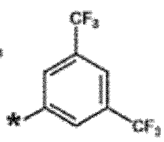
Formule 10-40

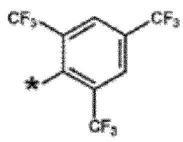
Formule 10-41

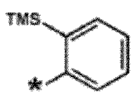
Formule 10-42

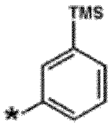
Formule 10-43

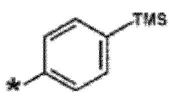
Formule 10-44

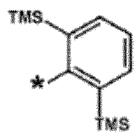
Formule 10-45

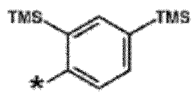
Formule 10-46

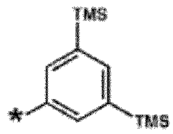
Formule 10-47

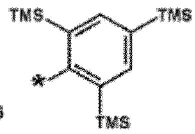
Formule 10-48

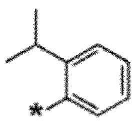
Formule 10-49

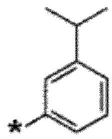
Formule 10-50

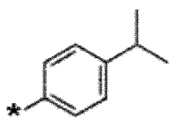
Formule 10-51

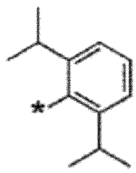
Formule 10-52

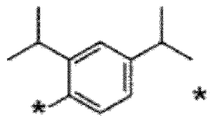
Formule 10-53

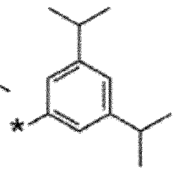
Formule 10-54

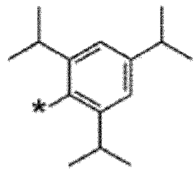
Formule 10-55

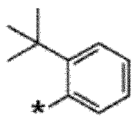
Formule 10-56

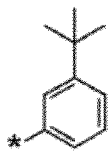
Formule 10-57

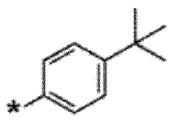
Formule 10-58

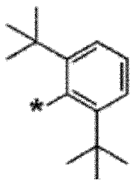
Formule 10-59

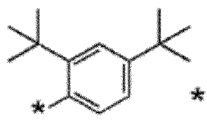
Formule 10-60

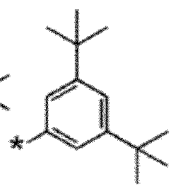
Formule 10-61

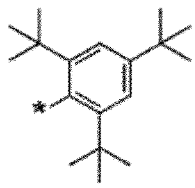
Formule 10-62

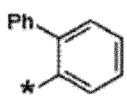
Formule 10-63

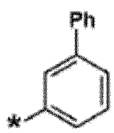
Formule 10-64

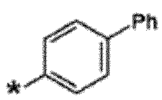
Formule 10-65

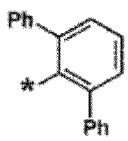
Formule 10-66

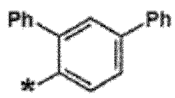
Formule 10-67

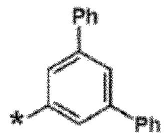
Formule 10-68

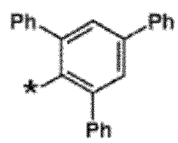
Formule 10-69

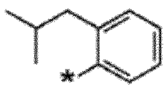
Formule 10-70

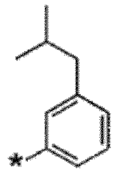
Formule 10-71

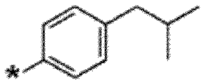
Formule 10-72

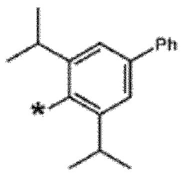
Formule 10-73

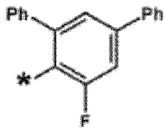
Formule 10-74

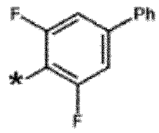
Formule 10-75

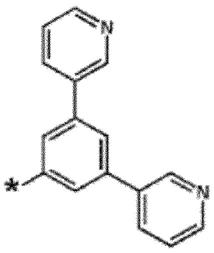
Formule 10-76

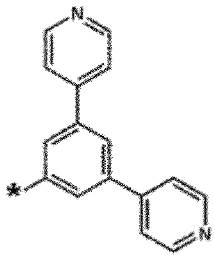
Formule 10-77

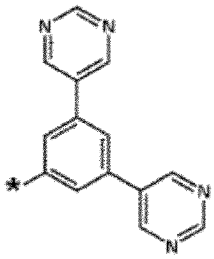
Formule 10-78

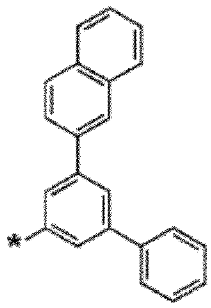
Formule 10-79

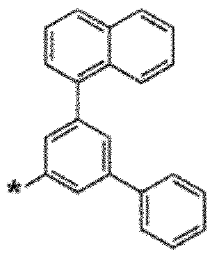
Formule 10-80

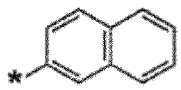
Formule 10-81

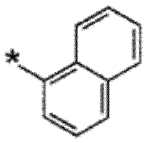
Formule 10-82

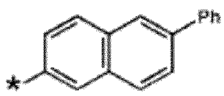
Formule 10-83

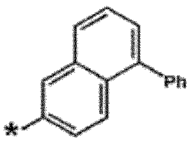
Formule 10-84

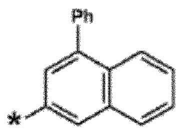
Formule 10-85

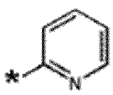
Formule 10-86

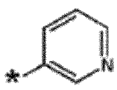
Formule 10-87

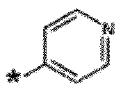
Formule 10-88

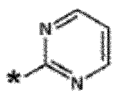
Formule 10-89

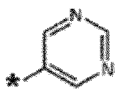
Formule 10-90

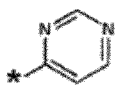
Formule 10-91

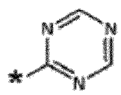
Formule 10-92

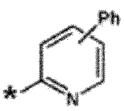
Formule 10-93

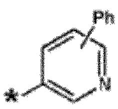
Formule 10-94

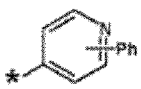
Formule 10-95

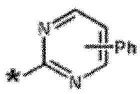
Formule 10-96

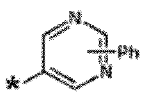
Formule 10-97

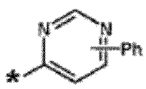
Formule 10-98

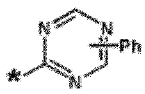
Formule 10-99

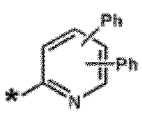
Formule 10-100

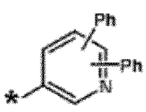
Formule 10-101

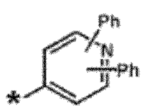
Formule 10-102

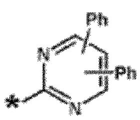
Formule 10-103

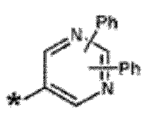
Formule 10-104

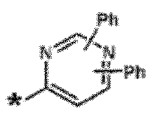
Formule 10-105

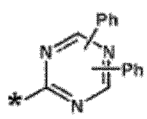
Formule 10-106

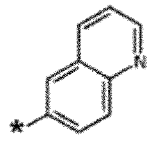
Formule 10-107

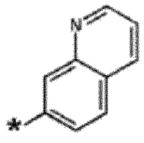
Formule 10-108

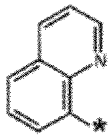
Formule 10-109

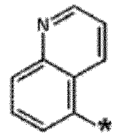
Formule 10-110

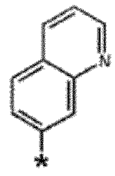
Formule 10-111

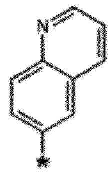
Formule 10-112

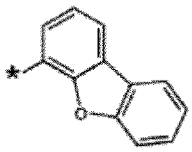
Formule 10-113

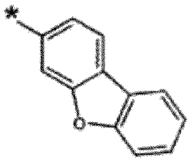
Formule 10-114

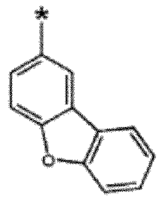
Formule 10-115

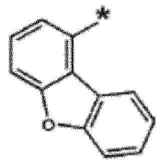
Formule 10-116

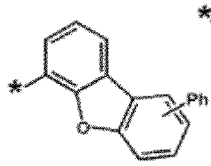
Formule 10-117

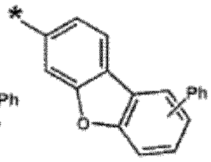
Formule 10-118

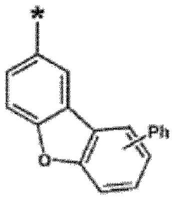
Formule 10-119

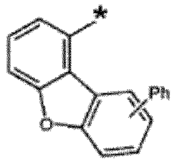
Formule 10-120

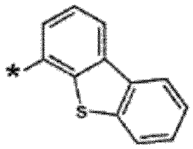
Formule 10-121

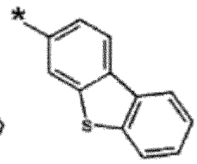
Formule 10-122

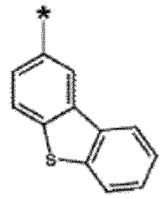
Formule 10-123

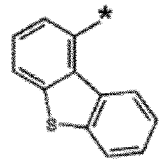
Formule 10-124

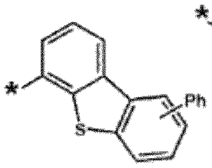
Formule 10-125

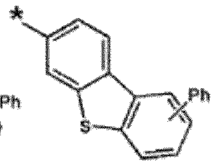
Formule 10-126

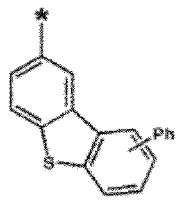
Formule 10-127

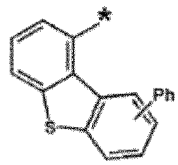
Formule 10-128

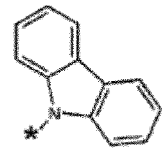
Formule 10-129

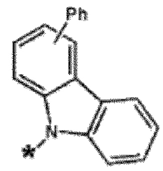
Formule 10-130

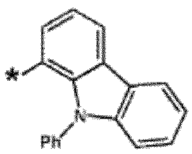
Formule 10-131

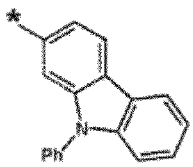
Formule 10-132

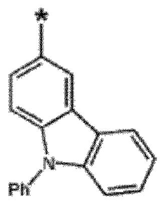
Formule 10-133

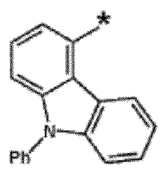
Formule 10-134

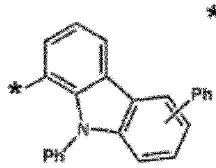
Formule 10-135

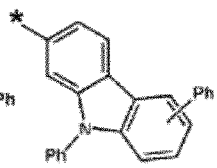
Formule 10-136

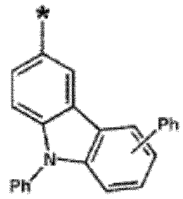
Formule 10-137

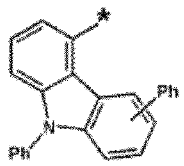
Formule 10-138

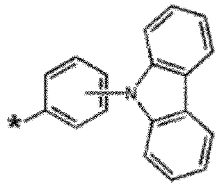
Formule 10-139

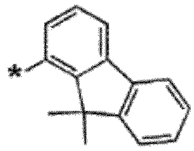
Formule 10-140

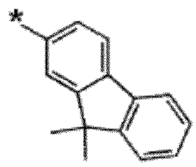
Formule 10-141

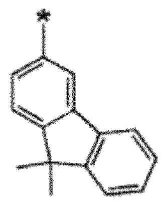
Formule 10-142

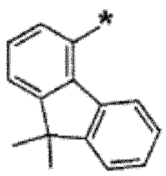
Formule 10-143

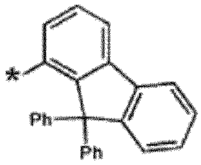
Formule 10-144

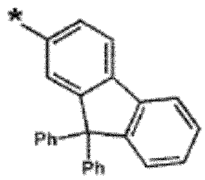
Formule 10-145

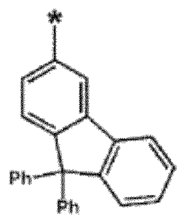
Formule 10-146

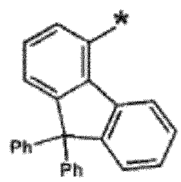
Formule 10-147

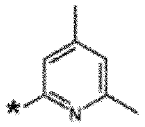
Formule 10-148

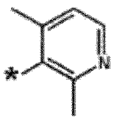
Formule 10-149

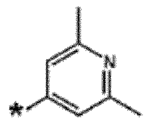
Formule 10-150

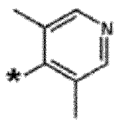
Formule 10-151

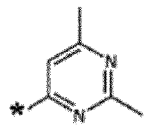
Formule 10-152

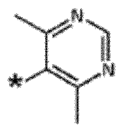
Formule 10-153

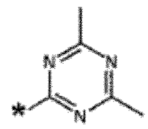
Formule 10-154

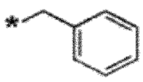
Formule 10-155

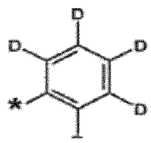
Formule 10-156

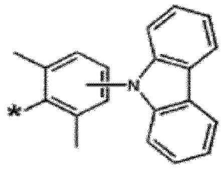
Formule 10-157

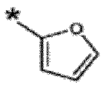
Formule 10-158

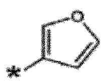
Formule 10-159

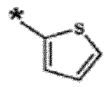
Formule 10-160

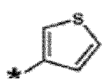
Formule 10-161

, où, dans les Formules 9-1 à 9-19 et 10-1 à 10-161, « Ph » indique un groupe phényle, « TMS » indique un groupe triméthylsilyle, et * indique un site de fixation à un atome voisin et $Q_1$ à $Q_9$ sont identiques à la description de la revendication 1.

**8.** Composé organométallique selon l'une quelconque des revendications 1-7, où $A_1$ est représenté par l'une des Formules A1-1(1) à A1-1(24) et A1-2(1) à A1-2(8) :

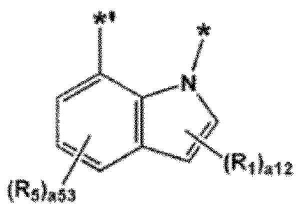
Formule A1-1(1)

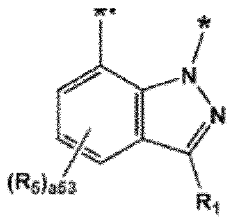
Formule A1-1(2)

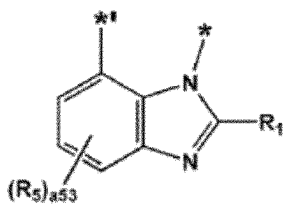
Formule A1-1(3)

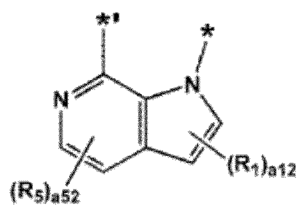
Formule A1-1(4)

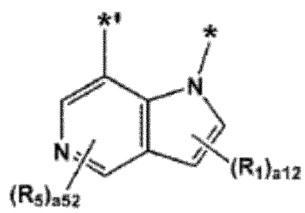
Formule A1-1(5)

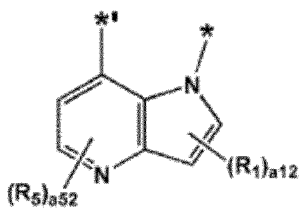
Formule A1-1(6)

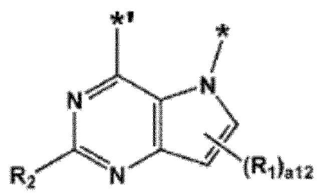
Formule A1-1(7)

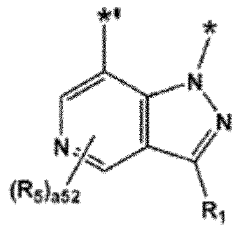
Formule A1-1(8)

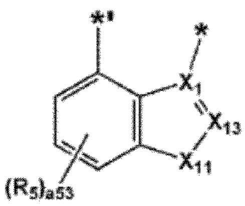
Formule A1-1(9)

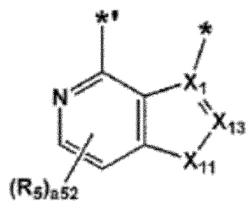
Formule A1-1(10)

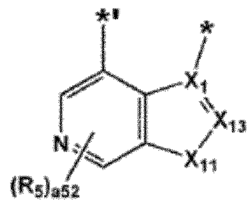
Formule A1-1(11)

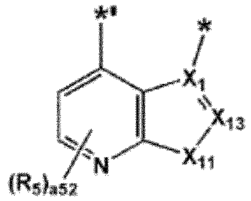
Formule A1-1(12)

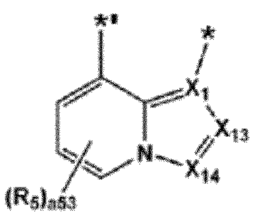
Formule A1-1(13)

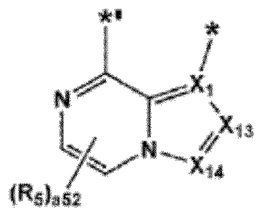
Formule A1-1(14)

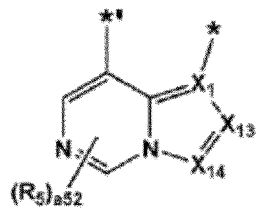
Formule A1-1(15)

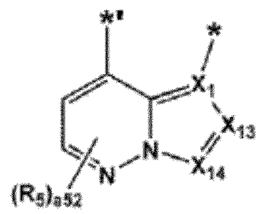
Formule A1-1(16)

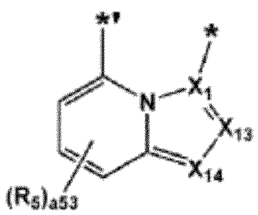
Formule A1-1(17)

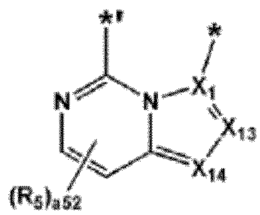
Formule A1-1(18)

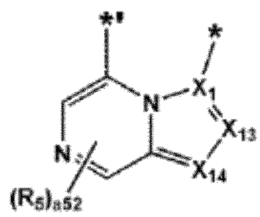
Formule A1-1(19)

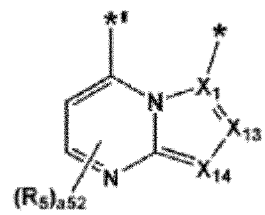
Formule A1-1(20)

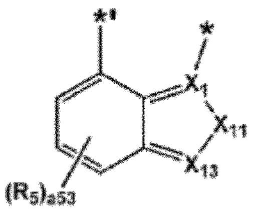
Formule A1-1(21)

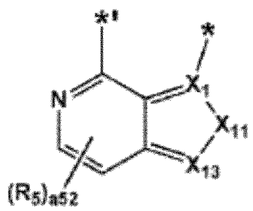
Formule A1-1(22)

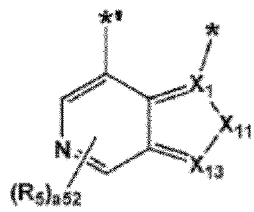
Formule A1-1(23)

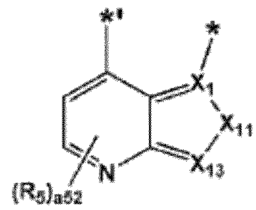
Formule A1-1(24)

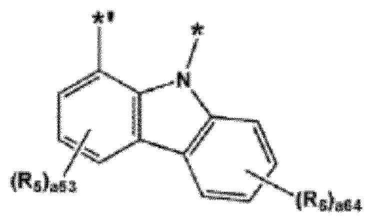

Formule A1-2(1)

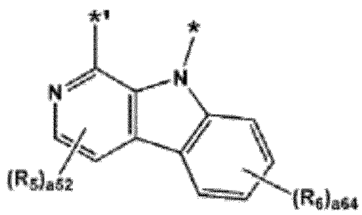

Formule A1-2(2)

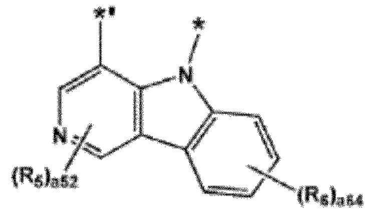

Formule A1-2(3)

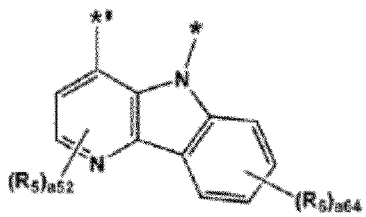

Formule A1-2(4)

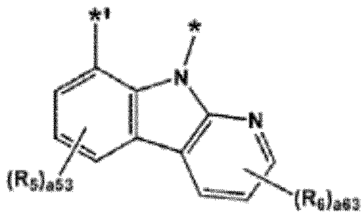

Formule A1-2(5)

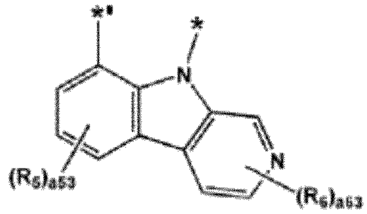

Formule A1-2(6)

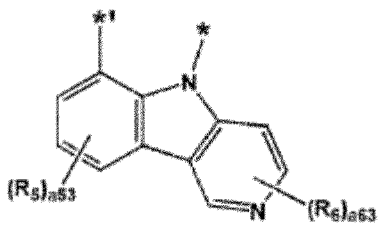

Formule A1-2(7)

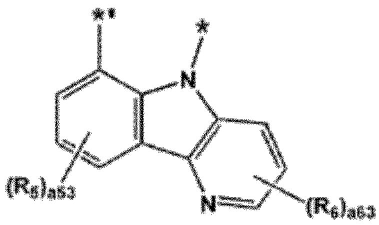

Formule A1-2(8)

,

où, dans les Formules A1-1(1) à A1-1(24) et A1-2(1) à A1-2(8),

$X_1$, $R_1$, $R_5$, $R_6$, *, et *' sont identiques à la description de la revendication 1,
$X_{11}$ est O, S, $N(R_{11})$, $C(R_{11})(R_{12})$, ou $Si(R_{11})(R_{12})$,
$X_{13}$ est N ou $C(R_{13})$,
$X_{14}$ est N ou $C(R_{14})$,
$R_{11}$ à $R_{14}$ sont identiques à la description concernant $R_1$,
a64 est un nombre entier de 0 à 4,
a53 et a63 sont chacun indépendamment un nombre entier de 0 à 3, et
a12 et a52 sont chacun indépendamment un nombre entier de 0 à 2 ; et/ou

où
$A_2$ est représenté par l'une des Formules A2-1(1) à A2-1(17), A2-2(1) à A2-2(58), et A2-3(1) à A2-3(58):

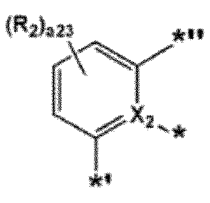

Formule A2-1(1)

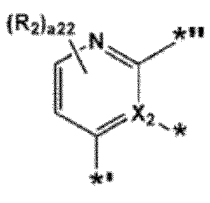

Formule A2-1(2)

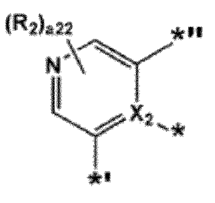

Formule A2-1(3)

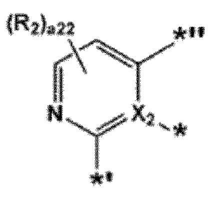

Formule A2-1(4)

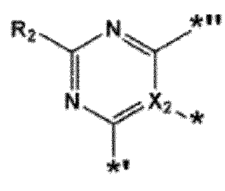

Formule A2-1(5)

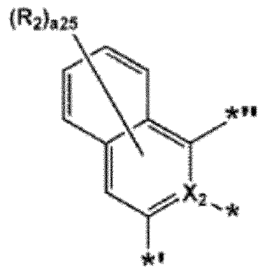

Formule A2-1(6)

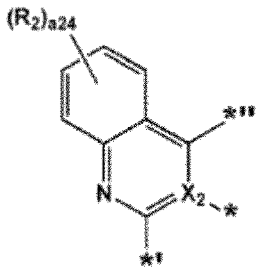

Formule A2-1(7)

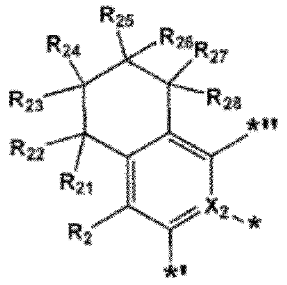

Formule A2-1(8)

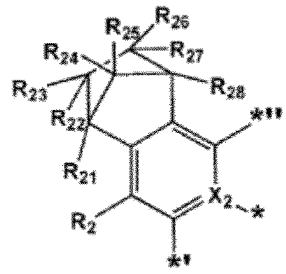

Formule A2-1(9)

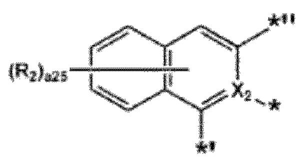

Formule A2-1(10)

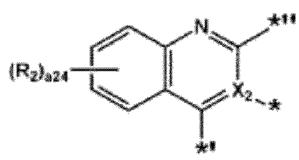

Formule A2-1(11)

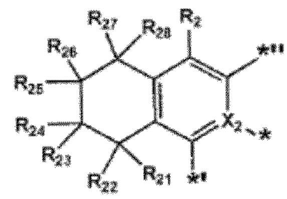

Formule A2-1(12)

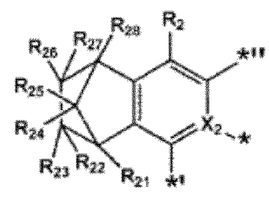

Formule A2-1(13)

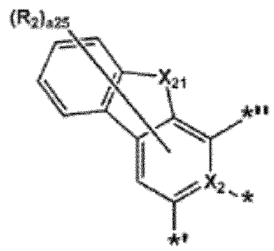

Formule A2-1(14)

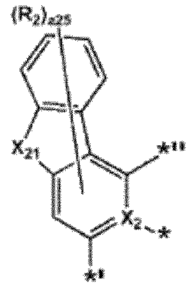

Formule A2-1(15)

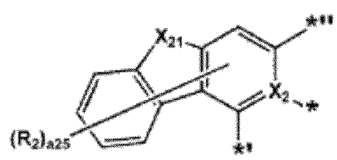

Formule A2-1(16)

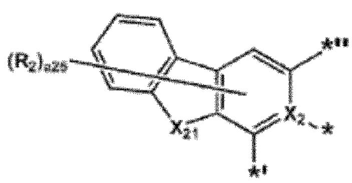

Formule A2-1(17)

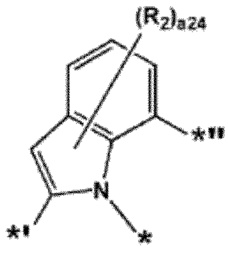

Formule A2-2(1)

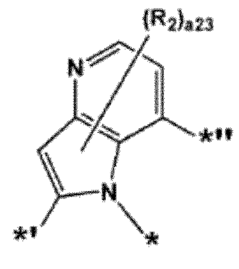

Formule A2-2(2)

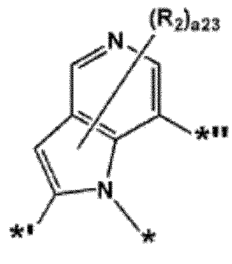

Formule A2-2(3)

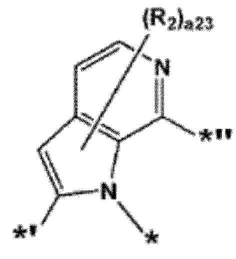

Formule A2-2(4)

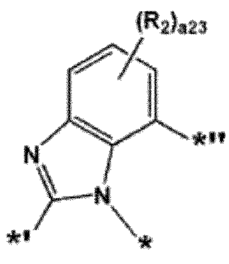

Formule A2-2(5)

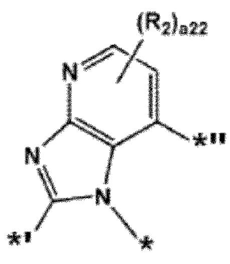

Formule A2-2(6)

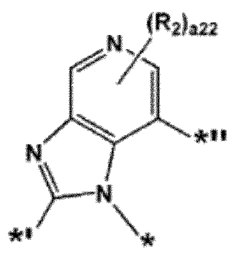

Formule A2-2(7)

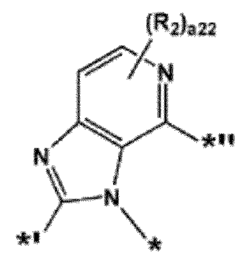

Formule A2-2(8)

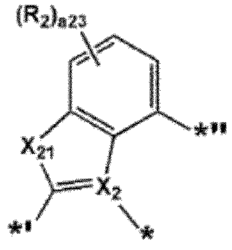
Formule A2-2(9)

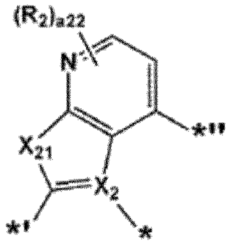
Formule A2-2(10)

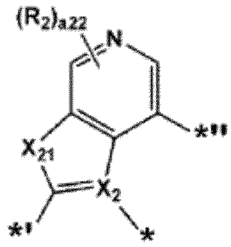
Formule A2-2(11)

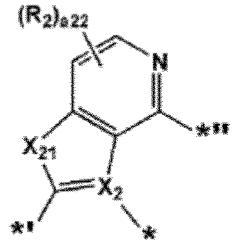
Formule A2-2(12)

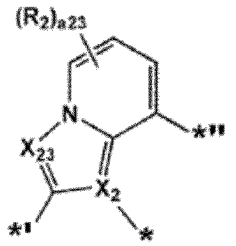
Formule A2-2(13)

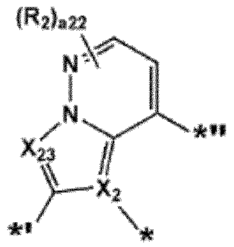
Formule A2-2(14)

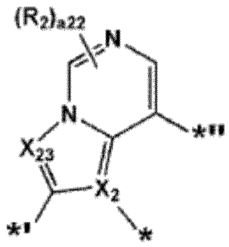
Formule A2-2(15)

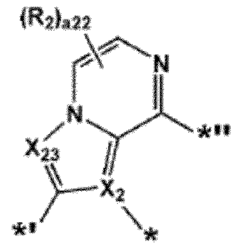
Formule A2-2(16)

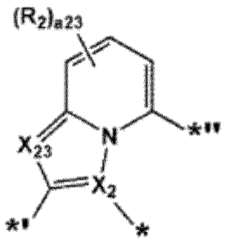
Formule A2-2(17)

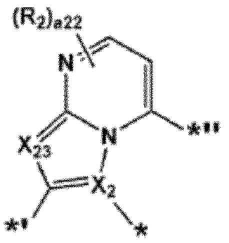
Formule A2-2(18)

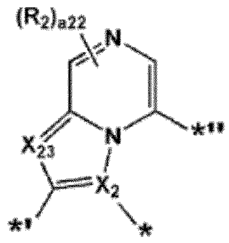
Formule A2-2(19)

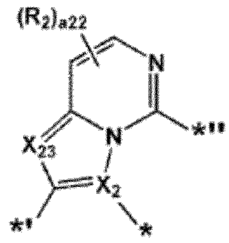
Formule A2-2(20)

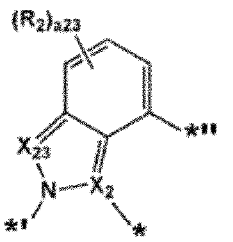
Formule A2-2(21)

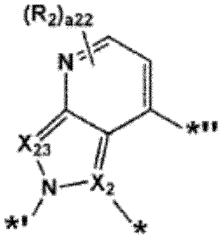
Formule A2-2(22)

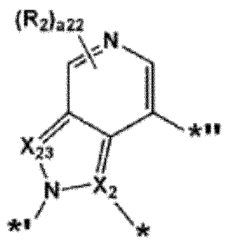
Formule A2-2(23)

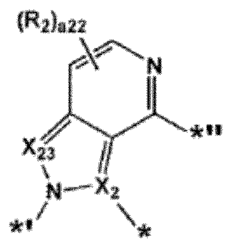
Formule A2-2(24)

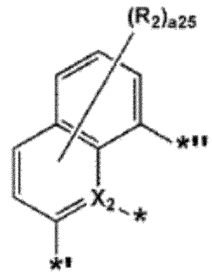
Formule A2-2(25)

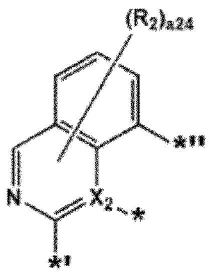

Formule A2-2(26)

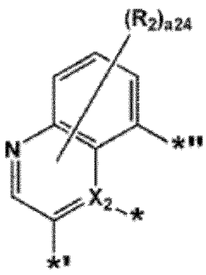

Formule A2-2(27)

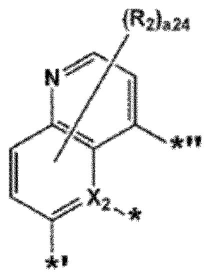

Formule A2-2(28)

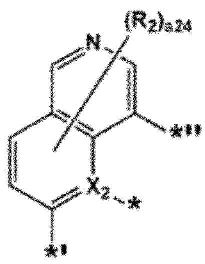

Formule A2-2(29)

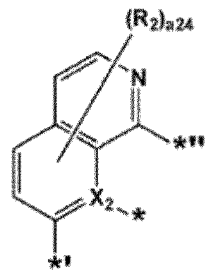

Formule A2-2(30)

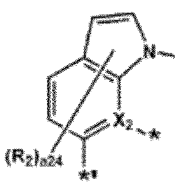

Formule A2-2(31)

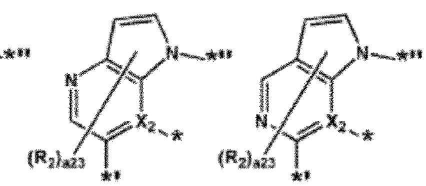

Formule A2-2(32)

Formule A2-2(33)

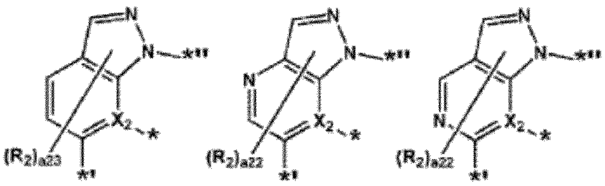

Formule A2-2(34)

Formule A2-2(35)

Formule A2-2(36)

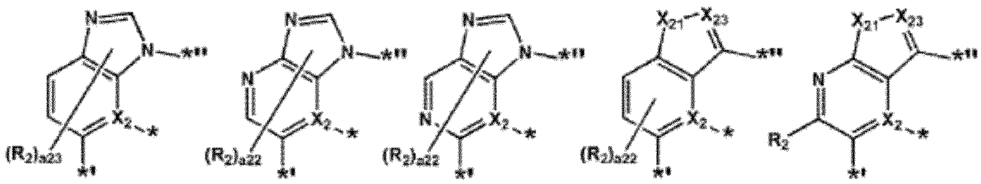

Formule A2-2(37)

Formule A2-2(38)

Formule A2-2(39)

Formule A2-2(40)

Formule A2-2(41)

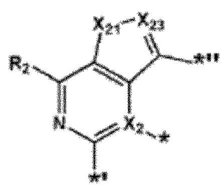

Formule A2-2(42)

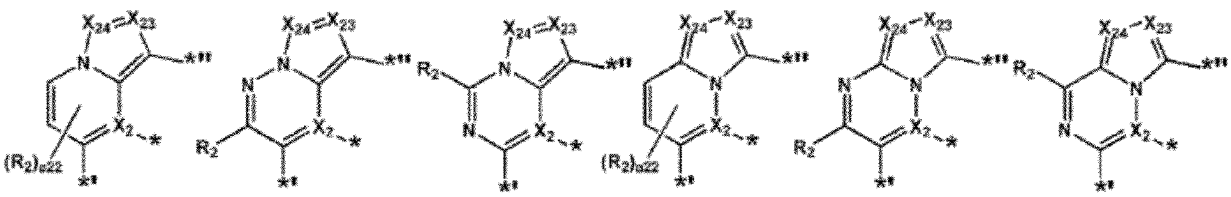

Formule A2-2(43)

Formule A2-2(44)

Formule A2-2(45)

Formule A2-2(46)

Formule A2-2(47)

Formule A2-2(48)

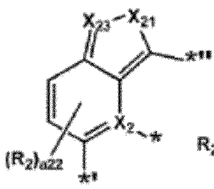
Formule A2-2(49)

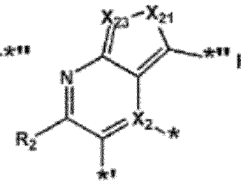
Formule A2-2(50)

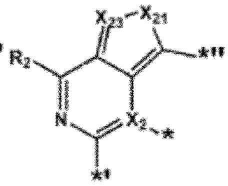
Formule A2-2(51)

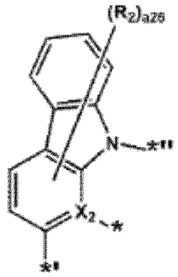
Formule A2-2(52)

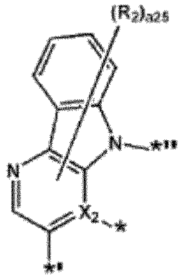
Formule A2-2(53)

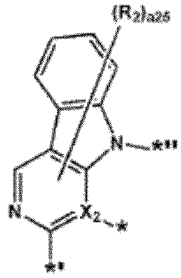
Formule A2-2(54)

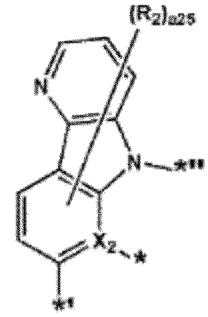
Formule A2-2(55)

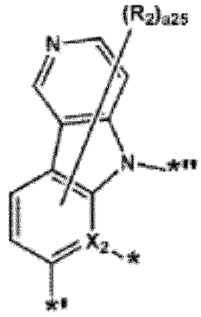
Formule A2-2(56)

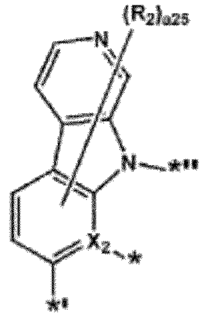
Formule A2-2(57)

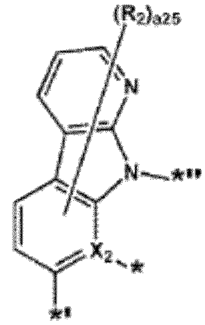
Formule A2-2(58)

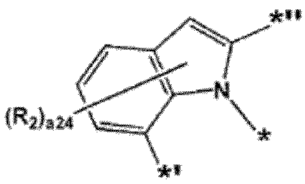
Formule A2-3(1)

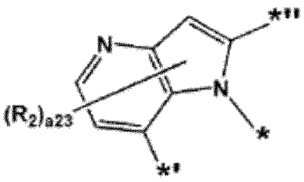
Formule A2-3(2)

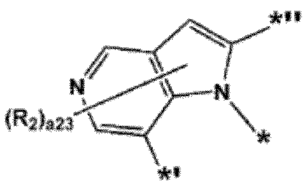
Formule A2-3(3)

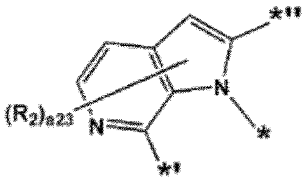
Formule A2-3(4)

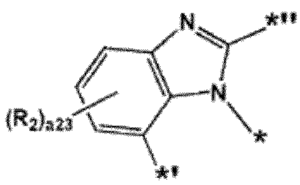
Formule A2-3(5)

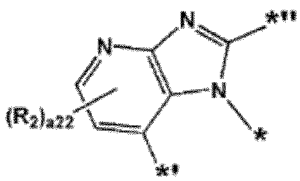
Formule A2-3(6)

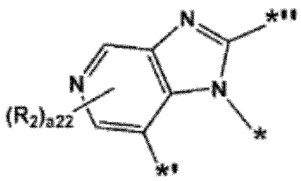
Formule A2-3(7)

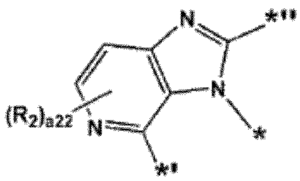
Formule A2-3(8)

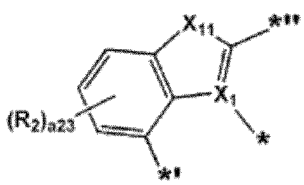
Formule A2-3(9)

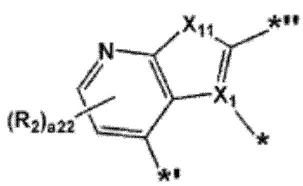
Formule A2-3(10)

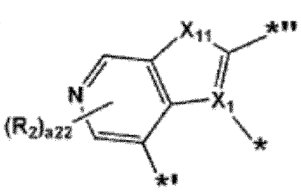
Formule A2-3(11)

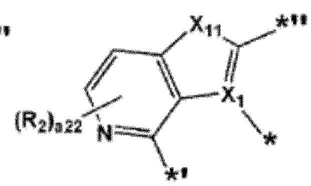
Formule A2-3(12)

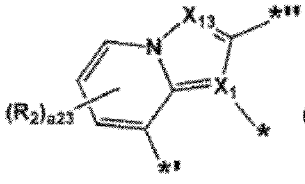 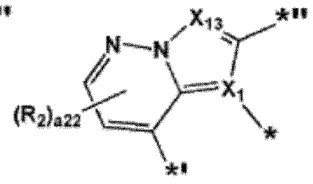 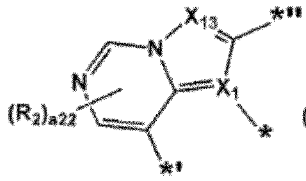 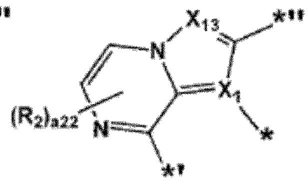

Formule A2-3(13) Formule A2-3(14) Formule A2-3(15) Formule A2-3(16)

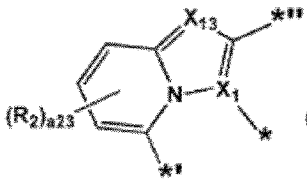 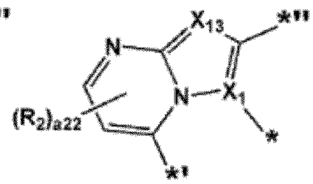 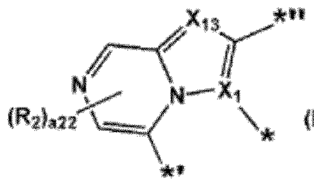 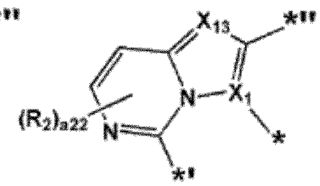

Formule A2-3(17) Formule A2-3(18) Formule A2-3(19) Formule A2-3(20)

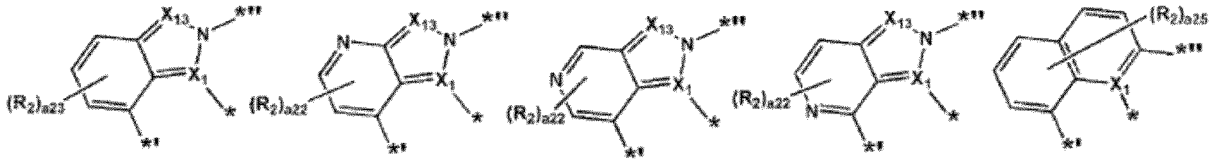

Formule A2-3(21) Formule A2-3(22) Formule A2-3(23) Formule A2-3(24) Formule A2-3(25)

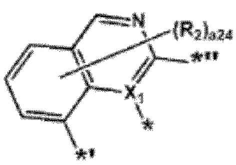 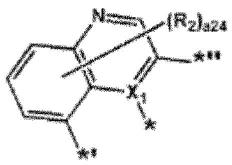 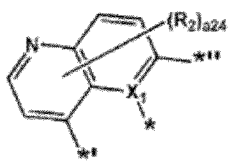 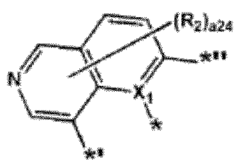 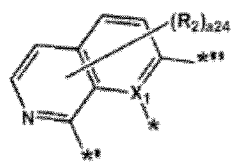

Formule A2-3(26) Formule A2-3(27) Formule A2-3(28) Formule A2-3(29) Formule A2-3(30)

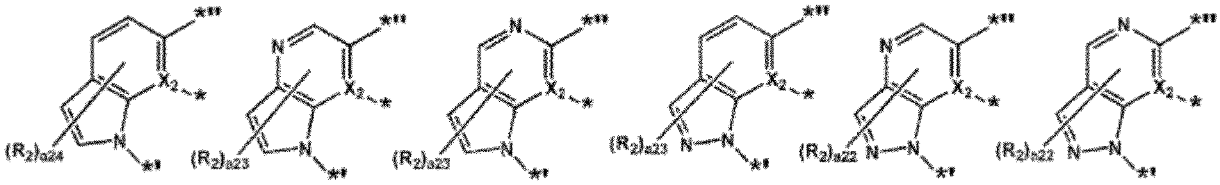

Formule A2-3(31) Formule A2-3(32) Formule A2-3(33) Formule A2-3(34) Formule A2-3(35) Formule A2-3(36)

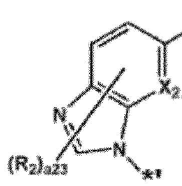
Formule A2-3(37)

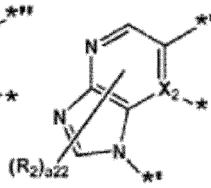
Formule A2-3(38)

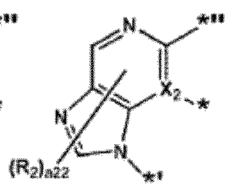
Formule A2-3(39)

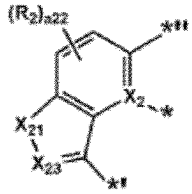
Formule A2-3(40)

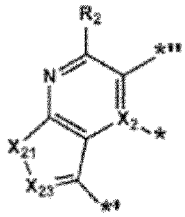
Formule A2-3(41)

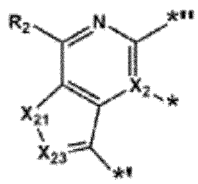
Formule A2-3(42)

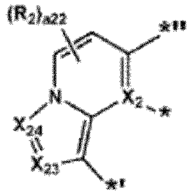
Formule A2-3(43)

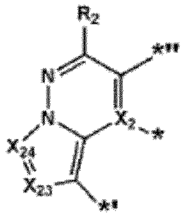
Formule A2-3(44)

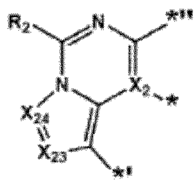
Formule A2-3(45)

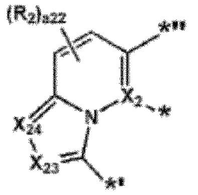
Formule A2-3(46)

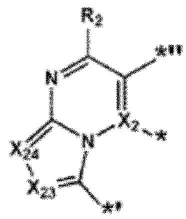
Formule A2-3(47)

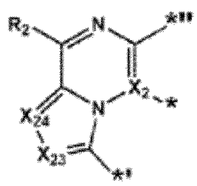
Formule A2-3(48)

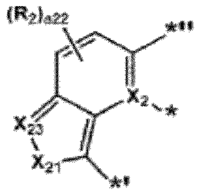
Formule A2-3(49)

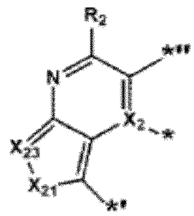
Formule A2-3(50)

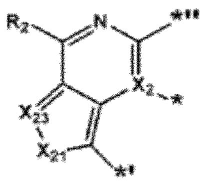
Formule A2-3(51)

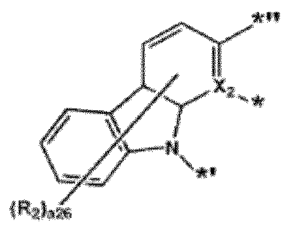
Formule A2-3(52)

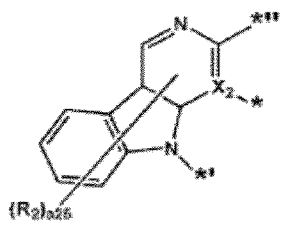
Formule A2-3(53)

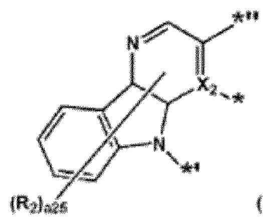
Formule A2-3(54)

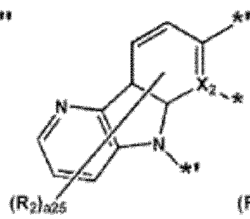
Formule A2-3(55)

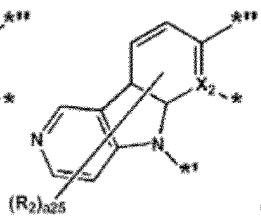
Formule A2-3(56)

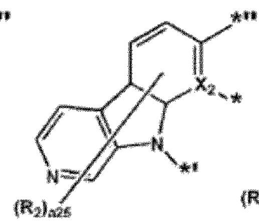
Formule A2-3(57)

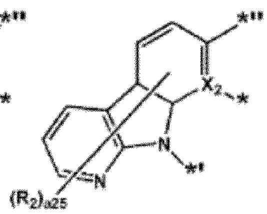
Formule A2-3(58)

, où, dans les Formules A2-1(1) à A2-1(17), A2-2(1) à A2-2(58), et A2-3(1) à A2-3(58),

$X_2$ et $R_2$ sont identiques à la description de la revendication 1,
$X_{21}$ est O, S, $N(R_{21})$, $C(R_{21})(R_{22})$, ou $Si(R_{21})(R_{22})$,
$X_{23}$ est N ou $C(R_{23})$,
$X_{24}$ est N ou $C(R_{24})$,
$R_{21}$ à $R_{28}$ sont identiques à la description concernant $R_2$ dans la revendication 1,
a26 est un nombre entier de 0 à 6,
a25 est un nombre entier de 0 à 5,
a24 est un nombre entier de 0 à 4,

a23 est un nombre entier de 0 à 3,
a22 est un nombre entier de 0 à 2, et
*, *', et *" sont identiques à la description concernant *, *', et *" dans la Formule A2-1; et/ou

où
$A_3$ est représenté par l'une des Formules A3-1(1) à A3-1(21), A3-2(1) à A3- 2(58), et A3-3(1) à A3-3(58) :

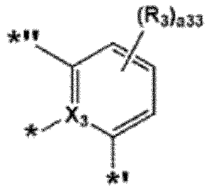
Formule A3-1(1)

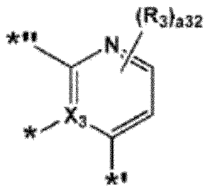
Formule A3-1(2)

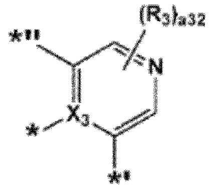
Formule A3-1(3)

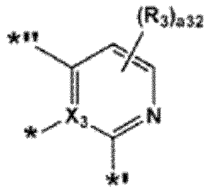
Formule A3-1(4)

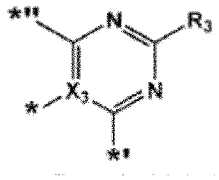
Formule A3-1(5)

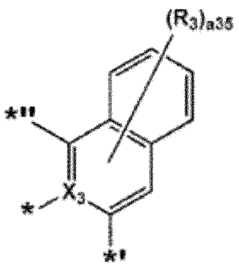
Formule A3-1(6)

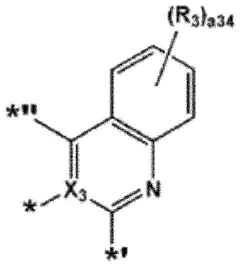
Formule A3-1(7)

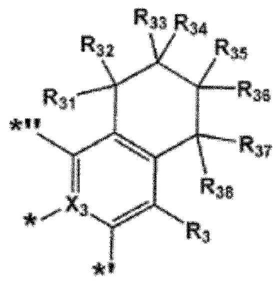
Formule A3-1(8)

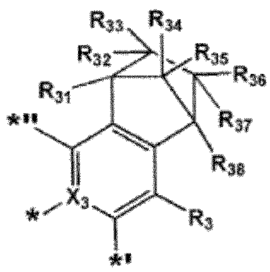
Formule A3-1(9)

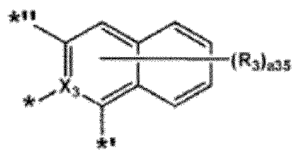
Formule A3-1(10)

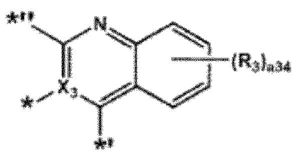
Formule A3-1(11)

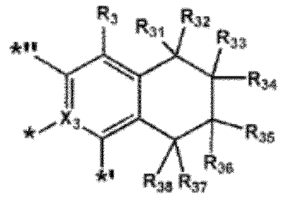
Formule A3-1(12)

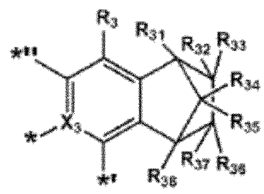
Formule A3-1(13)

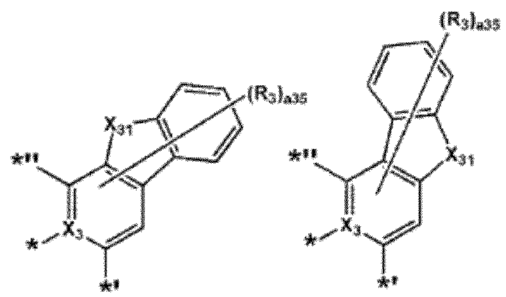
Formule A3-1(14) Formule A3-1(15)

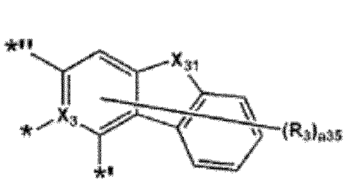
Formule A3-1(16)

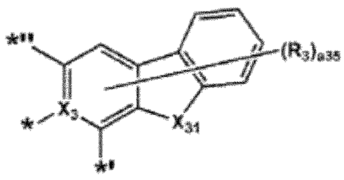
Formule A3-1(17)

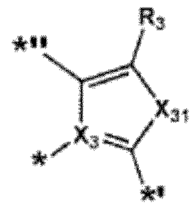
Formule A3-1(18)

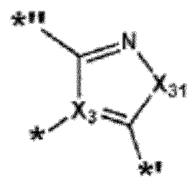
Formule A3-1(19)

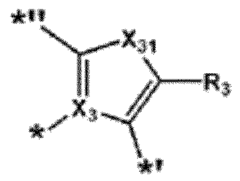
Formule A3-1(20)

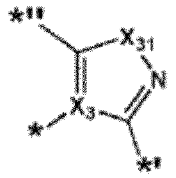
Formule A3-1(21)

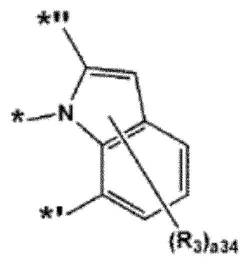
Formule A3-2(1)

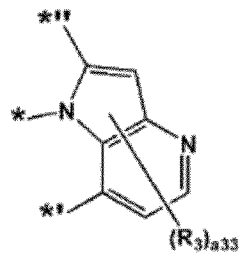
Formule A3-2(2)

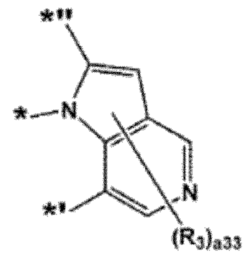
Formule A3-2(3)

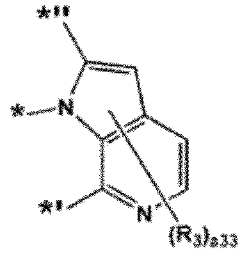
Formule A3-2(4)

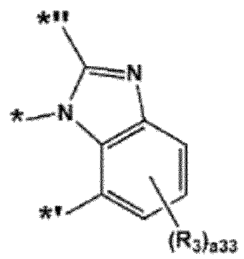
Formule A3-2(5)

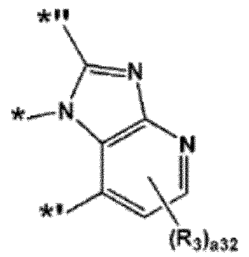
Formule A3-2(6)

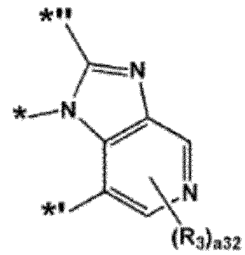
Formule A3-2(7)

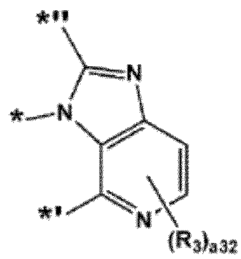
Formule A3-2(8)

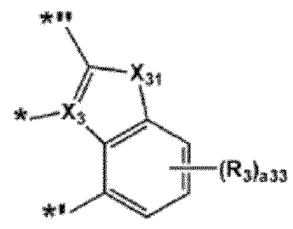
Formule A3-2(9)

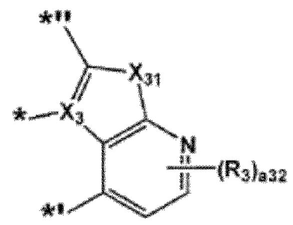
Formule A3-2(10)

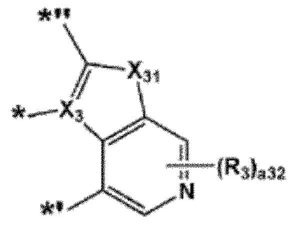
Formule A3-2(11)

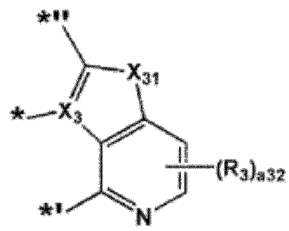
Formule A3-2(12)

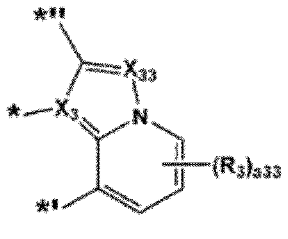
Formule A3-2(13)

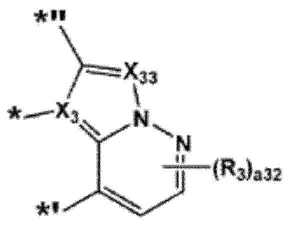
Formule A3-2(14)

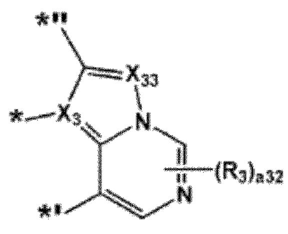
Formule A3-2(15)

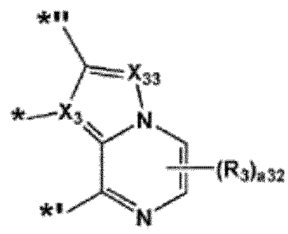
Formule A3-2(16)

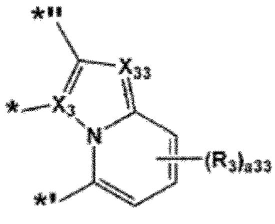

Formule A3-2(17)

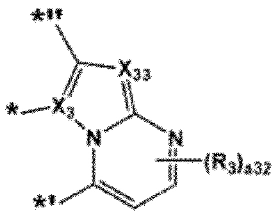

Formule A3-2(18)

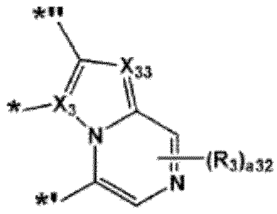

Formule A3-2(19)

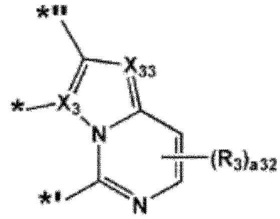

Formule A3-2(20)

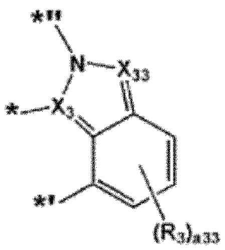

Formule A3-2(21)

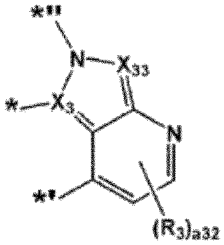

Formule A3-2(22)

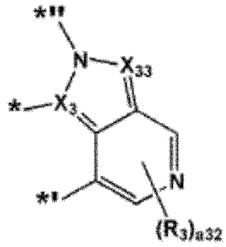

Formule A3-2(23)

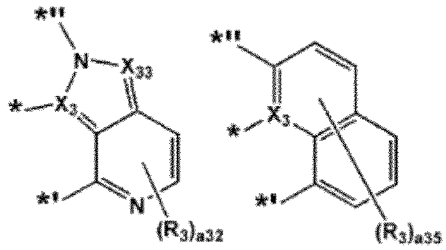

Formule A3-2(24)

Formule A3-2(25)

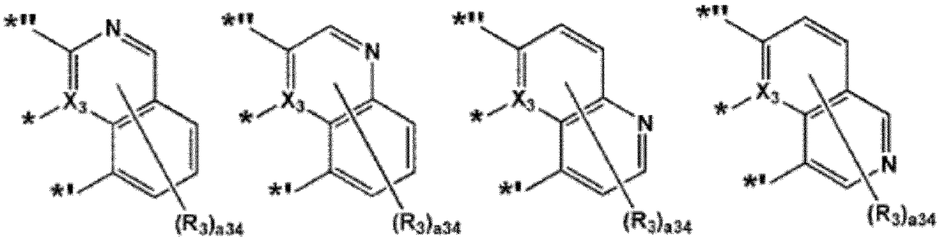

Formule A3-2(26)

Formule A3-2(27)

Formule A3-2(28)

Formule A3-2(29)

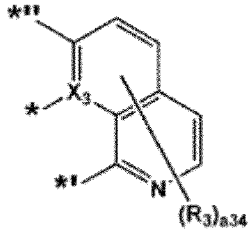

Formule A3-2(30)

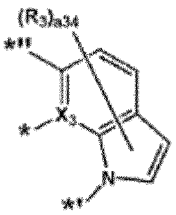

Formule A3-2(31)

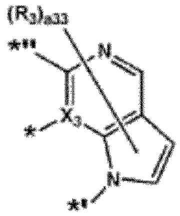

Formule A3-2(32)

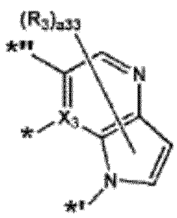

Formule A3-2(33)

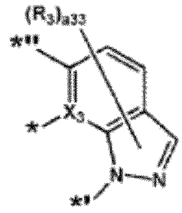

Formule A3-2(34)

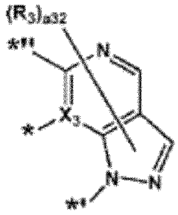

Formule A3-2(35)

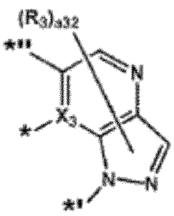

Formule A3-2(36)

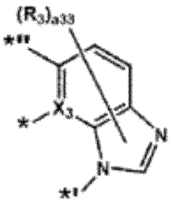

Formule A3-2(37)

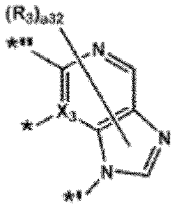

Formule A3-2(38)

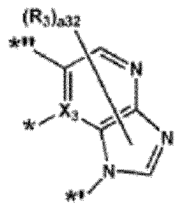

Formule A3-2(39)

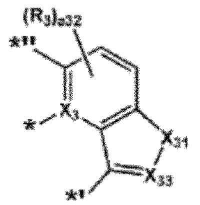

Formule A3-2(40)

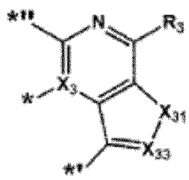

Formule A3-2(41)

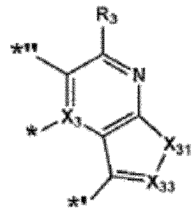

Formule A3-2(42)

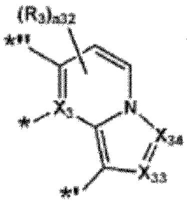

Formule A3-2(43)

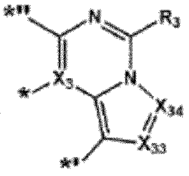

Formule A3-2(44)

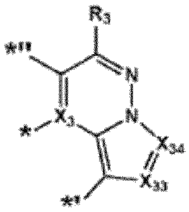

Formule A3-2(45)

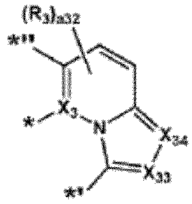

Formule A3-2(46)

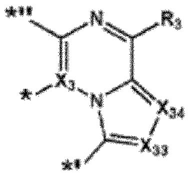

Formule A3-2(47)

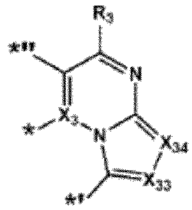

Formule A3-2(48)

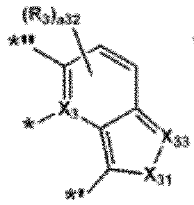

Formule A3-2(49)

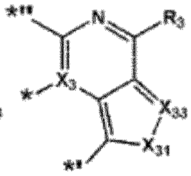

Formule A3-2(50)

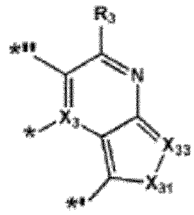

Formule A3-2(51)

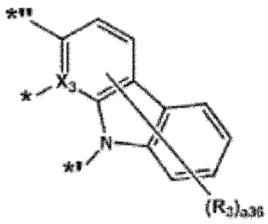

Formule A3-2(52)

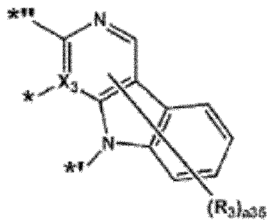

Formule A3-2(53)

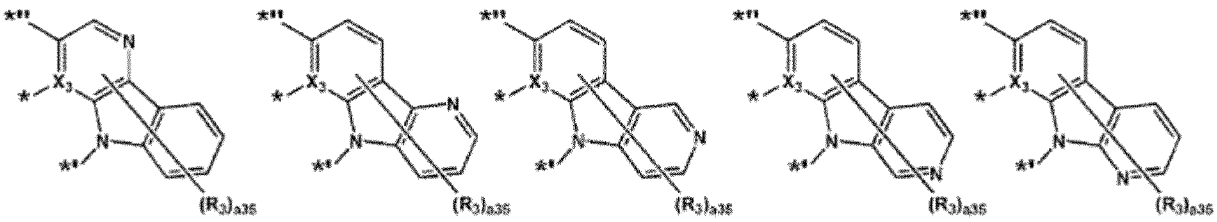

Formule A3-2(54)

Formule A3-2(55)

Formule A3-2(56)

Formule A3-2(57)

Formule A3-2(58)

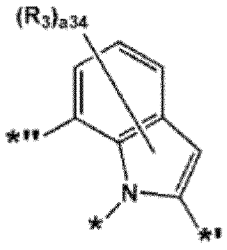
Formule A3-3(1)

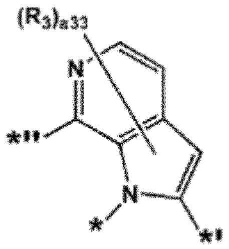
Formule A3-3(2)

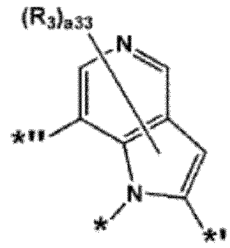
Formule A3-3(3)

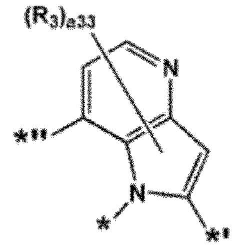
Formule A3-3(4)

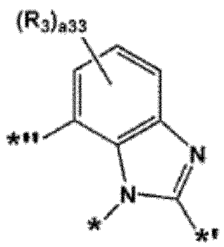
Formule A3-3(5)

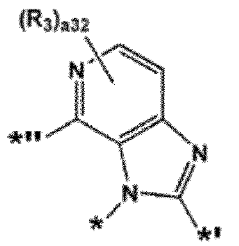
Formule A3-3(6)

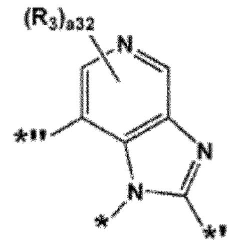
Formule A3-3(7)

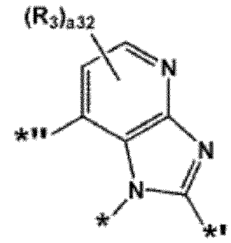
Formule A3-3(8)

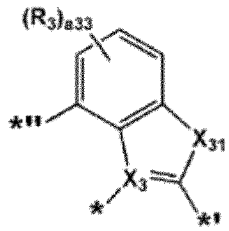
Formule A3-3(9)

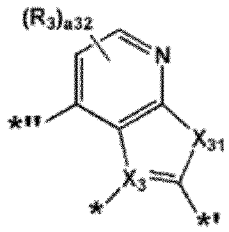
Formule A3-3(10)

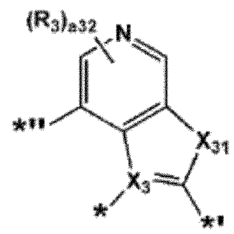
Formule A3-3(11)

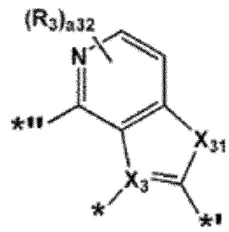
Formule A3-3(12)

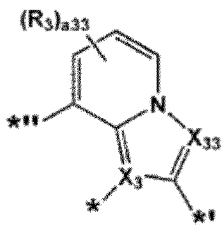
Formule A3-3(13)

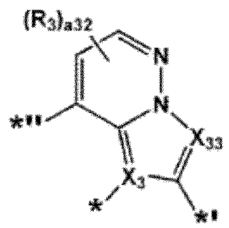
Formule A3-3(14)

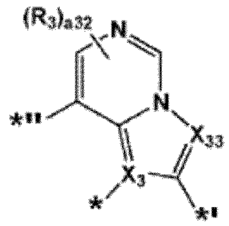
Formule A3-3(15)

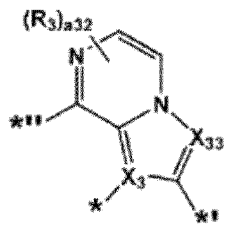
Formule A3-3(16)

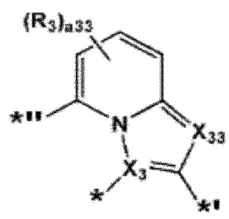
Formule A3-3(17)

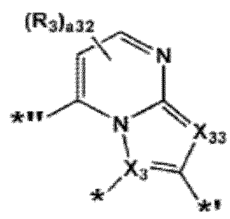
Formule A3-3(18)

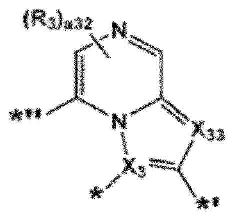
Formule A3-3(19)

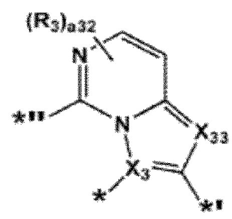
Formule A3-3(20)

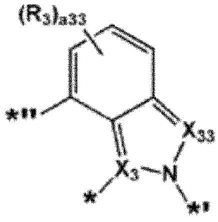

Formule A3-3(21)

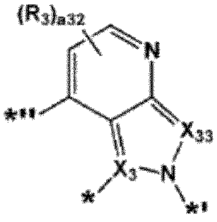

Formule A3-3(22)

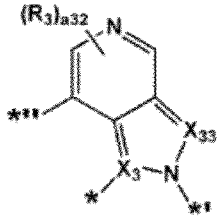

Formule A3-3(23)

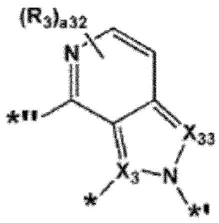

Formule A3-3(24)

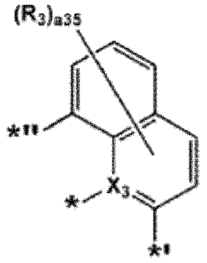

Formule A3-3(25)

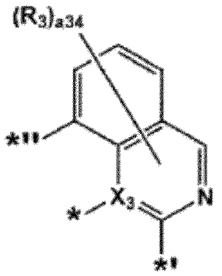

Formule A3-3(26)

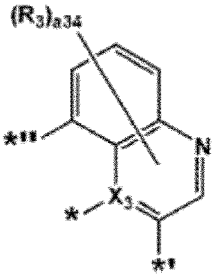

Formule A3-3(27)

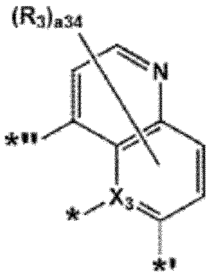

Formule A3-3(28)

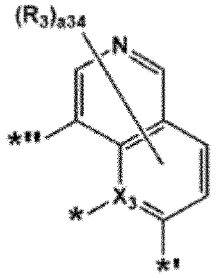

Formule A3-3(29)

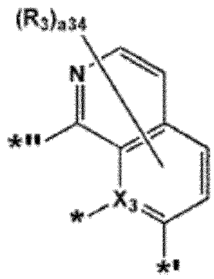

Formule A3-3(30)

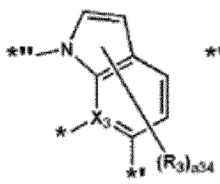

Formule A3-3(31)

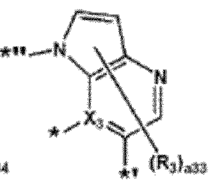

Formule A3-3(32)

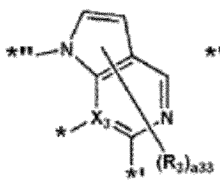

Formule A3-3(33)

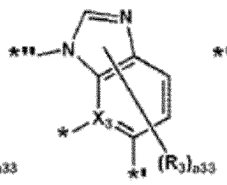

Formule A3-3(34)

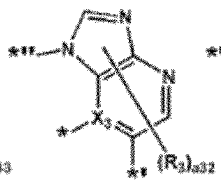

Formule A3-3(35)

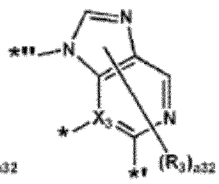

Formule A3-3(36)

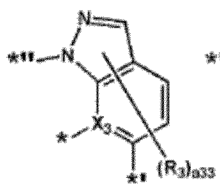

Formule A3-3(37)

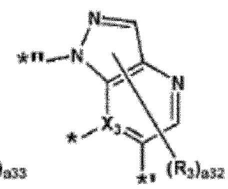

Formule A3-3(38)

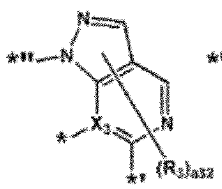

Formule A3-3(39)

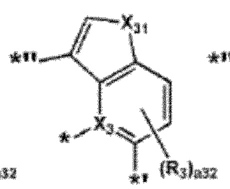

Formule A3-3(40)

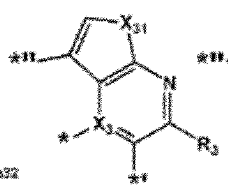

Formule A3-3(41)

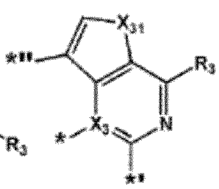

Formule A3-3(42)

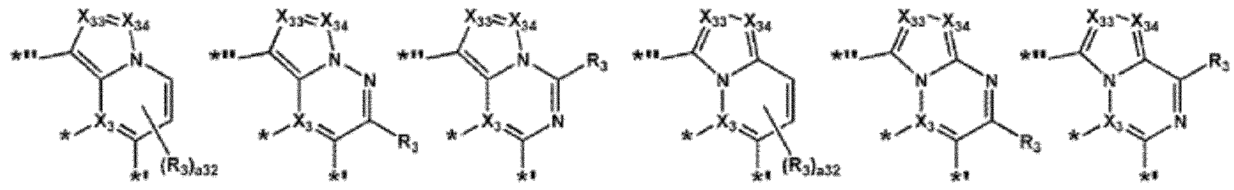

Formule A3-3(43) Formule A3-3(44) Formule A3-3(45) Formule A3-3(46) Formule A3-3(47) Formule A3-3(48)

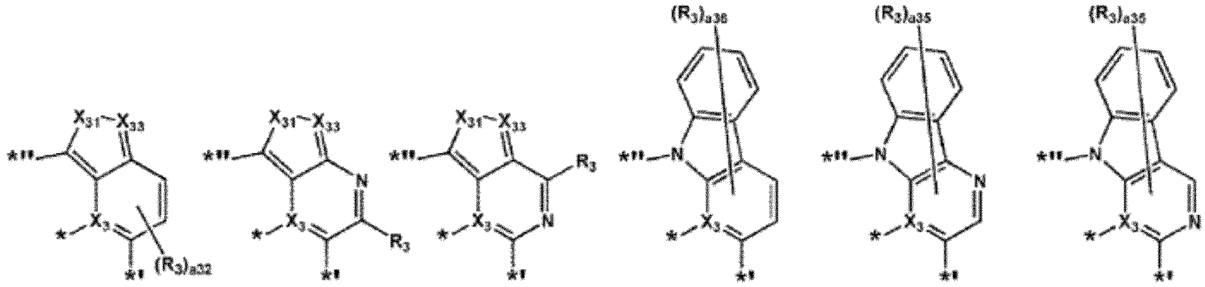

Formule A3-3(49) Formule A3-3(50) Formule A3-3(51) Formule A3-3(52) Formule A3-3(53) Formule A3-3(54)

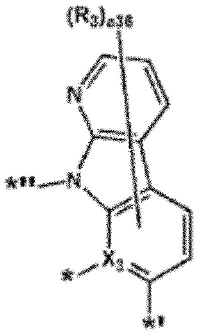 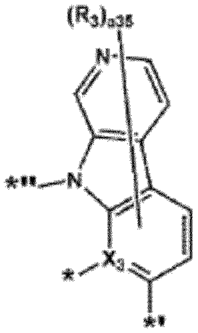 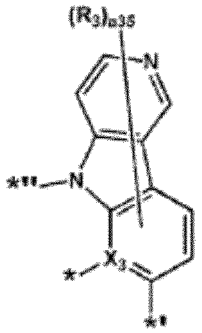 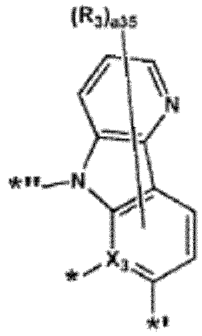

Formule A3-3(55) Formule A3-3(56) Formule A3-3(57) Formule A3-3(58)

,

où, dans les Formules A3-1(1) à A3-1(21), A3-2(1) à A3-2(58), et A3-3(1) à A3-3(58),

$X_3$ et $R_3$ sont identiques à la description de la revendication 1,
$X_{31}$ est O, S, $N(R_{31})$, $C(R_{31})(R_{32})$, ou $Si(R_{31})(R_{32})$,
$X_{33}$ est N ou $C(R_{33})$,
$X_{34}$ est N ou $C(R_{34})$,
$R_{31}$ à $R_{38}$ sont identiques à la description concernant $R_3$ dans la revendication 1,
a36 est un nombre entier de 0 à 6,
a35 est un nombre entier de 0 à 5,
a34 est un nombre entier de 0 à 4,
a33 est un nombre entier de 0 à 3,
a32 est un nombre entier de 0 à 2, et
*, *', et *" sont identiques à la description concernant *, *', et *" dans la Formule A3-1 ; et/ou

où
$A_4$ est représenté par l'une des Formules A4-1(1) à A4-1(44) et A4-2(1) à A4-2(71) :

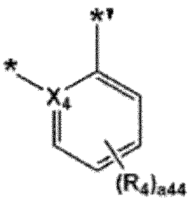
Formule A4-1(1)

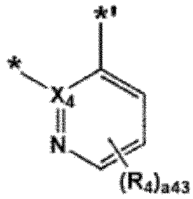
Formule A4-1(2)

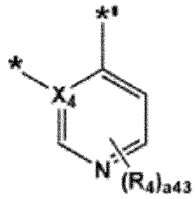
Formule A4-1(3)

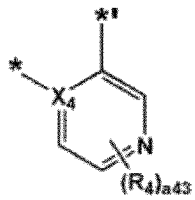
Formule A4-1(4)

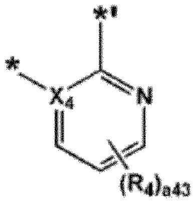
Formule A4-1(5)

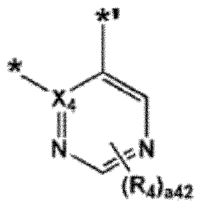
Formule A4-1(6)

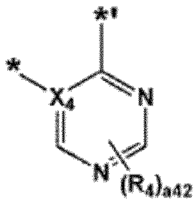
Formule A4-1(7)

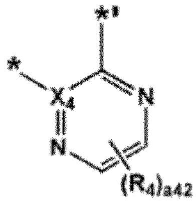
Formule A4-1(8)

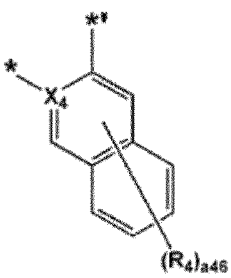
Formule A4-1(9)

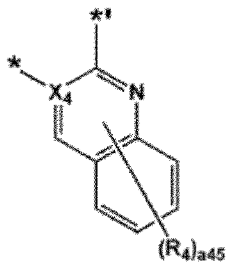
Formule A4-1(10)

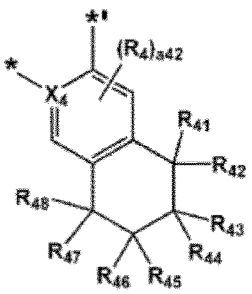
Formule A4-1(11)

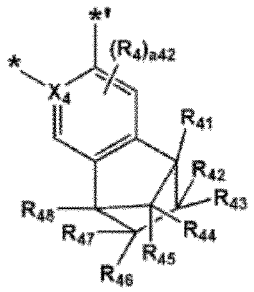
Formule A4-1(12)

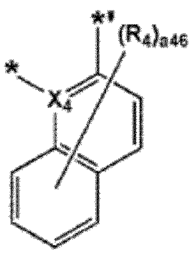
Formule A4-1(13)

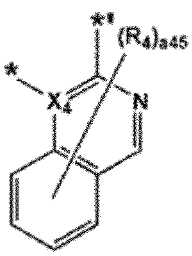
Formule A4-1(14)

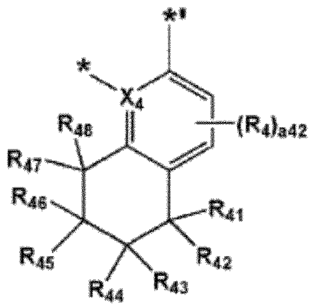
Formule A4-1(15)

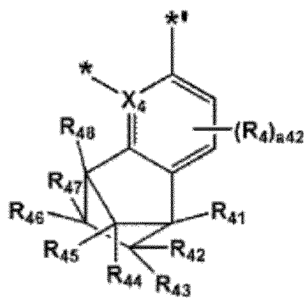
Formule A4-1(16)

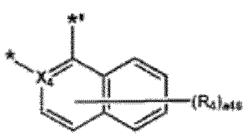
Formule A4-1(17)

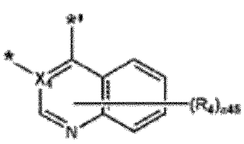
Formule A4-1(18)

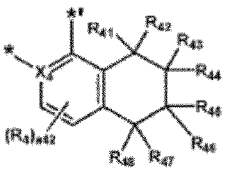
Formule A4-1(19)

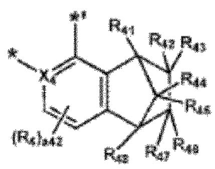
Formule A4-1(20)

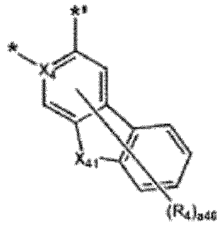
Formule A4-1(21)

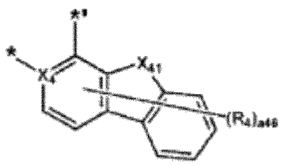
Formule A4-1(22)

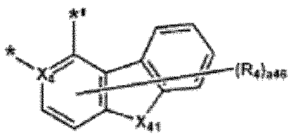
Formule A4-1(23)

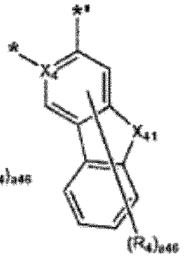
Formule A4-1(24)

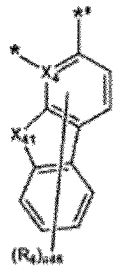
Formule A4-1(25)

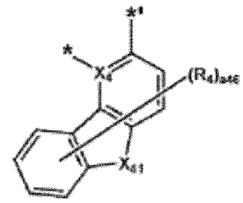
Formule A4-1(26)

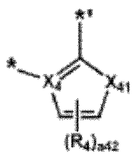
Formule A4-1(27)

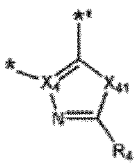
Formule A4-1(28)

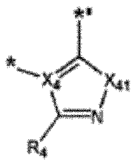
Formule A4-1(29)

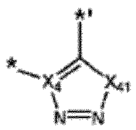
Formule A4-1(30)

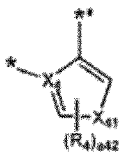
Formule A4-1(31)

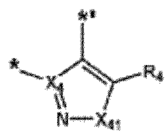
Formule A4-1(32)

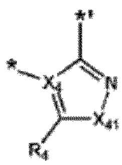
Formule A4-1(33)

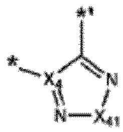
Formule A4-1(34)

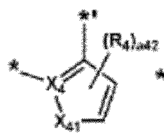
Formule A4-1(35)

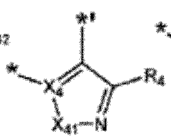
Formule A4-1(36)

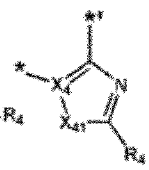
Formule A4-1(37)

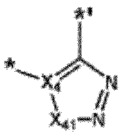
Formule A4-1(38)

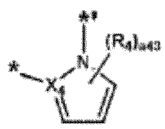
Formule A4-1(39)

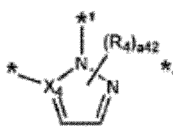
Formule A4-1(40)

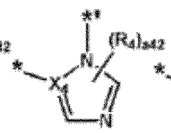
Formule A4-1(41)

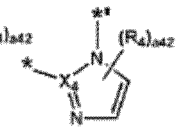
Formule A4-1(42)

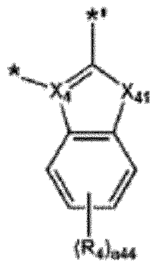
Formule A4-1(43)

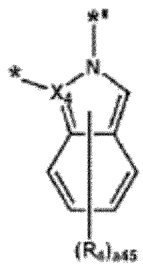
Formule A4-1(44)

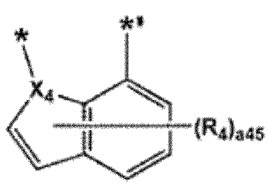
Formule A4-2(1)

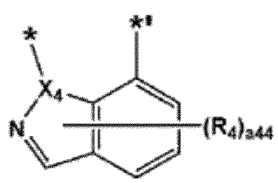
Formule A4-2(2)

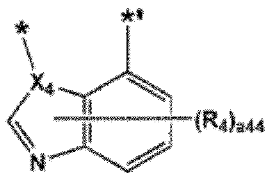
Formule A4-2(3)

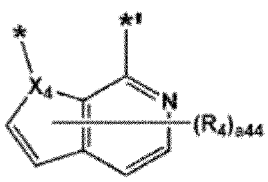
Formule A4-2(4)

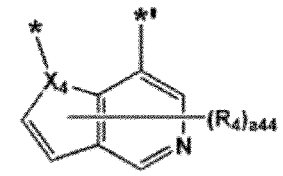
Formule A4-2(5)

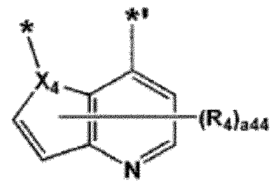
Formule A4-2(6)

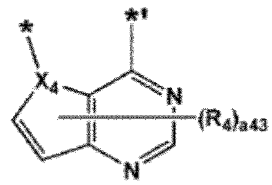
Formule A4-2(7)

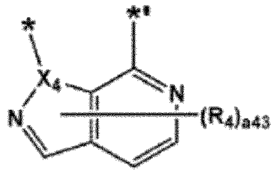
Formule A4-2(8)

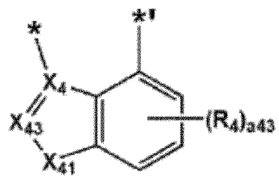
Formule A4-2(9)

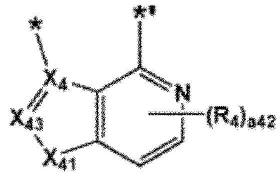
Formule A4-2(10)

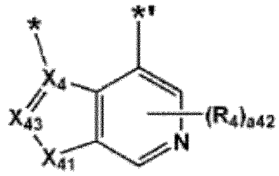
Formule A4-2(11)

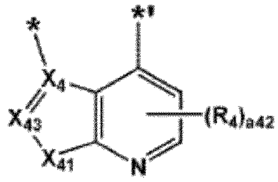
Formule A4-2(12)

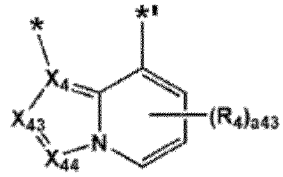
Formule A4-2(13)

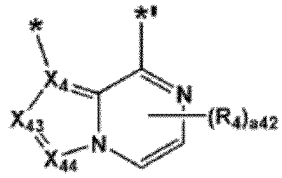
Formule A4-2(14)

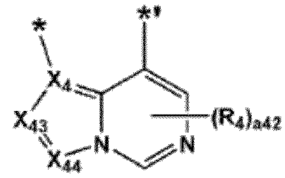
Formule A4-2(15)

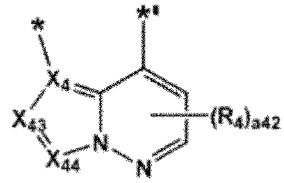
Formule A4-2(16)

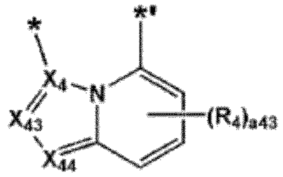
Formule A4-2(17)

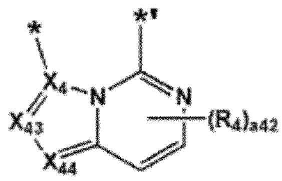
Formule A4-2(18)

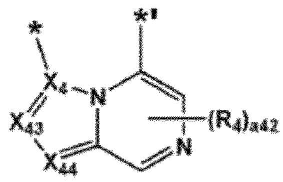
Formule A4-2(19)

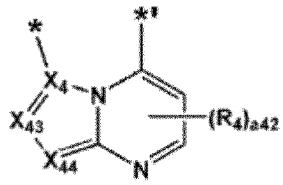
Formule A4-2(20)

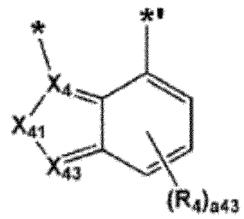
Formule A4-2(21)

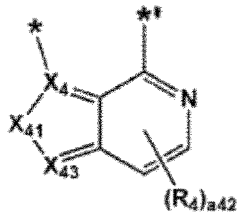
Formule A4-2(22)

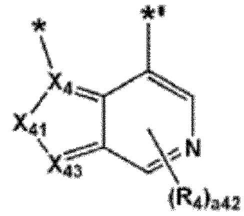
Formule A4-2(23)

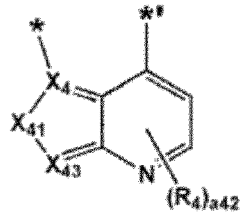
Formule A4-2(24)

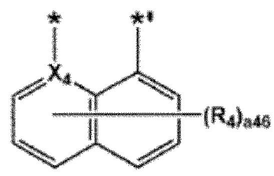
Formule A4-2(25)

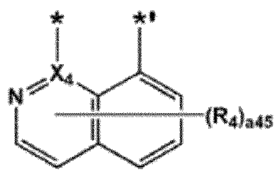
Formule A4-2(26)

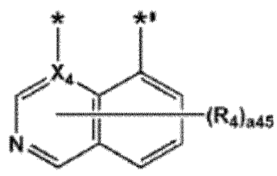
Formule A4-2(27)

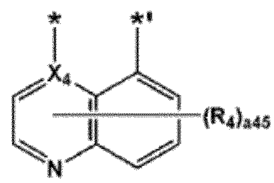
Formule A4-2(28)

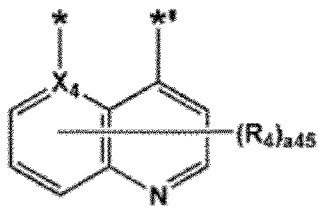
Formule A4-2(29)

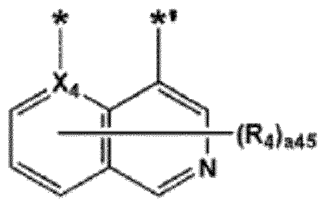
Formule A4-2(30)

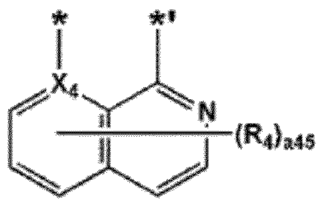
Formule A4-2(31)

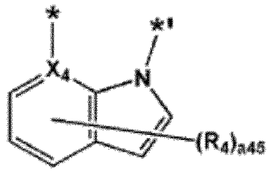
Formule A4-2(32)

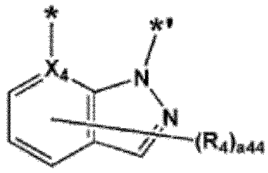
Formule A4-2(33)

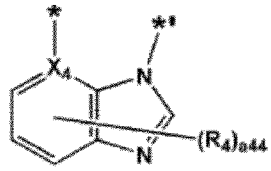
Formule A4-2(34)

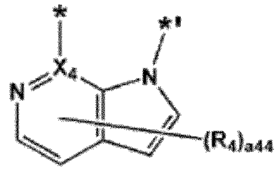
Formule A4-2(35)

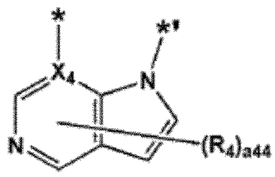
Formule A4-2(36)

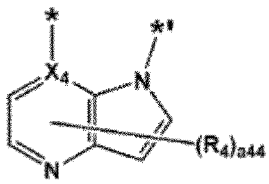
Formule A4-2(37)

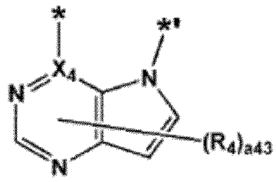
Formule A4-2(38)

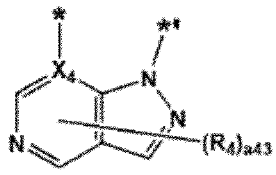
Formule A4-2(39)

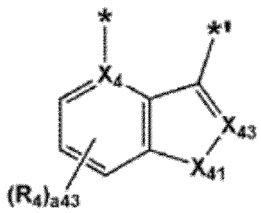
Formule A4-2(40)

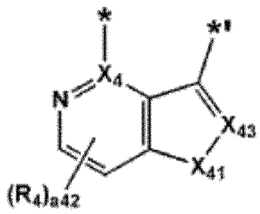
Formule A4-2(41)

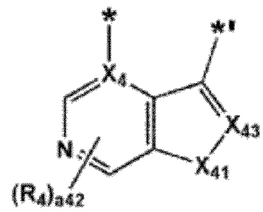
Formule A4-2(42)

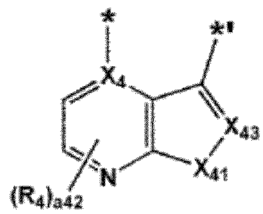
Formule A4-2(43)

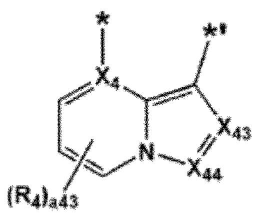
Formule A4-2(44)

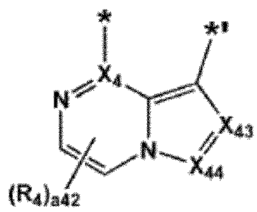
Formule A4-2(45)

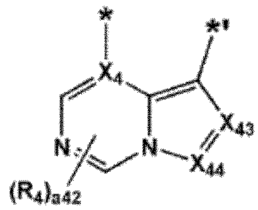
Formule A4-2(46)

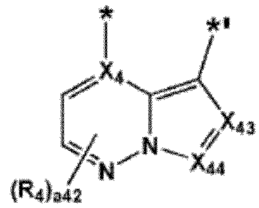
Formule A4-2(47)

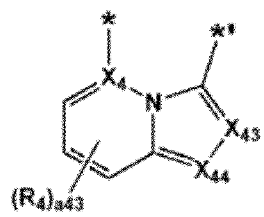

Formule A4-2(48)

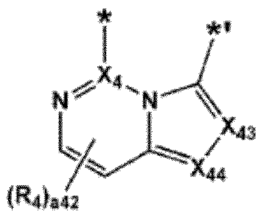

Formule A4-2(49)

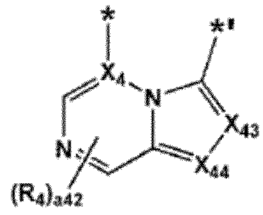

Formule A4-2(50)

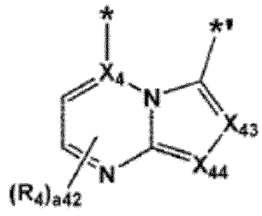

Formule A4-2(51)

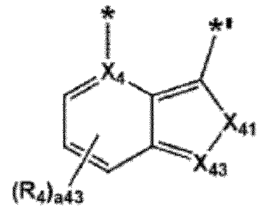

Formule A4-2(52)

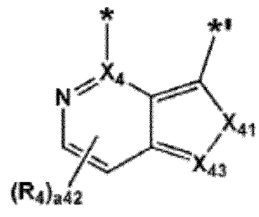

Formule A4-2(53)

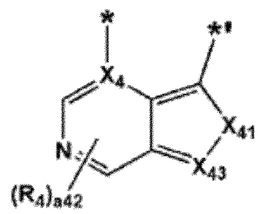

Formule A4-2(54)

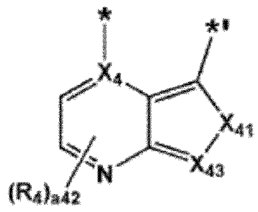

Formule A4-2(55)

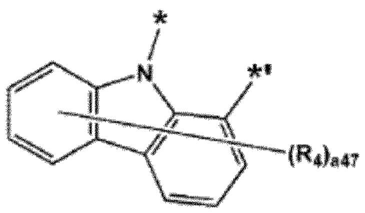

Formule A4-2(56)

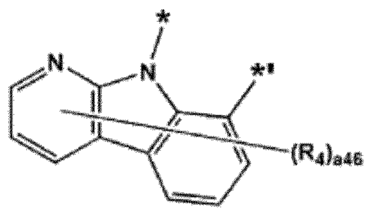

Formule A4-2(57)

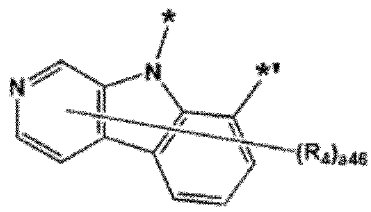

Formule A4-2(58)

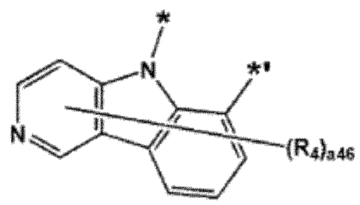

Formule A4-2(59)

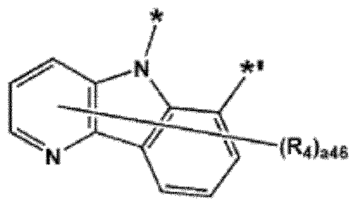

Formule A4-2(60)

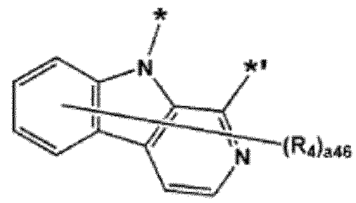

Formule A4-2(61)

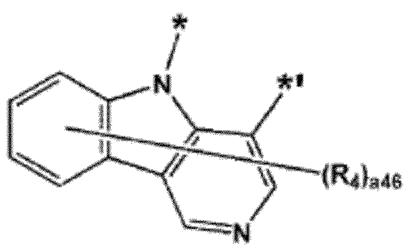

Formule A4-2(62)

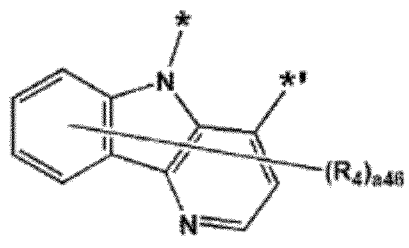

Formule A4-2(63)

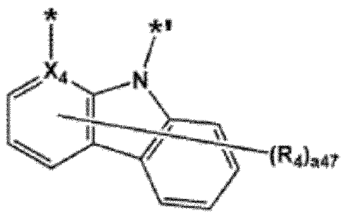

Formule A4-2(64)

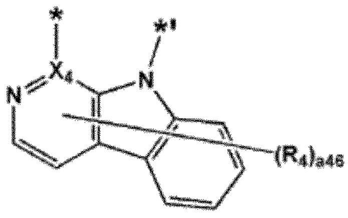

Formule A4-2(65)

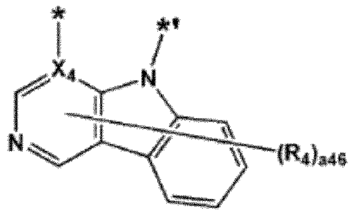

Formule A4-2(66)

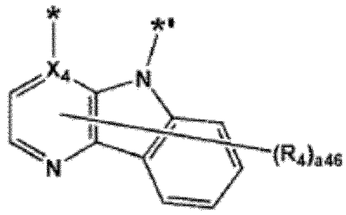

Formule A4-2(67)

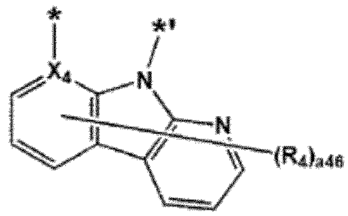

Formule A4-2(68)

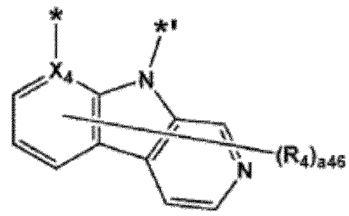

Formule A4-2(69)

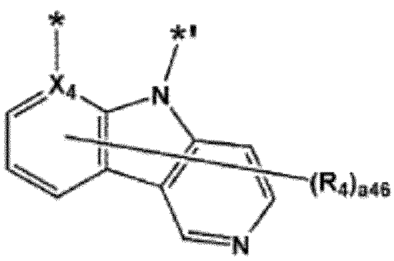

Formule A4-2(70)

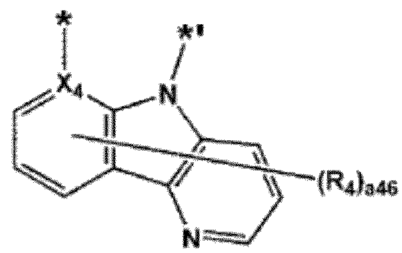

Formule A4-2(71)

,

où, dans les Formules A4-1(1) à A4-1(44) et A4-2(1) à A4-2(71),

$X_4$, $R_4$, *, et *' sont identiques à la description de la revendication 1,
$X_{41}$ est O, S, $N(R_{41})$, $C(R4_1)(R4_2)$, ou $Si(R_{41})(R_{42})$,
$X_{43}$ est N ou $C(R_{43})$,
$X_{44}$ est N ou $C(R_{44})$,
$R_{41}$ à $R_{48}$ sont identiques à la description concernant $R_4$,
a47 est un nombre entier de 0 à 7,
a46 est un nombre entier de 0 à 6,
a45 est un nombre entier de 0 à 5,
a44 est un nombre entier de 0 à 4,
a43 est un nombre entier de 0 à 3, et
a42 est un nombre entier de 0 à 2.

**9.** Composé organométallique selon l'une quelconque des revendications 1-8, dans lequel
$A_2$ est représenté par la Formule A2-2 ; et/ou
dans lequel
$A_1$ est représenté par l'une des Formules A1-1-1 à A1-1-10 et A1-2-1 à A1-2- 4,
$A_2$ est représenté par l'une des Formules A2-2-1 à A2-2-4,
$A_3$ est représenté par l'une des Formules A3-1-1 à A3-1-10, et
$A_4$ est représenté par l'une des Formules A4-1-1 à A4-1-14 :

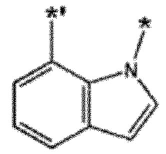
Formule A1-1-1

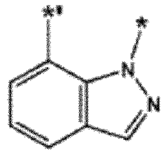
Formule A1-1-2

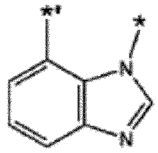
Formule A1-1-3

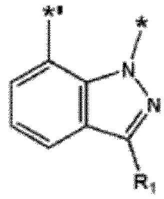
Formule A1-1-4

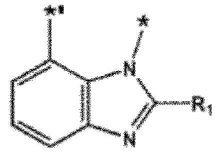
Formule A1-1-5

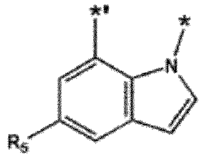
Formule A1-1-6

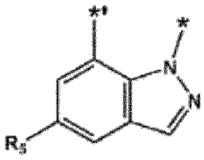
Formule A1-1-7

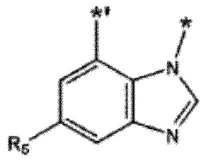
Formule A1-1-8

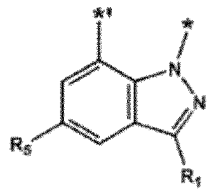
Formule A1-1-9

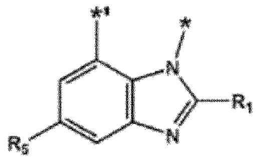
Formule A1-1-10

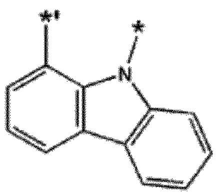
Formule A1-2-1

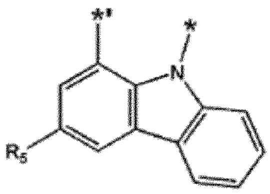
Formule A1-2-2

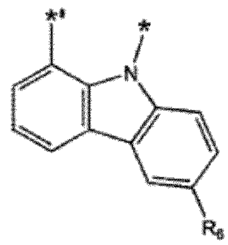
Formule A1-2-3

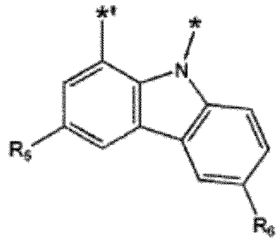
Formule A1-2-4

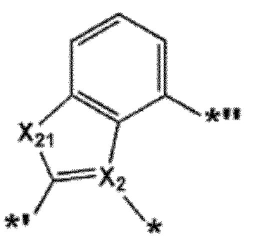
Formule A2-2-1

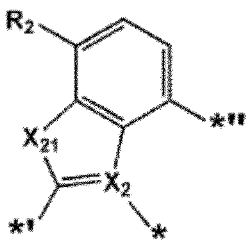
Formule A2-2-2

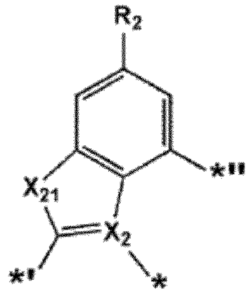
Formule A2-2-3

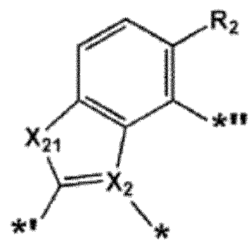
Formule A2-2-4

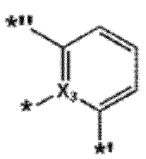
Formule A3-1-1

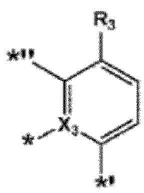
Formule A3-1-2

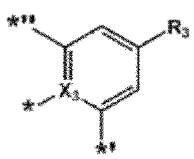
Formule A3-1-3

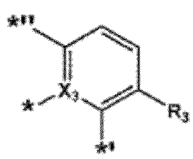
Formule A3-1-4

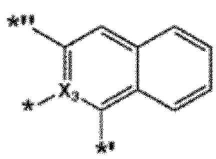
Formule A3-1-5

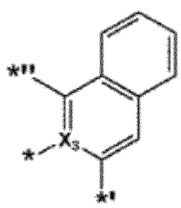
Formule A3-1-6

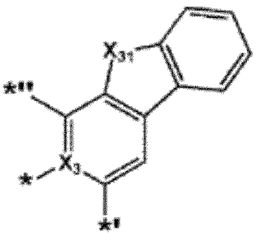
Formule A3-1-7

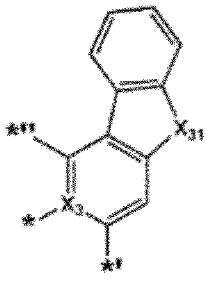
Formule A3-1-8

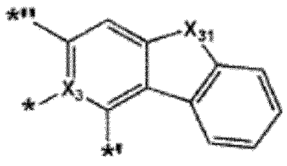
Formule A3-1-9

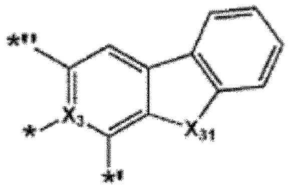
Formule A3-1-10

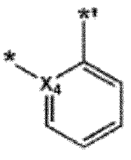
Formule A4-1-1

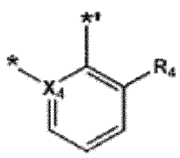
Formule A4-1-2

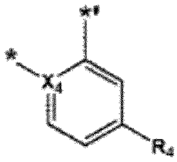
Formule A4-1-3

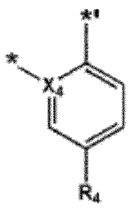
Formule A4-1-4

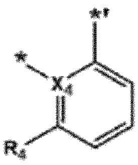
Formule A4-1-5

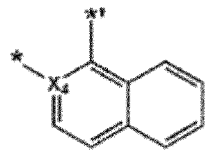
Formule A4-1-6

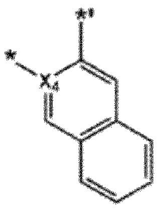
Formule A4-1-7

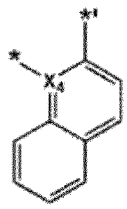
Formule A4-1-8

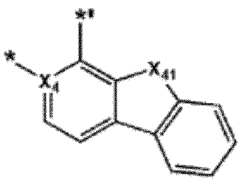
Formule A4-1-9

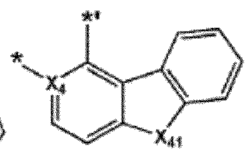
Formule A4-1-10

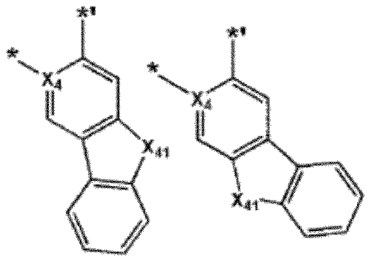
Formule A4-1-11

Formule A4-1-12

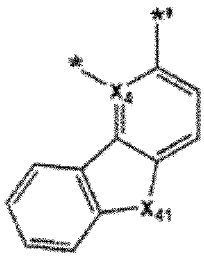
Formule A4-1-13

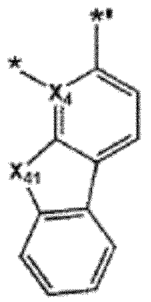
Formule A4-1-14

,

où, dans les Formules A1-1-1 à A1-1-10, A1-2-1 à A1-2-4, A2-2-1 à A2-2-4, A3-1-1 à A3-1-10, et A4-1-1 à A4-1-14

$X_1$ à $X_4$ et $R_1$ à $R_6$ sont identiques à la description de la revendication 1, étant entendu que $R_1$ à $R_6$ ne sont pas l'hydrogène,

$X_{21}$ est O, S, $N(R_{21})$, $C(R_{21})(R_{22})$, ou $Si(R_{21})(R_{22})$, et $R_{21}$ et $R_{22}$ sont identiques à la description concernant $R_2$ dans la revendication 1,

$X_{31}$ est O, S, $N(R_{31})$, $C(R_{31})(R_{32})$, ou $Si(R_{31})(R_{32})$, et $R_{31}$ et $R_{32}$ sont identiques à la description concernant

$R_3$ dans la revendication 1,
$X_{41}$ est O, S, $N(R_{41})$, $C(R_{41})(R_{42})$, ou $Si(R_{41})(R_{42})$, et $R_{41}$ et $R_{42}$ sont identiques à la description concernant $R_4$ dans la revendication 1,
dans les Formules A1-1-1 à A1-1-10 et A1-2-1 à A1-2-4, * indique un site de fixation à M dans la Formule 1, et *' indique un site de fixation à $T_1$ dans la Formule 1,
dans les Formules A2-2-1 à A2-2-4, * indique un site de fixation à M dans la Formule 1, *' indique un site de fixation à $T_1$ dans la Formule 1, et *" indique un site de fixation à $T_2$ dans la Formule 1,
dans les Formules A3-1-1 à A3-1-10, * indique un site de fixation à M dans la Formule 1, *" indique un site de fixation à $T_2$ dans la Formule 1, et *' indique un site de fixation à $T_3$ dans la Formule 1, et
dans les Formules A4-1-1 à A4-1-14, * indique un site de fixation à M dans la Formule 1, et *' indique un site de fixation à $T_3$ dans la Formule 1.

**10.** Composé organométallique selon l'une quelconque des revendications 1-9, le composé organométallique étant l'un des Composés 1 à 273 :

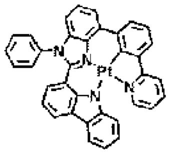
1
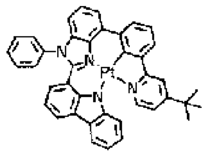
2
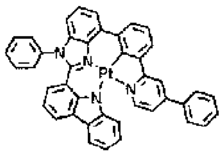
3
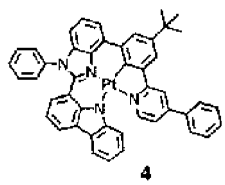
4
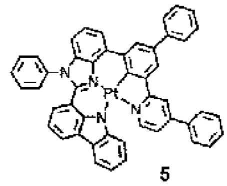
5

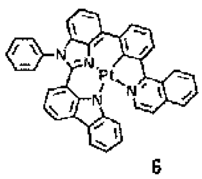
6
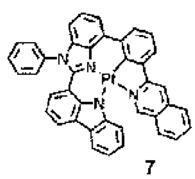
7
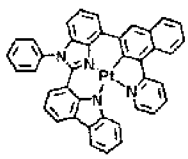
8
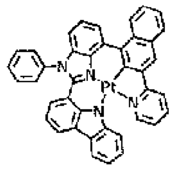
9
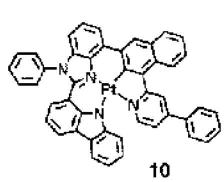
10

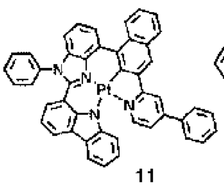
11
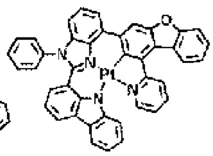
12
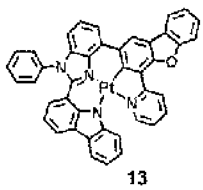
13
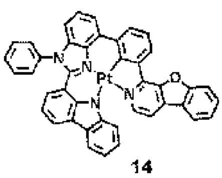
14
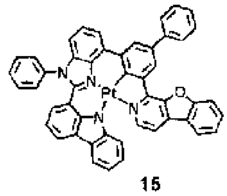
15

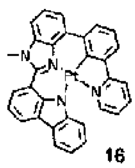
16
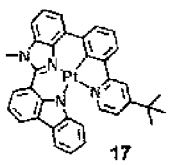
17
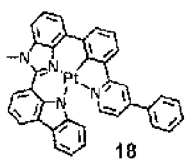
18
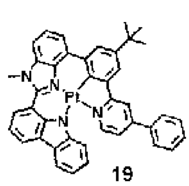
19
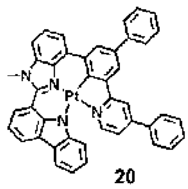
20

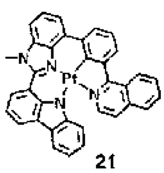
21
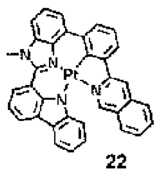
22
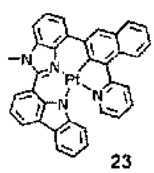
23
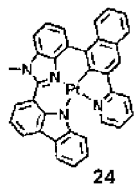
24
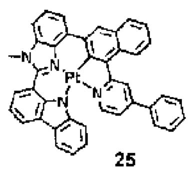
25

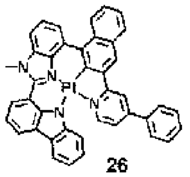
26

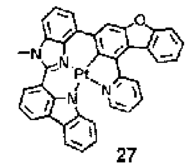
27

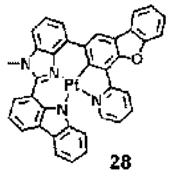
28

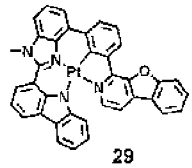
29

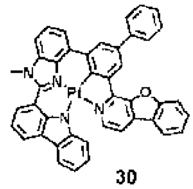
30

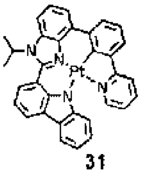
31

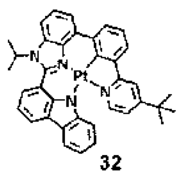
32

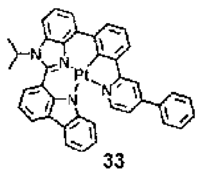
33

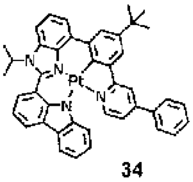
34

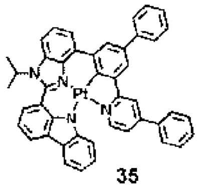
35

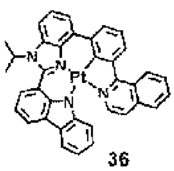
36

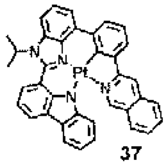
37

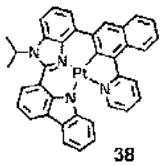
38

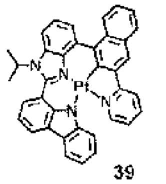
39

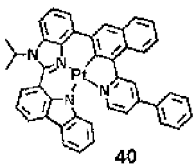
40

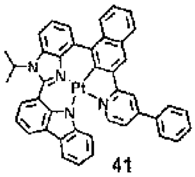
41

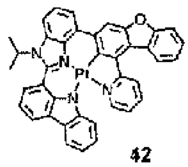
42

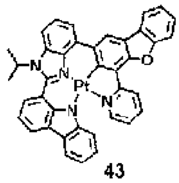
43

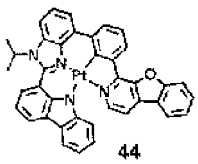
44

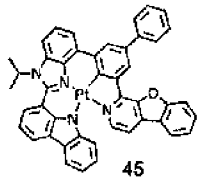
45

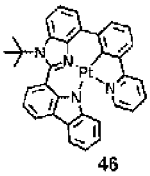
46

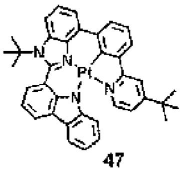
47

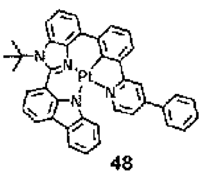
48

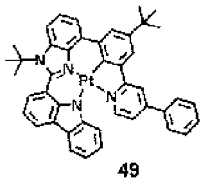
49

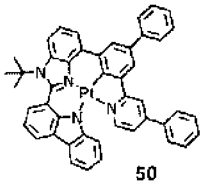
50

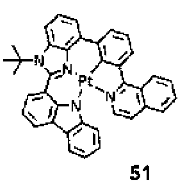
51

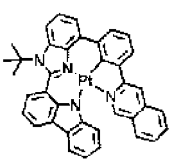
52

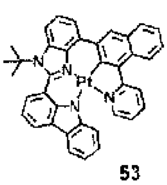
53

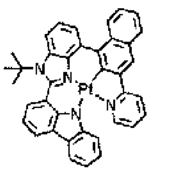
54

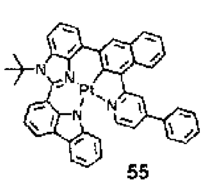
55

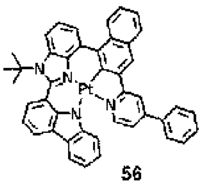
56

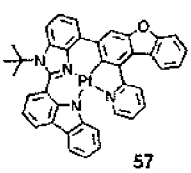
57

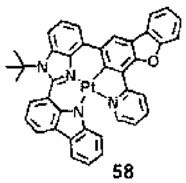
58

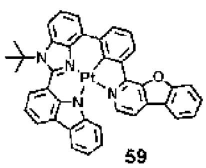
59

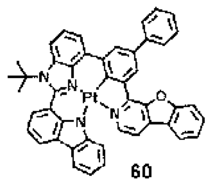
60

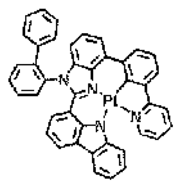
61
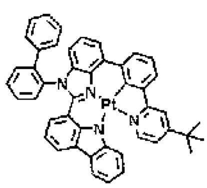
62
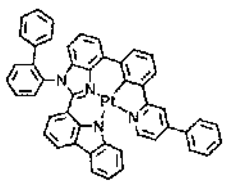
63
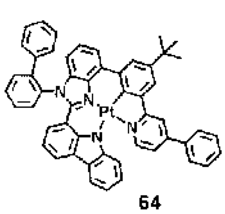
64
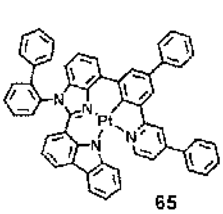
65

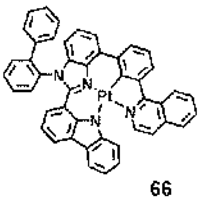
66
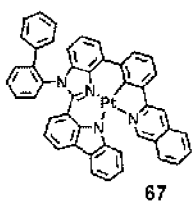
67
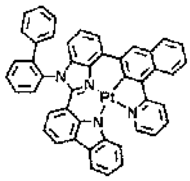
68
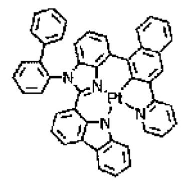
69
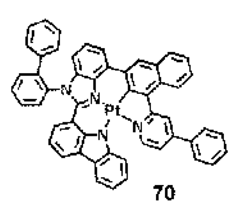
70

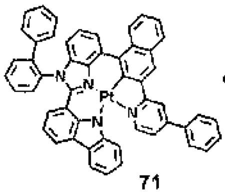
71
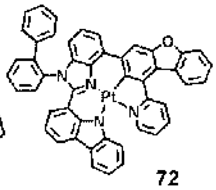
72
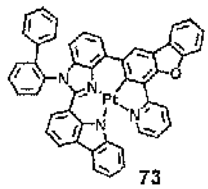
73
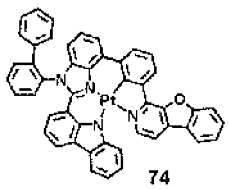
74
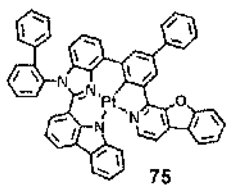
75

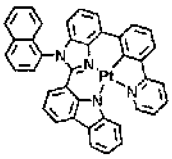
76
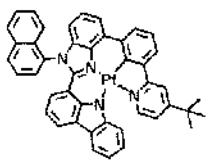
77
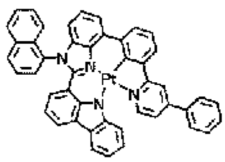
78
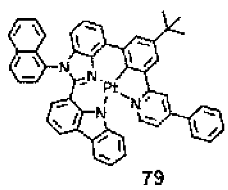
79
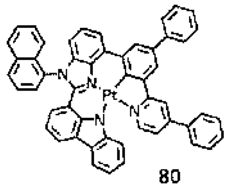
80

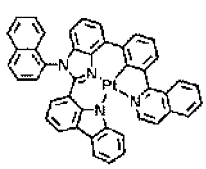
81
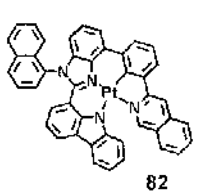
82
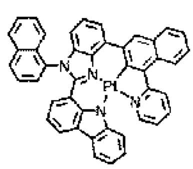
83
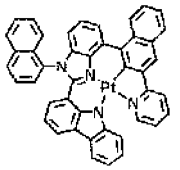
84
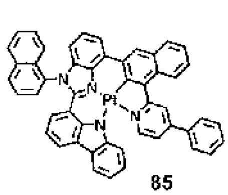
85

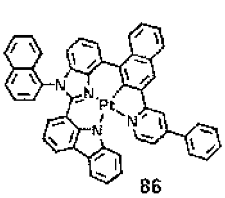
86
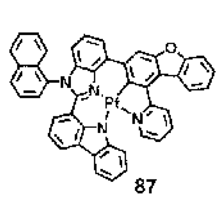
87
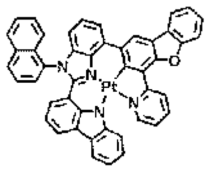
88
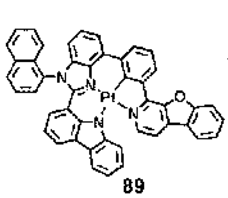
89
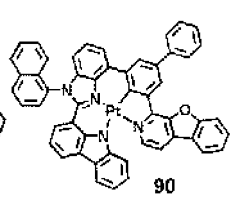
90

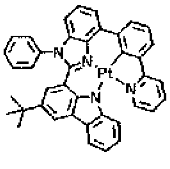
91
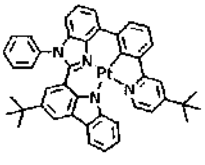
92
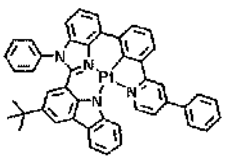
93
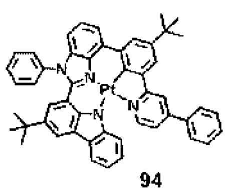
94
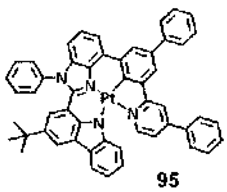
95

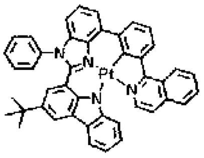
96
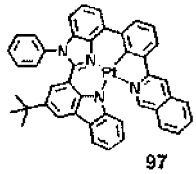
97
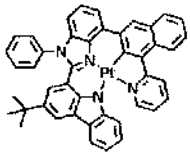
98
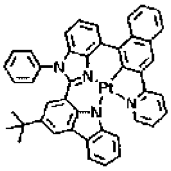
99
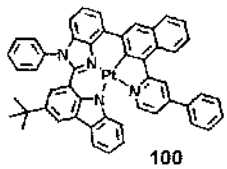
100

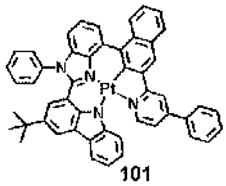
101
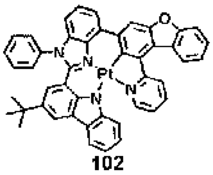
102
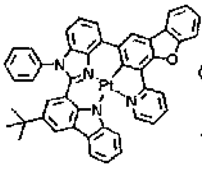
103
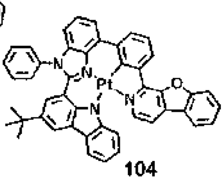
104
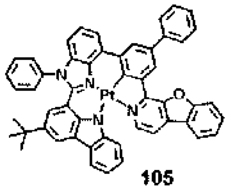
105

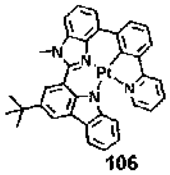
106
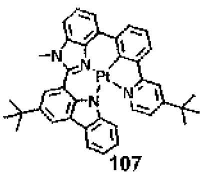
107
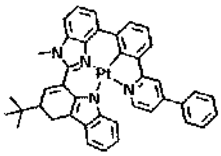
108
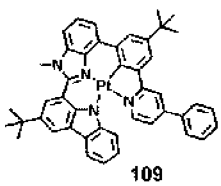
109
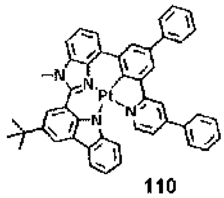
110

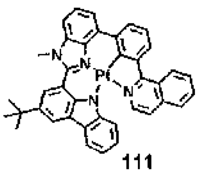
111
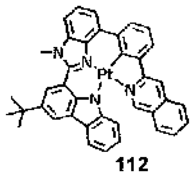
112
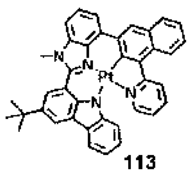
113
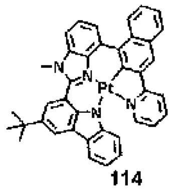
114
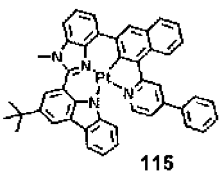
115

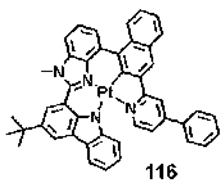
116
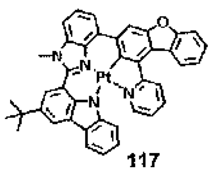
117
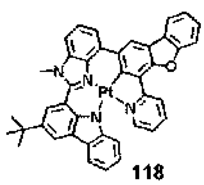
118
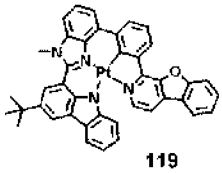
119
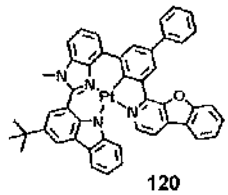
120

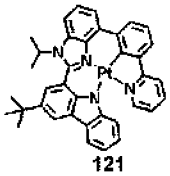
121
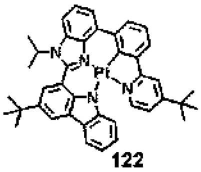
122
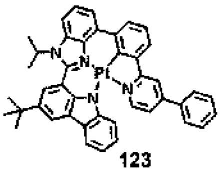
123
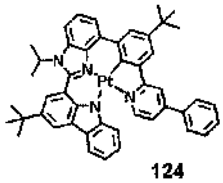
124
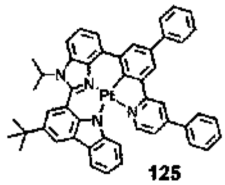
125

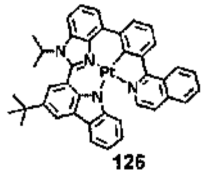
126
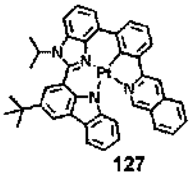
127
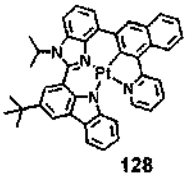
128
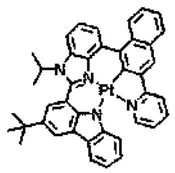
129
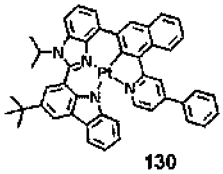
130

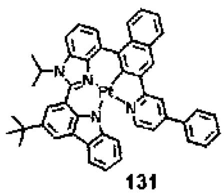
131
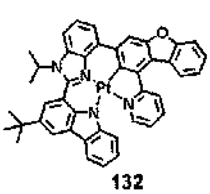
132
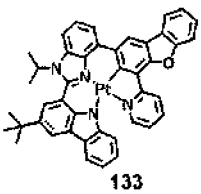
133
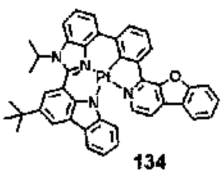
134
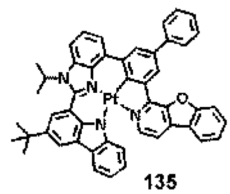
135

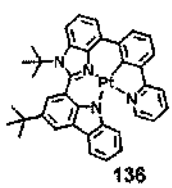
136
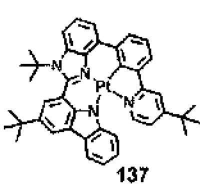
137
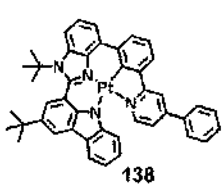
138
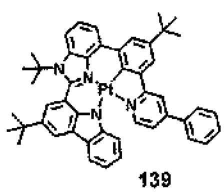
139
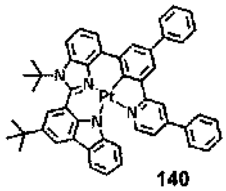
140

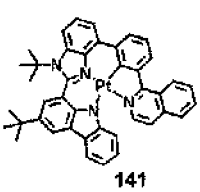
141
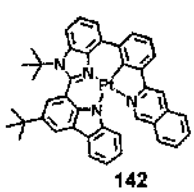
142
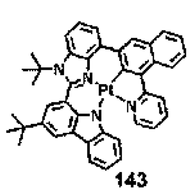
143
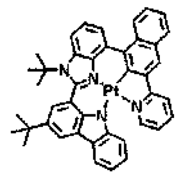
144
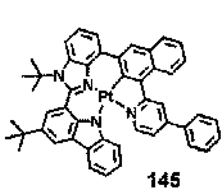
145

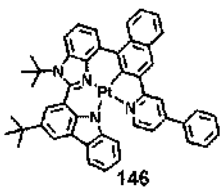
146
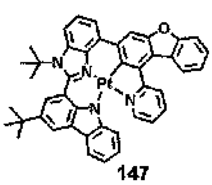
147
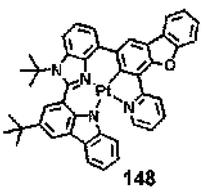
148
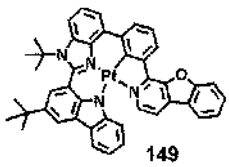
149
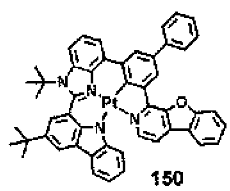
150

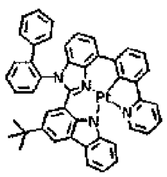
151
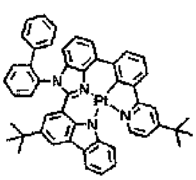
152
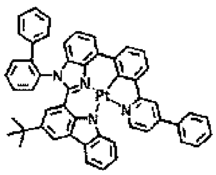
153
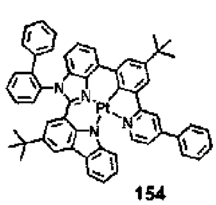
154
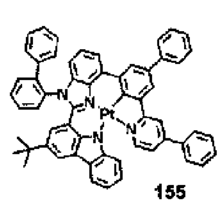
155

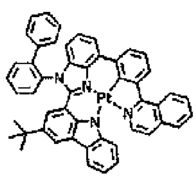
156
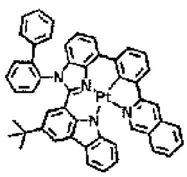
157
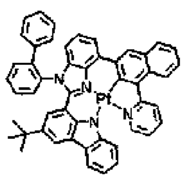
158
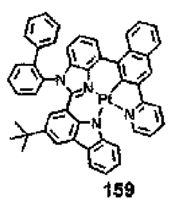
159
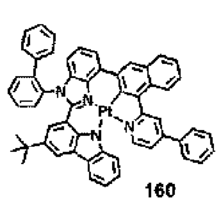
160

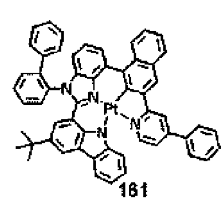
161
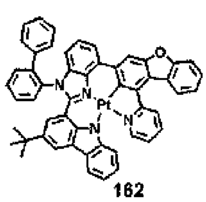
162
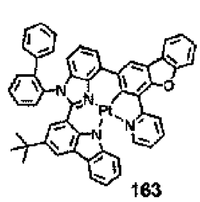
163
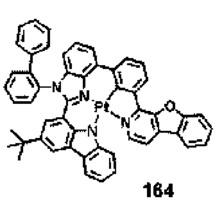
164
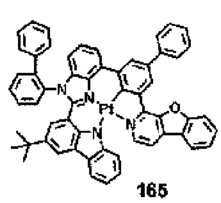
165

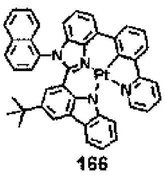
166
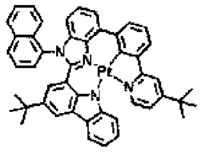
167
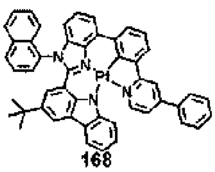
168
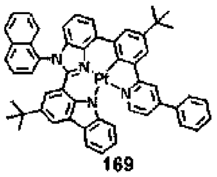
169
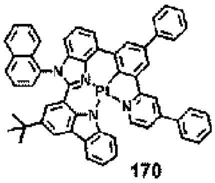
170

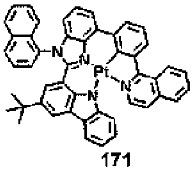
171
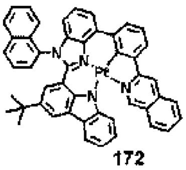
172
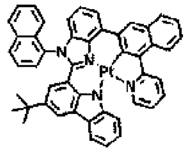
173
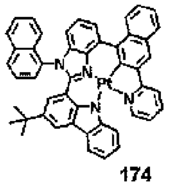
174
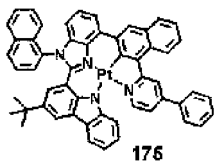
175

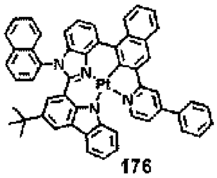
176
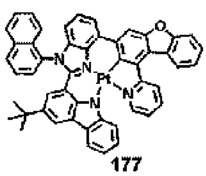
177
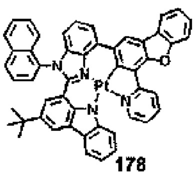
178
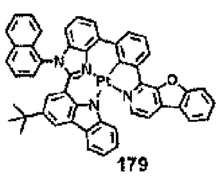
179
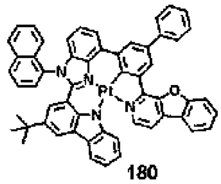
180

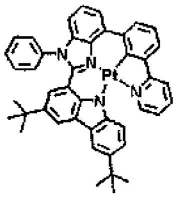
181
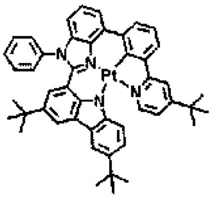
182
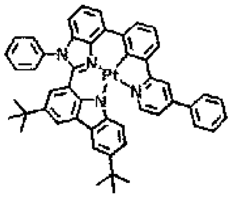
183
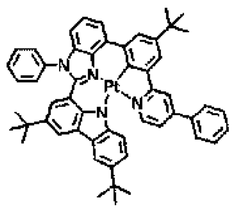
184
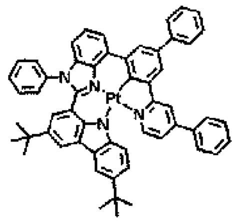
185

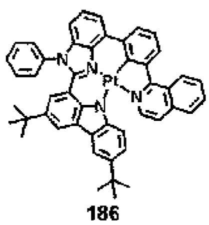
186
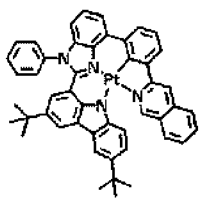
187
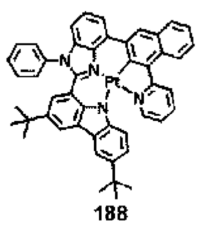
188
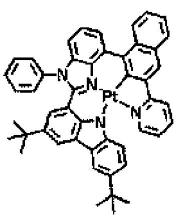
189
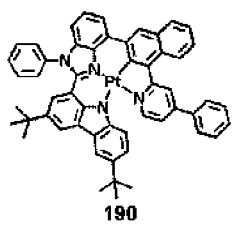
190

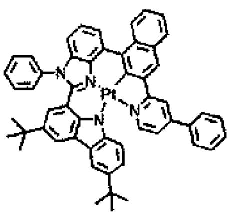
191
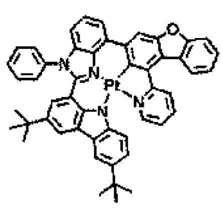
192
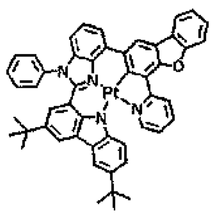
193
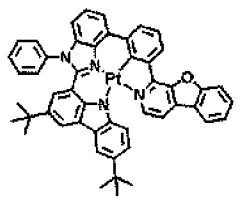
194
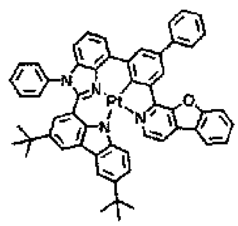
195

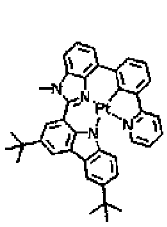
196
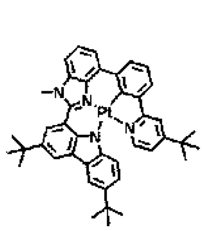
197
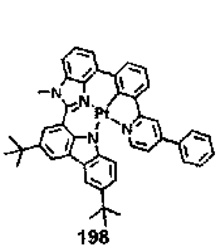
198
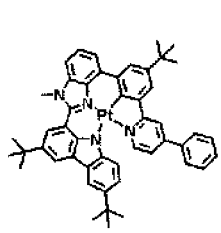
199
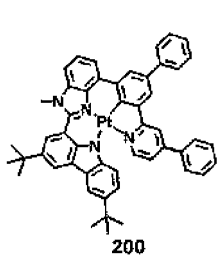
200

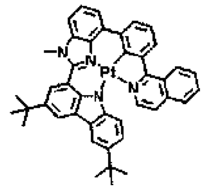
201

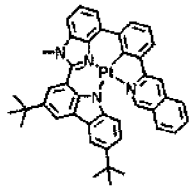
202

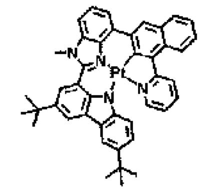
203

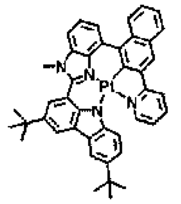
204

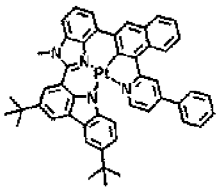
205

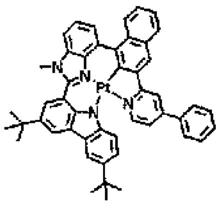
206

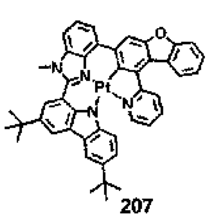
207

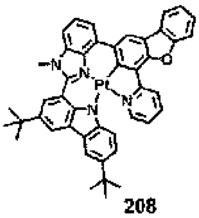
208

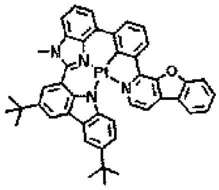
209

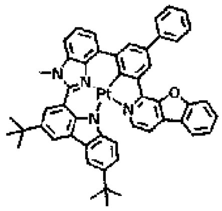
210

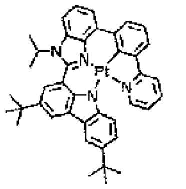
211

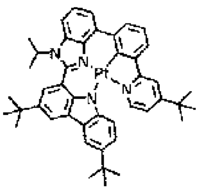
212

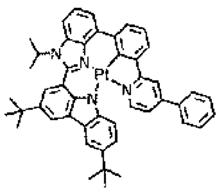
213

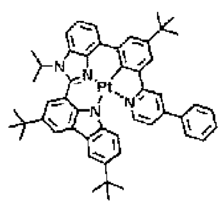
214

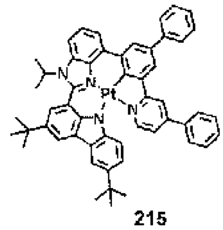
215

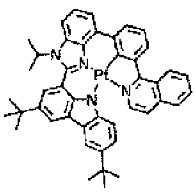
216

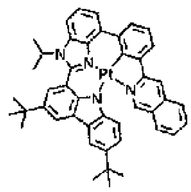
217

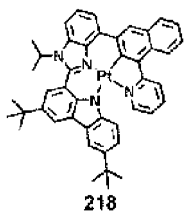
218

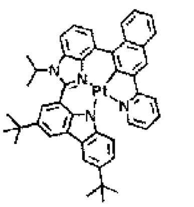
219

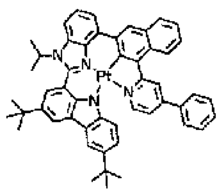
220

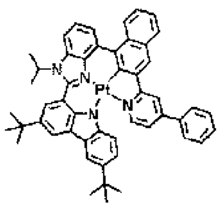
221

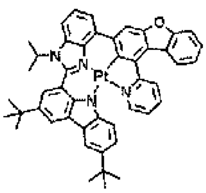
222

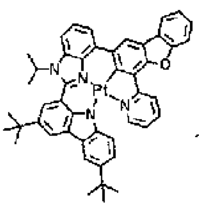
223

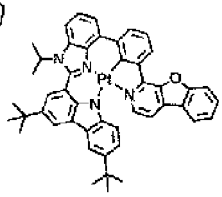
224

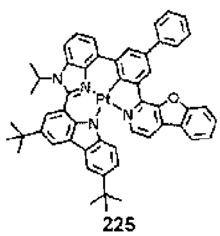
225

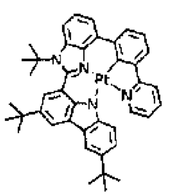
226

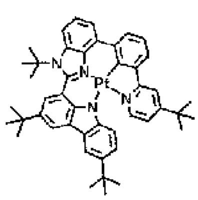
227

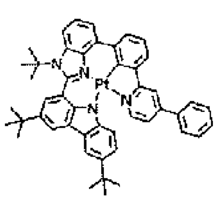
228

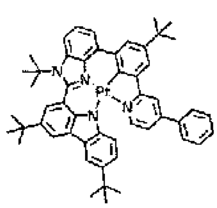
229

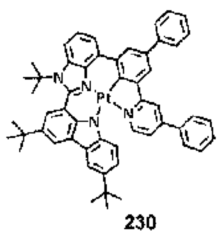
230

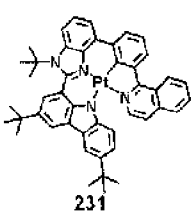
231
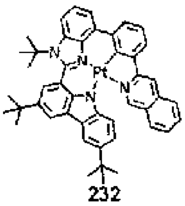
232
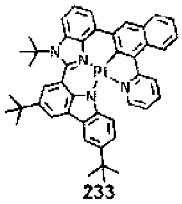
233
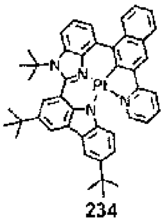
234
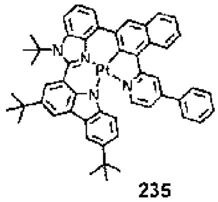
235

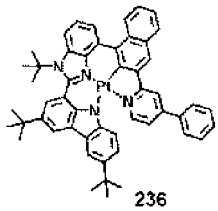
236
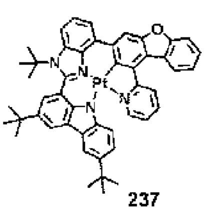
237
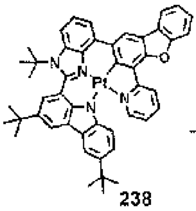
238
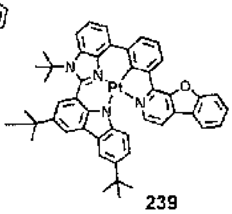
239
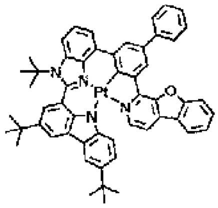
240

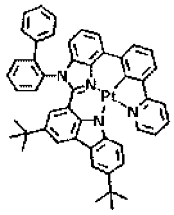
241
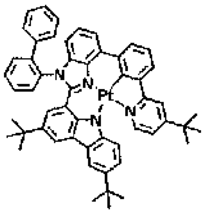
242
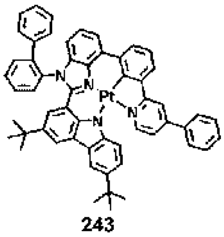
243
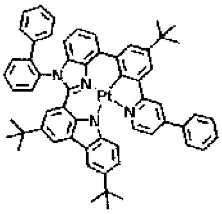
244
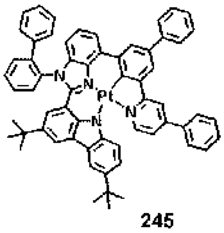
245

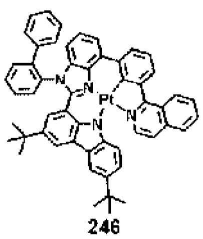
246
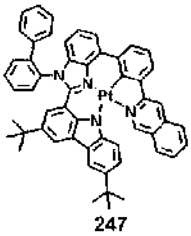
247
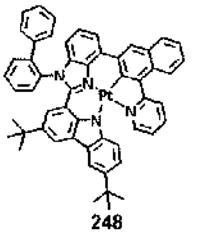
248
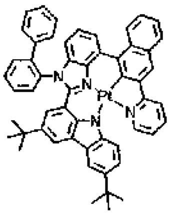
249
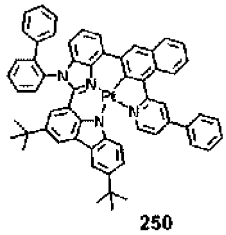
250

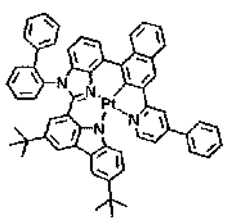
251
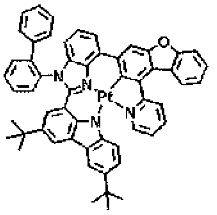
252
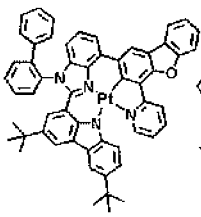
253
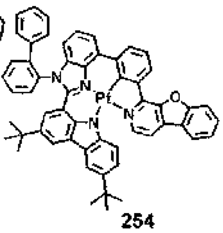
254
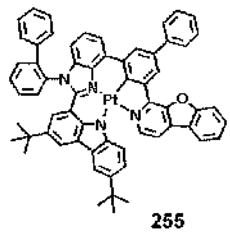
255

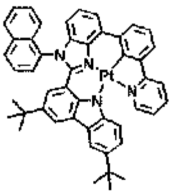
256
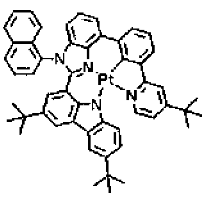
257
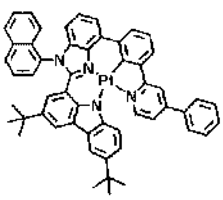
258
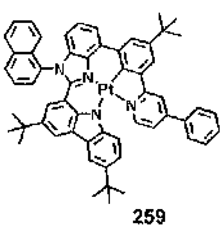
259
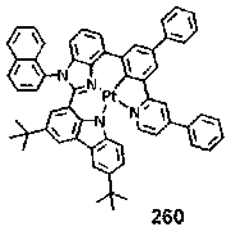
260

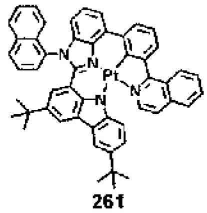
261
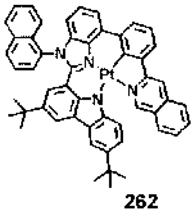
262
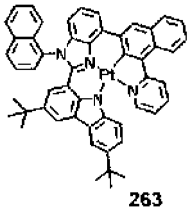
263
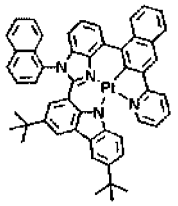
264
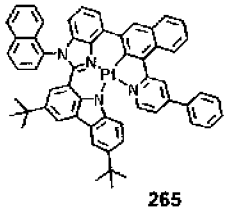
265

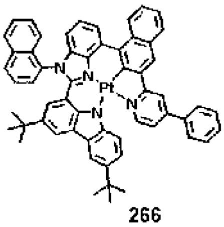
266
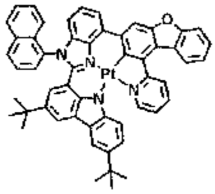
267
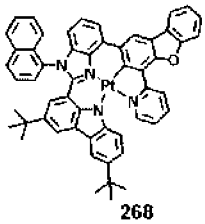
268
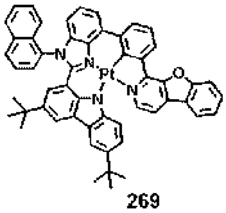
269
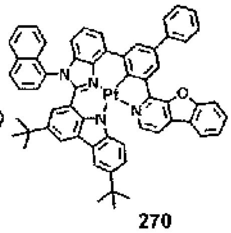
270

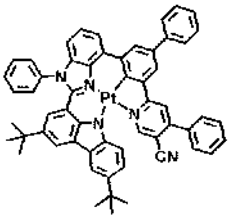
271
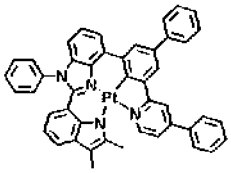
272
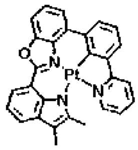
273.

**11.** Dispositif luminescent organique comprenant :

une première électrode ;
une deuxième électrode ; et
une couche organique disposée entre la première électrode et la deuxième électrode, la couche organique comprenant une couche d'émission et au moins un composé organométallique selon l'une quelconque des revendications 1-10.

**12.** Dispositif luminescent organique selon la revendication 11, dans lequel
la première électrode est une anode,
la deuxième électrode est une cathode,
la couche organique comprend en outre une zone de transport de trous disposée entre la première électrode et la couche d'émission et une zone de transport d'électrons disposée entre la couche d'émission et la deuxième électrode,
dans lequel la zone de transport de trous comprend une couche d'injection de trous, une couche de transport de trous, une couche de blocage d'électrons ou une combinaison de celles-ci, et
dans lequel la zone de transport d'électrons comprend une couche de blocage de trous, une couche de transport d'électrons, une couche d'injection d'électrons ou une combinaison de celles-ci.

**13.** Dispositif luminescent organique selon la revendication 11 ou 12, dans lequel
la couche d'émission comprend le composé organométallique.

**14.** Dispositif luminescent organique selon la revendication 13, dans lequel
la couche d'émission comprend en outre un hôte, et dans lequel une quantité de l'hôte est plus grande qu'une quantité du composé organométallique.

**15.** Composition de diagnostic comprenant au moins l'un du composé organométallique selon l'une des revendications 1-10.

# FIGURE

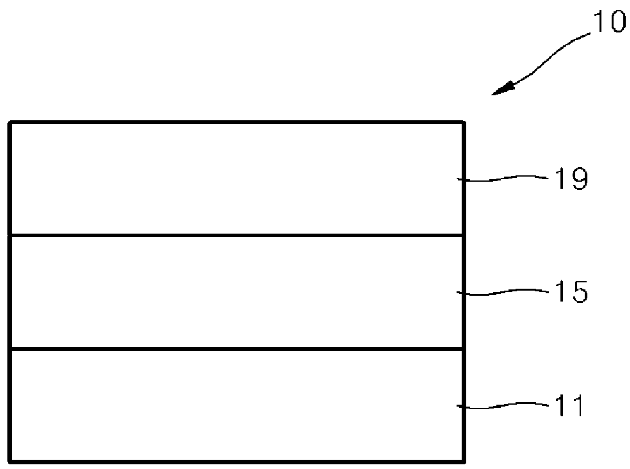

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010135689 A
- US 2013168656 A
- WO 2014109814 A